(19) Europäisches Patentamt
European Patent Office
Office européen des brevets

(11) EP 4 597 225 A1

(12) **EUROPEAN PATENT APPLICATION**
published in accordance with Art. 153(4) EPC

(43) Date of publication:
**06.08.2025 Bulletin 2025/32**

(21) Application number: **23872189.8**

(22) Date of filing: **22.09.2023**

(51) International Patent Classification (IPC):
***G03F 7/004*** (2006.01) ***C08F 290/14*** (2006.01)
***C08G 73/10*** (2006.01) ***G03F 7/027*** (2006.01)
***G03F 7/09*** (2006.01) ***G03F 7/20*** (2006.01)
***G03F 7/26*** (2006.01) ***H01L 21/312*** (2006.01)

(52) Cooperative Patent Classification (CPC):
**C08F 290/14; C08G 73/10; G03F 7/004; G03F 7/027; G03F 7/09; G03F 7/20; G03F 7/26; H01L 21/31**

(86) International application number:
**PCT/JP2023/034551**

(87) International publication number:
**WO 2024/070963 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.09.2022 JP 2022158659**
**13.09.2023 JP 2023148829**

(71) Applicant: **FUJIFILM Corporation**
**Tokyo 106-8620 (JP)**

(72) Inventors:
- **SAKITA, Kyohei**
**Haibara-gun, Shizuoka 421-0396 (JP)**
- **OGAWA, Michihiro**
**Haibara-gun, Shizuoka 421-0396 (JP)**

(74) Representative: **HGF**
**HGF Limited**
**1 City Walk**
**Leeds LS11 9DX (GB)**

# (54) FILM PRODUCTION METHOD, PHOTOSENSITIVE RESIN COMPOSITION, CURED PRODUCT PRODUCTION METHOD, CURED PRODUCT, AND LAMINATE

(57) There are provided a manufacturing method for a film, including a step of applying a photosensitive resin composition onto a base material and then drying the photosensitive resin composition under a pressure of 5,000 Pa or less, the photosensitive resin composition containing (A) a resin, (C) a photopolymerization initiator, (D) a radical polymerization inhibitor which is at least one compound selected from the group consisting of (D-1) a compound having a free radical in a molecule and (D-2) a compound having no free radical in a molecule and having a molecular weight of 270 or more, and (E) a solvent, or including a step of drying the photosensitive resin composition at a first temperature and a step of drying the photosensitive resin composition at a second temperature higher than the first temperature under a pressure within a range of ±10% of the pressure in the step of drying the photosensitive resin composition at the first temperature, or including only a step of drying the photosensitive resin composition at 90°C or higher for a time longer than 5 minutes as a drying step, a manufacturing method for a cured substance using the photosensitive resin composition, a cured substance obtained by curing the photosensitive resin composition, and a laminate including the cured substance.

EP 4 597 225 A1

## Description

### BACKGROUND OF THE INVENTION

1. Field of the Invention

The present invention relates to a manufacturing method for a film, a photosensitive resin composition, a manufacturing method for a cured substance, a cured substance, and a laminate.

2. Description of the Related Art

As a new packaging technology in manufacturing of semiconductor devices and the like, fan-out panel level packaging (FOPLP) in which a package is manufactured with a substrate larger than a wafer and a manufacturing cost per package is reduced has attracted attention. In a method for forming a film for a panel such as FOPLP, a composition (coating liquid) for forming a film may be applied by a slit coating method.

WO2019/163860A describes a manufacturing method for a film by applying a composition containing a polyimide precursor and at least two solvents having different solubilities with respect to the polyimide precursor onto a member by a slit coating method.

WO2014/045783A describes a lithographic printing plate precursor in which an image recording layer containing a radical polymerization initiator, a radically polymerizable compound, and two or more radical trapping sites that are directly bonded to a radical in a molecule to form a covalent bond is provided on a support.

### SUMMARY OF THE INVENTION

It is known that a viscosity of a coating liquid is lowered in order to impart suitability to slit coating, and it is known that soft baking is performed after vacuum (reduced pressure) drying in a drying step of a coating film after coating.

However, according to the studies of the present inventors, it was found that, in a case where a pattern is formed by exposing and developing a film manufactured by the film manufacturing method of the related art, there is room for improvement in resolution and residues generated in an unexposed portion.

An object of the present invention is to provide a manufacturing method for a film with excellent resolution and with less occurrence of residues in an unexposed portion.

In addition, an object of the present invention is to provide a photosensitive resin composition capable of forming a film having excellent resolution and hardly generating residues in an unexposed portion, a manufacturing method for a cured substance using the photosensitive resin composition, a cured substance obtained by curing the photosensitive resin composition, and a laminate including the cured substance.

Examples of representative embodiments according to the present invention are described below.

[1] A manufacturing method for a film, comprising:
a step of applying a photosensitive resin composition onto a base material and then drying the photosensitive resin composition under a pressure of 5,000 Pa or less, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

[2] A manufacturing method for a film, comprising:

a step of applying a photosensitive resin composition onto a base material and then drying the photosensitive resin composition at a first temperature, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a

molecule and having a molecular weight of 270 or more, and
(E) a solvent; and

a step of drying the photosensitive resin composition at a second temperature higher than the first temperature under a pressure within a range of ±10% of the pressure in the step of drying the photosensitive resin composition at the first temperature.

[3] A manufacturing method for a film, comprising only:
a step of applying a photosensitive resin composition onto a base material and then drying the photosensitive resin composition at 90°C or higher for a time longer than 5 minutes as a drying step, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

[4] The manufacturing method for a film according to any one of [1] to [3],
in which the photosensitive resin composition satisfies at least one of (i) or (ii),

(i) (B-1) radically polymerizable compound is contained,
(ii) the (A) includes a radically polymerizable site.

[5] The manufacturing method for a film according to any one of [1] to [4],
in which the (A) is at least one resin selected from the group consisting of a polyimide and a polyimide precursor.
[6] The manufacturing method for a film according to any one of [1] to [5],
in which the (A) includes a repeating unit represented by Formula (2).

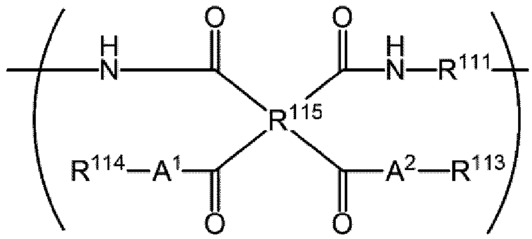
(2)

In Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group. Provided that at least one of $R^{113}$ or $R^{114}$ has a group represented by Formula (III).

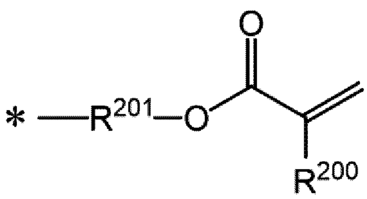
(III)

In Formula (III), $R^{200}$ represents a hydrogen atom, a methyl group, an ethyl group, or a methylol group, and * represents a bonding site to another structure. $R^{201}$ represents an alkylene group having 2 to 12 carbon atoms, $-CH_2CH(OH)CH_2-$, a cycloalkylene group, or a polyalkyleneoxy group.

[7] The manufacturing method for a film according to any one of [1] to [6],
in which the molecular weight of the (D-2) is 700 or more.
[8] The manufacturing method for a film according to any one of [1] to [7],
in which a molecular weight of the (D-1) is 160 or more.

[9] The manufacturing method for a film according to any one of [1] to [8],
in which a concentration of solid contents of the photosensitive resin composition is 35% by mass or less.
[10] The manufacturing method for a film according to any one of [1] to [9],
in which the base material contains Cu on a surface.
[11] The manufacturing method for a film according to [1],
in which a temperature in the step of drying under the pressure of 5,000 Pa or less is 35°C or higher and 80°C or lower.
[12] A photosensitive resin composition comprising:

(A) a resin;
(C) a photopolymerization initiator;
(D) a radical polymerization inhibitor which is at least one compound selected from the group consisting of (D-1) a compound having a free radical in a molecule and (D-2) a compound having no free radical in a molecule and having a molecular weight of 270 or more; and
(E) a solvent.

[13] The photosensitive resin composition according to [12],
in which the photosensitive resin composition satisfies at least one of (i) or (ii),

(i) (B-1) radically polymerizable compound is contained,
(ii) the (A) includes a radically polymerizable site.

[14] The photosensitive resin composition according to [12] or [13],
in which the (A) is at least one resin selected from the group consisting of a polyimide and a polyimide precursor.
[15] The photosensitive resin composition according to any one of [12] to [14],
in which the (A) includes a repeating unit represented by Formula (2).

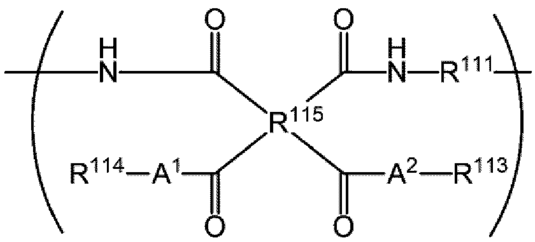

(2)

In Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group. Provided that at least one of $R^{113}$ or $R^{114}$ has a group represented by Formula (III).

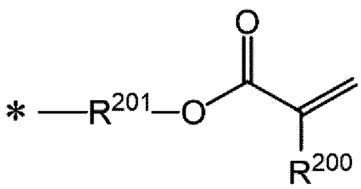

(III)

In Formula (III), $R^{200}$ represents a hydrogen atom, a methyl group, an ethyl group, or a methylol group, and * represents a bonding site to another structure. $R^{201}$ represents an alkylene group having 2 to 12 carbon atoms, $-CH_2CH(OH)CH_2-$, a cycloalkylene group, or a polyalkyleneoxy group.

[16] The photosensitive resin composition according to any one of [12] to [15],
in which a molecular weight of the (D-2) is 700 or more.
[17] The photosensitive resin composition according to any one of [12] to [16],
in which a molecular weight of the (D-1) is 160 or more.
[18] The photosensitive resin composition according to any one of [12] to [17],
in which a concentration of solid contents of the photosensitive resin composition is 35% by mass or less.
[19] The photosensitive resin composition according to any one of [12] to [18],
in which the photosensitive resin composition is used for forming an interlayer insulating film for a redistribution layer.

[20] A manufacturing method for a cured substance, comprising:

a step of applying the photosensitive resin composition according to any one of [12] to [19] onto a base material to dry the photosensitive resin composition under a reduced pressure to form a film;
an exposure step of selectively exposing the film; and
a development step of developing the film exposed by the exposure step using a developer to form a pattern.

[21] A cured substance obtained by curing the photosensitive resin composition according to any one of [12] to [19].
[22] A laminate comprising:

two or more layers consisting of the cured substance according to [21]; and
a metal layer provided between any of the layers consisting of the cured substance.

According to the present invention, it is possible to provide a manufacturing method for a film with excellent resolution and with less occurrence of residues in an unexposed portion.
In addition, according to the present invention, it is possible to provide a photosensitive resin composition capable of forming a film having excellent resolution and hardly generating residues in an unexposed portion, a manufacturing method for a cured substance using the photosensitive resin composition, a cured substance obtained by curing the photosensitive resin composition, and a laminate including the cured substance.

## DESCRIPTION OF THE PREFERRED EMBODIMENTS

Hereinafter, the main embodiments according to the present invention will be described. However, the present invention is not limited to the specified embodiments.
In the present specification, a numerical value range described by using "to" means a range including numerical values described before and after the preposition "to" as a lower limit value and an upper limit value, respectively.
In the present specification, the term "step" means not only an independent step but also a step that cannot be clearly distinguished from other steps as long as the desired action of the step can be achieved.
In describing a group (an atomic group) in the present specification, in a case where a description of substitution and unsubstitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).
In the present specification, the "exposure" includes not only exposure using light but also exposure using corpuscular beams such as an electron beam and an ion beam, unless otherwise specified. In addition, examples of the light that is used for exposure include an actinic ray such as a bright line spectrum of a mercury lamp, a far ultraviolet ray represented by an excimer laser, an extreme ultraviolet ray (EUV light), an X-ray, or an electron beam, and a radioactive ray.
In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".
In the structural formulae of the present specification, Me represents a methyl group, Et represents an ethyl group, Bu represents a butyl group, and Ph represents a phenyl group.
In the present specification, the total solid content refers to the total mass of components excluding a solvent from the entire components of the composition. In addition, in the present specification, the concentration of solid contents is a mass percentage of other components excluding a solvent with respect to the total mass of the composition.
In the present specification, weight-average molecular weight (Mw) and number-average molecular weight (Mn) are each a value measured using gel permeation chromatography (GPC) unless otherwise specified, which are defined as a polystyrene equivalent value. In the present specification, the weight-average molecular weight (Mw) and the number-average molecular weight (Mn) can be determined, for example, by using HLC-8220 GPC(manufactured by Tosoh Corporation) and using GUARD COLUMN HZ-L, TSKgel Super HZM-M, TSK gel Super HZ4000, TSK gel Super HZ3000, and TSK gel Super HZ2000 (all of which are manufactured by Tosoh Corporation) as a column connected in series. The measurements of the above molecular weights are carried out using tetrahydrofuran (THF) as an eluent unless otherwise specified. However, N-methyl-2-pyrrolidone (NMP) can also be used in a case where THF is not suitable as the eluent, for example, in a case where the solubility is low. In addition, the detection in GPC measurement is carried out using a detector with an ultraviolet ray (a UV ray) of a wavelength of 254 nm unless otherwise specified.
In the present specification, in a case where the positional relationship of respective layers constituting the laminate is described as "upper" or "lower", it suffices that another layer is on the upper side or the lower side of the reference layer among the plurality of layers of interest. That is, a third layer or element may be further interposed between

the reference layer and the other layer, and the reference layer and the other layer need not be in contact with each other. Unless otherwise specified, the direction in which the layers are laminated on the base material is referred to as "upward", or in a case where a resin composition layer is present, the direction from the base material to the resin composition layer is referred to as "upper". The opposite direction thereof is referred to as "downward". Furthermore, such a setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise specified. The content of each component in the composition means the total content of all the compounds corresponding to the component unless otherwise specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

[Photosensitive resin composition]

First, the photosensitive resin composition (also referred to as a "resin composition") according to the embodiment of the present invention will be described.

The photosensitive resin composition according to the embodiment of the present invention includes

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

The resin composition according to the embodiment of the present invention is preferably used for forming a photosensitive film that is subjected to exposure and development, and it is preferably used for forming a film that is subjected to exposure and development using a developer containing an organic solvent.

The resin composition according to the embodiment of the present invention can be used, for example, for forming an insulating film of a semiconductor device, an interlayer insulating film for a re-distribution layer, or a stress buffer film, and it is preferably used for forming an interlayer insulating film for a re-distribution layer.

The resin composition according to the embodiment of the present invention is preferably a negative-tone photosensitive resin composition. The negative-tone photosensitive resin composition is a photosensitive resin composition used for forming a photosensitive film to be subjected to negative tone development.

In the present invention, the negative-tone development refers to development in which, in exposure and development, a non-exposed portion is removed by the development, and the positive-tone development means a development in which an exposed portion is removed by the development.

As the exposure method, the developer, and the development method, for example, the following ones in the description of the manufacturing method for a cured substance, which will be described later, are used: an exposure method to be described in the exposure step, and a developer and a development method to be described in the development step.

With the resin composition according to the embodiment of the present invention, it is possible to form a film having excellent resolution and hardly generating residues in an unexposed portion.

Although the mechanism by which the above effect is obtained is not revealed, it is presumed as follows.

In the resin composition of the related art, since the polymerization inhibitor contained in the resin composition is likely to volatilize under reduced pressure, it is considered that dark polymerization of the polymerizable compound is likely to occur, resolution is decreased, or residues are generated in an unexposed portion. In the present invention, it is considered that a film having excellent resolution and hardly generating residues in an unexposed portion can be formed by using a compound which is hardly volatilized and has an effect even under reduced pressure, as the polymerization inhibitor.

Hereinafter, the components contained in the resin composition according to the embodiment of the present invention will be described in detail.

<(A) Resin>

The resin composition according to the embodiment of the present invention contains a (A) resin (also simply referred to as a "resin").

The resin is not particularly limited, but is preferably at least one resin (specific resin) selected from the group consisting of a cyclization resin and a precursor thereof.

The cyclization resin is preferably a resin containing an imide ring structure or an oxazole ring structure in the main chain structure.

In the present invention, the term "main chain" represents the relatively longest bonding chain in a resin molecule, and the term "side chain" refers to other bonding chains other than the main chain.

Examples of the cyclization resin include polyimide, polybenzoxazole, and polyamideimide.

The precursor of the cyclization resin refers to a resin of which the chemical structure changes by an external stimulus, thereby being converted to a cyclization resin. It is preferably a resin of which the chemical structure changes by heat, thereby being converted to a cyclization resin, and it is more preferably a resin which undergoes a ring closure reaction by heat to form a ring structure, thereby being converted to a cyclization resin.

Examples of the precursor of the cyclization resin include a polyimide precursor, a polybenzoxazole precursor, and a polyamideimide precursor.

That is, the resin composition preferably contains, as the specific resin, at least one resin selected from the group consisting of a polyimide, a polyimide precursor, a polybenzoxazole, a polybenzoxazole precursor, a polyamideimide, and a polyamideimide precursor.

The resin composition preferably contains at least one resin selected from the group consisting of a polyimide and a polyimide precursor.

The specific resin preferably has a polymerizable group and more preferably contains a radically polymerizable group.

In a case where the specific resin has a radically polymerizable group, the resin composition according to the embodiment of the present invention preferably contains a radical polymerization initiator, and it more preferably contains a radical polymerization initiator and a radical crosslinking agent. Further, a sensitizing agent can be contained as necessary. From such a resin composition, for example, a negative-tone photosensitive film is formed.

In addition, the specific resin may have a polarity converting group such as an acid-decomposable group.

In a case where the specific resin has an acid-decomposable group, it is preferable that the resin composition contains a photoacid generator. From such a resin composition, for example, a positive-tone photosensitive film or a negative-tone photosensitive film, which is a chemical amplification type photosensitive film, is formed.

[Polyimide precursor]

The kind and the like of the polyimide precursor are not particularly limited, but it is preferable that the polyimide precursor contains a repeating unit represented by Formula (2).

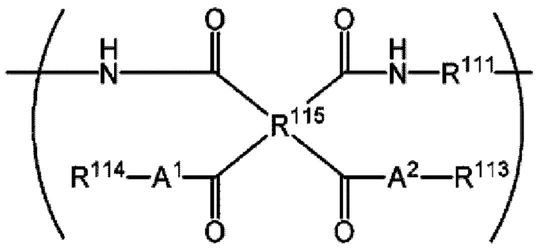

(2)

In Formula (2), $A^1$ and $A^2$ each independently represent an oxygen atom or $-NR^z-$, $R^{111}$ represents a divalent organic group, $R^{115}$ represents a tetravalent organic group, $R^{113}$ and $R^{114}$ each independently represent a hydrogen atom or a monovalent organic group, and $R^Z$ represents a hydrogen atom or a monovalent organic group.

$A^1$ and $A^2$ in Formula (2) each independently represent an oxygen atom or $-NR^z-$.

$R^Z$ represents a hydrogen atom or a monovalent organic group, and a hydrogen atom is preferable.

$A^1$ and $A^2$ are preferably an oxygen atom or -NH-, and more preferably an oxygen atom.

$R^{111}$ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of $R^{111}$ in Formula (2) include groups represented by -Ar- and -Ar-L-Ar-, respectively, and a group represented by -Ar-L-Ar- is preferable. However, Ar's are each independently an aromatic group, and L is a single bond or an aliphatic hydrocarbon

group having 1 to 10 carbon atoms, which may be substituted with a fluorine atom, -O-, -CO-, -S-, $-SO_2-$, or -NHCO-, or a group consisting of a combination of two or more of the above. The preferred ranges thereof are as described above.

$R^{111}$ is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, $R^{111}$ is preferably a diamine containing a linear or branched aliphatic group having 2 to 20 carbon atoms, a cyclic aliphatic group having 3 to 20 carbon atoms, an aromatic group having 3 to 20 carbon atoms, or a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

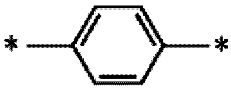
AR-1

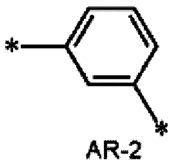
AR-2

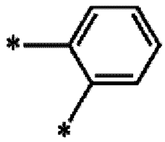
AR-3

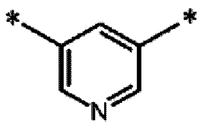
AR-4

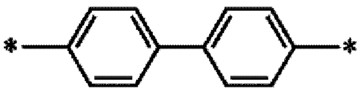
AR-5

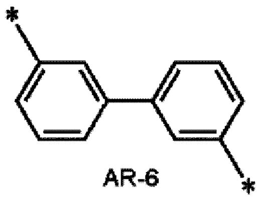
AR-6

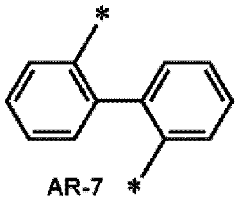
AR-7

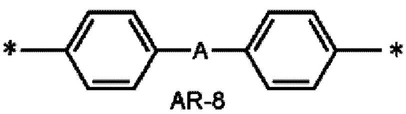
AR-8

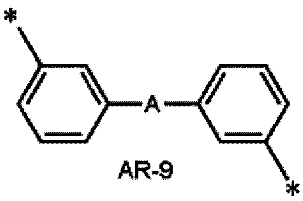
AR-9

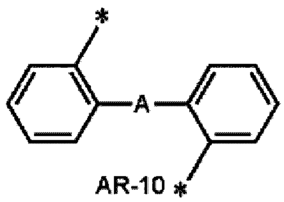
AR-10

In Formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, $-SO_2-$, -NHCO-, or a group selected from combinations thereof, more preferably a single bond or a group selected from an alkylene group having 1 to 3 carbon atoms, which may be substituted with a fluorine atom, -O-, -C(=O)-, -S-, or $-SO_2-$, and still more preferably $-CH_2-$, -O-, -S-, $-SO_2-$, $-C(CF_3)_2-$, or $-C(CH_3)_2-$.

In Formulae, * represents a bonding site to another structure.

Specific examples of the diamine include 1,2-diaminoethane, 1,2-diaminopropane, 1,3-diaminopropane, 1,4-diaminobutane, or 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, or isophorone diamine;

at least one diamine selected from m- or p-phenylenediamine, diaminotoluene, 4,4'- or 3,3'-diaminobiphenyl, 4,4'-diaminodiphenyl ether, 3,3'-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4'-bis(4-aminophenoxy)biphenyl, bis[4-(4-aminophenoxy)phenyl]sulfone, bis[4-(3-aminophenoxy)phenyl]sulfone, bis[4-(2-aminophenoxy)phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- and 2,5-diaminocumene, 2,5-dimethyl-p-phenylene diamine, acetoguanamine, 2,3,5,6-tetramethyl-p-phenylene diamine, 2,4,6-trimethyl-m-phenylene diamine, bis(3-aminopropyl)tetramethyldisiloxane, bis(p-aminophenyl)octamethylpentasiloxane, 2,7-diaminofluorene, 2,5-diaminopyridine,1,2-bis(4-aminophenyl)ethane, a diaminobenzanilide, an ester of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, and 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

$R^{111}$ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or $-SO_2-$. The aliphatic hydrocarbon group here is preferably an alkylene group.

In addition, from the viewpoint of the i-line transmittance, $R^{111}$ is preferably a divalent organic group represented by Formula (51) or Formula (61) below. In particular, from the viewpoint of the i-line transmittance and ease of availability, a divalent organic group represented by Formula (61) is more preferable.

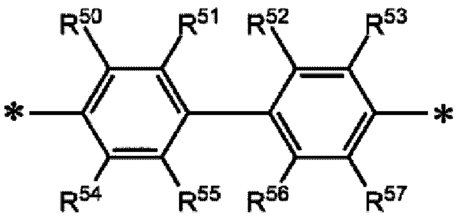

(51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, or a trifluoromethyl group, and *'s each independently represent a bonding site to the nitrogen atom in Formula (2).

Examples of the monovalent organic group as $R^{50}$ to $R^{57}$ include an unsubstituted alkyl group having 1 to 10 (preferably 1 to 6 carbon atoms) carbon atoms and a fluorinated alkyl group having 1 to 10 (preferably 1 to 6 carbon atoms) carbon atoms.

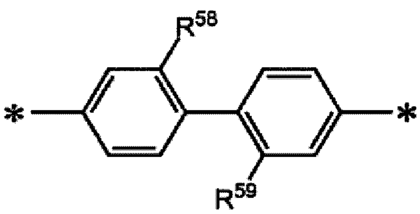

(61)

In Formula (61), $R^{58}$ and $R^{59}$ each independently represent a fluorine atom, a methyl group, or a trifluoromethyl group, and *'s each independently represent a bonding site to the nitrogen atom in Formula (2).

Examples of the diamine that provides a structure of Formula (51) or Formula (61), 2,2'-dimethylbenzidine, 2,2'-bis(trifluoromethyl)-4,4'-diaminobiphenyl, 2,2'-bis(fluoro)-4,4'-diaminobiphenyl, and 4,4'-diaminooctafluorobiphenyl. These may be used alone, or two or more kinds thereof may be used in combination.

$R^{115}$ in Formula (2) represents a tetravalent organic group. The tetravalent organic group is preferably a tetravalent organic group containing an aromatic ring and more preferably a group represented by Formula (5) or Formula

(6). In Formula (5) or Formula (6), *'s each independently represent a bonding site to another structure.

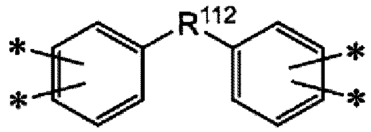
(5)

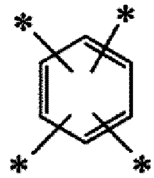
(6)

In Formula (5), $R^{112}$ is a single bond or a divalent linking group. It is preferably a single bond or a group selected from an aliphatic hydrocarbon group having 1 to 10 carbon atoms, which may be substituted with a fluorine atom, -O-, -CO-, -S-, $-SO_2-$, -NHCO-, or a combination thereof, more preferably a single bond or a group selected from an alkylene group having 1 to 3 carbon atoms, which may be substituted with a fluorine atom, -O-, -CO-, -S-, or $-SO_2-$, and still more preferably a divalent group selected from the group consisting of $-CH_2-$, $-C(CF_3)_2-$, $-C(CH_3)_2-$, -O-, -CO-, -S-, and $-SO_2-$.

Specific examples of $R^{115}$ include a tetracarboxylic acid residue that remains after the removal of the anhydride group from the tetracarboxylic acid dianhydride. The polyimide precursor may contain only one kind of tetracarboxylic acid dianhydride residue or may contain two or more kinds thereof, as a structure corresponding to $R^{115}$.

The tetracarboxylic acid dianhydride is preferably represented by Formula (O).

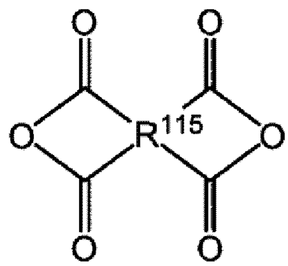
(O)

In Formula (O), $R^{115}$ represents a tetravalent organic group. The preferred range of $R^{115}$ has the same meaning as $R^{115}$ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In Formula (2), it is also possible that at least one of $R^{111}$ or $R^{115}$ has an OH group. More specifically, examples of $R^{111}$ include a residue of a bisaminophenol derivative.

$R^{113}$ and $R^{114}$ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of $R^{113}$ or $R^{114}$ preferably contains a polymerizable group, and more preferably both of them contain a polymerizable group. It is also preferable that at least one of $R^{113}$ or $R^{114}$ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and a group represented by Formula (III), where a group represented by Formula (III) is preferable.

At least one of $R^{113}$ or $R^{114}$ preferably has a group represented by Formula (III).

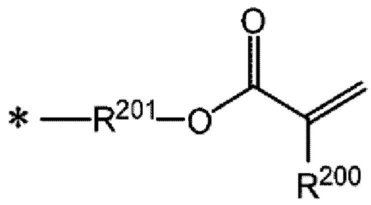

(III)

In Formula (III), $R^{200}$ represents a hydrogen atom, a methyl group, an ethyl group, or a methylol group, where a hydrogen atom or a methyl group is preferable.

In Formula (III), * represents a bonding site to another structure.

In Formula (III), $R^{201}$ represents an alkylene group having 2 to 12 carbon atoms, - $CH_2CH(OH)CH_2$-, a cycloalkylene group, or a polyalkyleneoxy group.

Suitable examples of $R^{201}$ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, -$CH_2CH(OH)CH_2$-, and a polyalkyleneoxy group, where an alkylene group such as an ethylene group or a propylene group, -$CH_2CH(OH)CH_2$-, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a randomly arranged sequence, may be a sequence arranged to have a block, or may be a sequence arranged to have an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even more preferably 2 to 5, even still more preferably 2 to 4, even further still more preferably 2 or 3, and particularly preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polyethyleneoxy group or a polypropyleneoxy group, and still more preferably a polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (2), in a case where $R^{113}$ is a hydrogen atom, or in a case where $R^{114}$ is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

In Formula (2), at least one of $R^{113}$ or $R^{114}$ may be a polarity converting group such as an acid-decomposable group. The acid-decomposable group is not particularly limited as long as it decomposes by the action of the acid to generate an alkali-soluble group such as a phenolic hydroxy group or a carboxy group; however, it is preferably an acetal group, a ketal group, a silyl group, or a silyl ether group, a tertiary alkyl ester group, or the like, and from the viewpoint of exposure sensitivity, it is more preferably an acetal group or a ketal group.

Specific examples of the acid-decomposable group include a tert-butoxycarbonyl group, an isopropoxycarbonyl

group, a tetrahydropyranyl group, a tetrahydrofuranyl group, an ethoxyethyl group, a methoxyethyl group, an ethoxymethyl group, a trimethylsilyl group, a tert-butoxycarbonylmethyl group, and a trimethylsilyl ether group. From the viewpoint of exposure sensitivity, an ethoxyethyl group or a tetrahydrofuranyl group is preferable.

The polyimide precursor preferably has a fluorine atom in the structure thereof. The content of fluorine atoms in the polyimide precursor is preferably 10% by mass or more, and it is preferably 20% by mass or less.

In addition, for the purpose of improving adhesiveness to a base material, the polyimide precursor may be copolymerized with an aliphatic group having a siloxane structure. Specifically, an aspect in which bis(3-aminopropyl) tetramethyldisiloxane, bis(p-aminophenyl)octamethylpentasiloxane, or the like is used as the diamine can be mentioned.

The repeating unit represented by Formula (2) is preferably a repeating unit represented by Formula (2-A). That is, at least one polyimide precursor that is used in the present invention is preferably a precursor having a repeating unit represented by Formula (2-A). In a case where the polyimide precursor contains a repeating unit represented by Formula (2-A), it is possible to further widen the width of the exposure latitude.

Formula (2-A)

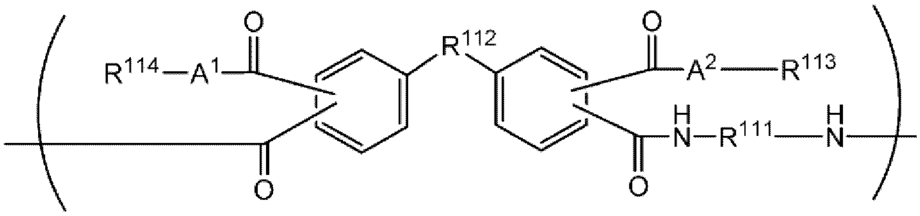

In Formula (2-A), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a group containing a polymerizable group, where both of them are preferably a group containing a polymerizable group.

$A^1$, $A^2$, $R^{111}$, $R^{113}$, and $R^{114}$ each independently have the same meaning as $A^1$, $A^2$, $R^{111}$, $R^{113}$, and $R^{114}$ in Formula (2), respectively, and the same applies to the preferred ranges thereof. $R^{112}$ has the same meaning as $R^{112}$ in Formula (5), and the same applies to the preferred range thereof.

The polyimide precursor may contain one kind of repeating unit represented by Formula (2) or may contain two or more kinds thereof. In addition, the polyimide precursor may contain structural isomers of the repeating unit represented by Formula (2). The polyimide precursor may also contain another kind of repeating unit in addition to the above repeating unit represented by Formula (2).

One embodiment of the polyimide precursor in the present invention includes an embodiment in which the content of the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyimide precursor excluding the terminal may be the repeating unit represented by Formula (2).

The weight-average molecular weight (Mw) of the polyimide precursor is preferably 5,000 to 100,000, more preferably 10,000 to 50,000, and still more preferably 15,000 to 40,000. The number-average molecular weight (Mn) of the polyimide precursor is preferably 2,000 to 40,000, more preferably 3,000 to 30,000, and still more preferably 4,000 to 20,000.

The dispersivity of the molecular weight of the polyimide precursor is preferably 1.5 or more, more preferably 1.8 or more, and still more preferably 2.0 or more. The upper limit value of the dispersivity of the molecular weight of the polyimide precursor is not particularly limited; however, it is, for example, preferably 7.0 or less, more preferably 6.5 or less, and still more preferably 6.0 or less.

In the present specification, the dispersity of the molecular weight is a value obtained by calculating "weight-average molecular weight/number-average molecular weight".

In a case where the resin composition contains a plurality of kinds of polyimide precursors as the specific resin, it is preferable that the weight-average molecular weight, the number-average molecular weight, and the dispersivity of at least one kind of polyimide precursor are in the above ranges. Further, it is also preferable that the weight-average molecular weight, the number-average molecular weight, and the dispersity, calculated by using the plurality of kinds of polyimide precursors as one resin, are within the above ranges.

[Polyimide]

The polyimide that is used in the present invention may be an alkali-soluble polyimide or may be a polyimide soluble in a developer containing an organic solvent as a main component.
In the present specification, the alkali-soluble polyimide refers to a polyimide, 0.1 g or more of which is dissolved in 100 g of an aqueous solution of 2.38% by mass of tetramethylammonium at 23°C, and from the viewpoint of pattern formation properties, it is preferably a polyimide, 0.5 g or more of which is dissolved therein and still more preferably a polyimide, 1.0 g or more of which is dissolved therein. The upper limit of the dissolution amount is not particularly limited; however, it is preferably 100 g or less.
The polyimide is preferably a polyimide having a plurality of imide structures in the main chain from the viewpoint of the film hardness and the insulating properties of the organic film to be obtained.

- Fluorine atom -

From the viewpoint of the film hardness of the organic film to be obtained, the polyimide preferably has a fluorine atom.
The fluorine atom is preferably contained in, for example, $R^{132}$ in a repeating unit represented by Formula (4) described later or $R^{131}$ in a repeating unit represented by Formula (4) described later, and it is more preferably contained, as a fluorinated alkyl group, in $R^{132}$ in a repeating unit represented by Formula (4) described later or $R^{131}$ in a repeating unit represented by Formula (4) described later.
The amount of fluorine atoms with respect to the total mass of the polyimide is preferably 5% by mass or more, and it is preferably 20% by mass or less.

- Silicon atom -

From the viewpoint of the film hardness of the organic film to be obtained, it is also preferable that the polyimide has a silicon atom.
The silicon atom is preferably contained in, for example, $R^{131}$ in a repeating unit represented by Formula (4) described later, and more preferably contained in $R^{131}$ in a repeating unit represented by Formula (4) described later as an organically modified (poly)siloxane structure.
The silicon atom or the organically modified (poly)siloxane structure may be contained in the side chain of the polyimide; however, it is preferably contained in the main chain of the polyimide.
The amount of silicon atoms with respect to the total mass of the polyimide is preferably 1% by mass or more and more preferably 20% by mass or less.

- Ethylenically unsaturated bond -

From the viewpoint of the film hardness of the organic film to be obtained, the polyimide preferably has an ethylenically unsaturated bond.
The polyimide may have an ethylenically unsaturated bond at the terminal of the main chain or the side chain; however, it preferably has an ethylenically unsaturated bond at the side chain.
The ethylenically unsaturated bond preferably has radical polymerizability.
The ethylenically unsaturated bond is preferably included in $R^{132}$ or $R^{131}$ in the repeating unit represented by Formula (4) described later, and more preferably included in $R^{132}$ or $R^{131}$ as a group having an ethylenically unsaturated bond.
Among these, the ethylenically unsaturated bond is preferably included in $R^{131}$ in the repeating unit represented by Formula (4) described later, and more preferably included in $R^{131}$ as a group having an ethylenically unsaturated bond.
Examples of the group having an ethylenically unsaturated bond include a group having a vinyl group which may be substituted, which is directly bonded to an aromatic ring such as a vinyl group, an allyl group, or a vinylphenyl group, a (meth)acrylamide group, a (meth)acryloyloxy group, and a group represented by Formula (IV).

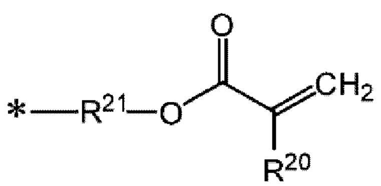

(IV)

In Formula (IV), $R^{20}$ represents a hydrogen atom, a methyl group, an ethyl group, or a methylol group, where a hydrogen atom or a methyl group is preferable.

In Formula (IV), $R^{21}$ represents an alkylene group having 2 to 12 carbon atoms, $-O-CH_2CH(OH)CH_2-$, -C(=O)O-, -O(C=O)NH-, a (poly)alkyleneoxy group having 2 to 30 carbon atoms (the alkylene group preferably has 2 to 12 carbon atoms, more preferably 2 to 6 carbon atoms, and particularly preferably 2 or 3 carbon atoms, and the number of repetitions of alkyleneoxy group is preferably 1 to 12, more preferably 1 to 6, and particularly preferably 1 to 3), or a group obtained by combining two or more of these.

The alkylene group having 2 to 12 carbon atoms may be a linear one, a branched one, or a cyclic one, or may be any alkylene group represented by a combination of these.

The alkylene group having 2 to 12 carbon atoms is preferably an alkylene group having 2 to 8 carbon atoms and more preferably an alkylene group having 2 to 4 carbon atoms.

Among the above, $R^{21}$ is preferably a group represented by any one of Formulae (R1) to (R3) and more preferably a group represented by Formula (R1).

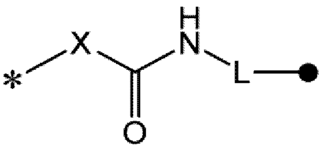
(R1)

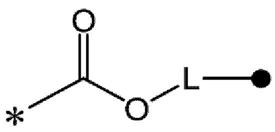
(R2)

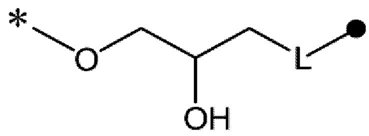
(R3)

In Formulae (R1) to (R3), L represents a single bond, an alkylene group having 2 to 12 carbon atoms, a (poly) alkyleneoxy group having 2 to 30 carbon atoms, or a group obtained by bonding two or more of these, X represents an oxygen atom or a sulfur atom, * represents a bonding site to another structure, and • represents a bonding site to an oxygen atom to which $R^{21}$ in Formula (IV) is bonded.

In Formulae (R1) to (R3), the preferred aspect of the alkylene group having 2 to 12 carbon atoms as L or the (poly) alkyleneoxy group having 2 to 30 carbon atoms is the same as the preferred aspect of the alkylene group having 2 to 12 carbon atoms as $R^{21}$ in Formula (IV) or the (poly)alkyleneoxy group having 2 to 30 carbon atoms.

In Formula (R1), X is preferably an oxygen atom.

In Formulae (R1) to (R3), * has the same meaning as * in Formula (IV), and the same applies to the preferred aspect thereof.

The structure represented by Formula (R1) is obtained, for example, by reacting a polyimide having a hydroxy group such as a phenolic hydroxy group with a compound (for example, 2-isocyanatoethyl methacrylate) having an isocyanato group and an ethylenically unsaturated bond.

The structure represented by Formula (R2) is obtained, for example, by reacting a polyimide having a carboxy group with a compound (for example, 2-hydroxyethyl methacrylate) having a hydroxy group and an ethylenically unsaturated bond.

The structure represented by Formula (R3) is obtained, for example, by reacting a polyimide having a hydroxy group such as a phenolic hydroxy group with a compound (for example, glycidyl methacrylate) having a glycidyl group and an ethylenically unsaturated bond.

In Formula (IV), * represents a bonding site to another structure, and it is preferably a bonding site to the main chain of the polyimide.

The amount of the ethylenically unsaturated bond with respect to the total mass of the polyimide is preferably 0.0001 to 0.1 mol/g and more preferably 0.0005 to 0.05 mol/g.

- Polymerizable group other than group having ethylenically unsaturated bond -

The polyimide may have a polymerizable group other than the group having an ethylenically unsaturated bond.

Examples of the polymerizable group other than the group having an ethylenically unsaturated bond include a cyclic ether group such as an epoxy group or an oxetanyl group, an alkoxymethyl group such as a methoxymethyl group, and a methylol group.

The polymerizable group other than the group having an ethylenically unsaturated bond is preferably contained in, for example, $R^{131}$ in a repeating unit represented by Formula (4) described later.

The amount of the polymerizable group other than the group having an ethylenically unsaturated bond with respect to the total mass of the polyimide is preferably 0.0001 to 0.1 mol/g and more preferably 0.001 to 0.05 mol/g.

- Polarity converting group -

The polyimide may have a polarity converting group such as an acid-decomposable group. The acid-decomposable group in the polyimide is the same as the acid-decomposable group described in $R^{113}$ and $R^{114}$ in Formula (2) described above, and the same applies to the preferred aspect thereof.
The polarity converting group is contained, for example, in $R^{131}$ or $R^{132}$ in the repeating unit represented by Formula (4) described later, or a terminal of the polyimide.

- Acid value -

In a case where the polyimide is subjected to alkaline development, the acid value of the polyimide is preferably 30 mgKOH/g or more, more preferably 50 mgKOH/g or more, and still more preferably 70 mgKOH/g or more, from the viewpoint of improving developability.
The acid value thereof is preferably 500 mgKOH/g or less, more preferably 400 mgKOH/g or less, and still more preferably 200 mgKOH/g or less.
In a case where the polyimide is subjected to the development (for example, the "solvent development") using a developer containing an organic solvent as a main component, the acid value of the polyimide is preferably 1 to 35 mgKOH/g, more preferably 2 to 30 mgKOH/g, and still more preferably 5 to 20 mgKOH/g.
The acid value is measured by a known method, for example, by the method described in JIS K0070: 1992.
The acid group contained in the polyimide is preferably an acid group having a pKa of 0 to 10 and more preferably an acid group having a pKa of 3 to 8 from the viewpoint of achieving both storage stability and developability.
The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is defined as a calculated value according to ACD/ChemSketch (registered trademark). pKa may refer to the values published in "Handbook of Chemistry, Pure Chemistry, 5th Edition" edited by the Chemical Society of Japan.
In a case where the acid group is a polyvalent acid such as phosphoric acid, the pKa is the first dissociation constant.
As such an acid group, the polyimide preferably contains at least one selected from the group consisting of a carboxy group and a phenolic hydroxy group and more preferably contains a phenolic hydroxy group.

- Phenolic hydroxy group -

From the viewpoint of allowing the speed of development with an alkaline developer to be proper, the polyimide preferably has a phenolic hydroxy group.
The polyimide may have a phenolic hydroxy group at the terminal of the main chain or the side chain.
The phenolic hydroxy group is preferably contained in, for example, $R^{132}$ or $R^{131}$ in a repeating unit represented by Formula (4) described later.
The amount of the phenolic hydroxy group with respect to the total mass of the polyimide is preferably 0.1 to 30 mol/g and more preferably 1 to 20 mol/g.
The polyimide that is used in the present invention is not particularly limited as long as it is a polymer compound having an imide structure; however, it is preferable that the polyimide contains a repeating unit represented by Formula (4).

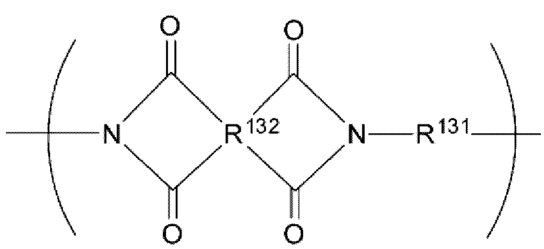
(4)

In Formula (4), $R^{131}$ represents a divalent organic group, and $R^{132}$ represents a tetravalent organic group.
In a case where a polymerizable group is contained, the polymerizable group may be located at at least one of $R^{131}$ or $R^{132}$ or may be located at the terminal of the polyimide as shown in Formula (4-1) or Formula (4-2).

Formula (4-1)

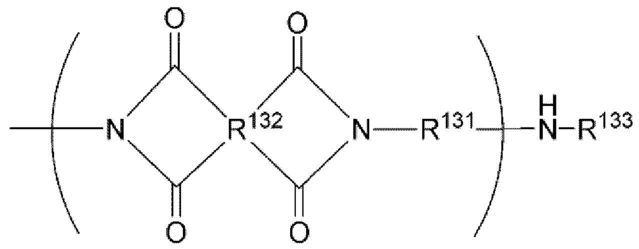

In Formula (4-1), $R^{133}$ is a polymerizable group, and the other groups respectively have the same meanings as those in Formula (4).

Formula (4-2)

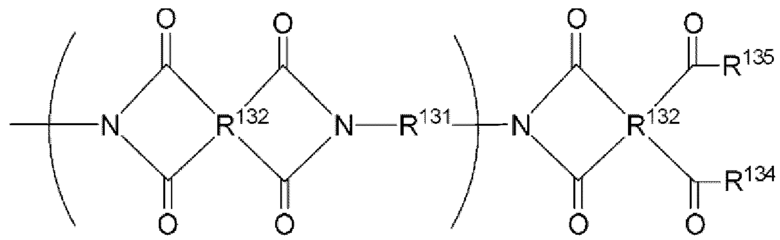

At least one of $R^{134}$ or $R^{135}$ is a polymerizable group, where it is an organic group in a case of not being a polymerizable group, and the other groups respectively have the same meanings as those in Formula (4).

Examples of the polymerizable group include the above-described group having an ethylenically unsaturated bond or a crosslinkable group other than the above-described group having an ethylenically unsaturated bond.

$R^{131}$ represents a divalent organic group. Examples of the divalent organic group include the same one as $R^{111}$ in Formula (2), and the same applies to the preferred range thereof.

Examples of $R^{131}$ include a diamine residue that remains after the removal of an amino group of a diamine. Examples of the diamine include an aliphatic, a cyclic aliphatic, and an aromatic diamine. Specific examples thereof include the example of $R^{111}$ in Formula (2) which is contained in the polyimide precursor.

It is preferable that $R^{131}$ is a diamine residue having at least two alkylene glycol units in the main chain from the viewpoint of more effectively suppressing the occurrence of warping during baking. It is more preferably a diamine residue containing, in one molecule, a total of two or more chains of any one or both of the ethylene glycol chain and the propylene glycol chain, and it is still more preferably the above-described diamine which is a diamine residue containing no aromatic ring.

Examples of the diamine containing, in one molecule, a total of two or more chains of any one or both of the ethylene glycol chain and the propylene glycol chain include JEFFAMINE (registered trade name) KH-511, ED-600, ED-900, ED-2003, EDR-148, EDR-176, D-200, D-400, D-2000, D-4000 (all product names, manufactured by HUNTSMAN Corporation), 1-(2-(2-(2-aminopropoxy)ethoxy)propoxy)propane-2-amine, and 1-(1-(1-(2-aminopropoxy)propan-2-yl)oxy)propane-2-amine, which are not limited thereto.

$R^{132}$ represents a tetravalent organic group. Examples of the tetravalent organic group include the same one as $R^{115}$ in Formula (2), and the same applies to the preferred range thereof.

For example, four bonding partners of the tetravalent organic group exemplified as $R^{115}$ are bonded to four -C(=O)- moieties in Formula (4) to form a fused ring.

Examples of $R^{132}$ include a tetracarboxylic acid residue that remains after the removal of the anhydride group from the tetracarboxylic acid dianhydride. Specific examples thereof include the example of $R^{115}$ in Formula (2) which is contained in the polyimide precursor. From the viewpoint of the hardness of the organic film, $R^{132}$ is preferably an aromatic diamine residue having 1 to 4 aromatic rings.

It is also preferable that an OH group is contained in at least one of $R^{131}$ or $R^{132}$. More specifically, preferred examples of $R^{131}$ include 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, and the above (DA-1) to (DA-18), and more preferred examples of $R^{132}$ include the above (DAA-1) to (DAA-5).

It is also preferable that the polyimide has a fluorine atom in the structure. The content of fluorine atoms in the polyimide is preferably 10% by mass or more, and it is more preferably 20% by mass or less.

For the intended purpose of improving adhesiveness to a base material, an aliphatic group having a siloxane structure may be copolymerized with the polyimide. Specific examples of the diamine component include bis(3-aminopropyl)tetramethyldisiloxane, and bis(p-aminophenyl)octamethyl pentasiloxane.

In order to improve the storage stability of the resin composition, the terminal of the main chain of the polyimide is preferably blocked with a terminal blocking agent such as a monoamine, an acid anhydride, a monocarboxylic acid, a monoacid chloride compound, or a monoactive ester compound. Among these, it is more preferable to use monoamine. Examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

- Imidization rate (ring closure rate) -

The imidization rate (also referred to as the "ring closure rate") of the polyimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured by, for example, the following method.

The infrared absorption spectrum of polyimide is measured, and a peak intensity P1 in the vicinity of 1,377 $cm^{-1}$, which is the absorption peak derived from the imide structure, is obtained. Next, the polyimide is subjected to a heat treatment at 350°C for 1 hour, and then the infrared absorption spectrum is measured again to obtain a peak intensity P2 in the vicinity of 1,377 $cm^{-1}$. Using the obtained peak intensities P1 and P2, the imidization rate of the polyimide can be determined based on the following expression.

$$\text{Imidization rate (\%)} = (\text{peak intensity P1}/\text{peak intensity P2}) \times 100$$

The polyimide may include the repeating unit represented by Formula (4) in which the combinations of $R^{131}$ and $R^{132}$ in all the repeating units are the same, or may include the repeating unit represented by Formula (4) including two or more different combinations of $R^{131}$ and $R^{132}$. The polyimide may contain another kind of repeating unit in addition to the above repeating unit represented by Formula (4). Examples of the other kind of repeating unit include the repeating unit represented by Formula (2) described above.

The polyimide can be synthesized by utilizing, for example, a method in which a tetracarboxylic acid dianhydride is reacted with a diamine (a part thereof is substituted with a terminal blocking agent which is a monoamine) at a low temperature, a method in which a tetracarboxylic acid dianhydride (a part thereof is substituted with a terminal blocking agent which is an acid anhydride, a monoacid chloride compound, or a monoactive ester compound) is reacted with a diamine at a low temperature, a method in which a diester is obtained from a tetracarboxylic acid dianhydride and alcohol and then reacted with a diamine (a part thereof is substituted with a terminal blocking agent which is a monoamine) in the presence of a condensing agent, a method in which a polyimide precursor is obtained, for example, by using a method in which a diester is obtained from a tetracarboxylic acid dianhydride and an alcohol, the remaining dicarboxylic acid is subjected to acid chloride modification and reacted with a diamine (a part thereof is substituted with a terminal blocking agent which is a monoamine), and the polyimide precursor is subjected to full imidization using a known imidization reaction method, or, a method in which the imidization reaction is stopped in the middle of the reaction and the imide structure is partially introduced, or furthermore a method in which a fully imidized polymer is blended with the polyimide precursor, whereby the imide structure is partially introduced. In addition, another known method for synthesizing polyimide can also be applied.

The weight-average molecular weight (Mw) of the polyimide is preferably 5,000 to 100,000, more preferably 10,000 to 50,000, and still more preferably 15,000 to 40,000. In a case where the weight-average molecular weight is set to 5,000 or more, it is possible to improve the breakage resistance of the film after curing. In order to obtain an organic film having excellent mechanical properties (for example, breaking elongation), the weight-average molecular weight is particularly preferably 15,000 or more.

The number-average molecular weight (Mn) of the polyimide is preferably 2,000 to 40,000, more preferably 3,000

to 30,000, and still more preferably 4,000 to 20,000.

The dispersivity of the molecular weight of the polyimide is preferably 1.5 or more, more preferably 1.8 or more, and still more preferably 2.0 or more. The upper limit value of the dispersivity of the molecular weight of the polyimide is not particularly limited; however, it is, for example, preferably 7.0 or less, more preferably 6.5 or less, and still more preferably 6.0 or less.

In a case where the resin composition contains a plurality of kinds of polyimides as the specific resin, it is preferable that the weight-average molecular weight, the number-average molecular weight, and the dispersivity of at least one kind of polyimide are in the above ranges. It is also preferable that the weight-average molecular weight, the number-average molecular weight, and the dispersity, calculated by using the plurality of kinds of polyimides as one resin, are within the above ranges.

[Polybenzoxazole precursor]

The structure or the like of the polybenzoxazole precursor that is used in the present invention is not particularly determined; however, it preferably includes a repeating unit represented by Formula (3).

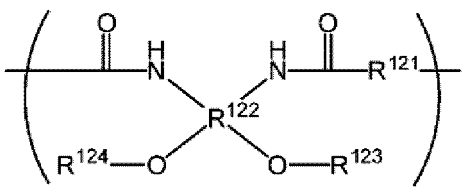

(3)

In Formula (3), $R^{121}$ represents a divalent organic group, $R^{122}$ represents a tetravalent organic group, and $R^{123}$ and $R^{124}$ each independently represent a hydrogen atom or a monovalent organic group.

In Formula (3), $R^{123}$ and $R^{124}$ have the same meanings as $R^{113}$ in Formula (2), and the same applies to the preferred ranges thereof. That is, it is preferable that at least one of them is a polymerizable group.

In Formula (3), $R^{121}$ represents a divalent organic group. The divalent organic group is preferably a group containing at least one of an aliphatic group or an aromatic group. The aliphatic group is preferably a linear aliphatic group. $R^{121}$ is preferably a dicarboxylic acid residue. One kind of dicarboxylic acid residue may be used alone, or two or more kinds thereof may be used.

The dicarboxylic acid residue is preferably a dicarboxylic acid containing an aliphatic group or a dicarboxylic acid residue containing an aromatic group, and more preferably a dicarboxylic acid residue containing an aromatic group.

The dicarboxylic acid containing an aliphatic group is preferably a dicarboxylic acid containing a linear or branched (preferably linear) aliphatic group, and more preferably a dicarboxylic acid consisting of a linear or branched (preferably linear) aliphatic group and two -COOH. The linear or branched (preferably linear) aliphatic group preferably has 2 to 30 carbon atoms, more preferably 2 to 25 carbon atoms, still more preferably 3 to 20 carbon atoms, even still more preferably 4 to 15 carbon atoms, particularly preferably 5 to 10 carbon atoms. The linear aliphatic group is preferably an alkylene group.

Examples of the dicarboxylic acid containing a linear aliphatic group include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, and furthermore, dicarboxylic acids represented by the following Formulae.

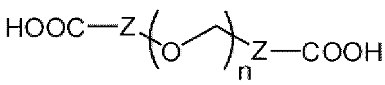
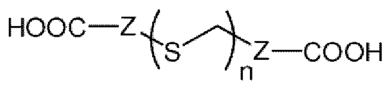
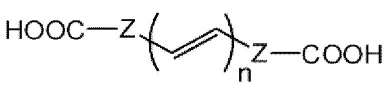
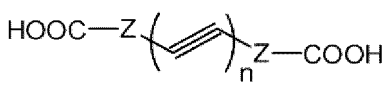

(In Formulae, Z is a hydrocarbon group having 1 to 6 carbon atoms, and n is an integer of 1 to 6).

The dicarboxylic acid containing an aromatic group is preferably a dicarboxylic acid having the following aromatic group and more preferably a dicarboxylic acid consisting of only the following group having an aromatic group and two pieces of -COOH.

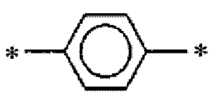
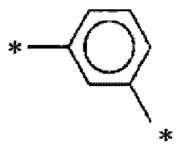
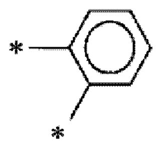
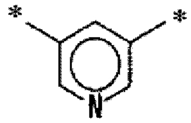

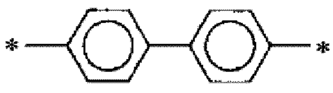
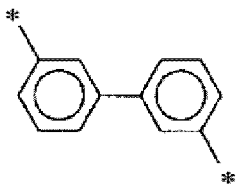
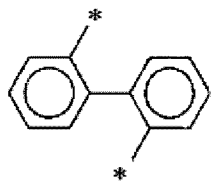

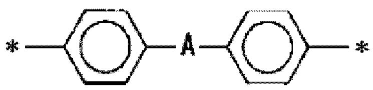
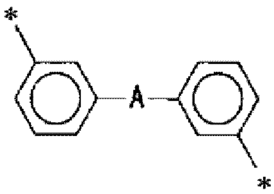
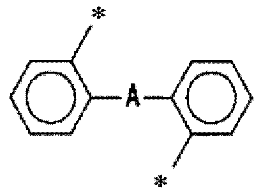

In Formulae, A represents a divalent group selected from the group consisting of $-CH_2-$, -O-, -S-, $-SO_2-$, -CO-, -NHCO-, $-C(CF_3)_2-$, and $-C(CH_3)_2-$, and *'s each independently represent a bonding site to another structure.

Specific examples of the dicarboxylic acid containing an aromatic group include 4,4'-carbonyldibenzoic acid, 4,4'-dicarboxydiphenyl ether, and terephthalic acid.

In Formula (3), $R^{122}$ represents a tetravalent organic group. The tetravalent organic group has the same meaning as $R^{115}$ in Formula (2) described above, and the same applies to the preferred range thereof.

$R^{122}$ is preferably a group derived from a bisaminophenol derivative. Examples of the group derived from the bisaminophenol derivative include 3,3'-diamino-4,4'-dihydroxybiphenyl, 4,4'-diamino-3,3'-dihydroxybiphenyl, 3,3'-diamino-4,4'-dihydroxydiphenylsulfone, 4,4'-diamino-3,3'-dihydroxydiphenylsulfone, bis-(3-amino-4-hydroxyphenyl) methane, 2,2-bis(3-amino-4-hydroxyphenyl)propane, 2,2-bis-(3-amino-4-hydroxyphenyl)hexafluoropropane, 2,2-bis-(4-amino-3-hydroxyphenyl)hexafluoropropane, bis-(4-amino-3-hydroxyphenyl)methane, 2,2-bis-(4-amino-3-hydroxyphenyl)propane, 4,4'-diamino-3,3'-dihydroxybenzophenone, 3,3'-diamino-4,4'-dihydroxybenzophenone, 4,4'-diamino-3,3'-dihydroxydiphenyl ether, 3,3'-diamino-4,4'-dihydroxydiphenyl ether, 1,4-diamino-2,5-dihydroxybenzene, 1,3-diamino-2,4-dihydroxybenzene, and 1,3-diamino-4,6-dihydroxybenzene. These bisaminophenols may be used alone or may be mixedly used.

Among the bisaminophenol derivatives, the bisaminophenol derivative having the following aromatic group is preferable.

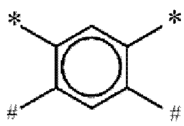
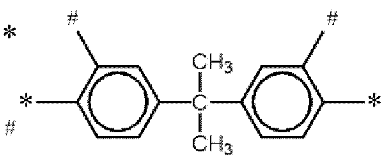
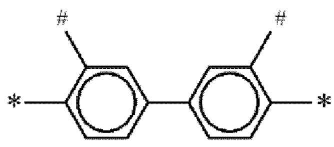

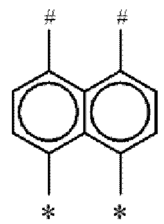
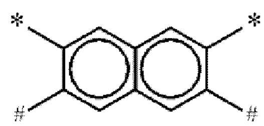
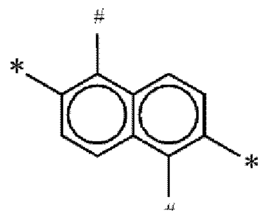

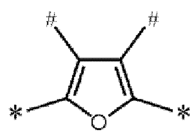
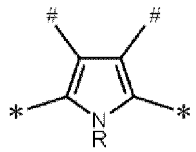
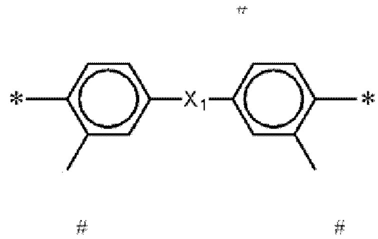
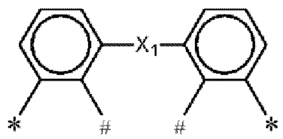

In Formulae, $X_1$ represents -O-, -S-, $-C(CF_3)_2-$, $-CH_2-$, $-SO_2-$, or -NHCO-, and * and # each represent a bonding site to another structure. R represents a hydrogen atom or a monovalent substituent, where a hydrogen atom or a hydrocarbon group is preferable, and a hydrogen atom or an alkyl group is more preferable. In addition, it is also preferable that $R^{122}$ has a structure represented by the above Formula. In a case where $R^{122}$ has a structure represented by the above Formula, it is preferable that any two of a total of four of *'s and #'s are bonding sites to the nitrogen atom to which $R^{122}$ in Formula (3) is bonded and the other two are bonding sites to the oxygen atom to which $R^{122}$ Formula (3) is bonded, it is more preferable that two *'s are bonding sites to the oxygen atom to which $R^{122}$ in Formula (3) is bonded and two #'s are bonding sites to the nitrogen atom to which $R^{122}$ Formula (3) is bonded or that two *'s are bonding sites to the nitrogen atom to which $R^{122}$ in Formula (3) is bonded and two #'s are bonding sites to the oxygen atom to which $R^{122}$ Formula (3) is bonded, and it is still more preferable that two *'s are bonding sites to the oxygen atom to which $R^{122}$ in Formula (3) is bonded and two #'s are bonding sites to the nitrogen atom to which $R^{122}$ Formula (3) is bonded.

The bisaminophenol derivative is also preferably a compound represented by Formula (A-s).

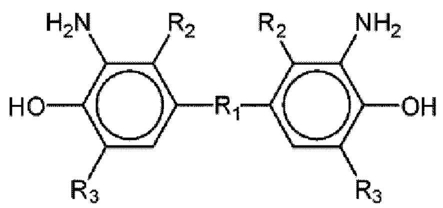
(A-s)

In Formula (A-s), $R_1$ is a hydrogen atom, an alkylene, a substituted alkylene, -O-, -S-, - $SO_2$-, -CO-, -NHCO-, a single bond, or an organic group selected from the group of Formula (A-sc). $R_2$'s are any one of a hydrogen atom, an alkyl group, an alkoxy group, an acyloxy group, or a cyclic alkyl group, and may be the same or different from each other. $R_3$'s are any one of a hydrogen atom, a linear or branched alkyl group, an alkoxy group, an acyloxy group, or a cyclic alkyl group, and may be the same or different from each other.

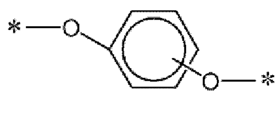
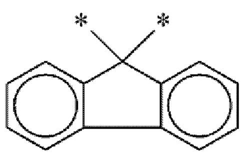
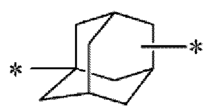
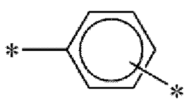
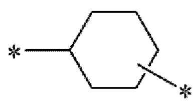
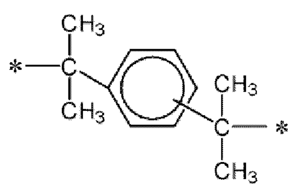

In the organic group selected from the group of Formula (A-sc), * represents bonding to an aromatic ring of an aminophenol group of the bisaminophenol derivative represented by Formula (A-s).

In Formula (A-s), it is conceived that in a case where a substituent is also provided at the ortho position of the phenolic hydroxy group, that is, $R_3$, the distance between the carbonyl carbon of the amide bond and the hydroxy group is reduced, and such a case is particularly preferable since the effect that the cyclization rate rises in a case where curing is carried out at a low temperature is further enhanced.

In Formula (A-s), in a case where $R_2$ is an alkyl group and $R_3$ is an alkyl group, it is possible to maintain the high transparency to the i-line and the effect that the cyclization rate is high in a case where curing is carried out at a low temperature, which is preferable.

In Formula (A-s), it is more preferable that $R_1$ is an alkylene or a substituted alkylene. Specific examples of the alkylene and the substituted alkylene, which is involved in $R_1$ include linear or branched alkyl groups having 1 to 8 carbon atoms. However, among them, $-CH_2-$, $-CH(CH_3)-$, or $-C(CH_3)_2-$ is more preferable since it is possible to obtain a polybenzoxazole precursor excellent in balance in terms of having sufficient solubility in a solvent while maintaining the high transparency to the i-line and the effect that the cyclization rate is high in a case where curing is carried out at a low temperature.

As a method of producing the bisaminophenol derivative represented by Formula (A-s), for example, paragraph Nos. 0085 to 0094 and Example 1 (paragraph Nos. 0189 to 0190) of JP2013-256506A can be referenced, the content of which is incorporated in the present specification by reference.

Specific examples of the structure of the bisaminophenol derivative represented by Formula (A-s) include those described in paragraph Nos. 0070 to 0080 of JP2013-256506A, the content of which is incorporated in the present specification. Specific examples of the structure of the bisaminophenol derivative represented by Formula (A-s) are not limited thereto.

The polybenzoxazole precursor may contain another kind of repeating unit in addition to the repeating unit of Formula (3).

From the viewpoint that the occurrence of warping associated with ring closure can be suppressed, the polybenzoxazole precursor preferably contains a diamine residue represented by Formula (SL) as another kind of repeating unit.

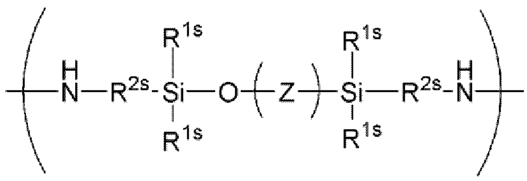 (SL)

a: 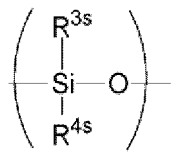 b: 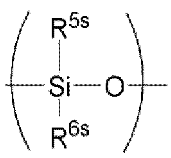

In Formula (SL), Z has a structure and a b structure, $R^{1s}$ is a hydrogen atom or a hydrocarbon group having 1 to 10 carbon atoms, $R^{2s}$ is a hydrocarbon group having 1 to 10 carbon atoms, and at least one of $R^{3s}$, $R^{4s}$, $R^{5s}$, or $R^{6s}$ is an aromatic group, where the rest are a hydrogen atom or an organic group having 1 to 30 carbon atoms and may be the same or different from each other. The polymerization of the a structure and the b structure may be block polymerization or random polymerization. Regarding the contents of the structures in the Z portion in terms of "% by mole", the content of the a structure is 5% to 95% by mole and the content of the b structure is 95% to 5% by mole, the sum (the content of the a structure + the content of the b structure) is 100% by mole.

In Formula (SL), examples of the preferred Z include one in which $R^{5s}$ and $R^{6s}$ in the b structure are a phenyl group. The molecular weight of the a structure represented by Formula (SL) is preferably 400 to 4,000 and more preferably 500 to 3,000. In a case where the molecular weight is within the above-described range, it is possible to more effectively decrease an elastic modulus of a polybenzoxazole precursor after the dehydration ring closure and to achieve both effects of suppressing warping and improving solubility in a solvent.

In a case where a diamine residue represented by Formula (SL) is contained as another kind of repeating unit, it is also preferable that a tetracarboxylic acid residue that has remained after removing an anhydride group from the tetracarboxylic acid dianhydride is further contained as a repeating unit. Examples of such a tetracarboxylic acid residue include the examples of $R^{115}$ in Formula (2).

The weight-average molecular weight(Mw) of polybenzoxazole precursor is preferably 18,000 to 30,000, more preferably 20,000 to 29,000, and still more preferably 22,000 to 28,000. The number-average molecular weight (Mn) is preferably 7,200 to 14,000, more preferably 8,000 to 12,000, and still more preferably 9,200 to 11,200.

The dispersivity of the molecular weight of the polybenzoxazole precursor is preferably 1.4 or more, more preferably 1.5 or more, and still more preferably 1.6 or more. The upper limit value of the dispersivity of the molecular weight of the polybenzoxazole precursor is not particularly determined; however, it is, for example, preferably 2.6 or less, more preferably 2.5 or less, still more preferably 2.4 or less, even still more preferably 2.3 or less, and even further still more

preferably 2.2 or less.

In a case where the resin composition contains a plurality of kinds of polybenzoxazole precursors as the specific resin, it is preferable that the weight-average molecular weight, the number-average molecular weight, and the dispersivity of at least one kind of polybenzoxazole precursor are in the above ranges. Further, it is also preferable that the weight-average molecular weight, the number-average molecular weight, and the dispersivity, calculated by using the plurality of kinds of polybenzoxazole precursors as one resin, are within the above ranges.

[Polybenzoxazole]

The polybenzoxazole is not particularly limited as long as it is a polymer compound having a benzoxazole ring; however, it is preferably a compound represented by Formula (X), and it is more preferably a compound represented by Formula (X), which is a compound having a polymerizable group. The polymerizable group is preferably a radically polymerizable group. In addition, it may be a compound represented by Formula (X), which is a compound having a polarity converting group such as an acid-decomposable group.

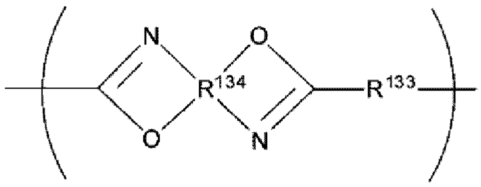

(X)

In Formula (X), $R^{133}$ represents a divalent organic group, and $R^{134}$ represents a tetravalent organic group.

In a case where the polymerizable group or the polarity converting group such as an acid-decomposable group is contained, the polymerizable group or the polarity converting group such as an acid-decomposable group may be located at at least one of $R^{133}$ or $R^{134}$, or may be located at a terminal of polybenzoxazole as shown in Formula (X-1) or Formula (X-2).

Formula (X-1)

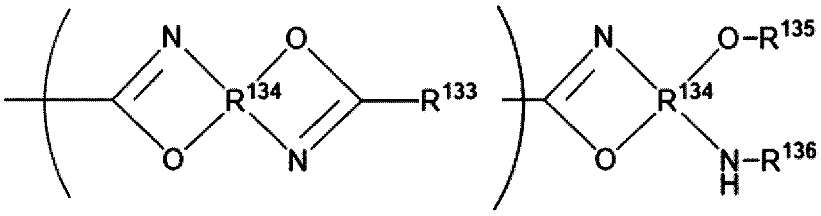

In Formula (X-1), at least one of $R^{135}$ or $R^{136}$ is a polymerizable group or a polarity converting group such as an acid-decomposable group, or it is an organic group in a case where it is not a polymerizable group or a polarity converting group such as an acid-decomposable group, and other groups are the same as those in Formula (X).

Formula (X-2)

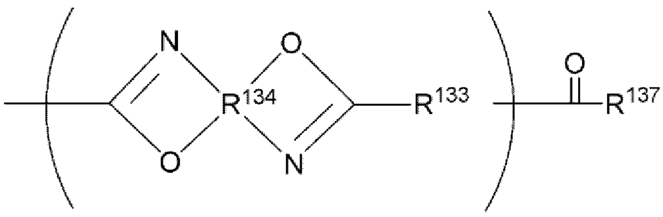

In Formula (X-2), $R^{137}$ is a polymerizable group or a polarity converting group such as an acid-decomposable group, others are substituents, and other groups are the same as those in Formula (X).

The polymerizable group or the polarity converting group such as an acid-decomposable group has the same

meaning as the polymerizable group described above for the polymerizable group contained in the polyimide precursor.

$R^{133}$ represents a divalent organic group. Examples of the divalent organic group include an aliphatic group and an aromatic group. Specific examples thereof include examples of $R^{121}$ in Formula (3) of the polybenzoxazole precursor, and preferred examples thereof are the same as those for $R^{121}$.

$R^{134}$ represents a tetravalent organic group. Examples of the tetravalent organic group include examples of $R^{122}$ in Formula (3) of the polybenzoxazole precursor, and preferred examples thereof are the same as those for $R^{122}$.

For example, four bonding partners of the tetravalent organic group exemplified as $R^{122}$ are bonded to the nitrogen atom and the oxygen atom in Formula (X) to form a fused ring. For example, in a case where $R^{134}$ is the following organic group, the following structure is formed. In the following structure, each * represents a bonding site to a nitrogen atom or an oxygen atom in Formula (X).

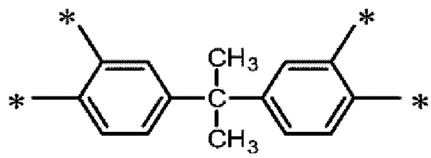

The oxazole modification rate of the polybenzoxazole is preferably 85% or more and more preferably 90% or more. The upper limit thereof is not particularly limited and may be 100%. In a case where the oxazole modification rate is 85% or more, the film shrinkage based on the ring closure, which occurs in a case where oxazole modification occurs due to heating, is reduced, and thus the occurrence of warping can be more effectively suppressed.

The oxazole modification rate is measured, for example, according to the following method.

An infrared absorption spectrum of polybenzoxazole is measured, and a peak intensity Q1 in the vicinity of 1,650 $cm^{-1}$, which is an absorption peak derived from the amide structure of the precursor, is determined. Next, the absorption intensity of the aromatic ring observed in the vicinity of 1,490 $cm^{-1}$ is standardized. The polybenzoxazole is heat-treated at 350°C for 1 hour, and then the infrared absorption spectrum is measured again to determine a peak intensity Q2 in the vicinity of 1,650 $cm^{-1}$, followed by standardization with the absorption intensity of the aromatic ring observed in the vicinity of 1,490 $cm^{-1}$. Using the obtained standard values of the peak intensities Q1 and Q2, it is possible to determine the oxazole modification rate of the polybenzoxazole based on the following expression.

Oxazole modification rate (%) = (standard value of peak intensity Q1/standard value of peak intensity Q2) $\times$ 100

The polybenzoxazole may include the repeating unit of Formula (X) in which combinations of $R^{133}$ and $R^{134}$ are the same, or may include the repeating unit of Formula (X) including two or more different combinations of $R^{133}$ and $R^{134}$. In addition, the polybenzoxazole may contain another kind of repeating unit in addition to the repeating unit of Formula (X).

The polybenzoxazole can be obtained by, for example, reacting a bisaminophenol derivative with a compound selected from a dicarboxylic acid dichloride, a dicarboxylic acid derivative, and the like of a dicarboxylic acid containing $R^{133}$ or the above dicarboxylic acid, to obtain a polybenzoxazole precursor, and subjecting it to the oxazole modification with a known oxazole reaction method.

In a case of a dicarboxylic acid, an active ester-type dicarboxylic acid derivative subjected to reaction in advance with 1-hydroxy-1,2,3-benzotriazole or the like may be used in order to increase the reaction yield or the like.

The weight-average molecular weight(Mw) of polybenzoxazole is preferably 5,000 to 70,000, more preferably 8,000 to 50,000, and still more preferably 10,000 to 30,000. In a case where the weight-average molecular weight is set to 5,000 or more, it is possible to improve the breakage resistance of the film after curing. In order to obtain an organic film having excellent mechanical properties, the weight-average molecular weight is particularly preferably 20,000 or more. In a case where two or more kinds of polybenzoxazole are contained, it is preferable that the weight-average molecular weight of at least one kind of polybenzoxazole is in the above range.

The number-average molecular weight (Mn) of the polybenzoxazole is preferably 7,200 to 14,000, more preferably 8,000 to 12,000, and still more preferably 9,200 to 11,200.

The dispersivity of the molecular weight of the polybenzoxazole is preferably 1.4 or more, more preferably 1.5 or more, and still more preferably 1.6 or more. The upper limit value of the dispersivity of the molecular weight of the polybenzoxazole is not particularly determined; however, it is, for example, preferably 2.6 or less, more preferably 2.5 or less, still more preferably 2.4 or less, even still more preferably 2.3 or less, and even further still more preferably 2.2 or less.

In a case where the resin composition contains a plurality of kinds of polybenzoxazoles as the specific resin, it is preferable that the weight-average molecular weight, the number-average molecular weight, and the dispersivity of at least one kind of polybenzoxazole are in the above ranges. Further, it is also preferable that the weight-average molecular weight, the number-average molecular weight, and the dispersivity, calculated by using the plurality of kinds of

polybenzoxazoles as one resin, are within the above ranges.

[Polyamideimide precursor]

The polyamideimide precursor preferably contains a repeating unit represented by Formula (PAI-2).

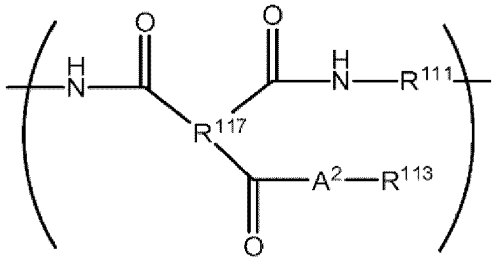

(PAI-2)

In Formula (PAI-2), $R^{117}$ represents a trivalent organic group, $R^{111}$ represents a divalent organic group, $A^2$ represents an oxygen atom or -NH-, and $R^{113}$ represents a hydrogen atom or a monovalent organic group.

In Formula (PAI-2), examples of $R^{117}$ include a linear or branched aliphatic group, a cyclic aliphatic group, an aromatic group, a heteroaromatic group, and a group obtained by linking two or more of these groups through a single bond or a linking group, where $R^{117}$ is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and $R^{117}$ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-,-S(=O)$_2$-, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, $R^{117}$ is preferably derived from a tricarboxylic acid compound in which at least one carboxy group may be subjected to halogenation. Here, the halogenation is preferably chlorination.

In the present invention, a compound having three carboxy groups is referred to as a tricarboxylic acid compound.

Two carboxy groups of the three carboxy groups of the tricarboxylic acid compound may be subjected to acid anhydrization.

Examples of the tricarboxylic acid compound which may be halogenated, which is used in the production of the polyamideimide precursor, include a branched aliphatic, cyclic aliphatic, or aromatic tricarboxylic acid compound.

One kind of these tricarboxylic acid compounds may be used alone, or two or more kinds thereof may be used.

Specifically, the tricarboxylic acid compound is preferably a tricarboxylic acid compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a tricarboxylic acid compound containing an aromatic group having 6 to 20 carbon atoms or a group obtained by combining two or more aromatic groups having 6 to 20 carbon atoms through a single bond or a linking group.

Specific examples of the tricarboxylic acid compound include 1,2,3-propanetricarboxylic acid, 1,3,5-pentanetricarboxylic acid, citric acid, trimellitic acid, 2,3,6-naphthalenetricarboxylic acid, and a compound in which phthalic acid (or phthalic anhydride) and benzoic acid are linked through a single bond, -O-, -$CH_2$-, -$C(CH_3)_2$-, -$C(CF_3)_2$-, -$SO_2$-, or a phenylene group.

These compounds may be a compound (for example, a trimellitic acid anhydride) in which two carboxy groups

have been subjected to anhydrization or may be a compound (for example, trimellitic anhydride chloride) in which at least one carboxy group has been halogenated.

In Formula (PAI-2), $R^{111}$, $A^2$, and $R^{113}$ respectively have the same meanings as $R^{111}$, $A^2$, and $R^{113}$ in Formula (2) described above, and the same applies to the preferred aspects thereof.

The polyamideimide precursor may further contain other repeating units.

Examples of the other repeating units include the above-described repeating unit represented by Formula (2) and a repeating unit represented by Formula (PAI-1).

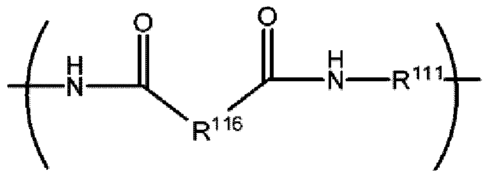
(PAI-1)

In Formula (PAI-1), $R^{116}$ represents a divalent organic group, and $R^{111}$ represents a divalent organic group.

In Formula (PAI-1), examples of $R^{116}$ include a linear or branched aliphatic group, a cyclic aliphatic group, an aromatic group, a heteroaromatic group, and a group obtained by linking two or more of these groups through a single bond or a linking group, where $R^{116}$ is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and $R^{116}$ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-,-$S(=O)_2$-, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, $R^{116}$ is preferably derived from a dicarboxylic acid compound or a dicarboxylic acid dihalide compound.

In the present invention, a compound having two carboxy groups is referred to as a dicarboxylic acid compound, and a compound having two halogenated carboxy groups is referred to as a dicarboxylic acid dihalide compound.

The carboxy group in the dicarboxylic acid dihalide compound may be halogenated; however, it is, for example, preferably chlorinated. That is, the dicarboxylic acid dihalide compound is preferably a dicarboxylic acid dichloride compound.

Examples of the dicarboxylic acid compound which may be halogenated or the dicarboxylic acid dihalide compound, which is used in the production of the polyamideimide precursor, include a linear or branched aliphatic, cyclic aliphatic, or aromatic dicarboxylic acid compound, and a dicarboxylic acid dihalide compound.

One kind of these dicarboxylic acid compounds or dicarboxylic acid dihalide compounds may be used alone, or two or more kinds thereof may be used.

Specifically, the dicarboxylic acid compound or the dicarboxylic acid dihalide compound is preferably a dicarboxylic acid compound or dicarboxylic acid dihalide compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a dicarboxylic acid compound or dicarboxylic acid dihalide compound containing an aromatic group having 6 to 20 carbon atoms or a group obtained by combining two or more aromatic groups having 6 to 20 carbon atoms through a single bond or a linking group.

In addition, specific example of the dicarboxylic acid compound include malonic acid, dimethylmalonic acid, ethylmalonic acid, isopropylmalonic acid, di-n-butylmalonic acid, succinic acid, tetrafluorosuccinic acid, methylsuccinic

acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelliic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, phthalic acid, isophthalic acid, terephthalic acid, 4,4'-biphenylcarboxylic acid, 4,4'-biphenylcarboxylic acid, 4,4'-dicarboxydiphenyl ether, and benzophenone-4,4'-dicarboxylic acid.

Specific examples of the dicarboxylic acid dihalide compound include a compound having a structure in which two carboxy groups in the specific examples of the dicarboxylic acid compound are halogenated.

In Formula (PAI-1), $R^{111}$ has the same meaning as $R^{111}$ in Formula (2) described above, and the same applies to the preferred aspect thereof.

In addition, the polyamideimide precursor preferably has a fluorine atom in the structure thereof. The content of fluorine atoms in the polyamideimide precursor is preferably 10% by mass or more, and it is preferably 20% by mass or less.

In addition, for the purpose of improving adhesiveness to a base material, the polyamideimide precursor may be copolymerized with an aliphatic group having a siloxane structure. Specifically, an aspect in which bis(3-aminopropyl) tetramethyldisiloxane, bis(p-aminophenyl)octamethyl pentasiloxane, or the like is used as the diamine component can be mentioned.

Examples of one embodiment of the polyamideimide precursor in the present invention include an aspect in which a repeating unit represented by Formula (PAI-2), a repeating unit represented by Formula (PAI-1), and a repeating unit represented by Formula (2) are included. The total content of the repeating units is preferably 50% by mole or more, more preferably 70% by mole or more, still more preferably 90% by mole or more, and particularly preferably more than 90% by mole of all the repeating units. The upper limit of the total content is not particularly limited, and is 100% by mole or less. All the repeating units in the polyamideimide precursor excluding the terminal may be any one of the repeating unit represented by Formula (PAI-2), the repeating unit represented by Formula (PAI-1), or the repeating unit represented by Formula (2).

In addition, examples of another embodiment of the polyamideimide precursor in the present invention include an aspect in which a repeating unit represented by Formula (PAI-2) and a repeating unit represented by Formula (PAI-1) are included. The total content of the repeating units is preferably 50% by mole or more, more preferably 70% by mole or more, still more preferably 90% by mole or more, and particularly preferably more than 90% by mole of all the repeating units. The upper limit of the total content is not particularly limited, and is 100% by mole or less. All repeating units in the polyamideimide precursor excluding the terminal may be any one of a repeating unit represented by Formula (PAI-2) or a repeating unit represented by Formula (PAI-1).

The weight-average molecular weight(Mw) of the polyamideimide precursor is preferably 2,000 to 500,000, more preferably 5,000 to 100,000, and still more preferably 10,000 to 50,000. In addition, the number-average molecular weight (Mn) is preferably 800 to 250,000, more preferably 2,000 to 50,000, and still more preferably 4,000 to 25,000.

The dispersivity of the molecular weight of the polyamideimide precursor is preferably 1.5 or more, more preferably 1.8 or more, and still more preferably 2.0 or more. The upper limit value of the dispersivity of the molecular weight of the polyamideimide precursor is not particularly limited; however, it is, for example, preferably 7.0 or less, more preferably 6.5 or less, and still more preferably 6.0 or less. In a case where the resin composition contains a plurality of kinds of polyamideimide precursors as the specific resin, it is preferable that the weight-average molecular weight, the number-average molecular weight, and the dispersivity of at least one kind of polyamideimide precursor are in the above ranges. Further, it is also preferable that the weight-average molecular weight, the number-average molecular weight, and the dispersivity, calculated by using the plurality of kinds of polyamideimide precursors as one resin, are within the above ranges.

[Polyamideimide]

The polyamideimide that is used in the present invention may be an alkali-soluble polyamideimide or may be a polyamideimide soluble in a developer containing an organic solvent as a main component.

In the present specification, the alkali-soluble polyamideimide refers to a polyamideimide, 0.1 g or more of which is dissolved in 100 g of an aqueous solution of 2.38% by mass of tetramethylammonium at 23°C, and from the viewpoint of pattern formation properties, it is preferably a polyamideimide, 0.5 g or more of which is dissolved therein and still more preferably a polyamideimide, 1.0 g or more of which is dissolved therein. The upper limit of the dissolution amount is not particularly limited; however, it is preferably 100 g or less.

In addition, the polyamideimide is preferably a polyamideimide having a plurality of amide bonds and a plurality of imide structures in the main chain from the viewpoint of the film hardness and the insulating properties of the organic film to be obtained.

- Fluorine atom -

From the viewpoint of the film hardness of the organic film to be obtained, the polyamideimide preferably has a fluorine atom.

The fluorine atom is preferably contained in, for example, $R^{117}$ or $R^{111}$ in a repeating unit represented by Formula (PAI-3) described later, and it is more preferably contained, as a fluorinated alkyl group, in $R^{117}$ or $R^{111}$ in the repeating unit represented by Formula (PAI-3) described later.

The amount of fluorine atoms with respect to the total mass of the polyamideimide is preferably 5% by mass or more, and it is preferably 20% by mass or less.

- Ethylenically unsaturated bond -

From the viewpoint of the film hardness of the organic film to be obtained, the polyamideimide may have an ethylenically unsaturated bond.

The polyamideimide may have an ethylenically unsaturated bond at the terminal of the main chain or the side chain; however, it preferably has an ethylenically unsaturated bond at the side chain.

The ethylenically unsaturated bond preferably has radical polymerizability.

The ethylenically unsaturated bond is preferably contained in $R^{117}$ or $R^{111}$ in a repeating unit represented by Formula (PAI-3) described later, and it is more preferably contained, as a group having an ethylenically unsaturated bond, in $R^{117}$ or $R^{111}$ in a repeating unit represented by Formula (PAI-3) described later.

The preferred aspect of the group having an ethylenically unsaturated bond is the same as the preferred aspect of the group having an ethylenically unsaturated bond in the above-described polyimide.

The amount of the ethylenically unsaturated bond with respect to the total mass of the polyamideimide is preferably 0.0001 to 0.1 mol/g and more preferably 0.001 to 0.05 mol/g.

- Polymerizable group other than ethylenically unsaturated bond -

The polyamideimide may have a polymerizable group other than the ethylenically unsaturated bond.

Examples of the polymerizable group other than the ethylenically unsaturated bond in the polyamideimide include the same group as the polymerizable group other than the ethylenically unsaturated bond in the above-described polyimide.

The polymerizable group other than the ethylenically unsaturated bond is preferably contained in, for example, $R^{111}$ in a repeating unit represented by Formula (PAI-3) described later.

The amount of the polymerizable group other than the ethylenically unsaturated bond with respect to the total mass of the polyamideimide is preferably 0.05 to 10 mol/g and more preferably 0.1 to 5 mol/g.

- Polarity converting group -

The polyamideimide may have a polarity converting group such as an acid-decomposable group. The acid-decomposable group in the polyamideimide is the same as the acid-decomposable group described in $R^{113}$ and $R^{114}$ in Formula (2) described above, and the same applies to the preferred aspect thereof.

- Acid value -

In a case where the polyamideimide is subjected to alkaline development, the acid value of the polyamideimide is preferably 30 mgKOH/g or more, more preferably 50 mgKOH/g or more, and still more preferably 70 mgKOH/g or more, from the viewpoint of improving developability.

In addition, the acid value thereof is preferably 500 mgKOH/g or less, more preferably 400 mgKOH/g or less, and still more preferably 200 mgKOH/g or less.

Further, in a case where the polyamideimide is subjected to the development (for example, the "solvent development") using a developer containing an organic solvent as a main component, the acid value of the polyamideimide is preferably 2 to 35 mgKOH/g, more preferably 3 to 30 mgKOH/g, and still more preferably 5 to 20 mgKOH/g.

The acid value is measured by a known method, for example, by the method described in JIS K0070: 1992.

In addition, examples of the acid group contained in the polyamideimide include the same group as the acid group

in the above-described polyimide, and the same applies to the preferred aspect thereof.

- Phenolic hydroxy group -

From the viewpoint of allowing the speed of development with an alkaline developer to be proper, the polyamideimide preferably has a phenolic hydroxy group.

The polyamideimide may have a phenolic hydroxy group at the terminal of the main chain or the side chain.

The phenolic hydroxy group is preferably contained in, for example, $R^{117}$ or $R^{111}$ in a repeating unit represented by Formula (PAI-3) described later.

The amount of the phenolic hydroxy group with respect to the total mass of the polyamideimide is preferably 0.1 to 30 mol/g and more preferably 1 to 20 mol/g.

The polyamideimide that is used in the present invention is not particularly limited as long as it is a polymer compound having an imide structure and an amide bond; however, it is preferable that the polyamideimide contains a repeating unit represented by Formula (PAI-3).

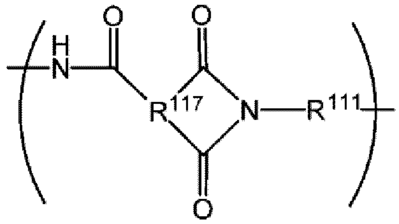

(PAI-3)

In Formula (PAI-3), $R^{111}$ and $R^{117}$ respectively have the same meanings as $R^{111}$ and $R^{117}$ in Formula (PAI-2), and the same applies to the preferred aspects thereof.

In a case where a polymerizable group is contained, the polymerizable group may be located at at least one of $R^{111}$ or $R^{117}$, or may be located at the terminal of the polyamideimide.

In addition, in order to improve the storage stability of the resin composition, the terminal of the main chain of the polyamideimide is preferably blocked with a terminal blocking agent such as a monoamine, an acid anhydride, a monocarboxylic acid, a monoacid chloride compound, or a monoactive ester compound. The preferred aspect of the terminal blocking agent is the same as the preferred aspect of the terminal blocking agent in the above-described polyimide.

- Imidization rate (ring closure rate) -

The imidization rate (also referred to as the "ring closure rate") of the polyamideimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured according to the same method as the above-described ring closure rate of the polyimide.

The polyamideimide may include a repeating unit represented by Formula (PAI-3) in which combinations of $R^{111}$ and $R^{117}$ are the same, or may include a repeating unit represented by Formula (PAI-3) including two or more different combinations of $R^{111}$ and $R^{117}$. In addition, the polyamideimide may also contain another kind of repeating unit in addition to the above repeating unit represented by Formula (PAI-3). Examples of the other kind of repeating unit include the repeating unit represented by Formula (PAI-1) or the repeating unit represented by Formula (PAI-2), which are described above.

The polyamideimide can be synthesized, for example, by using a method in which a polyamideimide precursor is obtained according to a known method, and the obtained polyamideimide precursor is completely imidized by using a known imidization reaction method, or a method in which the imidization reaction is stopped in the middle of the reaction and the imide structure is partially introduced, or furthermore, a method in which a fully imidized polymer is blended with the polyamideimide precursor, whereby the imide structure is partially introduced.

The weight-average molecular weight(Mw) of the polyamideimide is preferably 5,000 to 70,000, more preferably 8,000 to 50,000, and still more preferably 10,000 to 30,000. In a case where the weight-average molecular weight is set to 5,000 or more, it is possible to improve the breakage resistance of the film after curing. In order to obtain an organic film having excellent mechanical properties, the weight-average molecular weight is particularly preferably 20,000 or more.

In addition, the number-average molecular weight (Mn) of the polyamideimide is preferably 800 to 250,000, more preferably 2,000 to 50,000, and still more preferably 4,000 to 25,000.
The dispersivity of the molecular weight of the polyamideimide is preferably 1.5 or more, more preferably 1.8 or more, and still more preferably 2.0 or more. The upper limit value of the dispersivity of the molecular weight of the polyamideimide is not particularly limited; however, it is, for example, preferably 7.0 or less, more preferably 6.5 or less, and still more preferably 6.0 or less.
**In** addition, in a case where the resin composition contains a plurality of kinds of polyamideimides as the specific resin, it is preferable that the weight-average molecular weight, the number-average molecular weight, and the dispersivity of at least one kind of polyamideimide are in the above ranges. Further, it is also preferable that the weight-average molecular weight, the number-average molecular weight, and the dispersivity, calculated by using the plurality of kinds of polyamideimides as one resin, are within the above ranges.

[Production method for polyimide precursor and like]

The polyimide precursor the like can be obtained, for example, by a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production methods, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.
Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.
Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.
Examples of the halogenating agent include thionyl chloride, oxalyl chloride, and phosphorus oxychloride.
In the production method for a polyimide precursor the like, it is preferable to use an organic solvent in a case of carrying out the reaction. One kind of organic solvent may be used, or two or more kinds thereof may be used.
The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and γ-butyrolactone.
In the production method for a polyimide precursor the like, it is preferable to add a basic compound in a case of carrying out the reaction. One kind of basic compound may be used, or two or more kinds thereof may be used.
The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

- Terminal blocking agent -

In the production method for a polyimide precursor the like, it is preferable to block the carboxylic acid anhydride, the acid anhydride derivative, or the amino group, remaining at the terminal of the resin such as the polyimide precursor, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecanol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid,3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred blocking agent for the amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, benzoic anhydride, and 5-norbornene-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

- Solid precipitation -

In the production method for a polyimide precursor the like, a step of precipitating a solid may be included. Specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

[Content]

The content of the (A) resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition, the content of the (A) resin in the resin composition according to the embodiment of the present invention is preferably 99.5% by mass or less, more preferably 99% by mass or less, still more preferably 98% by mass or less, still more preferably 97% by mass or less, and even still more preferably 95% by mass or less, with respect to the total solid content of the resin composition.

The resin composition according to the embodiment of the present invention may contain only one kind of the (A) resin or may contain two or more kinds thereof. In a case where two or more kinds thereof are contained, the total amount thereof is preferably within the above range.

It is particularly preferable that the (A) resin is a specific resin and the content of the specific resin is in the above-described range.

It is also preferable that the resin composition according to the embodiment of the present invention contains at least two kinds of resins.

Specifically, the resin composition according to the embodiment of the present invention may contain in total two or more kinds of the specific resins and other resins described later or may contain two or more kinds of the specific resins; however, it is preferable to include two or more kinds of the specific resins.

In a case where the resin composition according to the embodiment of the present invention contains two or more kinds of the specific resins, it is preferable to contain, for example, two or more kinds of polyimide precursors which are polyimide precursors in which the structure ($R^{115}$ in Formula (2) described above) derived from the dianhydride is different.

The resin composition according to the embodiment of the present invention may contain the above-described specific resin and another resin (hereinafter, also simply referred to as "the other resin") that is different from the specific resin.

Examples of the other resin include a phenol resin, polyamide, an epoxy resin, polysiloxane, a resin containing a siloxane structure, a (meth)acrylic resin, a (meth)acrylamide resin, a urethane resin, a butyral resin, a styryl resin, a polyether resin, and a polyester resin.

For example, in a case where a (meth)acrylic resin is further added, it is possible to obtain a resin composition having excellent coatability, and it is possible to obtain a pattern (a cured substance) having excellent solvent resistance.

For example, in a case where a (meth)acrylic resin having a high polymerizable group value and having a weight-average molecular weight of 20,000 or less (for example, a molar content amount of a polymerizable group in 1 g of a resin is $1 \times 10^{-3}$ mol/g or more) is added to the resin composition instead of a polymerizable compound described later or in

addition to a polymerizable compound described later, it is possible to improve the coatability of the resin composition, the solvent resistance of the pattern (the cured substance).

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

The content of the other resin in the resin composition according to the embodiment of the present invention is preferably 80% by mass or less, more preferably 75% by mass or less, still more preferably 70% by mass or less, even still more preferably 60% by mass or less, and even further still more preferably 50% by mass or less, with respect to the total solid content of the resin composition.

As the preferred aspect of the resin composition according to the embodiment of the present invention, an aspect in which the content of the other resin is a low content can be adopted. In the above aspect, the content of the other resin is preferably 20% by mass or less, more preferably 15% by mass or less, still more preferably 10% by mass or less, even still more preferably 5% by mass or less, and even further still more preferably 1% by mass or less, with respect to the total solid content of the resin composition. The lower limit of the content is not particularly limited, and it may be any content of 0% by mass or more.

The resin composition according to the embodiment of the present invention may contain only one kind of the other resin or may contain two or more kinds thereof. **In** a case where two or more kinds thereof are contained, the total amount thereof is preferably within the above range.

The resin composition according to the embodiment of the present invention preferably satisfies at least one of (i) or (ii).

(i) (B-1) radically polymerizable compound is contained
(ii) the (A) resin includes a radically polymerizable site

Examples of the aspect in which the (A) resin of (ii) includes a radically polymerizable site include an aspect in which the (A) resin includes a radically polymerizable group. The radically polymerizable group is as described above.

<(B-1) Radically polymerizable compound>

(B-1) Description of radically polymerizable compound (also referred to as "radical crosslinking agent")

The radical crosslinking agent is a compound having a radically polymerizable group. The radically polymerizable group is preferably a group containing an ethylenically unsaturated bond. Examples of the group containing an ethylenically unsaturated bond include a vinyl group, an allyl group, a vinylphenyl group, a (meth)acryloyl group, a maleimide group, and a (meth)acrylamide group.

Among these, a (meth)acryloyl group, a (meth)acrylamide group, or a vinylphenyl group is preferable, and from the viewpoint of reactivity, a (meth)acryloyl group is more preferable.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

From the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, where esters between unsaturated carboxylic acids and polyhydric alcohol compounds or amides between unsaturated carboxylic acids and polyvalent amine compounds are preferable. **In** addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic

acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogeno group or a tosyloxy group, with monofunctional or polyfunctional alcohols, amines, or thiols is also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

The radical crosslinking agent is also preferably a compound having a boiling point of 100°C or higher under normal pressure. Examples of the compound having a boiling point of 100°C or higher under normal pressure include the compounds described in paragraph 0203 of WO2021/112189A. The content thereof is incorporated in the present specification.

Examples of the preferred radical crosslinking agent other than those described above include the radically polymerizable compounds described in paragraphs 0204 to 0208 of WO2021/112189A. The content thereof is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of a commercially available product of the radical crosslinking agent include SR-494 which is a tetrafunctional acrylate having four ethyleneoxy chains, SR-209, 205, 214, 231, and 239 which are difunctional methacrylates having four ethyleneoxy chains, SR-268, 213, 230, 238F, 272, 306H, and 508 which are difunctional methacrylates having four ethyleneoxy chains (all of which are manufactured by Sartomer Company Inc.), TPGDA, DPGDA, and HDDA (all of which are manufactured by Daicel-Allnex Ltd.), DPCA-60 which is a hexafunctional acrylate having six pentyleneoxy chains, and TPA-330 which is a trifunctional acrylate having three isobutyleneoxy chains (both of which are manufactured by Nippon Kayaku Co., Ltd.), UAS-10 and UAB-140 which are urethane oligomers (both of which are manufactured by Nippon Paper Industries Co., Ltd.), NK ESTER M-40G, NK ESTER 4G, NK ESTER M-9300, NK ESTER A-9300, and UA-7200 (all of which are manufactured by Shin-Nakamura Chemical Co., Ltd.), DPHA-40H (manufactured by Nippon Kayaku Co., Ltd.), UA-306H, UA-306T, UA-306I, AH-600, T-600, AI-600, LIGHT ESTER 3EG, LIGHT ESTER NP, LIGHT ESTER 1.6HX, and LIGHT ESTER 1.9ND (all of which are manufactured by KYOEISHA CHEMICAL Co., Ltd.), and BLEMMER PME-400 and PDE-200, 400 (all of which are manufactured by NOF Corporation).

As the radical crosslinking agent, the urethane acrylates as described in JP1973-041708B (JP-S48-041708B), JP1976-037193A(JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. As the radical crosslinking agent, the compounds having an amino structure or a sulfide structure in the molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester between an aliphatic polyhydroxy compound and an unsaturated carboxylic acid and more preferably a radical crosslinking agent obtained by reacting an unreacted hydroxy group of an aliphatic polyhydroxy compound with a nonaromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a nonaromatic carboxylic acid anhydride. Examples of the commercially available product thereof include M-510 and M-520 as polybasic acid-modified acrylic oligomers which are manufactured by Toagosei Co., Ltd.

An acid value of the radical crosslinking agent having an acid group is preferably 0.1 to 300 mgKOH/g and more preferably 1 to 100 mgKOH/g. In a case where the acid value of the radical crosslinking agent is within the above-described range, excellent manufacturing handleability is exhibited, and excellent developability is exhibited. In addition, good polymerization properties are exhibited. The acid value is measured in accordance with the description of JIS K 0070: 1992.

The radical crosslinking agent is also preferably a radical crosslinking agent having at least one selected from the

group consisting of a urea bond and a urethane bond (hereinafter, also referred to as a "crosslinking agent U").

In the present invention, the urea bond is a bond represented by *-$NR^N$-C(=O)-$NR^N$-*, where $R^N$'s each independently represent a hydrogen atom or a monovalent organic group, and *'s each represent a bonding site to a carbon atom.

In the present invention, the urethane bond is a bond represented by *-O-C(=O)-$NR^N$-*, where $R^N$ represents a hydrogen atom or a monovalent organic group, and *'s each represent a bonding site to a carbon atom.

In a case where the resin composition contains a crosslinking agent U, chemical resistance, resolution, and the like may be improved.

The mechanism by which the above-described effect is obtained is not revealed; however, it is considered that, for example, a part of the crosslinking agent U undergoes thermal decomposition during curing by heating or the like to generate an amine or the like, and the amine or the like accelerates the cyclization of the precursor of the cyclization resin such as the polyimide precursor.

The crosslinking agent U may have only one urea bond or urethane bond, may have one or more urea bonds and one or more urethane bonds, may have two or more urea bonds without having a urethane bond, or may have two or more urethane bonds without having a urea bond.

The total number of urea bonds and urethane bonds in the crosslinking agent U is 1 or more, and it is preferably 1 to 10, more preferably 1 to 4, and still more preferably 1 or 2.

In a case where the crosslinking agent U does not have a urethane bond, the number of urea bonds in the crosslinking agent U is 1 or more, and it is preferably 1 to 10, more preferably 1 to 4, and still more preferably 1 or 2.

In a case where the crosslinking agent U does not have a urea bond, the number of urethane bonds in the crosslinking agent U is 1 or more, and it is preferably 1 to 10, more preferably 1 to 4, and still more preferably 1 or 2.

The radically polymerizable group in the crosslinking agent U is not particularly limited; however, examples thereof include a vinyl group, an allyl group, a (meth)acryloyl group, a (meth)acryloxy group, a (meth)acrylamide group, a vinylphenyl group, and a maleimide group, where a (meth)acryloxy group, a (meth)acrylamide group, a vinylphenyl group, or a maleimide group is preferable, and a (meth)acryloxy group is more preferable.

In a case where the crosslinking agent U has two or more radically polymerizable groups, the structures of the respective radically polymerizable groups may be the same or different from each other.

The number of radically polymerizable groups in the crosslinking agent U may be only one or may be two or more, and it is preferably 1 to 10, more preferably 1 to 6, and particularly preferably 1 to 4.

The radically polymerizable group value (the mass of the compound per 1 mol of the radically polymerizable group) in the crosslinking agent U is preferably 150 to 400 g/mol.

From the viewpoint of the chemical resistance of the cured substance, the lower limit of the above-described radically polymerizable group value is more preferably 200 g/mol or more, still more preferably 210 g/mol or more, even more preferably 220 g/mol or more, even still more preferably 230 g/mol or more, even still more preferably 240 g/mol or more, and particularly preferably 250 g/mol or more.

From the viewpoint of developability, the upper limit of the above-described radically polymerizable group value is more preferably 350 g/mol or less, still more preferably 330 g/mol or less, and particularly preferably 300 g/mol or less.

Among the above, the polymerizable group value of the crosslinking agent U is preferably 210 to 400 g/mol and more preferably 220 to 400 g/mol.

The crosslinking agent U has preferably, for example, a structure represented by Formula (U-1).

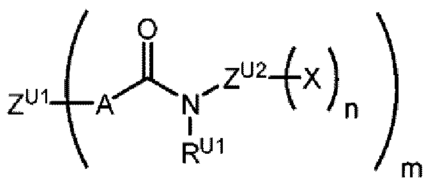

(U-1)

In Formula (U-1), $R^{U1}$ is a hydrogen atom or a monovalent organic group, A is -O-, or - $NR^N$-, $R^N$ is a hydrogen atom or a monovalent organic group, $Z^{U1}$ is an m-valent organic group, $Z^{U2}$ is an (n+1)-valent organic group, X is a radically polymerizable group, n is an integer of 1 or more, and m is an integer of 1 or more.

$R^{U1}$ is preferably a hydrogen atom, an alkyl group, or an aromatic hydrocarbon group, and more preferably a hydrogen atom.

$R^N$ is preferably a hydrogen atom, an alkyl group, or an aromatic hydrocarbon group, and more preferably a hydrogen atom.

$Z^{U1}$ is preferably a hydrocarbon group, -O-, -C(=O)-, -S-, $-S(=O)_2-$, -$NR^N$-, or a group in which two or more of these are bonded, and more preferably a hydrocarbon group or a group in which a hydrocarbon group is bonded to at least one group selected from the group consisting of -O-, -C(=O)-, -S-, $-S(=O)_2-$, and -$NR^N$-.

As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. Examples of the above-described hydrocarbon group include a saturated aliphatic hydrocarbon group, an aromatic hydrocarbon group, and a group obtained by bonding of these groups. $R^N$ represents a hydrogen atom or a monovalent organic group, and it is preferably a hydrogen atom or a hydrocarbon group, more preferably a hydrogen atom or an alkyl group, and still more preferably a hydrogen atom or a methyl group.

$Z^{U2}$ is preferably a hydrocarbon group, -O-, -C(=O)-, -S-, $-S(=O)_2-$, $-NR^N-$, or a group in which two or more of these are bonded, and more preferably a hydrocarbon group or a group in which a hydrocarbon group is bonded to at least one group selected from the group consisting of -O-, -C(=O)-, -S-, $-S(=O)_2-$, and $-NR^N-$.

Examples of the hydrocarbon group include the same ones as those exemplified as $Z^{U1}$, and the same applies to the preferred aspect thereof.

X is not particularly limited; however, examples thereof include a vinyl group, an allyl group, a (meth)acryloyl group, a (meth)acryloxy group, a (meth)acrylamide group, a vinylphenyl group, and a maleimide group, where a (meth) acryloxy group, a (meth)acrylamide group, a vinylphenyl group, or a maleimide group is preferable, and a (meth)acryloxy group is more preferable.

n is preferably an integer of 1 to 10, more preferably an integer of 1 to 4, still more preferably 1 or 2, and particularly preferably 1.

m is preferably an integer of 1 to 10, more preferably an integer of 1 to 4, and still more preferably 1 or 2.

It is also preferable that the crosslinking agent U has at least one of a hydroxy group, an alkyleneoxy group, an amide group, or a cyano group.

From the viewpoint of the chemical resistance of the cured film to be obtained, the hydroxy group may be an alcoholic hydroxy group or a phenolic hydroxy group; however, it is preferably an alcoholic hydroxy group.

From the viewpoint of the chemical resistance of the cured film to be obtained, the alkyleneoxy group is preferably an alkyleneoxy group having 2 to 20 carbon atoms, more preferably an alkyleneoxy group having 2 to 10 carbon atoms, still more preferably an alkyleneoxy group having 2 to 4 carbon atoms, even still more preferably an ethylene group or a propylene group, and particularly preferably an ethylene group.

The alkyleneoxy group may be contained in the crosslinking agent U as a polyalkyleneoxy group. The number of repetitions of the alkyleneoxy group in this case is preferably 2 to 10 and more preferably 2 to 6.

The amide group refers to a bond represented by $-C(=O)-NR^N-$. $R^N$ is as described above. In a case where the crosslinking agent U has an amide group, the crosslinking agent U can include, for example, a group represented by $R-C(=O)-NR^N-*$ or a group represented by $*-C(=O)-NR^N-R$. R represents a hydrogen atom or a monovalent substituent, and it is preferably a hydrogen atom or a hydrocarbon group and more preferably a hydrogen atom, an alkyl group, or an aromatic hydrocarbon group.

The crosslinking agent U may have, in the molecule, two or more structures selected from the group consisting of a hydroxy group, an alkyleneoxy group (however, a polyalkyleneoxy group in a case of constituting a polyalkyleneoxy group), an amide group, and a cyano group; however, an aspect in which only one structure is contained in the molecule is also preferable.

The hydroxy group, the alkyleneoxy group, the amide group, and the cyano group may be present at any position of the crosslinking agent U. However, from the viewpoint of chemical resistance, it is also preferable that the crosslinking agent U is such that at least one selected from the group consisting of the hydroxy group, the alkyleneoxy group, the amide group, and the cyano group, and at least one radically polymerizable group contained in the crosslinking agent U are linked by a linking group (hereinafter, also referred to as a "linking group L2-1") containing a urea bond or a urethane bond.

In particular, in a case where the crosslinking agent U contains only one radically polymerizable group, it is preferable that the radically polymerizable group contained in the crosslinking agent U and at least one selected from the group consisting of a hydroxy group, an alkyleneoxy group, an amide group, and a cyano group are linked by a linking group including a urea bond or a urethane bond (hereinafter, also referred to as a "linking group L2-2").

In a case where the crosslinking agent U contains an alkyleneoxy group (however, a polyalkyleneoxy group in a case of constituting a polyalkyleneoxy group) and has the above-described linking group L2-1 or the above-described linking group L2-2, a structure that is bonded to a side of the alkyleneoxy group (however, a polyalkyleneoxy group in a case of constituting a polyalkyleneoxy group) opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. Examples of the above-described hydrocarbon group include a saturated aliphatic hydrocarbon group, an aromatic hydrocarbon group, and a group obtained by bonding of these groups. In addition, the preferred aspect of the radically polymerizable group is the same as the preferred aspect of the radically polymerizable group in the above-described crosslinking agent U.

In a case where the crosslinking agent U contains an amide group and has the linking group L2-1 or the linking

group L2-2, a structure that is bonded to a side of the amide group opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. In addition, examples of the above-described hydrocarbon group include a saturated aliphatic hydrocarbon group, an aromatic hydrocarbon group, and a group obtained by bonding of these groups. The preferred aspect of the radically polymerizable group is the same as the preferred aspect of the radically polymerizable group in the above-described crosslinking agent U. In addition, in the above aspect, a carbon atom side of the amide group may be bonded to the linking group L2-1 or the linking group L2-2, or a nitrogen atom side of the amide group may be bonded to the linking group L2-1 or the linking group L2-2.

Among these, from the viewpoint of the adhesiveness to the base material, the chemical resistance, and the Cu void suppression, the crosslinking agent U preferably has a hydroxy group.

From the viewpoint of the compatibility with the specific resin and the like, the crosslinking agent U preferably contains an aromatic group.

The aromatic group is preferably directly bonded to a urea bond or a urethane bond contained in the crosslinking agent U. In a case where the crosslinking agent U contains two or more urea bonds or two or more urethane bonds, it is preferable that one of the urea bonds or urethane bonds is directly bonded to the aromatic group.

The aromatic group may be an aromatic hydrocarbon group or an aromatic heterocyclic group and may have a structure in which these groups form a fused ring; however, an aromatic hydrocarbon group is preferable.

The aromatic hydrocarbon group is preferably an aromatic hydrocarbon group having 6 to 30 carbon atoms, more preferably an aromatic hydrocarbon group having 6 to 20 carbon atoms, and still more preferably a group obtained by removing two or more hydrogen atoms from a benzene ring structure.

The aromatic heterocyclic group is preferably a 5-membered or 6-membered aromatic heterocyclic group. Examples of the aromatic heterocyclic ring in such an aromatic heterocyclic group include pyrrole, imidazole, triazole, tetrazole, pyrazole, furan, thiophene, oxazole, isoxazole, thiazole, pyridine, pyrazine, pyrimidine, pyridazine, and triazine. These rings may be further fused with another ring, for example, as in the case of indole or benzimidazole.

The heteroatom contained in the aromatic heterocyclic group is preferably a nitrogen atom, an oxygen atom, or a sulfur atom.

It is preferable that the aromatic group is included in, for example, a linking group that links two or more radically polymerizable groups and links a linking group having a urea bond or a urethane bond, or at least one selected from the group consisting of a hydroxy group, an alkyleneoxy group, an amide group, and a cyano group, to at least one radically polymerizable group contained in the crosslinking agent U.

The number of atoms (linking chain length) between the urea bond or urethane bond and the radically polymerizable group in the crosslinking agent U is not particularly limited; however, it is preferably 30 or less, more preferably 2 to 20, and still more preferably 2 to 10.

In a case where the crosslinking agent U contains two or more urea bonds or urethane bonds in total, the minimum number of atoms (linking chain length) between the urea bond or urethane bond and the radically polymerizable group is sufficient to be within the above-described range in a case where the crosslinking agent U contains two or more radically polymerizable groups, or in a case where the crosslinking agent U contains two or more urea bonds or two or more urethane bonds and two or more radically polymerizable groups.

In the present specification, the phrase "number of atoms (linking chain length) between the urea bond or urethane bond and the polymerizable group" refers to the smallest number of atoms (minimum number of atoms) for linking targets among the number of atoms for atomic chains on a path that links two atoms or atomic groups between the linking targets. For example, in a structure represented by the following Formula, the number of atoms (linking chain length) between the urea bond and the radically polymerizable group (methacryloyloxy group) is 2.

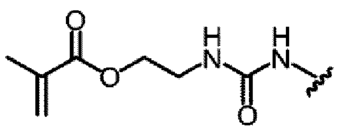

[Symmetry axis]

It is also preferable that the crosslinking agent U is a compound having a structure which does not have a symmetry axis.

The fact that the crosslinking agent U does not have a symmetry axis refers to that the crosslinking agent U is a left-right asymmetric compound which does not have an axis that generates the same molecule as the original molecule in a case where the entire compound is rotated. In addition, in a case where the structural formula of the crosslinking agent U

is shown on the paper surface, the fact that the crosslinking agent U does not have a symmetry axis refers to that the structural formula of the crosslinking agent U cannot be shown in a form having a symmetry axis.

It is considered that the aggregation of the crosslinking agents U is suppressed in the composition film in a case where the crosslinking agent U does not have a symmetry axis.

[Molecular weight]

The molecular weight of the crosslinking agent U is preferably 100 to 2,000, preferably 150 to 1,500, and more preferably 200 to 900.

A manufacturing method for the crosslinking agent U is not particularly limited; however, the crosslinking agent U can be obtained, for example, by reacting a radically polymerizable compound with a compound having an isocyanate group and a compound having at least one of a hydroxy group or an amino group.

Specific examples of the crosslinking agent U are shown below; however, the crosslinking agent U is not limited thereto.

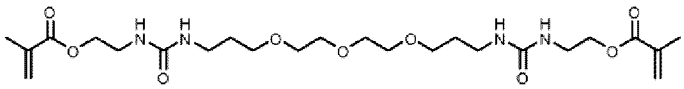

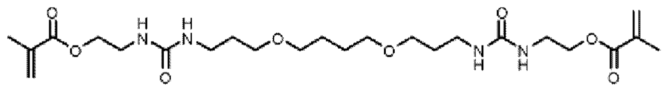

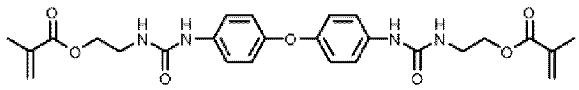

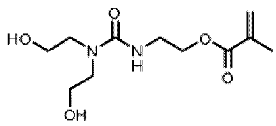
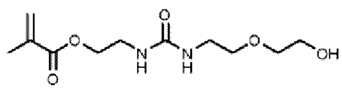

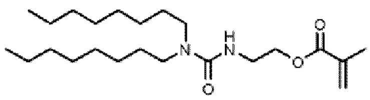
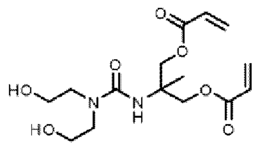

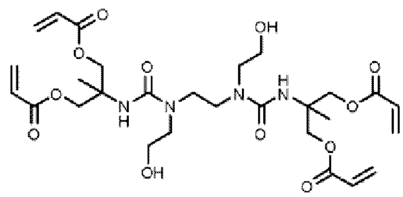

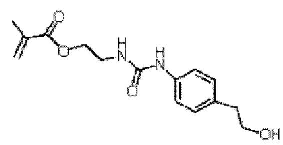
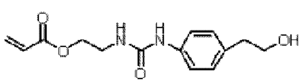

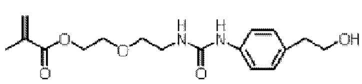
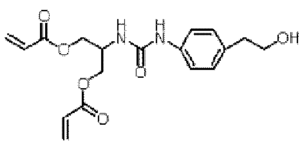

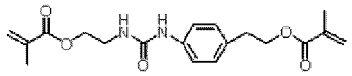

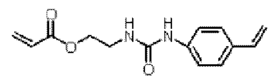

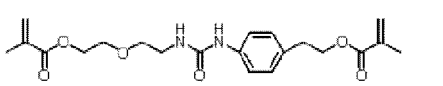

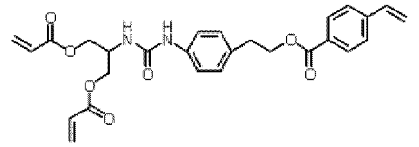

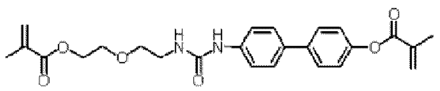

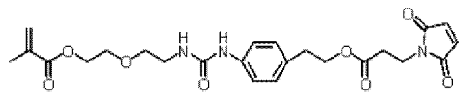

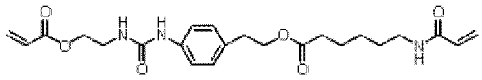

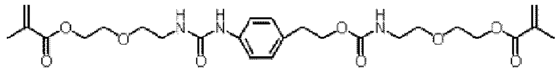

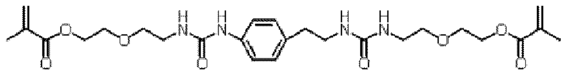

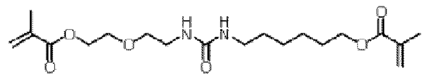

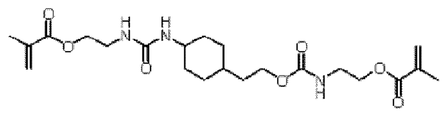

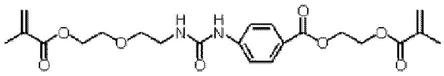

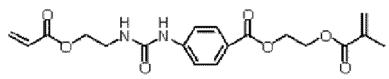

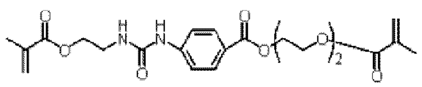

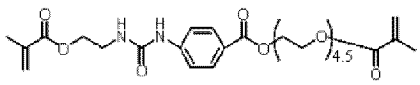

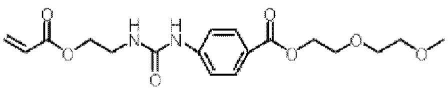

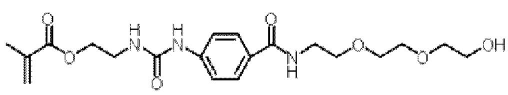

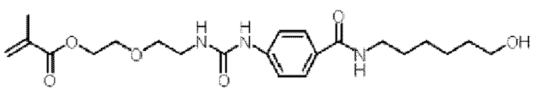

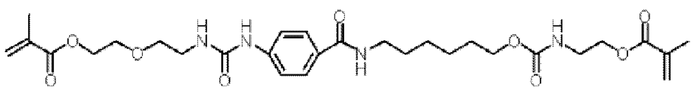

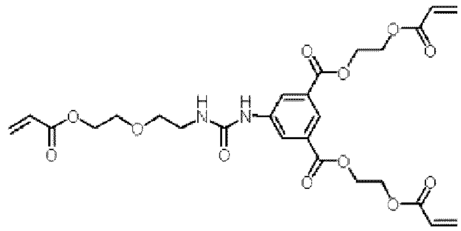

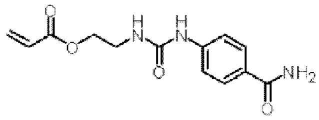

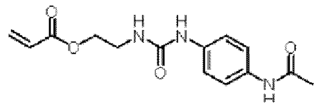

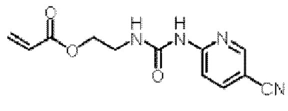

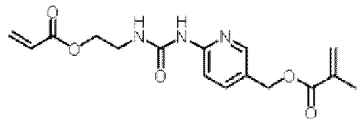

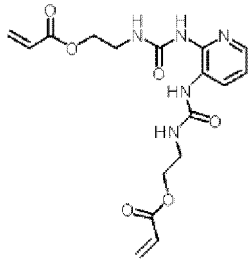

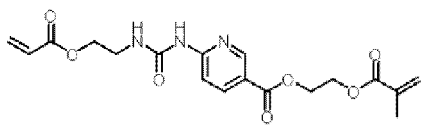

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, and polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, neopentyl glycol diacrylate, neopentyl glycol dimethacrylate, 3-methyl-1, 5-pentanediol diacrylate, 1,6-hexanediol diacrylate, 1,6-hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain Formula weight of about 200.

In the photocurable resin composition according to the embodiment of the present invention, a monofunctional radical crosslinking agent can be preferably used as the radical crosslinking agent from the viewpoint of suppressing the warping of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate; butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under normal pressure is also preferable in order to suppress volatilization before exposure.

In addition, examples of the bi- or higher functional radical crosslinking agent include allyl compounds such as diallyl phthalate and triallyl trimellitate.

In a case where a radical crosslinking agent is contained, the content of the radical crosslinking agent is preferably more than 0% by mass and 60% by mass or less with respect to the total solid content of the resin composition. The lower limit thereof is more preferably 5% by mass or more. The upper limit thereof is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

<Another crosslinking agent>

The photocurable resin composition according to the embodiment of the present invention also preferably contains another crosslinking agent different from the radical crosslinking agent described above.

The other crosslinking agent refers to a crosslinking agent other than the above-described radical crosslinking agent, where it is preferably a compound having a plurality of groups, in the molecule, which accelerates a reaction of forming a covalent bond between other compounds in the composition or reaction products thereof, by the photosensitization of the above-described photoacid generator photobase generator, and it is preferably a compound having a plurality of groups, in the molecule, which accelerates a reaction of forming a covalent bond between other compounds in the composition or reaction products thereof, by the action of the acid or the base.

The acid or the base is preferably an acid or a base, which is generated from a photoacid generator or a photobase generator in the exposure step.

The other crosslinking agent is preferably a compound having at least one group selected from the group consisting of an acyloxymethyl group, a methylol group, an ethylol group, and an alkoxymethyl group, and more preferably a compound having a structure in which at least one group selected from the group consisting of an acyloxymethyl group, a methylol group, an ethylol group, and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with an acyloxymethyl group, a methylol group, an ethylol group, or an alkoxymethyl group. The production method for these compounds is not particularly limited, and any compound having the same structure as the compound produced by the above method may be used. Oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, preferably 2 or 3 carbon atoms, and more preferably 2 carbon atoms.

The total number of alkoxymethyl groups and acyloxymethyl groups which are contained in the above compound is preferably 1 to 10, more preferably 2 to 8, and particularly preferably 3 to 6.

The molecular weight of the above compound is preferably 1500 or less, and more preferably 180 to 1200.

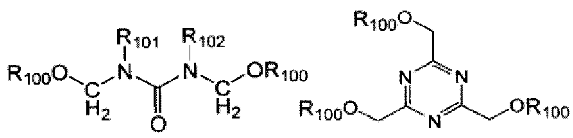

$R_{100}$ represents an alkyl group or an acyl group.

$R_{101}$ and $R_{102}$ each independently represent a monovalent organic group, and they may be bonded to each other to form a ring.

Examples of the compound in which an alkoxymethyl group or an acyloxymethyl group is directly substituted on an aromatic group include compounds such as those represented by the following general Formulae.

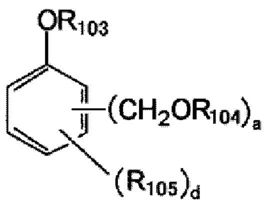

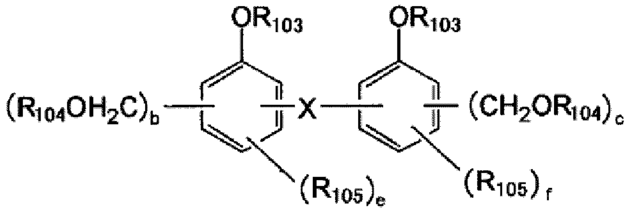

In Formula, X represents a single-bonded or divalent organic group, each $R_{104}$ independently represents an alkyl or acyl group, and $R_{103}$ represents a hydrogen atom, an alkyl group, an alkenyl group, an aryl group, an aralkyl group, or a group that decomposes under the action of acid and generates an alkali-soluble group (for example, a group that is eliminated by under the action of acid, a group represented by $-C(R^4)_2COOR^5$ (each $R^4$ independently represents a hydrogen atom or an alkyl group having 1 to 4 carbon atoms, and $R^5$ represents a group eliminated under the action of acid)).

Each $R_{105}$ independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less.

Examples of $R^5$ in the group that decomposes under the action of an acid to generate an alkali-soluble group, a group that is eliminated under the action of acid, and a group represented by $-C(R^4)_2COOR^5$, include $-C(R_{36})(R_{37})(R_{38})$, $-C(R_{36})(R_{37})(OR_{39})$, and - $C(R_{01})(R_{02})(OR_{39})$.

In Formulae, $R_{36}$ to $R_{39}$ each independently represent an alkyl group, a cycloalkyl group, an aryl group, an aralkyl group, or an alkenyl group. $R_{36}$ and $R_{37}$ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

These groups may further have a publicly known substituent.

$R_{01}$ and $R_{02}$ each independently represent a hydrogen atom, an alkyl group, a cycloalkyl group, an aryl group, an aralkyl group, or an alkenyl group.

The group that decomposes under the action of an acid to generate an alkali-soluble group or the group that is eliminated under the action of an acid is preferably a tertiary alkyl ester group, an acetal group, a cumyl ester group, an enol ester group, or the like. It is more preferably a tertiary alkyl ester group or an acetal group.

In addition, a compound having at least one group selected from the group consisting of a urea bond and a urethane bond is also preferable as the compound having at least one group selected from the group consisting of an acyloxymethyl group, a methylol group, an ethylol group, and an alkoxymethyl group. A preferred aspect of the above compound is the same as the preferred aspect of the crosslinking agent U described above, except that the polymerizable group is not a radically polymerizable group but at least one group selected from the group consisting of an acyloxymethyl group, a methylol group, an ethylol group, and an alkoxymethyl group.

Specific examples of the compound having at least one group selected from the group consisting of an acyloxymethyl group, a methylol group, and an ethylol group include the following structures. Examples of the compound having an acyloxymethyl group include compounds in which the alkoxymethyl group of the following compounds is changed to an acyloxymethyl group. Examples of the compound having an alkoxymethyl group or an acyloxymethyl group in the molecule include such compounds as follows; however, the compound is not limited thereto.

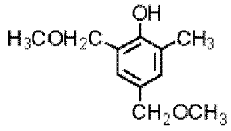 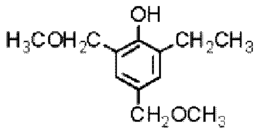 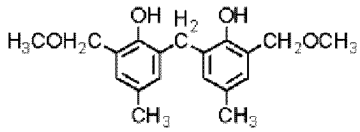

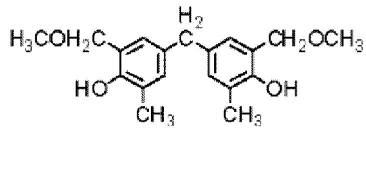 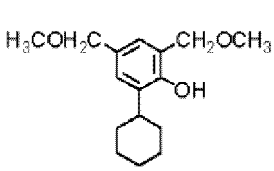 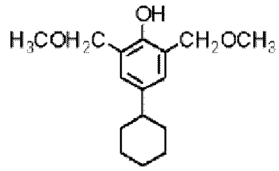

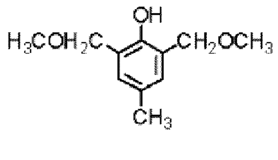 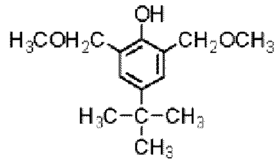 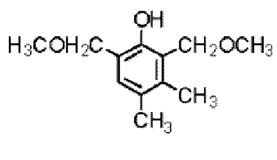

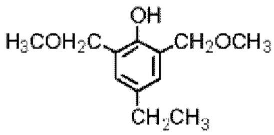 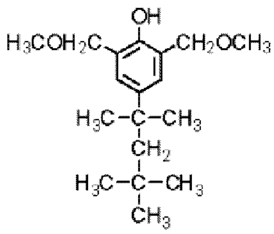 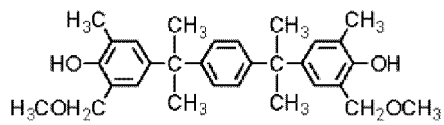

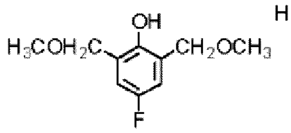 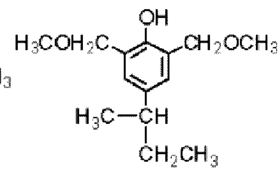 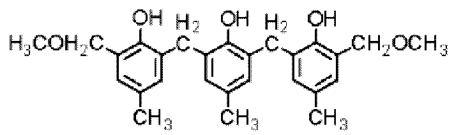

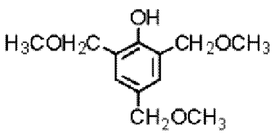 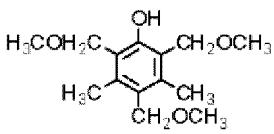 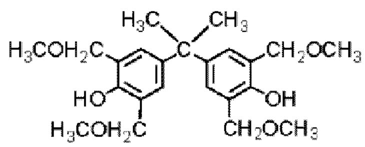

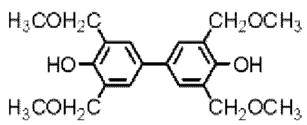 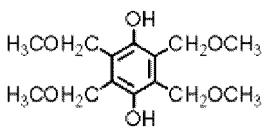 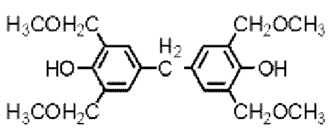

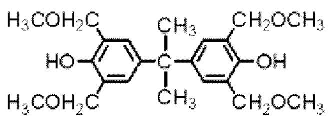 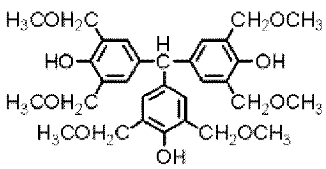 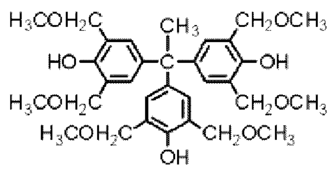

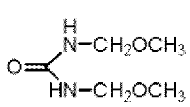 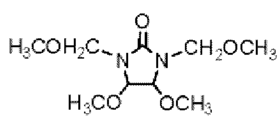 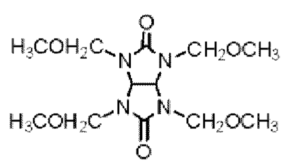

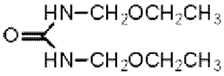
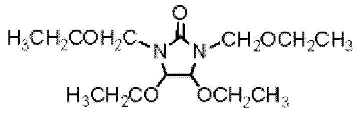
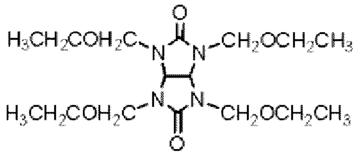

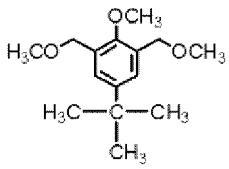
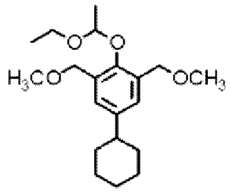
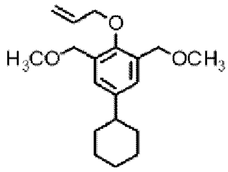
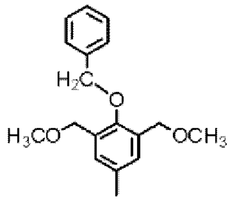

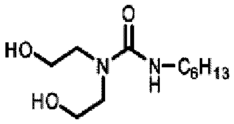
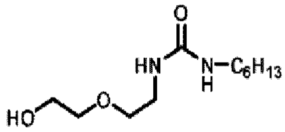
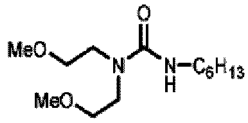

As the compound containing at least one of an alkoxymethyl group or an acyloxymethyl group, a commercially available compound may be used, or a compound synthesized by a publicly known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monoethoxymethylated glycoluril, diethoxymethylated glycoluril, triethoxymethylated glycoluril, tetramethoxymethylated glycoluril, monomethoxymethylated glycoluril, dimethoxymethylated glycoluril, trimethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril, and urea-based crosslinking agents such as bismethoxymethylurea, biseethoxymethylurea, bispropoxymethylurea, and bisbutoxymethylurea,
ethylene urea-based crosslinking agents such as monohydroxymethylated ethylene urea or dihydroxymethylated ethylene urea, monoethoxymethylated ethylene urea, diethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, or dibutoxymethylated ethylene urea, propylene urea-based crosslinking agents such as monohydroxymethylated propylene urea, dihydroxymethylated propylene urea, monoethoxymethylated propylene urea, diethoxymethylated propylene urea, monoethoxymethylated propylene urea, diethoxymethylated propylene urea, monopropoxymethylated propylene urea, dipropoxymethylated propylene urea, monobutoxymethylated propylene urea, or dibutoxymethylated propylene urea, and 1,3-di(methoxymethyl)-4,5-dihydroxy-2-imidazolidinone, 1,3-di(methoxymethyl)-4,5-dimethoxy-2-imidazolidinone, and the like.

Specific examples of the benzoguanamine-based crosslinking agent include monohydroxymethylated benzoguanamine, dihydroxymethylated benzoguanamine, trihydroxymethylated benzoguanamine, tetrahydroxymethylated benzoguanamine, monomethoxymethylated benzoguanamine, dimethoxymethylated benzoguanamine, trimethoxymethylated benzoguanamine, tetramethoxymethylated benzoguanamine, monoethoxymethylated benzoguanamine, diethoxymethylated benzoguanamine, triethoxymethylated benzoguanamine, tetraethoxymethylated benzoguanamine, monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether,

bis(methoxymethyl)benzophenone, methoxymethylphenyl methoxymethylbenzoate, bis(methoxymethyl)biphenyl, dimethylbis(methoxymethyl)biphenyl, 4,4',4"-ethylidenetris[2,6-bis(methoxymethyl)phenol], 5,5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all of which are manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DMLBisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all of which are manufactured by Honshu Chemical Industry Co., Ltd.), and NIKALAC (registered trademark, the same applies hereinafter) MX-290, NIKALAC MX-280, NIKALAC MX-270, NIKALAC MX-279, NIKALAC MW-100LM, and NIKALAC MX-750LM (all of which are manufactured by Sanwa Chemical Co., Ltd.).

The resin composition according to the embodiment of the present invention preferably contains, as the other crosslinking agent, at least one compound selected from the group consisting of an epoxy compound, an oxetane compound, and a benzoxazine compound.

- Epoxy compound (compound having epoxy group) -

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the resin composition and the suppression of warping.

The epoxy compound preferably contains a polyethylene oxide group. This makes it possible to further reduce the elastic modulus and suppress the warpage. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trademark, the same applies hereinafter) 850-S, EPICLON HP-4032, EPICLON HP-7200, EPICLON HP-820, EPICLON HP-4700, EPICLON HP-4770, EPICLON EXA-830LVP, EPICLON EXA-8183, EPICLON EXA-8169, EPICLON N-660, EPICLON N-665-EXP-S, and EPICLON N-740 (all of which are trade names, manufactured by DIC Corporation), RIKARESIN (registered trademark, the same applies hereinafter) BEO-20E, RIKARESIN BEO-60E, RIKARESIN HBE-100, RIKARESIN DME-100, and RIKARESIN L-200 (all of which are trade names, manufactured by New Japan Chemical Co., Ltd.), EP-4003S, EP-4000S, EP-4088S, and EP-3950S (all of which are trade names, manufactured by ADEKA Corporation), CELLOXIDE (registered trademark, the same applies hereinafter) 2021P, CELLOXIDE 2081, CELLOXIDE 2000, EHPE3150, EPOLEAD (registered trademark, the same applies hereinafter) GT401, EPOLEAD PB4700, and EPOLEAD PB3600 (all of which are trade names, manufactured by Daicel Corporation), and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BRENS, and BREN-10S (all of which are trade names, manufactured by Nippon Kayaku Co., Ltd.). In addition, the following compounds are also suitably used.

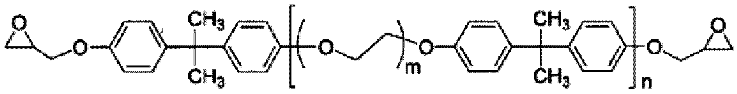

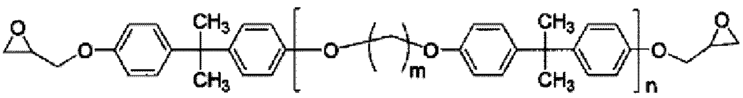

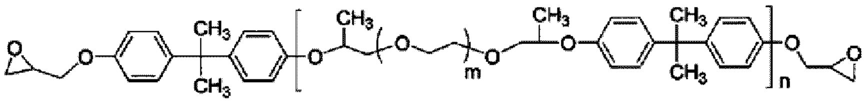

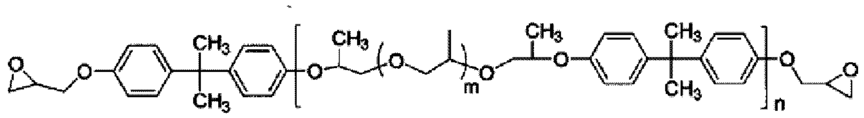

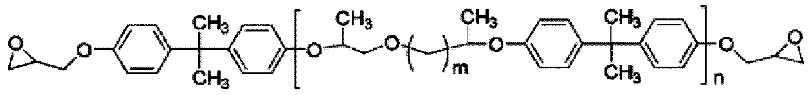

In Formulae, n is an integer of 1 to 5, and m is an integer of 1 to 20.

Among the above structures, n is preferably 1 to 2, and m is preferably 3 to 7 from the viewpoint of achieving both heat resistance and improvement in elongation.

- Oxetane compound (compound having oxetanyl group) -

Examples of the oxetane compound include a compound having two or more oxetane rings in one molecule, 3-ethyl-3-hydroxymethyloxetane, 1,4-bis{[(3-ethyl-3-oxetanyl)methoxy]methyl}benzene, 3-ethyl-3-(2-ethylhexylmethyl) oxetane, and 1,4-benzenedicarboxylic acid-bis[(3-ethyl-3-oxetanyl)methyl]ester. As specific examples thereof, the ARON OXETANE series (for example, OXT-121 and OXT-221) manufactured by Toagosei Co., Ltd., can be suitably used, and these can be used alone or two or more thereof may be mixedly used.

- Benzoxazine compound (compound having benzoxazolyl group) -

Due to a crosslinking reaction derived from a ring-opening addition reaction, the benzoxazine compound does not result in degassing during curing and results in decreased thermal contraction, and thus the occurrence of warping is suppressed, which is preferable.

Preferred examples of the benzoxazine compound include P-d type benzoxazine, F-a type benzoxazine (trade names, all of which are manufactured by Shikoku Chemicals Corporation), a benzoxazine adduct of polyhydroxystyrene resin, and a phenol novolac type dihydrobenzoxazine compound. These may be used alone, or two or more thereof may be mixed and used.

The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the resin composition. One kind of the other crosslinking agent may be contained, or two or more kinds thereof may be contained. In a case where two or more kinds of the other crosslinking agents are contained, the total thereof is preferably within the above-described range.

<(C) Photopolymerization Initiator>

The resin composition according to the embodiment of the present invention contains (C) photopolymerization initiator (also simply referred to as "photopolymerization initiator").

The photopolymerization initiator is preferably a photoradical polymerization initiator. The photoradical polymerization initiator is not particularly limited and can be appropriately selected from publicly known photoradical polymerization initiators. For example, a photoradical polymerization initiator having photosensitivity to rays ranging from the ultraviolet ray range to the visible light range is preferable. In addition, it may be an activator that acts with a sensitizing agent to generate an active radical.

The photoradical polymerization initiator preferably contains at least one compound having a molar absorption coefficient of at least about 50 $L \cdot mol^{-1} \cdot cm^{-1}$ within a range of a wavelength of about 240 to 800 nm (preferably 330 to 500 nm). The molar absorption coefficient of a compound can be measured using a well-publicly known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-publicly known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an

acylphosphine oxide, hexaarylbiimidazole, an oxime compound such as an oxime derivative, an organic peroxide, a thio compound, a ketone compound, an aromatic onium salt, a keto oxime ether, an α-amino ketone compound such as aminoacetophenone, an α-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 of WO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313A, the contents of which are incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodiment of the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in the present specification.

As the α-hydroxy ketone-based initiator, Omnirad 184, Omnirad 1173, Omnirad 2959, Omnirad 127 (all of which manufactured by IGM Resins B.V), IRGACURE 184 (IRGACURE is a registered trademark), DAROCUR 1173, IRGACURE 500, IRGACURE-2959, and IRGACURE 127 (all of which manufactured by BASF SE) can be used.

As the α-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (all of which are manufactured by BASF SE) can be used.

As the aminoacetophenone-based initiator, the acylphosphine oxide-based initiator, and the metallocene compound, it is also possible to suitably use, for example, the compounds described in paragraphs 0161 to 0163 of WO2021/112189A. The content thereof is incorporated in the present specification.

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, and the compounds described in WO2013/167515A, the content of which is incorporated in the present specification.

Examples of the preferred oxime compound include compounds having the following structures, 3-(benzoyloxy(imino))butan-2-one, 3-(acetoxy(imino))butan-2-one, 3-(propionyloxy(imino))butan-2-one, 2-(acetoxy(imino))pentan-3-one, 2-(acetoxy(imino))-1-phenylpropan-1-one, 2-(benzoyloxy(imino))-1-phenylpropan-1-one, 3-((4-toluenesulfonyloxy)imino)butan-2-one, and 2-(ethoxycarbonyloxy(imino))-1-phenylpropan-1-one. In the resin composition, it is preferable to use an oxime compound, particularly as a photoradical polymerization initiator. The oxime compound as a photoradical polymerization initiator has a linking group of >C=N-O-C(=O)- in the molecule.

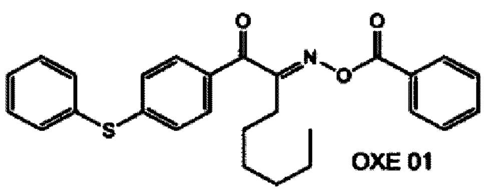
OXE 01
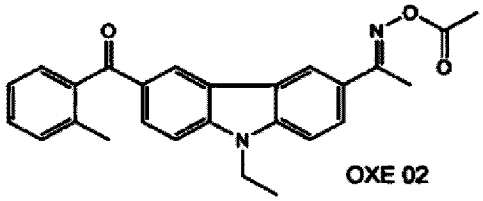
OXE 02

Examples of the commercially available product of the oxime compound include IRGACURE OXE 01, IRGACURE OXE 02, IRGACURE OXE 03, and IRGACURE OXE 04 (all of which are manufactured by BASF SE), ADEKA OPTOMER N-1919 (manufactured by ADEKA Corporation, the photoradical polymerization initiator 2 described in JP2012-014052A), TR-PBG-304 and TR-PBG-305 (all of which are manufactured by Changzhou Tronly New Electronic Materials Co., Ltd.), ADEKAARKLS NCI-730, NCI-831, and ADEKA ARKLS NCI-930 (all of which are manufactured by ADEKA Corporation), DFI-091 (manufactured by DAITO CHEMIX Co., Ltd.), and SpeedCure PDO (manufactured by SARTOMER ARKEMA). In addition, oxime compounds having the following structures can also be used.

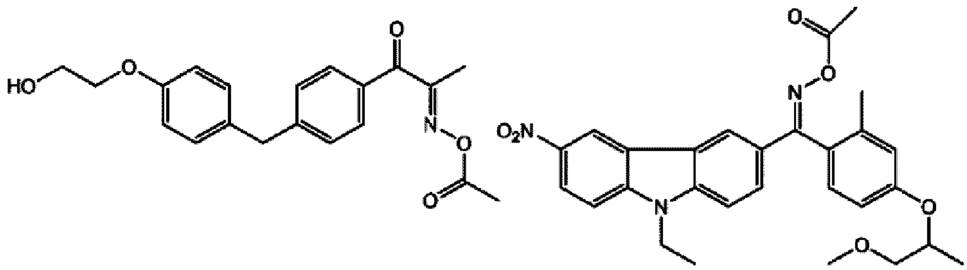

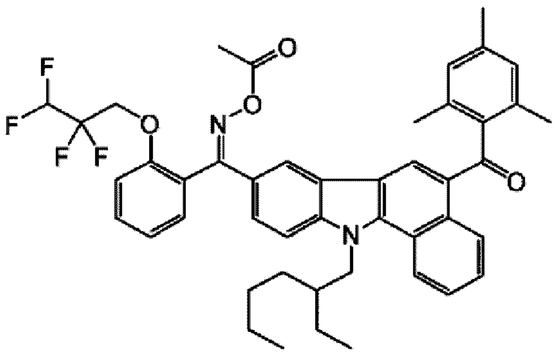

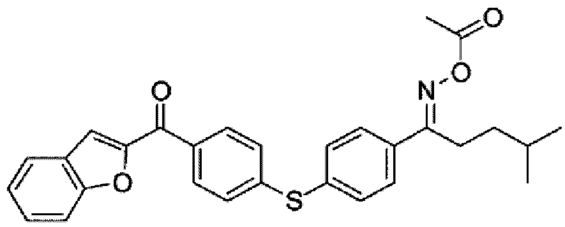

As the photoradical polymerization initiator, it is also possible to use, for example, the oxime compounds having a fluorene ring, which are described in paragraphs 0169 to 0171 of WO2021/112189A, an oxime compound having a skeleton in which at least one benzene ring of a carbazole ring is a naphthalene ring, or an oxime compound having a fluorine atom.

In addition, it is also possible to use the oxime compounds having a nitro group, which are described in paragraphs 0208 to 0210 of WO2021/020359A, an oxime compound having a benzofuran skeleton, or an oxime compound in which a substituent having a hydroxy group is bonded to a carbazole skeleton. The content thereof is incorporated in the present specification.

As the photopolymerization initiator, an oxime compound having an aromatic ring group $Ar^{OX1}$ in which an electron withdrawing group is introduced into an aromatic ring (hereinafter, also referred to as an oxime compound OX) can also be used. Examples of the electron withdrawing group contained in the aromatic ring group $Ar^{OX1}$ include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula (OX1) or a compound represented by Formula (OX2), and more preferably a compound represented by Formula (OX2).

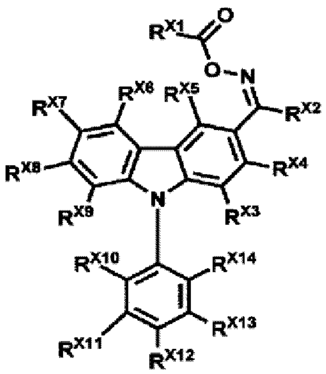

(OX1)

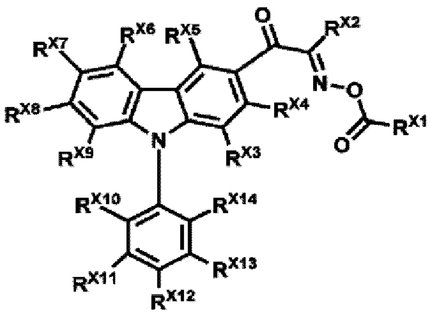

(OX2)

In Formulae, $R^{X1}$ represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group, $R^{X2}$ represents an alkyl group, an alkenyl group, an alkoxy group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy group, or an amino group, and $R^{X3}$ to $R^{X14}$ each independently represent a hydrogen atom or a substituent.
However, at least one of $R^{X10}$, ..., or $R^{X14}$ is an electron withdrawing group.
In the above Formulae, it is preferable that $R^{X12}$ is an electron withdrawing group, and $R^{X10}$, $R^{X11}$, $R^{X13}$ and $R^{X14}$ are a hydrogen atom.
Specific examples of the oxime compound OX include the compounds described in paragraph Nos. 0083 to 0105 of JP4600600B, the content of which is incorporated in the present specification.
Examples of the particularly preferred oxime compound include the oxime compound having a specific substituent described in JP2007-269779A and the oxime compound having a thioaryl group described in JP2009-191061A, the contents of which are incorporated in the present specification.
From the viewpoint of exposure sensitivity, the photoradical polymerization initiator is preferably a compound selected from the group consisting of a trihalomethyltriazine compound, a benzyl dimethyl ketal compound, an $\alpha$-hydroxy ketone compound, an $\alpha$-aminoketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.
In addition, the photoradical polymerization initiator is a trihalomethyltriazine compound, an $\alpha$-aminoketone compound, an acylphosphine compound, a phosphine oxide compound, a metallocene compound, an oxime compound, a triaryl imidazole dimer, an onium salt compound, a benzophenone compound, or an acetophenone compound. It is more preferably at least one compound selected from the group consisting of a trihalomethyltriazine compound, an $\alpha$-aminoketone compound, a metallocene compound, an oxime compound, a triaryl imidazole dimer, and a benzophenone compound, and still more preferably a metallocene compound or an oxime compound.
As the photoradical polymerization initiator, the compounds described in paragraphs 0175 to 0179 of WO2021/020359A and the compounds described in paragraphs 0048 to 0055 of WO2015/125469A can also be used, the contents of which are incorporated in the present specification.
As the photoradical polymerization initiator, a photoradical polymerization initiator which is difunctional or tri- or higher functional may be used. In a case where such a photoradical polymerization initiator is used, two or more radicals are generated from one molecule of the photoradical polymerization initiator, and thus good sensitivity is obtained. Further, in a case where a compound having an asymmetric structure is used, the crystallinity is reduced, the solubility in a solvent or the like is improved, and the compound is hardly precipitated over time, which makes it possible to improve the temporal stability of the resin composition. Specific examples of the photoradical polymerization initiator which is difunctional or tri- or higher functional include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A, the compound (E) and compound (G) described in JP2013-522445A, Cmpd 1 to 7 described in

WO2016/034963A, the oxime ester photoinitiators described in paragraph No. 0007 of JP2017-523465A, the photoinitiators described in paragraph Nos. 0020 to 0033 of JP2017-167399A, the photopolymerization initiator (A) described in paragraph Nos. 0017 to 0026 of JP2017-151342A, and the oxime ester photoinitiator described in JP6469669B, the contents of which are incorporated in the present specification.

The content of the photopolymerization initiator in the resin composition according to the embodiment of the present invention is preferably 0.1% to 30% by mass, more preferably 0.1% to 20% by mass, still more preferably 0.5% to 15% by mass, and even still more preferably 1.0% to 10% by mass, with respect to the total solid content of the resin composition. Only one kind of photopolymerization initiator may be contained, or two or more kinds thereof may be contained. In a case where two or more kinds of photopolymerization initiators are contained, the total amount thereof is preferably within the above-described range.

It is noted that since the photopolymerization initiator may also function as a thermal polymerization initiator, crosslinking with the photopolymerization initiator may be further allowed to proceed by heating an oven, a hot plate, or the like.

The resin composition according to the embodiment of the present invention may contain a thermal polymerization initiator.

[Sensitizing agent]

The resin composition may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based, a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a cyanine-based, a phenothiazine-based, a pyrrolopyrazole azomethine-based, a xanthene-based, a phthalocyanine-based, a benzopyran-based, and an indigo-based compound can be used.

Examples of the sensitizer include Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylideneindanone, p-dimethylaminobenzylideneindanone, 2-(p-dimethylaminophenylbiphenylene)-benzothiazole, 2-(p-dimethylaminophenylvinylene)benzothiazole, 2-(p-dimethylaminophenylvinylene)isonaphthothiazole, 1,3-bis(4'-dimethylaminobenzal)acetone, 1,3-bis(4'-diethylaminobenzal)acetone, 3,3'-carbonyl-bis(7-diethylamino-coumarin), 3-acetyl-7-dimethylamino-coumarin, 3-ethoxycarbonyl-7-dimethylamino-coumarin,3-benzylcarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethyl ethanolamine, N-phenyldiethanolamine, N-p-tolyldiethanolamine, N-phenylethanolamine, 4-morpholinobenzophenone, isoamyl dimethylamino benzoate, isoamyl diethylamino benzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho(1,2-d)thiazole, 2-(p-dimethylaminobenzoyl)styrene, diphenylacetamide, benzanilide, N-methylacetamide, 3',4'-dimethylacetamide, and the like.

In addition, other sensitizing dyes may be used.

For details of the sensitizing dye, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass with respect to the total solid content of the resin composition. One kind of sensitizing agent may be used alone, or two or more kinds thereof may be used in combination.

[Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, the following compound is used; a group of compounds having -S-S-, $-SO_2-S-$, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be

preferably used.

In addition, as the chain transfer agent, the compounds described in paragraphs 0152 and 0153 of WO2015/199219A can also be used, the content of which is incorporated in the present specification.

In a case where the resin composition has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition. One kind of chain transfer agent may be used alone, or two or more kinds thereof may be used. In a case where two or more kinds of chain transfer agents are used, the total thereof is preferably within the above-described range.

[Photoacid generator]

The resin composition according to the embodiment of the present invention may contain a photoacid generator.

The photoacid generator indicates a compound that generates at least one of a Brønsted acid or a Lewis acid upon irradiation with light of 200 nm to 900 nm. The light to be irradiated is preferably light having a wavelength of 300 nm to 450 nm, and more preferably light having a wavelength of 330 nm to 420 nm. The photoacid generator is preferably a photoacid generator that is capable of generating an acid by being photosensitized by using a photoacid generator alone or by using a photoacid generator and a sensitizing agent in combination.

Preferred examples of the acid to be generated include a hydrogen halide, a carboxylic acid, sulfonic acid, a sulfinic acid, thiosulfinic acid, phosphoric acid, a phosphoric acid monoester, a phosphoric acid diester, a boron derivative, a phosphorus derivative, an antimony derivative, a halogen peroxide, and a sulfone amide.

Examples of the photoacid generator include a quinone diazide compound, an oxime sulfonate compound, an organic halogenated compound, an organic borate compound, a disulfone compound, and an onium salt compound.

From the viewpoint of sensitivity and storage stability, an organic halogen compound, an oxime sulfonate compound, or an onium salt compound is preferable, and from the viewpoint of mechanical properties of a film to be formed, or the like, an oxime ester is preferable.

Examples of the quinone diazide compound include a compound in which sulfonic acid of quinone diazide is bonded to a monovalent or polyvalent hydroxy compound through an ester bond, a compound in which sulfonic acid of quinone diazide is bonded to a monovalent or polyvalent compound through a sulfonamide bond, and a compound in which sulfonic acid of quinone diazide is bonded to a polyhydroxypolyamino compound through an ester bond and/or a sulfonamide bond. All functional groups of these polyhydroxy compounds, polyamino compounds, and polyhydroxypolyamino compounds may not be substituted with quinone diazide; however, it is preferable that, on average, 40% by mole or more of all the functional groups are substituted with quinone diazide. In a case of containing such a quinone diazide compound, it is possible to obtain a resin composition that is sensitized to the i-line (wavelength: 365 nm), the h-line (wavelength: 405 nm), and the g-line (wavelength: 436 nm) of a mercury lamp, which are general ultraviolet rays.

Specific examples of the hydroxy compound include phenol, trihydroxybenzophenone, 4-methoxyphenol, isopropanol, octanol, t-Bu alcohol, cyclohexanol, naphthol, Bis-Z, BisP-EZ, TekP-4HBPA, TrisP-HAP, TrisP-PA, TrisP-SA, TrisOCR-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X, DML-MBPC, DML-MBOC, DML-OCHP, DML-PCHP, DML-PC, DML-PTBP, DML-34X, DML-EP, DML-POP, Dimethylol-BisOC-P, DML-PFP, DML-PSBP, DML-MTrisPC, TriML-P, TriML-35XL, TML-BP, TML-HQ, TML-pp-BPF, TML-BPA, TMOM-BP, HML-TPPHBA, HML-TPHAP (all, product names, manufactured by Honshu Chemical Industry Co., Ltd.), BIR-OC, BIP-PC, BIR-PC, BIR-PTBP, BIR-PCHP, BIP-BIOC-F, 4PC, BIR-BIPC-F, TEP-BIP-A, 46DMOC, 46DMOEP, TM-BIP-A(all, product names, manufactured by ASAHI YUKIZAI Corporation), 2,6-dimethoxymethyl-4-t-butylphenol, 2,6-dimethoxymethyl-p-cresol, 2,6-diacetoxymethyl-p-cresol, naphthol, tetrahydroxybenzophenone, gallic acid methyl ester, bisphenol A, bisphenol E, methylene bisphenol, BisP-AP (product name, manufactured by Honshu Chemical Industry Co., Ltd.), and a novolak resin, which are not limited thereto.

Specific examples of the amino compound include aniline, methylaniline, diethylamine, butylamine, 1,4-phenylenediamine, 1,3-phenylenediamine, 4,4'-diaminodiphenyl ether, 4,4'-diaminodiphenylmethane, 4,4'-diaminodiphenylsulfone, and 4,4'-diaminodiphenylsulfide, which are not limited thereto.

In addition, specific examples of the polyhydroxypolyamino compound include 2,2-bis(3-amino-4-hydroxyphenyl)hexafluoropropane and 3,3'-dihydroxybenzidine, which are not limited thereto.

Among these, the quinone diazide compound preferably includes an ester of a phenol compound and a 4-naphthoquinone diazidosulfonyl group. This makes it possible to obtain higher sensitivity to the i-line exposure and higher resolution.

The content of the quinone diazide compound that is used in the resin composition according to the embodiment of the present invention is preferably 1 to 50 parts by mass and more preferably 10 to 40 parts by mass with respect to 100 parts by mass of the resin. It is preferable that the content of the quinone diazide compound is set in this range since the contrast between the exposed portion and the unexposed portion can be obtained, whereby the sensitivity can be increased. Further, a sensitizing agent or the like may be added as necessary.

The photoacid generator is preferably a compound containing an oxime sulfonate group (hereinafter, also simply referred to as an "oxime sulfonate compound").

The oxime sulfonate compound is not particularly limited as long as it has an oxime sulfonate group, but is preferably a compound represented by Formula (OS-1), Formula (OS-103), Formula (OS-104), or Formula (OS-105).

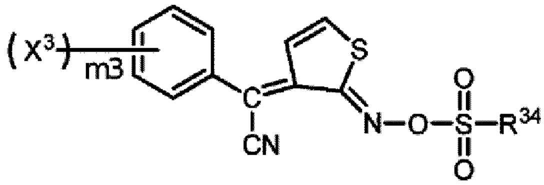

( OS-1)

In Formula (OS-1), $X^3$ represents an alkyl group, an alkoxy group, or a halogen atom. In a case where a plurality of $X^3$'s are present, they may be the same or different from each other. The alkyl group and the alkoxy group as $X^3$ may have a substituent. As the alkyl group, a linear or branched alkyl group having 1 to 4 carbon atoms is preferable. As the alkoxy group, a linear or branched alkoxy group having 1 to 4 carbon atoms is preferable. The halogen atom is preferably a chlorine atom or a fluorine atom.

m3 indicates an integer of 0 to 3, and is preferably 0 or 1. In a case where m3 is 2 or 3, the plurality of $X^3$'s may be the same or different from each other.

$R^{34}$ represents an alkyl group or an aryl group, and it is preferably an alkyl group having 1 to 10 carbon atoms, an alkoxy group having 1 to 10 carbon atoms, a halogenated alkyl group having 1 to 5 carbon atoms, a halogenated alkoxy group having 1 to 5 carbon atoms, a phenyl group which may be substituted with W, a naphthyl group which may be substituted with W, or an anthranyl group which may be substituted with W. W represents a halogen atom, a cyano group, a nitro group, an alkyl group having 1 to 10 carbon atoms, an alkoxy group having 1 to 10 carbon atoms, a halogenated alkyl group having 1 to 5 carbon atoms or a halogenated alkoxy group having 1 to 5 carbon atoms, an aryl group having 6 to 20 carbon atoms, or a halogenated aryl group having 6 to 20 carbon atoms.

A compound represented by Formula (OS-1), in which m3 is 3, $X^3$ is a methyl group, the substitution position of $X^3$ is the ortho position, and $R^{34}$ is a linear alkyl group having 1 to 10 carbon atoms, a 7,7-dimethyl-2-oxonorbornylmethyl group, or a p-tolyl group is particularly preferable.

Specific examples of the oxime sulfonate compound represented by Formula (OS-1) include the following compounds described in paragraph Nos. 0064 to 0068 of JP2011-209692A and paragraph Nos. 0158 to 0167 of JP2015-194674A, the contents of which are incorporated in the present specification.

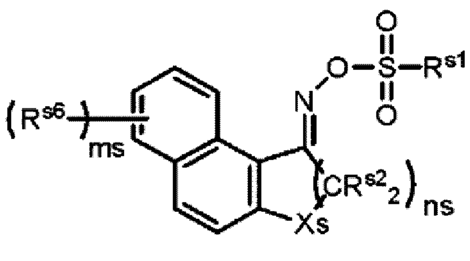

(OS-103)

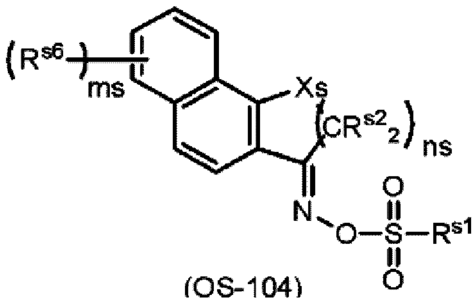

(OS-104)

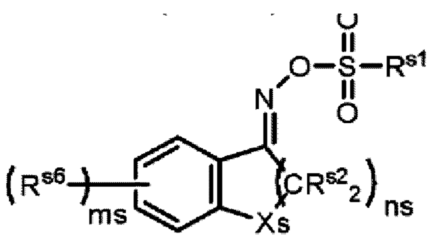

(OS-105)

In Formulae (OS-103) to (OS-105), $R^{s1}$ represents an alkyl group, an aryl group, or a heteroaryl group, $R^{s2}$'s in a case of being present in plurality each independently represent a hydrogen atom, an alkyl group, an aryl group, or a halogen atom, $R^{s6}$'s in a case of being present in plurality each independently represent a halogen atom, an alkyl group, an alkyloxy group, a sulfonate group, an aminosulfonyl group, or an alkoxysulfonyl group, Xs represents O or S, ns represents

1 or 2, and ms represents an integer of 0 to 6.

An alkyl group (preferably having 1 to 30 carbon atoms) represented by $R^{s1}$, an aryl group (preferably having 6 to 30 carbon atoms), or a heteroaryl group (preferably having 4 to 30 carbon atoms) may have a substituent.

$R^{s2}$ is preferably a hydrogen atom, an alkyl group (preferably having 1 to 12 carbon atoms), or an aryl group (preferably having 6 to 30 carbon atoms), and more preferably a hydrogen atom or an alkyl group. Among $R^{s2}$'s in a case where two or more thereof are present, it is preferable that one or two thereof are an alkyl group, an aryl group, or a halogen atom, it is more preferable that one thereof is an alkyl group, an aryl group, or a halogen atom, and it is particularly preferable that one thereof is an alkyl group and the rest thereof is a hydrogen atom. The alkyl group or aryl group represented by $R^{s2}$ may have the substituent.

Xs represents O or S, and O is preferable. In Formulae (OS-103) to (OS-105), the ring containing Xs as a ring member is a 5-membered ring or a 6-membered ring.

ns represents 1 or 2, and in a case where Xs is O, ns is preferably 1, and in a case where Xs is S, ns is preferably 2.

The alkyl group (preferably having 1 to 30 carbon atoms) and the alkyloxy group (preferably having 1 to 30 carbon atoms), which are represented by $R^{s6}$, may have a substituent.

ms represents an integer of 0 to 6, preferably an integer of 0 to 2, more preferably 0 or 1, and particularly preferably 0.

The compound represented by Formula (OS-103) is preferably a compound represented by Formula (OS-106), Formula (OS-110), or Formula (OS-111), the compound represented by Formula (OS-104) is preferably a compound represented by Formula (OS-107), and the compound represented by Formula (OS-105) is particularly preferably a compound represented by Formula (OS-108) or Formula (OS-109).

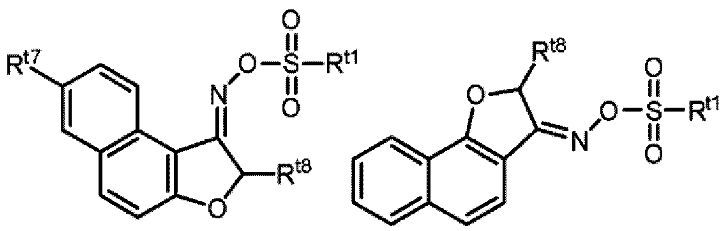

( OS-106) ( OS-107)

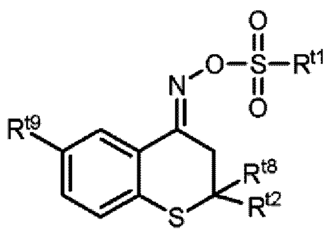

( OS-108)

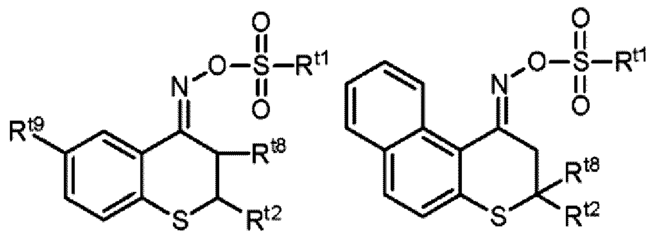

( OS-109) ( OS-110)

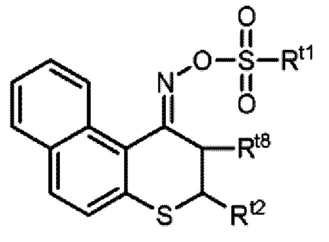

( OS-111)

**In** Formulae (OS-106) to (OS-111), $R^{t1}$ represents an alkyl group, an aryl group, or a heteroaryl group, $R^{t7}$ represents a hydrogen atom or a bromine atom, $R^{t8}$ represents a hydrogen atom, an alkyl group having 1 to 8 carbon atoms, a halogen atom, a chloromethyl group, a bromomethyl group, a bromoethyl group, a methoxymethyl group, a phenyl group, or a chlorophenyl group, $R^{t9}$ represents a hydrogen atom, a halogen atom, a methyl group, or a methoxy group, and $R^{t2}$ represents a hydrogen atom or a methyl group.

$R^{t7}$ represents a hydrogen atom or a bromine atom, and is preferably a hydrogen atom.

$R^{t8}$ represents a hydrogen atom, an alkyl group having 1 to 8 carbon atoms, a halogen atom, a chloromethyl group, a bromomethyl group, a bromoethyl group, a methoxymethyl group, a phenyl group, or a chlorophenyl group, and it is preferably an alkyl group having 1 to 8 carbon atoms, a halogen atom or a phenyl group, more preferably an alkyl group having 1 to 8 carbon atoms, still more preferably an alkyl group having 1 to 6 carbon atoms, and particularly preferably a methyl group.

$R^{t9}$ represents a hydrogen atom, a halogen atom, a methyl group, or a methoxy group, and it is preferably a hydrogen atom.

$R^{t2}$ represents a hydrogen atom or a methyl group, and it is preferably a hydrogen atom.

In addition, in the above-described oxime sulfonate compound, the three-dimensional structure (E, Z) of the oxime may be any one or a mixture of E and Z.

Specific examples of the oxime sulfonate compounds represented by Formulae (OS-103) to (OS-105) include

the compounds described in paragraph numbers 0088 to 0095 of JP2011-209692A and paragraph numbers 0168 to 0194 of JP2015-194674A, the contents of which are incorporated in the present specification.

Examples of suitable another aspect of the compound containing at least one oxime sulfonate group include compounds represented by Formulae (OS-101) and (OS-102).

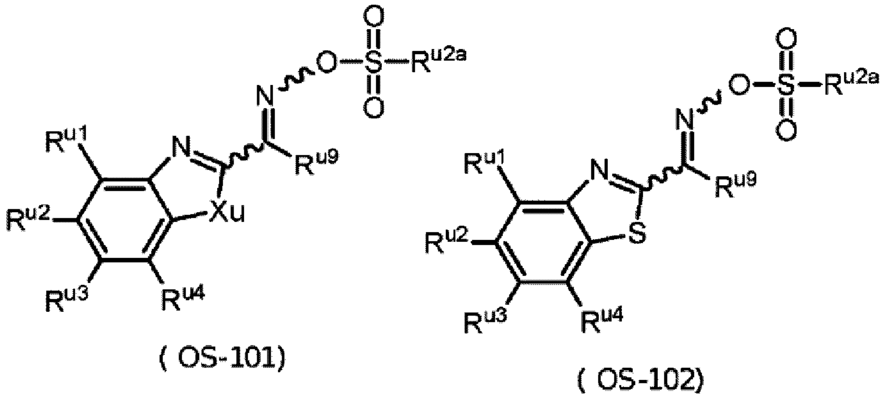

( OS-101) ( OS-102)

In Formula (OS-101) and Formula (OS-102), $R^{u9}$ represents a hydrogen atom, an alkyl group, an alkenyl group, an alkoxy group, an alkoxycarbonyl group, an acyl group, a carbamoyl group, a sulfamoyl group, a sulfo group, a cyano group, an aryl group, or a heteroaryl group. $R^{u9}$ is preferably a cyano group or an aryl group, and more preferably a cyano group, a phenyl group, or a naphthyl group.

$R^{u2a}$ represents an alkyl group or an aryl group.

Xu represents -O-, -S-, -NH-, $-NR^{u5}-$, $-CH_2-$, $-CR^{u6}H-$, or $CR^{u6}R^{u7}-$, and $R^{u5}$ to $R^{u7}$ each independently represent an alkyl group or an aryl group.

$R^{u1}$ to $R^{u4}$ each independently represent a hydrogen atom, a halogen atom, an alkyl group, an alkenyl group, an alkoxy group, an amino group, an alkoxycarbonyl group, an alkylcarbonyl group, an arylcarbonyl group, an amide group, a sulfo group, a cyano group, or an aryl group. Two of $R^{u1}$ to $R^{u4}$ may be bonded to each other to form a ring. In this case, the ring may be fused to form a fused ring together with the benzene ring. $R^{u1}$ to $R^{u4}$ are each preferably a hydrogen atom, a halogen atom, or an alkyl group. At least two of $R^{u1}$ to $R^{u4}$ may be bonded to each other to form an aryl group. Among these, it is preferable that all of $R^{u1}$ to $R^{u4}$ are hydrogen atoms. Any one of the above-described substituents may further have a substituent.

The compound containing at least one oxime sulfonate group is more preferably a compound represented by Formula (OS-102).

In addition, in the above-described oxime sulfonate compound, the three-dimensional structure (E, Z, or the like) of the oxime or the benzothiazole ring may be each any one or a mixture of E, Z, and the like.

Specific examples of the compound represented by Formula (OS-101) include the compounds described in paragraph numbers 0102 to 0106 of JP2011-209692A and paragraph numbers 0195 to 0207 of JP2015-194674A, the contents of which are incorporated in the present specification.

Among the above compounds, the following b-9, b-16, b-31, or b-33 is preferable.

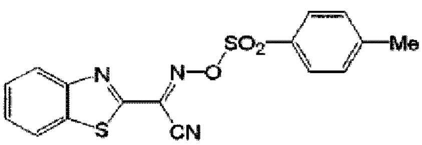

b - 9

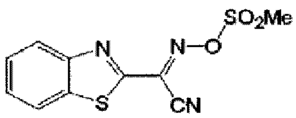

b - 16

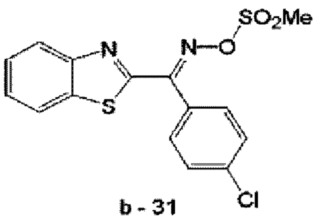

b - 31

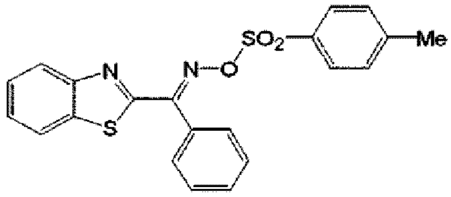

b - 33

Examples of the commercially available product thereof include WPAG-336 (manufactured by FUJIFILM Wako

Pure Chemical Corporation), WPAG-443 (manufactured by FUJIFILM Wako Pure Chemical Corporation), and MBZ-101 (manufactured by Midori Kagaku Co., Ltd.).

In addition, preferred examples thereof also include compounds represented by the following structural formulae.

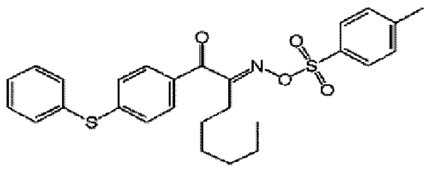

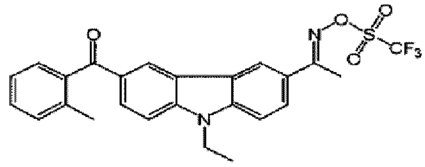

Examples of the organic halogenated compound include the compounds described in paragraphs 0042 to 0043 of JP2015-087409A. The content thereof is incorporated in the present specification.

The content of the photoacid generator is preferably 0.1% to 20% by mass, more preferably 0.5% to 18% by mass, still more preferably 0.5% to 10% by mass, even more preferably 0.5% to 3% by mass, and even still more preferably 0.5% to 1.2% by mass, with respect to the total solid content of the resin composition.

One kind of photoacid generator may be used alone, or a plurality of kinds thereof may be used in combination. In the case of the combination of a plurality of kinds, it is preferable that the total amount thereof is within the above range.

In addition, in order to impart photosensitivity to a desired light source, it is also preferable to use a sensitizing agent in combination.

<Base generator>

The resin composition according to the embodiment of the present invention may contain a base generator. Here, the base generator is a compound that is capable of generating a base under a physical or chemical action. Examples of the preferred base generator include a thermal base generator and a photobase generator.

In particular, in a case where the resin composition contains a precursor of a cyclization resin, it is preferable that the resin composition contains a base generator. In a case where the resin composition contains a thermal-base generator, it is possible to, for example, accelerate the cyclization reaction of the precursor by heating, whereby the mechanical properties and chemical resistance of the cured substance are improved and for example, the performance as an interlayer insulating film for a re-distribution layer, included in a semiconductor package, is improved.

The base generator may be an ionic base generator or may be a nonionic base generator. Examples of the base that is generated from the base generator include a secondary amine and a tertiary amine.

The base generator is not particularly limited, and a publicly known base generator can be used. Examples of the publicly known base generator include a carbamoyloxime compound, a carbamoylhydroxylamine compound, a carbamic acid compound, a formamide compound, an acetamide compound, a carbamate compound, a benzylcarbamate compound, a nitrobenzylcarbamate compound, a sulfonamide compound, an imidazole derivative compound, an aminimide compound, a pyridine derivative compound, an α-aminoacetophenone derivative compound, a quaternary ammonium salt derivative compound, an iminium salt, a pyridinium salt, an α-lactone ring derivative compound, an aminimide compound, a phthalimide derivative compound, and an acyloxyimino compound.

Specific examples of the compound of the nonionic base generator include compounds represented by Formula (B1), Formula (B2), or Formula (B3).

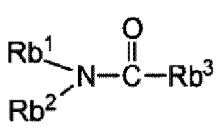 (B1) 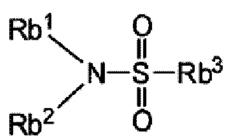 (B2)

In Formulae (B1) and (B2), $Rb^1$, $Rb^2$, and $Rb^3$ each independently represent an organic group that does not have a tertiary amine structure, a halogen atom, or a hydrogen atom. However, $Rb^1$ and $Rb^2$ are not hydrogen atoms at the same time. Further, none of $Rb^1$, $Rb^2$, and $Rb^3$ have a carboxy group. In the present specification, the tertiary amine structure refers to a structure in which all three bonding sites of a trivalent nitrogen atom are covalently bonded to carbon atoms of the hydrocarbon group. Therefore, in a case where the carbon atom bonded to the trivalent nitrogen atom is a carbon atom constituting a carbonyl group, that is, in a case where an amide group is formed together with the nitrogen atom, it is not a tertiary amine structure.

In Formula (B1) and Formula (B2), a cyclic structure is preferably contained in at least one of $Rb^1$, $Rb^2$, or $Rb^3$ and is more preferably contained in at least two thereof. The cyclic structure may be any one of a monocyclic ring or a fused ring

and is preferably a monocyclic ring or a fused ring in which two monocyclic rings are fused. The monocyclic ring is preferably a 5-membered ring or a 6-membered ring, and more preferably a 6-membered ring. The monocyclic ring is preferably a cyclohexane ring or a benzene ring, and more preferably a cyclohexane ring.

More specifically, $Rb^1$ and $Rb^2$ are preferably a hydrogen atom, an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 25 carbon atoms, more preferably having 7 to 19 carbon atoms, and still more preferably having 7 to 12 carbon atoms). These groups may have a substituent. $Rb^1$ and $Rb^2$ may be bonded to each other to form a ring. The ring to be formed is preferably a 4- to 7-membered nitrogen-containing heterocycle. $Rb^1$ and $Rb^2$ are preferably a linear, branched, or cyclic alkyl groups (preferably having 1 to 24 carbon atoms, more preferably 2 to 18 carbon atoms, and still more preferably having 3 to 12 carbon atoms) which may have a substituent, more preferably a cycloalkyl group (preferably having 3 to 24 carbon atoms, more preferably having 3 to 18 carbon atoms, and still more preferably having 3 to 12 carbon atoms) which may have a substituent, and still more preferably a cyclohexyl group which may have a substituent.

Examples of $Rb^3$ include an alkyl group (preferably having 1 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), an alkenyl group (preferably having 2 to 24 carbon atoms, more preferably having 2 to 12 carbon atoms, and still more preferably having 2 to 6 carbon atoms), an arylalkyl group (preferably having 7 to 23 carbon atoms, more preferably having 7 to 19 carbon atoms, and still more preferably having 7 to 12 carbon atoms), an arylalkenyl group (preferably having 8 to 24 carbon atoms, more preferably having 8 to 20 carbon atoms, and still more preferably having 8 to 16 carbon atoms), an alkoxyl group (preferably having 1 to 24 carbon atoms, more preferably having 2 to 18 carbon atoms, and still more preferably having 3 to 12 carbon atoms), an aryloxy group (preferably having 6 to 22 carbon atoms, more preferably having 6 to 18 carbon atoms, and still more preferably having 6 to 12 carbon atoms), and an arylalkyloxy group (preferably having 7 to 23 carbon atoms, more preferably having 7 to 19 carbon atoms, and still more preferably having 7 to 12 carbon atoms). Among the above, a cycloalkyl group (preferably having 3 to 24 carbon atoms, more preferably 3 to 18 carbon atoms, and still more preferably 3 to 12 carbon atoms), an arylalkenyl group, or an arylalkyloxy group is preferable. $Rb^3$ may further have a substituent.

The compound represented by Formula (B1) is preferably a compound represented by Formula (B1-1) or Formula (B1-2).

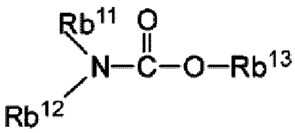 (B1-1) 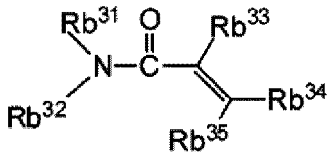 (B1-2)

In Formula, $Rb^{11}$ and $Rb^{12}$, and $Rb^{31}$ and $Rb^{32}$ are each the same as $Rb^1$ and $Rb^2$ in Formula (B1).

$Rb^{13}$ is an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and may have a substituent. Among the above, $Rb^{13}$ is preferably an arylalkyl group.

$Rb^{33}$ and $Rb^{34}$ are each independently a hydrogen atom, an alkyl group (preferably having 1 to 12 carbon atoms, more preferably having 1 to 8 carbon atoms, and still more preferably having 1 to 3 carbon atoms), an alkenyl group (preferably having 2 to 12 carbon atoms, more preferably having 2 to 8 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom.

$Rb^{35}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and

still more preferably having 7 to 12 carbon atoms), and is preferably an aryl group.

The compound represented by Formula (B1-1) is preferably a compound represented by Formula (B1-1a).

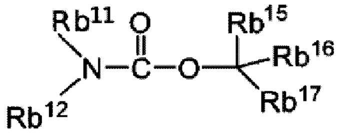
(B1-1a)

$Rb^{11}$ and $Rb^{12}$ respectively have the same meanings as $Rb^{11}$ and $Rb^{12}$ in Formula (B1-1). $Rb^{15}$ and $Rb^{16}$ are a hydrogen atom, an alkyl group (preferably having 1 to 12 carbon atoms, more preferably having 1 to 6 carbon atoms, and still more preferably having 1 to 3 carbon atoms), an alkenyl group (preferably having 2 to 12 carbon atoms, more preferably having 2 to 6 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom or a methyl group.

$Rb^{17}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and among the above, is preferably an aryl group.

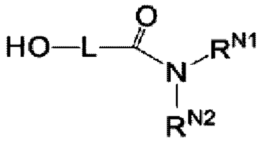
(B3)

In Formula (B3), L represents a hydrocarbon group which is a divalent hydrocarbon group having a saturated hydrocarbon group on a path of a linking chain that links adjacent oxygen atom and carbon atom and in which the number of the atoms on the path of the linking chain is 3 or more. Further, $R^{N1}$ and $R^{N2}$ each independently represent a monovalent organic group.

In the present specification, the "linking chain" refers to an atomic chain which interconnects linking targets shortest (with the minimum number of atoms) among the atomic chains on the path, which interconnects two atoms or a group of atoms to be linked. For example, in the compound represented by the following Formula, L is composed of a phenylene ethylene group, has an ethylene group as a saturated hydrocarbon group, and the linking chain is composed of four carbon atoms, and the number of atoms (that is, the number of atoms constituting the linking chain, and hereinafter, also referred to as the "linking chain length" or the "length of linking chain") on the path of the linking chain is 4.

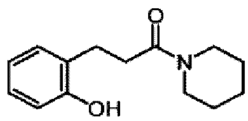

The number of carbon atoms in L in Formula (B3) (including carbon atoms other than the carbon atoms in the linking chain) is preferably 3 to 24. The upper limit thereof is more preferably 12 or less, still more preferably 10 or less, and particularly preferably 8 or less. The lower limit thereof is more preferably 4 or more. From the viewpoint of rapidly advancing the intramolecular cyclization reaction, the upper limit of the linking chain length of L is preferably 12 or less, more preferably 8 or less, still more preferably 6 or less, and particularly preferably 5 or less. In particular, the linking chain length of L is preferably 4 or 5 and most preferably 4. Specific preferred compounds of the base generator include the compounds described in paragraphs 0102 to 0168 of WO2020/066416A and the compounds described in paragraphs 0143 to 0177 of WO2018/038002A.

In addition, it is also preferable that the base generator includes a compound represented by Formula (N1).

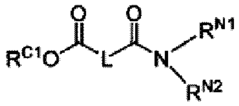
(N1)

In Formula (N1), $R^{N1}$ and $R^{N2}$ each independently represent a monovalent organic group, $R^{C1}$ represents a hydrogen atom or a protective group, and L represents a divalent linking group.

L is a divalent linking group, and it is preferably a divalent organic group. The linking chain length of the linking group is preferably 1 or more and more preferably 2 or more. The upper limit thereof is preferably 12 or less, more preferably 8 or less, and still more preferably 5 or less. The linking chain length is the number of atoms present in the atom sequence that is the shortest route between the two carbonyl groups in Formula.

$R^{N1}$ and $R^{N2}$ in Formula (N1) each independently represent a monovalent organic group (preferably having 1 to 24 carbon atoms, more preferably 2 to 18 carbon atoms, and still more preferably 3 to 12 carbon atoms), more preferably a hydrocarbon group (preferably having 1 to 24 carbon atoms, more preferably 1 to 12 carbon atoms, and still more preferably 1 to 10 carbon atoms), and specific examples thereof include an aliphatic hydrocarbon group (preferably having 1 to 24 carbon atoms, more preferably 1 to 12 carbon atoms, and still more preferably 1 to 10 carbon atoms) and an aromatic hydrocarbon group (preferably having 6 to 22 carbon atoms, more preferably 6 to 18 carbon atoms, and still more preferably 6 to 10 carbon atoms), and an aliphatic hydrocarbon group is preferable. As $R^{N1}$ and $R^{N2}$, an aliphatic hydrocarbon group is preferably used since the basicity of the base to be generated is high. It is noted that the aliphatic hydrocarbon group and the aromatic hydrocarbon group may have a substituent, and the aliphatic hydrocarbon group and the aromatic hydrocarbon group may have an oxygen atom in an aliphatic hydrocarbon chain, in an aromatic ring, or in a substituent. **In** particular, an aspect in which the aliphatic hydrocarbon group has an oxygen atom in a hydrocarbon chain is exemplified.

Examples of the aliphatic hydrocarbon group constituting $R^{N1}$ and $R^{N2}$ include a linear or branched chain-like alkyl group, a cyclic alkyl group, a group including a combination of a chain-like alkyl group and a cyclic alkyl group, and an alkyl group having an oxygen atom in the chain. The linear or branched chain-like alkyl group preferably has 1 to 24 carbon atoms, more preferably 2 to 18, and still more preferably 3 to 12 carbon atoms. Examples of the linear or branched chain-like alkyl group include a methyl group, an ethyl group, a propyl group, a butyl group, a pentyl group, a hexyl group, a heptyl group, an octyl group, a nonyl group, a decyl group, an undecyl group, a dodecyl group, an isopropyl group, an isobutyl group, a secondary butyl group, a tertiary butyl group, an isopentyl group, a neopentyl group, a tertiary pentyl group, and an isohexyl group.

The cyclic alkyl group preferably has 3 to 12 carbon atoms and more preferably 3 to 6 carbon atoms. Examples of the cyclic alkyl group include a cyclopropyl group, a cyclobutyl group, a cyclopentyl group, a cyclohexyl group, and a cyclooctyl group.

The group including a combination of a chain-like alkyl group and a cyclic alkyl group preferably has 4 to 24 carbon atoms, more preferably 4 to 18 carbon atoms, and still more preferably 4 to 12 carbon atoms. Examples of the group including a combination of a chain-like alkyl group and a cyclic alkyl group include a cyclohexylmethyl group, a cyclohexylethyl group, a cyclohexylpropyl group, a methylcyclohexylmethyl group, and an ethylcyclohexylethyl group.

The alkyl group having an oxygen atom in the chain preferably has 2 to 12 carbon atoms, more preferably 2 to 6 carbon atoms, and still more preferably 2 to 4 carbon atoms. The alkyl group having an oxygen atom in the chain may be chain-like or cyclic or may be linear or branched.

Among the above, from the viewpoint of increasing the boiling point of the decomposition-generated base described later, $R^{N1}$ and $R^{N2}$ are preferably an alkyl group having 5 to 12 carbon atoms. However, in a prescription in which adhesiveness in a case of carrying out lamination with a metal (for example, copper) layer is important, a group having a cyclic alkyl group or an alkyl group having 1 to 8 carbon atoms is preferable.

$R^{N1}$ and $R^{N2}$ may be linked to each other to form a cyclic structure. The cyclic structure may have an oxygen atom or the like in the chain. The cyclic structure formed by $R^{N1}$ and $R^{N2}$ can be a monocyclic ring or may be a fused ring, but is preferably a monocyclic ring. The cyclic structure to be formed is preferably a 5-membered ring or a 6-membered ring containing a nitrogen atom in Formula (N1), examples thereof include a pyrrole ring, an imidazole ring, a pyrazole ring, a pyrroline ring, a pyrrolidine ring, an imidazolidine ring, a pyrazolidine ring, a piperidine ring, a piperazine ring, and a morpholine ring, and preferred examples thereof include a pyrroline ring, a pyrrolidine ring, a piperidine ring, a piperazine ring, and a morpholine ring.

$R^{C1}$ represents a hydrogen atom or a protective group, and it is preferably a hydrogen atom.

The protective group is preferably a protective group that decomposes under the action of an acid or a base, and examples thereof preferably include a protective group that decomposes by an acid.

Specific examples of the protective group include a chain-like or cyclic alkyl group and a chain-like or cyclic alkyl group having an oxygen atom in the chain. Examples of the chain-like or cyclic alkyl group include a methyl group, an ethyl group, an isopropyl group, a tert-butyl group, and a cyclohexyl group. Examples of the chain-like alkyl group having an oxygen atom in the chain include an alkyloxyalkyl group, and a methyloxymethyl (MOM) group and an ethyloxyethyl (EE) group are preferable. Examples of the cyclic alkyl group having an oxygen atom in the chain include an epoxy group, a glycidyl group, an oxetanyl group, a tetrahydrofuranyl group, and a tetrahydropyranyl (THP) group.

**In** Formula (N1), the divalent linking group constituting L is not particularly limited, but is preferably a hydrocarbon group and more preferably an aliphatic hydrocarbon group. The hydrocarbon group may have a substituent or may have

an atom other than a carbon atom in the hydrocarbon chain. The divalent linking group is more preferably a divalent hydrocarbon linking group which may have an oxygen atom in the chain, still more preferably a divalent aliphatic hydrocarbon group which may have an oxygen atom in the chain, a divalent aromatic hydrocarbon group, or a group including a combination of a divalent aliphatic hydrocarbon group which may have an oxygen atom in the chain and a divalent aromatic hydrocarbon group, and even still more preferably a divalent aliphatic hydrocarbon group which may have an oxygen atom in the chain. These groups may not have an oxygen atom.

The divalent hydrocarbon linking group preferably has 1 to 24 carbon atoms, more preferably 2 to 12 carbon atoms, and still more preferably 2 to 6 carbon atoms. The divalent aliphatic hydrocarbon group preferably has 1 to 12 carbon atoms, more preferably 2 to 6 carbon atoms, and still more preferably 2 to 4 carbon atoms. The divalent aromatic hydrocarbon group preferably has 6 to 22 carbon atoms, more preferably 6 to 18 carbon atoms, and still more preferably 6 to 10 carbon atoms. The group including a combination of a divalent aliphatic hydrocarbon group and a divalent aromatic hydrocarbon group (for example, an arylene alkyl group) preferably has 7 to 22 carbon atoms, more preferably 7 to 18 carbon atoms, and still more preferably 7 to 10 carbon atoms.

Specifically, the linking group L is preferably a linear or branched chain alkylene group, a cyclic alkylene group, a group including a combination of a chain-like alkylene group and a cyclic alkylene group, an alkylene group having an oxygen atom in the chain, a linear or branched chain-lik alkenylene group, a cyclic alkenylene group, an arylene group, or an arylene alkylene group.

The linear or branched chain-like alkylene group preferably has 1 to 12 carbon atoms, more preferably 2 to 6 carbon atoms, and still more preferably 2 to 4 carbon atoms.

The cyclic alkylene group preferably has 3 to 12 carbon atoms and more preferably 3 to 6 carbon atoms.

The group including a combination of a chain-like alkylene group and a cyclic alkylene group preferably has 4 to 24 carbon atoms, more preferably 4 to 12 carbon atoms, and still more preferably 4 to 6 carbon atoms.

The alkylene group having an oxygen atom in the chain may be chain-like or cyclic or may be linear or branched. The alkylene group having an oxygen atom in the chain preferably has 1 to 12 carbon atoms, more preferably 1 to 6 carbon atoms, and still more preferably 1 to 3 carbon atoms.

The linear or branched chain-like alkenylene group preferably has 2 to 12 carbon atoms, more preferably 2 to 6 carbon atoms, and still more preferably 2 to 3 carbon atoms. The number of C=C bonds in the linear or branched chain-like alkenylene group is preferably 1 to 10, more preferably 1 to 6, and still more preferably 1 to 3.

The cyclic alkenylene group preferably has 3 to 12 carbon atoms and more preferably 3 to 6 carbon atoms. In the cyclic alkenylene group, the number of C=C bonds is preferably 1 to 6, more preferably 1 to 4, and still more preferably 1 to 2.

The arylene group preferably has 6 to 22 carbon atoms, more preferably 6 to 18 carbon atoms, and still more preferably 6 to 10 carbon atoms.

The arylene alkylene group preferably has 7 to 23 carbon atoms, more preferably 7 to 19, and still more preferably 7 to 11 carbon atoms.

Among the above, a preferred one is a chain-like alkylene group, a cyclic alkylene group, an alkylene group having an oxygen atom in the chain, a chain-like alkenylene group, an arylene group, or an arylene alkylene group, and more preferred one is a 1,2-ethylene group, a propanediyl group (particularly a 1,3-propanediyl group), a cyclohexanediyl group (particularly a 1,2-cyclohexanediyl group), a vinylene group (particularly a cisvinylene group), a phenylene group (a 1,2-phenylene group), a phenylene methylene group (particularly a 1,2-phenylene methylene group) or an ethyleneoxyethylene group (particularly a 1,2-ethyleneoxy-1,2-ethylene group).

Examples of the base generator include the following compounds; however, the base generator is not limited thereto.

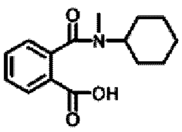
(B-1)

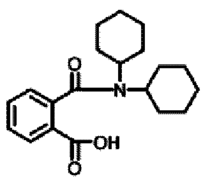
(B-2)

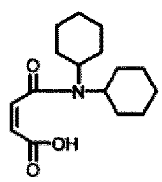
(B-3)

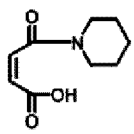
(B-4)

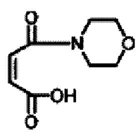
(B-5)

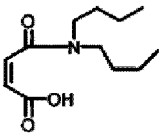
(B-6)
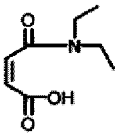
(B-7)
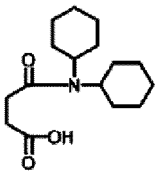
(B-8)
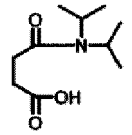
(B-9)
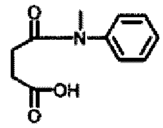
(B-10)

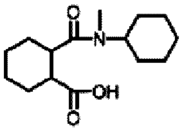
(B-11)
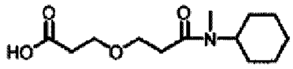
(B-12)
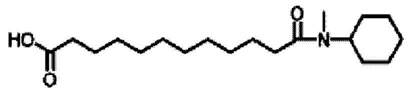
(B-13)

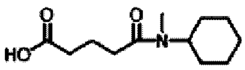
(B-14)
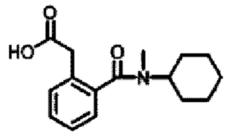
(B-15)
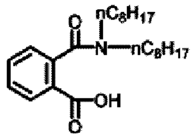
(B-16)

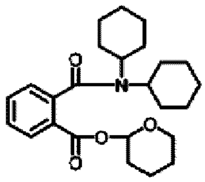
(B-17)
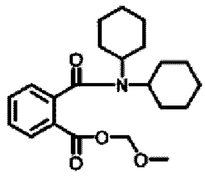
(B-18)
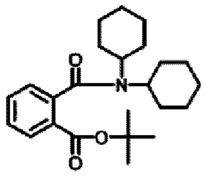
(B-19)

The molecular weight of the nonionic base generator is preferably 800 or less, more preferably 600 or less, and still more preferably 500 or less. The lower limit thereof is preferably 100 or more, more preferably 200 or more, and still more preferably 300 or more.

Examples of the specific preferred compound of the ionic base generator include the compounds described in paragraphs 0148 to 0163 of WO2018/038002A.

Specific examples of the ammonium salt include the following compounds; however, the ammonium salt is not limited thereto.

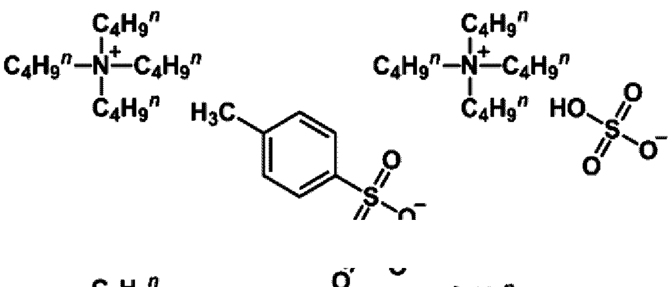
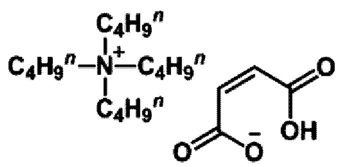

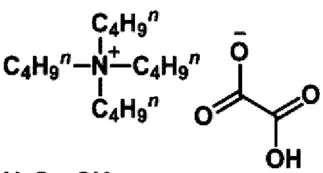
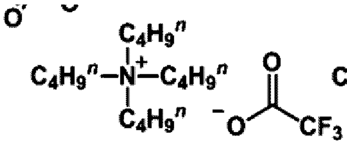
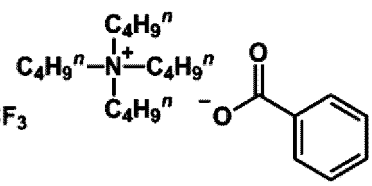

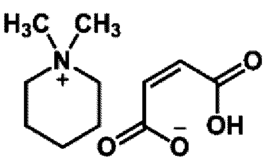
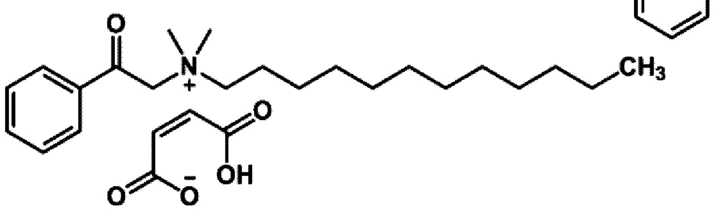

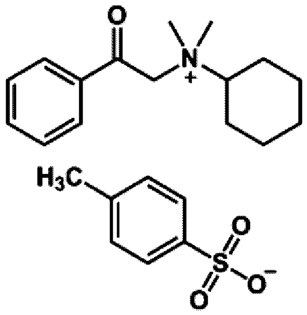
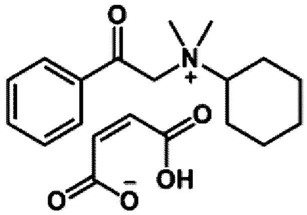
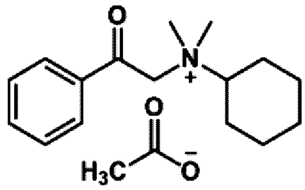

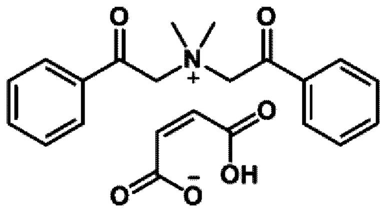

Specific examples of the iminium salt include the following compounds; however, the iminium salt is not limited thereto.

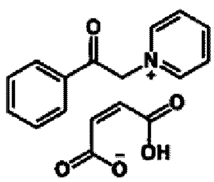
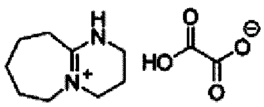
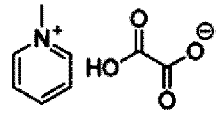

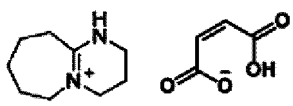
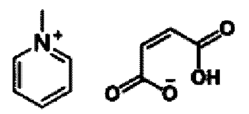

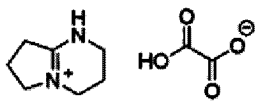
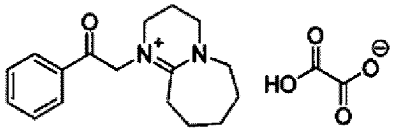

In a case where the resin composition contains a base generator, the content of the base generator is preferably 0.1 to 50 parts by mass with respect to 100 parts by mass of the resin in the resin composition. The lower limit thereof is more preferably 0.3 parts by mass or more and still more preferably 0.5 parts by mass or more. The upper limit thereof is more preferably 30 parts by mass or less, still more preferably 20 parts by mass or less, even still more preferably 10 parts by mass or less, even further still more preferably 5 parts by mass or less, and particularly preferably 4 parts by mass or less.

One kind or two or more kinds of base generators can be used. In a case where two or more kinds thereof are used, the total amount is preferably within the above-described range.

<(D) Radical polymerization inhibitor>

The resin composition according to the embodiment of the present invention contains a (D) radical polymerization inhibitor. The (D) radical polymerization inhibitor is at least one compound selected from the group consisting of a (D-1) compound having a free radical in a molecule and a (D-2) compound having a molecular weight of 270 or more, which has no free radical in a molecule.

It is preferable that the (D) radical polymerization inhibitor includes at least the (D-1) compound having a free radical in the molecule.

[(D-1) Compound having free radical in molecule]

The (D-1) compound having a free radical in the molecule (also referred to as "compound (D-1)") is a compound having a free radical in the molecule and functioning as a radical polymerization inhibitor.
The compound (D-1) is preferably a compound having an oxyl free radical group (*-O·) in the molecule. * represents a bonding site to another structure.
The compound (D-1) is more preferably a compound having an N-oxyl free radical group (a group represented by Formula (n1)) in the molecule. In Formula (n1), * represents a bonding site to another structure.

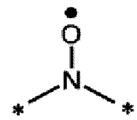
(n1)

The compound (D-1) is more preferably a compound represented by Formula (n2).

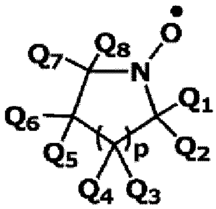
(n2)

In Formula (n2), $Q_1$ to $Q_8$ each independently represent a hydrogen atom or a substituent. p represents an integer of 1 to 5. In a case where a plurality of $Q_3$'s and a plurality of $Q_4$'s are present, the $Q_3$'s and the $Q_4$'s may be the same as or different from each other. At least two of $Q_1$, ..., or $Q_8$ may be bonded to each other to form a ring. At least one of $-CQ_1Q_2-$, $-CQ_3Q_4-$,$-CQ_5Q_6-$, or $-CQ_7Q_8-$ may be replaced with at least one of -O- or -C(=O)-.
The substituent represented by $Q_1$ to $Q_8$ is not particularly limited, and examples thereof include an organic group, a sulfamoyl group, a halogen atom, a hydroxy group, a sulfo group, an amino group, a thiol group, a cyano group, a carboxy group, an epoxy group, a glycidyl group, a (meth)acryloyl group, a (meth)acryloyloxy group, a (meth)acrylamide group, a nitro group, an isocyanate group, an isothiocyanate group, a (trialkoxysilyl) alkyloxy group, and a (trialkoxysilyl) alkylamide group. The organic group is not particularly limited, and examples thereof include the following organic group W.

(Organic group W)

Examples of the organic group W include an alkyl group, a cycloalkyl group, an alkenyl group, a cycloalkenyl group, an alkynyl group, a cycloalkynyl group, an aryl group, a heterocyclic group, an aralkyl group, a cyano group, an alkoxy group, an aryloxy group, a heterocyclic oxy group, an acyl group (an alkylcarbonyl group or an arylcarbonyl group), an acyloxy group (an alkylcarbonyloxy group or an arylcarbonyloxy group), a carbamoyloxy group, an alkoxycarbonyloxy group, an aryloxycarbonyloxy group, an alkylthio group, an arylthio group, a heterocyclic thio group, an alkyl or arylsulfinyl group, an alkyl or arylsulfonyl group, an aryloxycarbonyl group, an alkoxycarbonyl group, an aryl or heterocyclic azo group, an amide group, a sulfonamide group, an imide group, an acylamino group, a carbamoyl group, and a lactone group.
In addition, each of the above-described groups may further have a substituent as much as possible. For example, an alkyl group which may have a substituent is also included as a form of the organic group W. The substituent is not particularly limited, and examples thereof include one or more groups among the groups exemplified as the above-described organic group W, a halogen atom, a nitro group, a primary to tertiary amino group, a phosphino group, a phosphinyl group, a phosphinyloxy group, a phosphinylamino group, a phosphono group, a silyl group, a hydroxy group, a carboxy group, a sulfonic acid group, a phosphoric acid group, and the like (hereinafter, these are referred to as "substituent T").
In addition, the number of carbon atoms in the organic group W is, for example, 1 to 30.
In addition, the number of atoms other than the hydrogen atom in the organic group W is, for example, 1 to 50.
In addition, the number of carbon atoms in the alkyl group exemplified in the organic group W is preferably 1 to 20, more preferably 1 to 10, and still more preferably 1 to 6.
The alkyl group may be any of linear or branched.
Examples of the alkyl group include a linear or branched chain alkyl group such as a methyl group, an ethyl group, an n-propyl group, an i-propyl group, an n-butyl group, a t-butyl group, or an n-hexyl group.

In the alkyl group which may have a substituent, the substituent which may be contained in the alkyl group is not particularly limited, and examples thereof include the group exemplified by the above-described substituent T.

As the alkyl group moiety in the alkoxy group (also including an alkoxy group moiety in a substituent (for example, an alkoxycarbonyloxy group) which includes an alkoxy group) exemplified in the organic group W, the alkyl group moiety in the aralkyl group, the alkyl group moiety in the alkylcarbonyl group, the alkyl group moiety in the alkylcarbonyloxy group, the alkyl group moiety in the alkylthio group, the alkyl group moiety in the alkylsulfinyl group, and the alkyl moiety in the alkylsulfonyl group, the above-described alkyl group is preferable. In addition, in the alkoxy group which may have a substituent, the aralkyl group which may have a substituent, the alkylcarbonyloxy group which may have a substituent, the alkylthio group which may have a substituent, the alkylsulfinyl group which may have a substituent, and the alkylsulfonyl group which may have a substituent, examples of the substituent which may be contained in the alkoxy group, the aralkyl group, the alkylcarbonyloxy group, the alkylthio group, the alkylsulfinyl group, and the alkylsulfonyl group include the same examples as the substituent in the alkyl group which may have a substituent.

Examples of the cycloalkyl group exemplified in the organic group W include a monocyclic cycloalkyl group such as a cyclopentyl group and a cyclohexyl group, and a polycyclic cycloalkyl group such as a norbornyl group, a tetracyclodecanyl group, a tetracyclododecanyl group, and an adamantyl group. The cycloalkyl group preferably has 5 to 20 carbon atoms, and more preferably has 5 to 15 carbon atoms. **In** the cycloalkyl group which may have a substituent, the substituent which may be contained in the cycloalkyl group includes the same examples as the substituent in the alkyl group which may have a substituent.

The alkenyl group exemplified in the organic group W may be linear or branched. The number of carbon atoms of the above-described alkenyl group is preferably 2 to 20. **In** the alkenyl group which may have a substituent, the substituent which may be contained in the alkenyl group includes the same examples as the substituent in the alkyl group which may have a substituent.

The number of carbon atoms in the cycloalkenyl group exemplified in the organic group W is preferably 5 to 20. **In** the cycloalkenyl group which may have a substituent, the substituent which may be contained in the cycloalkenyl group includes the same examples as the substituent in the alkyl group which may have a substituent.

The alkynyl group exemplified in the organic group W may be linear or branched. The number of carbon atoms of the above-described alkynyl group is preferably 2 to 20. In the alkynyl group which may have a substituent, the substituent which may be contained in the alkynyl group includes the same examples as the substituent in the alkyl group which may have a substituent.

The number of carbon atoms in the cycloalkynyl group exemplified in the organic group W is preferably 5 to 20. In the cycloalkynyl group which may have a substituent, the substituent which may be contained in the cycloalkynyl group includes the same examples as the substituent in the alkyl group which may have a substituent.

The aryl group exemplified in the organic group W may be monocyclic or polycyclic (for example, 2 to 6 rings or the like) unless otherwise specified.

The number of ring member atoms in the aryl group is preferably 6 to 15 and more preferably 6 to 10.

As the aryl group, a phenyl group, a naphthyl group, or an anthranil group is preferable, and a phenyl group is more preferable.

In the aryl group which may have a substituent, the substituent which may be contained in the aryl group includes the same examples as the substituent in the alkyl group which may have a substituent.

In addition, among the groups exemplified in the organic group W, examples of the aryl group moiety in a substituent (for example, an aryloxy group) including an aryl group also include the same examples as those of the aryl group exemplified in the organic group W.

The heterocyclic group exemplified in the organic group W may be any of an aromatic heterocyclic group (heteroaryl group) or an aliphatic heterocyclic group, and may be any of a monocyclic ring or a polycyclic ring (for example, 2 to 6 rings).

The number of heteroatoms that the heterocyclic group has as a ring member atom is, for example, 1 to 10. Examples of the above-described heteroatoms include a nitrogen atom, a sulfur atom, an oxygen atom, a selenium atom, a tellurium atom, a phosphorus atom, a silicon atom, and a boron atom.

The number of ring member atoms of the heterocyclic ring group is preferably 5 to 15.

In the heterocyclic group which may have a substituent, the substituent which may be contained in the heterocyclic group includes the same examples as the substituent in the alkyl group which may have a substituent.

The heterocycle of the heterocyclic oxy group, the heterocyclic thio group, and the heterocyclic azo group, which are exemplified in the organic group W, is intended to be a ring including a heteroatom as a ring member atom, and may be any of an aromatic heterocyclic ring or an aliphatic heterocyclic ring, and may be any of a monocyclic ring or a polycyclic ring (for example, 2 to 6 rings) unless otherwise specified.

The number of heteroatoms that the heterocycle has as a ring member atom is, for example, 1 to 10. Examples of the above-described heteroatoms include a nitrogen atom, a sulfur atom, an oxygen atom, a selenium atom, a tellurium atom, a phosphorus atom, a silicon atom, and a boron atom.

The number of ring member atoms of the heterocycle is preferably 5 to 15.

In the heterocycle which may have a substituent, the substituent which may be contained in the heterocycle includes the same examples as the substituent in the alkyl group which may have a substituent.

The lactone group exemplified in the organic group W is preferably a 5- to 7-membered ring lactone group, and more preferably a 5- to 7-membered ring lactone ring having another ring structure fused to the 5- to 7-membered ring lactone ring in the form of forming a bicyclo structure or a spiro structure.

In the lactone group which may have a substituent, the substituent which may be contained in the lactone group includes the same examples as the substituent in the alkyl group which may have a substituent.

It is preferable that at least one of $Q_1$, ..., or $Q_8$ is a polar group. Examples of the polar group include an alkoxy group, an acyl group, an acyloxy group, an acylamino group, a carbamoyl group, a hydroxy group, a cyano group, a carboxy group, an amino group, a thiol group, an epoxy group, a glycidyl group, a (meth)acryloyl group, a (meth) acryloyloxy group, a (meth)acrylamide group, and a nitro group. An alkoxy group, an acyl group, an acyloxy group, an acylamino group, a carbamoyl group, a hydroxy group, a cyano group, a (meth)acryloyl group, a (meth)acryloyloxy group, a (meth)acrylamide group, or a nitro group is particularly preferable.

An aspect in which at least one of $-CQ_1Q_2-$, $-CQ_3Q_4-$, $-CQ_5Q_6-$, or $-CQ_7Q_8-$ is replaced with at least one of -O- or -C(=O)- is also preferable.

p represents an integer of 1 to 5, preferably an integer of 1 to 4, more preferably an integer of 1 to 3, and particularly preferably 1 or 2.

The compound (D-1) is particularly preferably a compound represented by Formula (n3).

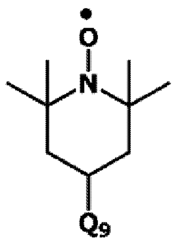

(n3)

In Formula (n3), $Q_9$ represents a hydrogen atom or a substituent.

$Q_9$ preferably represents a substituent, and more preferably represents a polar group. The polar group is the same as described above.

The molecular weight of the compound (D-1) is preferably 140 or more, more preferably 160 or more, and still more preferably 170 or more. The upper limit of the molecular weight of the compound (D-1) is not particularly limited, but may be, for example, 3,000 or less or 1,000 or less. In addition, the compound (D-1) may be a polymer, and in this case, the weight-average molecular weight thereof may be 3,000 to 30,000.

[(D-2) Compound having no free radical in molecule and having molecular weight of 270 or more]

A (D-2) compound having no free radical in the molecule and having a molecular weight of 270 or more (also referred to as a "compound (D-2)") is a compound that does not have a free radical in the molecule, has a molecular weight of 270 or more, and functions as a radical polymerization inhibitor.

The molecular weight of the compound (D-2) is preferably 500 or more and more preferably 700 or more. The upper limit of the molecular weight of the compound (D-2) is not particularly limited, but may be, for example, 3,000 or less or 2,000 or less. **In** addition, the compound (D-2) may be a polymer, and in this case, the weight-average molecular weight thereof may be 3,000 to 30,000.

The compound (D-2) is preferably at least one selected from the group consisting of a phenol-based compound, a quinone-based compound, an amino-based compound, a thiol-based compound, a phosphorus-based compound, a nitro-based compound, a nitroso-based compound, a heteroaromatic ring-based compound, and a metal compound.

The phenol-based compound is a compound in which one or more hydroxy groups are substituted in one aromatic ring, more preferably a compound in which one or more hydroxy groups are substituted in one aromatic hydrocarbon ring, even more preferably a compound in which one or more hydroxy groups are substituted in an aromatic hydrocarbon ring having 6 to 20 carbon atoms, and particularly preferably a compound in which one or more hydroxy groups are substituted in a benzene ring or a naphthalene ring. The number of hydroxy groups substituted in one aromatic ring of the phenol-based compound is preferably 1 or more and 4 or less. As the phenol-based compound, a compound represented by Formula (m1) is preferable.

As the quinone-based compound, a compound represented by Formula (m2) is preferable.

As the amino-based compound, an aromatic amine compound is preferable, and at least one selected from the

group consisting of a compound represented by Formula (m3) and a compound represented by Formula (m4) is preferable.

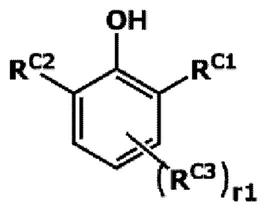

(m1)

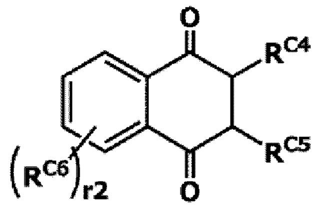

(m2)

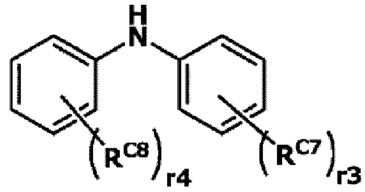

(m3)

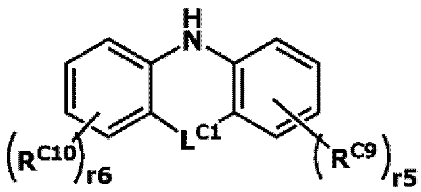

(m4)

In Formula (m1), $R^{C1}$ and $R^{C2}$ each independently represent a hydrogen atom or an organic group. Provided that at least one of $R^{C1}$ or $R^{C2}$ represents an organic group, $R^{C3}$ represents a substituent. r1 represents an integer of 0 to 3. In a case where a plurality of $R^{C3}$'s are present, the plurality of $R^{C3}$'s may be the same as or different from each other. The plurality of $R^{C3}$'s may be bonded to each other to form a ring.

In Formula (m2), $R^{C4}$ and $R^{C5}$ each independently represent a hydrogen atom or a substituent. $R^{C6}$ represents a substituent. r2 represents an integer of 0 to 4. In a case where a plurality of $R^{C6}$'s are present, the plurality of $R^{C6}$'s may be the same as or different from each other. $R^{C4}$ and $R^{C5}$ may be bonded to each other to form a ring. The plurality of $R^{C6}$'s may be bonded to each other to form a ring.

In Formula (m3), $R^{C7}$ and $R^{C8}$ each independently represent a substituent. r3 and r4 each independently represent an integer of 0 to 5. In a case where a plurality of $R^{C7}$'s are present, the plurality of $R^{C7}$'s may be the same as or different from each other. The plurality of $R^{C7}$'s may be bonded to each other to form a ring. In a case where a plurality of $R^{C8}$'s are present, the plurality of $R^{C8}$s may be the same as or different from each other. The plurality of $R^{C8}$s may be bonded to each other to form a ring.

In Formula (m4) $R^{C9}$and $R^{C10}$ each independently represent a substituent. r5 and r6 each independently represent an integer of 0 to 4. In a case where a plurality of $R^{C9}$'s are present, the plurality of $R^{C9}$'s may be the same as or different from each other. The plurality of $R^{C9}$'s may be bonded to each other to form a ring. In a case where a plurality of $R^{C10}$'s are present, the plurality of $R^{C10}$'s may be the same as or different from each other. The plurality of $R^{C10}$'s may be bonded to each other to form a ring. $L^{C1}$ represents a single bond or a divalent linking group.

In Formula (m1), examples of the organic group represented by at least one of $R^{C1}$ or $R^{C2}$ include the above-described organic group W, and an alkyl group is preferable, an alkyl group having 1 to 10 carbon atoms is more preferable, and a t-butyl group is particularly preferable.

In a case where $R^{C3}$ is an organic group, it is preferably an organic group having 1 to 100 carbon atoms, and more preferably an organic group having 1 to 50 carbon atoms. Examples of the organic group include the above-described organic group W.

In Formula (m2), the substituent represented by $R^{C4}$ to $R^{C6}$ is not particularly limited, and examples thereof include an organic group, a sulfamoyl group, a halogen atom, a hydroxy group, a sulfo group, an amino group, a thiol group, a cyano group, a carboxy group, an epoxy group, a glycidyl group, a (meth)acryloyl group, a (meth)acryloyloxy group, a (meth)acrylamide group, and a nitro group. Examples of the organic group include the above-described organic group W.

In Formulae (m3) and (m4), the substituent represented by $R^{C7}$ to $R^{C10}$ is not particularly limited, and examples thereof include an organic group, a hydroxy group, a halogen atom, and an amino group (the amino group may have a substituent, and examples of the substituent include the above-described organic group W). Examples of the organic group include the above-described organic group W.

The divalent linking group represented by $L^{C1}$ is not particularly limited, but is preferably an alkylene group, -S-, -O-, -SO-, $-SO_2-$, -CO-, $-NR^{C11}-$, or a linking group formed by combining two or more of these groups. $R^{C11}$ represents a hydrogen atom or an organic group. Examples of the organic group include the above-described organic group W.

As the thiol-based compound, an aromatic thiol compound is preferable. The aromatic thiol compound is

preferably a compound in which a thiol group is bonded to an aromatic group, examples of the aromatic group include an aryl group and a heteroaryl group, and examples of the aryl group and the heteroaryl group include the aryl group and the heteroaryl group exemplified in the above-described organic group W.

As the phosphorus-based compound, a phosphite compound is preferable, and an aromatic phosphite compound is more preferable. Examples of the aromatic group included in the aromatic phosphite compound include an aryl group and a heteroaryl group, and examples of the aryl group and the heteroaryl group include the aryl group and the heteroaryl group exemplified in the above-described organic group W.

As the nitro-based compound and the nitroso-based compound, an aromatic nitro compound and an aromatic nitroso compound are preferable. The aromatic ring included in the aromatic nitro compound and the aromatic nitroso compound is preferably an aromatic hydrocarbon ring. The number of carbon atoms in a ring member of the aromatic ring is preferably 6 to 20 and more preferably 6 to 15. The aromatic ring may have a substituent, and examples of the substituent include an alkyl group, a cycloalkyl group, and a hydroxy group.

The content of the (D) radical polymerization inhibitor is preferably 0.01% to 20% by mass, more preferably 0.02% to 10% by mass, and still more preferably 0.05% to 5% by mass, with respect to the total solid content of the resin composition.

As the (D) radical polymerization inhibitor, one kind or two or more kinds can be used. In a case where two or more kinds thereof are used, the total amount is preferably within the above-described range.

<Other polymerization inhibitors>

The resin composition according to the embodiment of the present invention may contain other polymerization inhibitors (polymerization inhibitors other than the (D) radical polymerization inhibitor). Examples of the other polymerization inhibitors include a compound having a molecular weight of less than 270 and not having a free radical in the molecule, such as a phenol-based compound, a quinone-based compound, an amino-based compound, a nitro-based compound, a nitroso-based compound, a heteroaromatic ring-based compound, and a metal compound.

Examples of specific compounds of other polymerization inhibitors include the compounds described in paragraph 0310 of WO2021/112189A, p-hydroquinone, o-hydroquinone, phenoxazine, and the like. The content thereof is incorporated in the present specification.

In a case where the resin composition according to the embodiment of the present invention contains other polymerization inhibitors, the content of the other polymerization inhibitors is preferably 0.01% to 20% by mass, more preferably 0.02% to 10% by mass, and still more preferably 0.05% to 5% by mass, with respect to the total solid content of the resin composition.

The other polymerization inhibitor may be used alone, or two or more kinds thereof may be used. In a case where two or more kinds of the other polymerization inhibitors are used, the total thereof is preferably within the above-described range.

<(E) Solvent>

The resin composition according to the embodiment of the present invention contains a (E) solvent (also simply referred to as a "solvent").

As the solvent, any publicly known solvent can be used. The solvent is preferably an organic solvent. Examples of the organic solvent include compounds such as esters, ethers, ketones, cyclic hydrocarbons, sulfoxides, amides, ureas, and alcohols.

Suitable examples of the esters include ethyl acetate, n-butyl acetate, isobutyl acetate, hexyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl

ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate, and dipropylene glycol dimethyl ether.

Suitable examples of the ketones include methyl ethyl ketone, cyclohexanone, cyclopentanone, 2-heptanone, 3-heptanone, 3-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the amide include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropionamide, 3-butoxy-N,N-dimethylpropionamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, γ- valerolactone, 3-methoxy-N,N-dimethylpropionamide, toluene, dimethyl sulfoxide, ethyl carbitol acetate, butyl carbitol acetate, N-methyl-2-pyrrolidone, propylene glycol methyl ether, and propylene glycol methyl ether acetate, as well as levoglucosenone and dihydrolevoglucosenone, or a mixed solvent composed of two or more of these. A combined use of dimethyl sulfoxide and γ-butyrolactone, a combined use of dimethyl sulfoxide and γ-valerolactone, a combined use of 3-methoxy-N,N-dimethylpropionamide and γ-butyrolactone, a combined use of 3-methoxy-N,N-dimethylpropionamide and dimethyl sulfoxide, or, a combined use of N-methyl-2-pyrrolidone and ethyl lactate is particularly preferable. An aspect in which an amount of about 1% to 10% by mass of toluene with respect to the total mass of the solvent is further added to these combinedly used solvents is also one of the preferred aspects of the present invention.

In particular, from the viewpoint of the storage stability of the resin composition, an aspect in which γ-valerolactone is included as the solvent is also one of the preferred aspects of the present invention. In such an aspect, the content of γ-valerolactone with respect to the total mass of the solvent is preferably 50% by mass or more, more preferably 60% by mass or more, and still more preferably 70% by mass or more. In addition, the upper limit of the above-described content is not particularly limited, and it may be 100% by mass. The above-described content may be determined in consideration of the solubility or the like of the component contained in the resin composition, such as the specific resin.

In addition, in a case where dimethyl sulfoxide and γ-valerolactone are used in combination, with respect to the total mass of the solvent, it is preferable to contain 60% to 90% by mass of γ-valerolactone and 10% to 40% by mass of dimethyl sulfoxide, it is more preferable to contain 70% to 90% by mass of γ-valerolactone and 10% to 30% by mass of dimethyl sulfoxide, and it is still more preferable to contain 75% to 85% by mass of γ-valerolactone and 15% to 25% by mass of dimethyl sulfoxide.

The concentration of solid contents of the resin composition according to the embodiment of the present invention is not particularly limited, and may be set to, for example, 1% to 80% by mass. However, in a case of performing coating by a slit coating method, the concentration of solid contents is preferably 40% by mass or less, more preferably 5% to 35% by mass, and particularly preferably 10% to 33% by mass.

The content of the solvent is preferably set to an amount such that the concentration of solid contents of the resin composition according to the embodiment of the present invention is in the above-described range. In a case where two or more kinds of solvents are contained, the total thereof is preferably within the above-described range.

<Acid trapping agent>

The resin composition according to the embodiment of the present invention preferably contains an acid trapping agent in order to reduce a change in performance during the period from exposure to heating. Here, the acid trapping agent

refers to a compound that can trap a generated acid by being present in the system, and it is preferably a compound having a low acidity and a high pKa. The acid trapping agent is preferably a compound having an amino group, preferably a primary amine, a secondary amine, a tertiary amine, an ammonium salt, or a tertiary amide, preferably a primary amine, a secondary amine, a tertiary amine, or an ammonium salt, and more preferably a secondary amine, a tertiary amine, or an ammonium salt.

Preferred examples of the acid trapping agent include a compound having an imidazole structure, a diazabicyclo structure, an onium structure, a trialkylamine structure, an aniline structure, or a pyridine structure, an alkylamine derivative having a hydroxyl group and/or an ether bond, and aniline having a hydroxyl group and/or an ether bond. In a case having an onium structure, the acid trapping agent is preferably a salt having a cation selected from ammonium, diazonium, iodonium, sulfonium, phosphonium, pyridinium, or the like, and an anion of an acid having an acidity lower than that of the acid generated by the acid generator.

Examples of the acid trapping agent having an imidazole structure include imidazole, 2,4,5-triphenylimidazole, benzimidazole, and 2-phenylbenzoimidazole. Examples of the acid trapping agent having a diazabicyclo structure include 1,4-diazabicyclo[2,2,2]octane, 1,5-diazabicyclo[4,3,0]nona-5-ene, and 1,8-diazabicyclo[5,4,0]undec-7-ene. Examples of the acid trapping agent having an onium structure include tetrabutylammonium hydroxide, a triarylsulfonium hydroxide, phenacylsulfonium hydroxide, and a sulfonium hydroxide having a 2-oxoalkyl group, and specifically, triphenylsulfonium hydroxide, tris (t-butylphenyl)sulfonium hydroxide, bis(t-butylphenyl)iodonium hydroxide, phenacylthiophenium hydroxide, and 2-oxopropylthiophenium hydroxide. Examples of the acid trapping agent having a trialkylamine structure include tri(n-butyl)amine and tri(n-octyl)amine. Examples of the acid trapping agent having an aniline structure include 2,6-diisopropylaniline, N,N-dimethylaniline, N,N-dibutylaniline, and N,N-dihexylaniline. Examples of the acid trapping agent having a pyridine structure include pyridine and 4-methylpyridine. Examples of the alkylamine derivative having a hydroxyl group and/or an ether bond include ethanolamine, diethanolamine, triethanolamine, N-phenyldiethanolamine, and tris(methoxyethoxyethyl)amine. Examples of the aniline derivative having a hydroxyl group and/or an ether bond include N,N-bis(hydroxyethyl)aniline.

Specific examples of the preferred acid trapping agent include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, ethylenediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl)amine, piperidine, methylpiperidine, piperazine, tropane, N-phenylbenzylamine, 1,2-dianilinoethane, 2-aminoethanol, toluidine, aminophenol, hexylaniline, phenylenediamine, phenylethylamine, dibenzylamine, pyrrole, N-methylpyrrole, guanidine, aminopyrrolidine, pyrazole, pyrazoline, aminomorpholine, and aminoalkylmorpholine.

One acid trapping agent may be used alone, or two or more kinds thereof may be used in combination. The composition according to the embodiment of the present invention may or may not contain an acid trapping agent, but in a case where the composition contains an acid trapping agent, the content of the acid trapping agent is preferably 0.001% to 10% by mass, and more preferably 0.01% to 5% by mass, with respect to the total solid content of the composition.

The using ratio of the acid generator to the acid trapping agent is preferably, acid generator/acid trapping agent (in terms of molar ratio) = 2.5 to 300. That is, from the viewpoint of sensitivity and resolution, the molar ratio is preferably 2.5 or more, and from the viewpoint of suppressing the decrease in resolution due to the thickening of the relief pattern during the period from the exposure to the heat treatment, it is preferably 300 or less. The acid generator to the acid trapping agent (molar ratio) is preferably 5.0 to 200 and more preferably 7.0 to 150.

[Urea compound, carbodiimide compound, and isourea compound]

From the viewpoint of breaking elongation and adhesiveness to a metal or a resin layer, the resin composition according to the embodiment of the present invention may contain at least one compound (hereinafter, also referred to as a "urea compound or the like") selected from the group consisting of a urea compound, a carbodiimide compound, and an isourea compound.

Examples of the urea compound include a compound represented by Formula (UR-1), examples of the carbodiimide compound include a compound represented by the following Formula (UR-2), and examples of the isourea compound include a compound represented by Formula (UR-3).

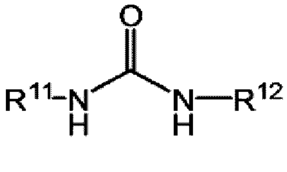
(UR-1)

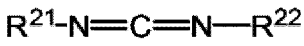
(UR-2)

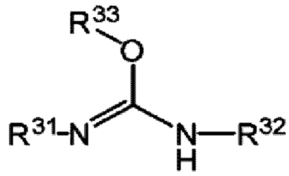
(UR-3)

In Formula (UR-1), Formula (UR-2), or Formula (UR-3), $R^{11}$ and $R^{12}$ each independently represent an aliphatic hydrocarbon group having 1 to 7 carbon atoms, which may have a substituent, $R^{21}$ and $R^{22}$ each independently represent an aliphatic hydrocarbon group having 1 to 7 carbon atoms, which may have a substituent, $R^{31}$ and $R^{32}$ each independently represent an aliphatic hydrocarbon group having 1 to 7 carbon atoms, which may have a substituent, and $R^{33}$ represents an aliphatic hydrocarbon group having 1 to 7 carbon atoms, which may have a substituent.

In Formula (UR-1), $R^{11}$ and $R^{12}$ are each independently preferably an unsubstituted aliphatic hydrocarbon group having 1 to 7 carbon atoms or an aliphatic hydrocarbon group having 1 to 7 carbon atoms, which has, as a substituent, at least one substituent selected from the group consisting of a primary amine salt structure, a secondary amine salt structure, a tertiary amino group, a tertiary amine salt structure, and a quaternary ammonium group, and they are more preferably an unsubstituted aliphatic hydrocarbon group having 1 to 7 carbon atoms.

The unsubstituted aliphatic hydrocarbon group having 1 to 7 carbon atoms in $R^{11}$ and $R^{12}$ is preferably an unsubstituted saturated aliphatic hydrocarbon group having 1 to 7 carbon atoms, more preferably an unsubstituted saturated aliphatic hydrocarbon group having 2 to 7 carbon atoms, and still more preferably an ethyl group, an isopropyl group, a t-butyl group, or a cyclohexyl group.

In Formula (UR-1), $R^{11}$ and $R^{12}$ each independently an aliphatic hydrocarbon group having 2 to 7 carbon atoms, which has at least one substituent selected from the group consisting of a hydroxy group, an alkoxy group, a thiol group, and an alkylthio group.

The aliphatic hydrocarbon group having 2 to 7 carbon atoms may have two or more of the above-described substituents, but it is preferable to have only one of the above-described substituents.

In Formula (UR-2), $R^{21}$ and $R^{22}$ each independently represent an aliphatic hydrocarbon group having 1 to 7 carbon atoms, which may have a substituent.

In Formula (UR-2), $R^{21}$ and $R^{22}$ are preferably unsubstituted aliphatic hydrocarbon groups having 1 to 7 carbon atoms or an aliphatic hydrocarbon group having 1 to 7 carbon atoms, which has an amino group or a quaternary ammonium group as a substituent, and more preferably an unsubstituted aliphatic hydrocarbon group having 1 to 7 carbon atoms.

In Formula (UR-2), the preferred aspect of the unsubstituted aliphatic hydrocarbon group having 1 to 7 carbon atoms in $R^{21}$ and $R^{22}$ or the aliphatic hydrocarbon group having 1 to 7 carbon atoms, which has the above-described substituent is the same as that shown in the description of $R^{11}$ and $R^{12}$, respectively.

In Formula (UR-3), $R^{31}$ and $R^{32}$ are preferably unsubstituted aliphatic hydrocarbon groups having 1 to 7 carbon atoms or an aliphatic hydrocarbon group having 1 to 7 carbon atoms, which has an amino group or a quaternary ammonium group as a substituent, and more preferably an unsubstituted aliphatic hydrocarbon group having 1 to 7 carbon atoms.

In Formula (UR-3), the preferred aspect of the unsubstituted aliphatic hydrocarbon group having 1 to 7 carbon atoms in $R^{31}$ and $R^{32}$ or the aliphatic hydrocarbon group having 1 to 7 carbon atoms, which has the above-described substituent is the same as that shown in the description of $R^{11}$ and $R^{12}$, respectively.

In Formula (UR-3), $R^{33}$ represents an aliphatic hydrocarbon group having 1 to 7 carbon atoms, which may have a substituent, it is preferably an unsubstituted aliphatic hydrocarbon group having 1 to 7 carbon atoms, more preferably an unsubstituted saturated aliphatic hydrocarbon group having 1 to 7 carbon atoms, and still more preferably a saturated aliphatic hydrocarbon group having 1 to 4 carbon atoms.

In Formula (UR-3), $R^{33}$ is preferably a methyl group, an ethyl group, a propyl group, an isopropyl group, a butyl group, or a t-butyl group, and more preferably an ethyl group.

Specific examples of the urea compound or the like include dicyclohexylurea, diisopropylurea, dicyclohexylcarbodiimide, diisopropylcarbodiimide, dicyclohexylisourea, and diisopropylisourea, which are not limited thereto.

The total content of the urea compound or the like is preferably 0.1 to 10.0 parts by mass, more preferably 0.5 to 8.0 parts by mass, and still more preferably 1.0 to 6.0 parts by mass, with respect to 100 parts by mass of the specific resin.

One kind of urea compound or the like may be used alone, or two or more kinds thereof may be used in combination. In a case where two or more kinds of bases are used in combination in the base-containing treatment liquid, it is preferable that the total content thereof is within the above-described range.

<Characteristics of resin composition>

The viscosity of the resin composition according to the embodiment of the present invention can be adjusted by adjusting the concentration of solid contents of the resin composition. From the viewpoint of the coating film thickness, it is preferably 1,000 $mm^2/s$ to 12,000 $mm^2/s$, more preferably 2,000 $mm^2/s$ to 10,000 $mm^2/s$, and still more preferably 2,500 $mm^2/s$ to 8,000 $mm^2/s$. Within the above range, it is easy to obtain a coating film having high uniformity. In a case of being 1,000 $mm^2/s$ or more, it is easy to carry out coating at a film thickness to be required as, for example, an insulating film for re-distribution of a wiring line, and in a case of being 12,000 $mm^2/s$ or less, a coating film having an excellent coating surface shape is obtained.

<Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.
Examples of the method of maintaining the moisture content include adjusting the humidity under storage conditions and reducing the void ratio of the storage container during storage.
From the viewpoint of insulating properties, the metal content of the resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.
In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.
In the resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.
Preferred examples of the method of adjusting the content of halogen atoms include ion exchange treatment.
A storage container publicly known in the related art can be used as a storage container for the resin composition according to the embodiment of the present invention. As the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

<Cured substance of resin composition>

In a case of curing the resin composition according to the embodiment of the present invention, it is possible to obtain a cured substance of the resin composition.
The cured substance according to the embodiment of the present invention is a cured substance formed by curing the resin composition.
The curing of the resin composition is preferably carried out by heating. The heating temperature is more preferably 120°C to 400°C, still more preferably 140°C to 380°C, and particularly preferably 170°C to 350°C. The form of the cured substance of the resin composition is not particularly limited and can be selected depending on the use application, where the form includes a film shape, a rod shape, a spherical shape, a pellet shape, and the like. In the present invention, the cured substance preferably has a film shape. The shape of the cured substance can also be selected depending on the use application by the pattern processing of the resin composition, where the use application includes the formation of a protective film on a wall surface, formation of via holes for conduction, adjustment of impedance, electrostatic capacity, or internal stress, and impartment of heat radiation function. The film thickness of the cured

substance (the film consisting of the cured substance) is preferably 0.5 μm or more and 150 μm or less.

The shrinkage ratio of the resin composition according to the embodiment of the present invention after curing is preferably 50% or less, more preferably 45% or less, and still more preferably 40% or less. Here, the shrinkage ratio refers to a percentage of a change in the volume of the resin composition before and after curing, and it can be calculated according to the following expression.

$$\text{Shrinkage ratio [\%]} = 100 - (\text{volume after curing}/\text{volume before curing}) \times 100$$

<Characteristics of cured substance of resin composition>

The imidization reaction rate of the cured substance of the resin composition according to the embodiment of the present invention is preferably 70% or more, more preferably 80% or more, and still more preferably 90% or more. In a case of being 70% or more, a cured substance having excellent mechanical properties may be obtained.

The breaking elongation of the cured substance of the resin composition according to the embodiment of the present invention is preferably 30% or more, more preferably 40% or more, and still more preferably 50% or more.

The glass transition temperature (Tg) of the cured substance of the resin composition according to the embodiment of the present invention is preferably 180°C or higher, more preferably 210°C or higher, and still more preferably 230°C or higher.

<Metal adhesiveness improving agent>

From the viewpoint of improving adhesiveness to a metal material used for an electrode, a wire, or the like, the resin composition according to the embodiment of the present invention preferably contains a metal adhesiveness improving agent. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

[Silane coupling agent]

Examples of the silane coupling agent include the compounds described in paragraph 0316 of WO2021/112189A and the compounds described in paragraphs 0067 to 0078 of JP2018-173573A, the contents of which are incorporated in the present specification. In addition, it is also preferable to use two or more kinds of different silane coupling agents as described in paragraphs 0050 to 0058 of JP2011-128358A. It is also preferable to use the following compound as the silane coupling agent. In the following Formulae, Me represents a methyl group, and Et represents an ethyl group.

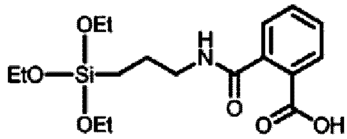
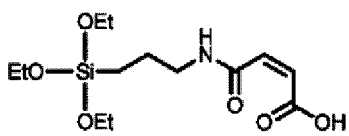

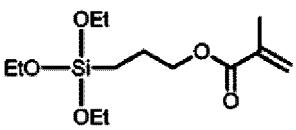
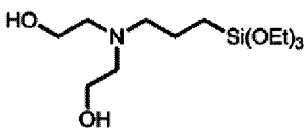
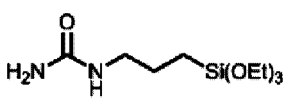

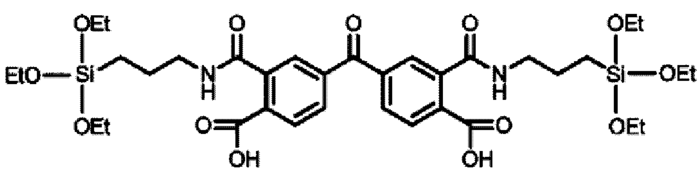

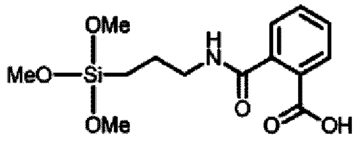
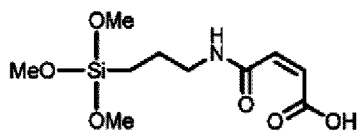

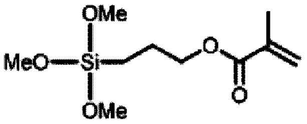
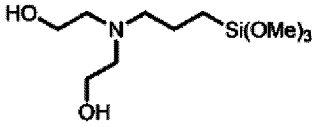
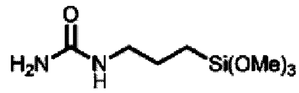

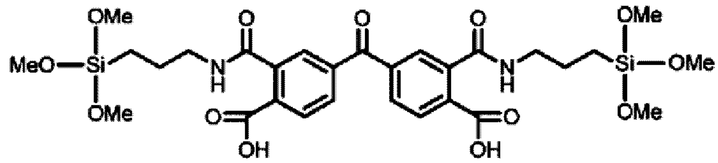

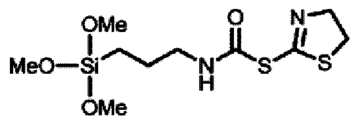
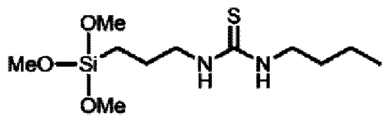

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, tris-(trimethoxysilylpropyl)isocyanurate, 3-ureidopropyltrialkoxysilane, 3-mercaptopropylmethyldimethoxysilane, 3-mercaptopropyltrimethoxysilane, 3-isocyanatepropyltriethoxysilane, and 3-trimethoxysilylpropylsuccinic acid anhydride. These can be used alone or in a combination of two or more thereof.

[Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

As another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably 0.01 to 30 parts by mass, more preferably 0.1 to 10 parts by mass, and still more preferably 0.5 to 5 parts by mass with respect to 100 parts by mass of the resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical characteristics are exhibited. One kind of metal adhesiveness improving agent may be used, or two or more kinds thereof may be used. In a case where two or more kinds thereof are used, the total content thereof is preferably within the above-described range.

<Migration suppressing agent>

The resin composition according to the embodiment of the present invention preferably further contains a migration suppressing agent. For example, in a case where the resin composition is applied to a metal layer (or a metal wiring line) to form a film, it is possible to effectively suppress the migration of metal ions derived from the metal layer (or the metal wiring line) into the film, in a case where a migration suppressing agent is contained.

The migration suppressing agent is not particularly limited; however, examples thereof include a compound having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a

pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, it is possible to preferably use a triazole-based compound such as 1,2,4-triazole, benzotriazole, 3-amino-1,2,4-triazole, or 3,5-diamino-1,2,4-triazole, or a tetrazole-based compound such as 1H-tetrazole, 5-phenyltetrazole or 5-amino-1H-tetrazole.

As the migration suppressing agent, an ion trap agent that captures an anion such as a halogen ion can also be used.

Regarding other migration suppressing agents, for example, the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, the compounds described in paragraph 0166 of WO2015/199219A, or the like can be used as the other migration suppressing agents, the contents of which are incorporated in the present specification.

Specific examples of the migration suppressing agent include the following compounds.

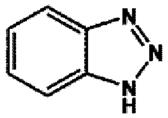
M-1

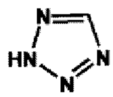
M-2

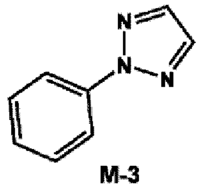
M-3

**In** a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition.

One kind of migration suppressing agent may be used alone, or two or more kinds thereof may be used. In a case where two or more kinds of migration suppressing agents are used, the total thereof is preferably within the above-described range.

<Organic metal complex>

From the viewpoint of chemical resistance, the resin composition according to the embodiment of the present invention may contain an organic metal complex.

The organic metal complex is not particularly limited as long as it is an organic complex compound containing a metal atom, but it is preferably a complex compound containing a metal atom and an organic group, more preferably a compound in which an organic group is coordinated to a metal atom, and still more preferably a metallocene compound.

The metallocene compound refers to an organic metal complex that has, as $\eta$5-ligands, two cyclopentadienyl anion derivatives which may have a substituent.

The organic group is not particularly limited; however, it is preferably a hydrocarbon group or a group consisting of a combination of a hydrocarbon group and a heteroatom. The heteroatom is preferably an oxygen atom, a sulfur atom, or a nitrogen atom.

It is preferable that at least one of the organic groups is a cyclic group, and it is more preferable that at least two thereof are a cyclic group.

The above-described cyclic group is preferably a cyclic group selected from a cyclic group of a 5-membered ring or a cyclic group of a 6-membered ring, and more preferably a cyclic group of a 5-membered ring.

The above-described cyclic group may be a hydrocarbon ring or a heterocyclic ring; however, it is preferably a hydrocarbon ring.

The 5-membered cyclic group is preferably a cyclopentadienyl group.

The organic metal complex preferably contains two to four cyclic groups in one molecule.

The metal contained in the organic metal complex is not particularly limited; however, it is preferably a metal corresponding to a Group 4 element, more preferably at least one metal selected from the group consisting of titanium, zirconium, and hafnium, still more preferably at least one metal selected from the group consisting of titanium and zirconium, and particularly preferably titanium.

The organic metal complex may contain two or more metal atoms or may contain only one metal atom; however, it preferably contains only one metal atom. **In** a case where the organic metal complex contains two or more metal atoms, it may contain only one kind of metal atom or may contain two or more kinds of metal atoms.

The organic metal complex is preferably a ferrocene compound, a titanocene compound, a zirconocene compound, or a hafnocene compound, more preferably a titanocene compound, a zirconocene compound, or a

hafnocene compound, still more preferably a titanocene compound or a zirconocene compound, and particularly preferably a titanocene compound.

An aspect in which the organic metal complex has a photoradical polymerization initiation ability is also preferable.

In the present invention, the phrase "having a photoradical polymerization initiation ability" means it is possible to generate a free radical that can initiate radical polymerization by irradiation with light. For example, in a case where a composition containing a radical crosslinking agent and an organic metal complex is irradiated with light in a wavelength range in which the organic metal complex absorbs light, where the wavelength range is a wavelength

range in which the radical crosslinking agent does not absorb light, the presence or absence of the photoradical polymerization initiation ability can be checked by checking the presence or absence of the disappearance of the radical crosslinking agent. In order to check the presence or absence of the disappearance, an appropriate method can be selected depending on the kind of radical crosslinking agent, and for example, the checking can be carried out by an IR measurement (infrared spectrometric measurement) or an HPLC measurement (high performance liquid chromatography).

In a case where the organic metal complex has a photoradical polymerization initiation ability, the organic metal complex is preferably a metallocene compound, more preferably a titanocene compound, a zirconocene compound, or a hafnocene compound, still more preferably a titanocene compound or a zirconocene compound, and particularly preferably a titanocene compound.

In a case where the organic metal complex does not have a photoradical polymerization initiation ability, the organic metal complex is preferably at least one compound selected from the group consisting of a titanocene compound, a tetraalkoxytitanium compound, a titanium acylate compound, a titanium chelate compound, a zirconocene compound, and a hafnocene compound, more preferably at least one compound selected from the group consisting of a titanocene compound, a zirconocene compound, and a hafnocene compound, still more preferably at least one compound selected from the group consisting of a titanocene compound and a zirconocene compound, and particularly preferably a titanocene compound.

The molecular weight of the organic metal complex is preferably 50 to 2,000 and more preferably 100 to 1,000.

Preferred examples of the organic metal complex include a compound represented by Formula (P).

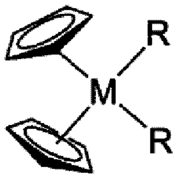

(P)

In Formula (P), M is a metal atom, and R's are each independently a substituent.

R's are each independently preferably selected from an aromatic group, an alkyl group, a halogen atom, and an alkylsulfonyloxy group.

The metal atom represented by M in Formula (P) is preferably an iron atom, a titanium atom, a zirconium atom, or a hafnium atom, more preferably a titanium atom, a zirconium atom, or a hafnium atom, still more preferably a titanium atom or a zirconium atom, and particularly preferably a titanium atom.

Examples of the aromatic group in R in Formula (P) include an aromatic group having 6 to 20 carbon atoms. An aromatic hydrocarbon group having 6 to 20 carbon atoms is preferable, and examples thereof include a phenyl group, a 1-naphthyl group, and a 2-naphthyl group.

The alkyl group as R in Formula (P) is preferably an alkyl group having 1 to 20 carbon atoms, more preferably an alkyl group having 1 to 10 carbon atoms, and examples thereof include a methyl group, an ethyl group, a propyl group, an octyl group, an isopropyl group, a t-butyl group, an isopentyl group, a 2-ethylhexyl group, a 2-methylhexyl group, and a cyclopentyl group.

Examples of the halogen atom as R include F, Cl, Br, and I.

The alkyl group constituting the alkylsulfonyloxy group as R is preferably an alkyl group having 1 to 20 carbon atoms, more preferably an alkyl group having 1 to 10 carbon atoms, and examples thereof include a methyl group, an ethyl group, a propyl group, an octyl group, an isopropyl group, a t-butyl group, an isopentyl group, a 2-ethylhexyl group, a 2-methylhexyl group, and a cyclopentyl group.

R may further have a substituent. Examples of the substituent include a halogen atom (F, Cl, Br, or I), a hydroxy group, a carboxy group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group, and a diarylamino group.

Specific examples of the organic metal complex are not particularly limited; however, examples thereof include

tetraisopropoxytitanium, tetrakis(2-ethylhexyloxy)titanium, diisopropoxybis(ethyl acetoacetate)titanium, diisopropoxybis(acetylacetonato)titanium, bis(η5-2,4-cyclopentadien-1-yl)bis(2,6-difluoro-3-(1H-pyrrol-1-yl)phenyl)titanium, pentamethylcyclopentadienyl titanium trimethoxide, bis(η5-2,4-cyclopentadien-1-yl)bis(2,6-difluorophenyl)titanium, and the following compounds.

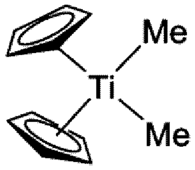
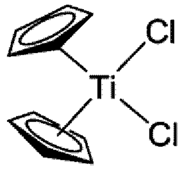
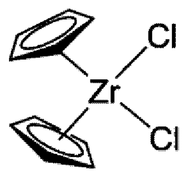
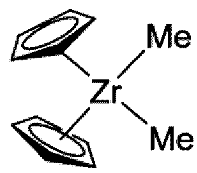

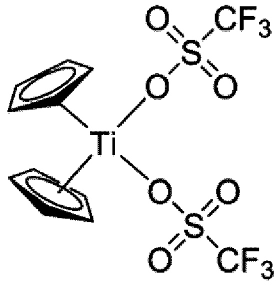
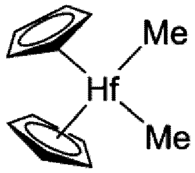
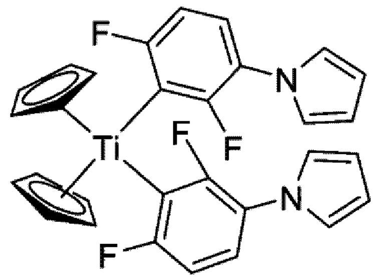

In addition, examples thereof also include the compounds described in paragraphs 0078 to 0088 of WO2018/025738A, the contents of which are incorporated in the present specification.

The content of the organic metal complex is preferably 0.1% to 30% by mass with respect to the total solid content of the resin composition. The lower limit thereof is more preferably 1.0% by mass or more, still more preferably 1.5% by mass or more, and particularly preferably 3.0% by mass or more. The upper limit is more preferably 25% by mass or less.

One kind or two or more kinds of organic metal complexes can be used. In a case where two or more kinds thereof are used, the total amount is preferably within the above-described range.

The resin composition may contain a compound (hereinafter, also referred to as a "compound AA") having a decreased absorbance at an exposure wavelength thereof upon exposure.

In a case where the resin composition contains the compound AA in which the absorbance at the exposure wavelength decreases upon exposure, it is presumed that the photosensitive agent such as the photopolymerization initiator is less likely to be exposed in a region where the exposure amount is small (for example, a region around a region where exposure is actually desired) due to absorbance of exposure light by the compound AA in a case where a layer consisting of the resin composition is exposed. In addition, it is presumed that the photosensitive agent such as the photopolymerization initiator is more likely to be exposed in a region where the exposure amount is large due to decolorization of the compound AA (decrease in absorbance at the exposure wavelength upon exposure).

Further, it is conceived that the chemical resistance of the cured substance is also improved since a decomposition product generated through the decoloring of the compound AA (for example, a decomposition product of the naphthoquinone diazide compound) is also incorporated into a crosslink of a resin or the like, and the crosslinking density is further increased.

In particular, in a case where the resin composition contains a specific resin as a resin and contains a naphthoquinone diazide compound as the compound AA, the resin and a decomposition product of the naphthoquinone diazide compound may form a crosslinked structure, and the chemical resistance may be significantly improved.

Whether or not a compound a contained in the resin composition corresponds to the compound AA (that is, whether or not the absorbance at the exposure wavelength decreases upon exposure) can be determined according to the following method.

First, a solution of the compound a having the same concentration as the concentration contained in the resin composition is prepared, and the molar absorption coefficient of the compound a at the wavelength of the exposure light ($mol^{-1} \cdot L \cdot cm^{-1}$; also referred to as a "molar absorption coefficient 1") is measured. The above measurement is carried out quickly so that an influence of a change such as a decrease in the molar absorption coefficient of the compound a is small. As a solvent in the above solution, a solvent of the resin composition is used in a case where the resin composition contains a solvent, and N-methyl-2-pyrrolidone is used in a case where the resin composition does not contain a solvent.

Next, the solution of the compound a is irradiated with exposure light. The exposure amount is 500 mJ, in terms of the integrated amount, with respect to 1 mol of the compound a.

Then, using the exposed solution of the compound a, the molar absorption coefficient of the compound a at the wavelength of the exposure light ($mol^{-1} \cdot L \cdot cm^{-1}$; also referred to as a "molar absorption coefficient 2") is measured.

From the above-described molar absorption coefficient 1 and molar absorption coefficient 2, a decay rate (%) is calculated based on the following expression, and in a case where the decay rate (%) is 5% or more, it is determined that the compound a is a compound (that is, a compound AA) in which the absorbance at the exposure wavelength decreases due to the exposure.

Attenuation rate (%) = (1 - molar absorption coefficient 2/molar absorption coefficient 1) × 100

The attenuation rate is preferably 10% or more and more preferably 20% or more. The upper limit of the attenuation rate is not particularly limited and may be 100%.

In a case where the resin composition is used for forming a photosensitive film, the wavelength of the exposure light may be any wavelength at which the photosensitive film is exposed.

In addition, in a case where the resin composition contains a photopolymerization initiator as a compound different from the compound AA, the wavelength of the exposure light is preferably a wavelength at which the photopolymerization initiator has sensitivity. The fact that the photopolymerization initiator has sensitivity to a certain wavelength refers to that a polymerization initiation species is generated in a case where the photopolymerization initiator is exposed at a certain wavelength.

Examples of the wavelength of the exposure light, which are mentioned in the relationship with the light source, include (1) a semiconductor laser (wavelength: 830 nm, 532 nm, 488 nm, 405 nm, 375 nm, 355 nm, etc); (2) a metal halide lamp; (3) a high-pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an F2 excimer laser (wavelength: 157 nm); (5) an extreme ultraviolet (EUV) ray (wavelength: 13.6 nm); (6) an electron beam; and (7) a second harmonic wave of 532 nm and a third harmonic wave of 355 nm of a YAG laser.

As the wavelength of the exposure light, for example, any wavelength at which the photopolymerization initiator has sensitivity may be selected; however, an h-line (wavelength: 405 nm) or an i-line (wavelength: 365 nm) is preferable, and an i-line (wavelength: 365 nm) is more preferable.

The compound AA may be a compound that generates a radical polymerization initiation species upon exposure; however, it is preferably a compound that does not generate a radical polymerization initiation species upon exposure from the viewpoint of resolution and chemical resistance.

Whether or not the compound AA is a compound that generates a radical polymerization initiation species upon exposure can be determined according to the following method.

A solution, which contains the compound AA having the same concentration as the concentration contained in the resin composition and contains a radical crosslinking agent, is prepared. In a case where the resin composition contains a radical crosslinking agent, as the radical crosslinking agent in the solution, the same compound as the radical crosslinking agent contained in the resin composition is used at the same concentration. In a case where the resin composition does not contain a radical crosslinking agent, methyl methacrylate is used at a concentration 5 times that of the compound AA.

Then, the irradiation with the exposure light is carried out. The exposure amount is 500 mJ in terms of the integrated amount.

After the exposure, the polymerization of the polymerizable compound is determined by, for example, high performance liquid chromatography, and in a case where the proportion of the molar amount of the polymerized polymerizable compound to the total molar amount of the polymerizable compound is 10% or less, it is determined that the compound AA is a compound that does not generate a radical polymerization initiation species upon exposure.

The proportion of the molar amount is preferably 5% or less and more preferably 3% or less. In addition, the lower limit of the proportion of the molar amount is not particularly limited and may be 0%.

In a case where the resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the resin composition has sensitivity.

Examples of the compound that generates a radical polymerization initiation species upon exposure include the same compound as the photoradical polymerization initiator. In a case where the composition contains a photoradical polymerization initiator as the compound AA, the compound AA shall be a compound, where a radical species generated from the compound has the lowest polymerization initiation ability, and the photopolymerization initiator shall be the other ones.

Examples of the compound that does not generate a radical polymerization initiation species upon exposure include a photoacid generator, a photobase generator, and a coloring agent having a changed absorption wavelength upon exposure.

Among these, the compound AA is preferably a naphthoquinone diazide compound or a coloring agent having a changed absorbance upon exposure, and it is more preferably a naphthoquinone diazide compound.
In addition, for example, it is also possible to use, as the compound AA, a photoacid generator or photobase generator in combination with a compound of which an absorbance is reduced at the exposure wavelength depending on the pH.

[Naphthoquinone diazide compound]

Examples of the naphthoquinone diazide compound include a compound of which an absorbance is reduced at an exposure wavelength due to generation of an indene carboxylic acid upon exposure, where a compound having a 1,2-naphthoquinone diazide structure is preferable.
The naphthoquinone diazide compound is preferably a naphthoquinone diazide sulfonic acid ester of a hydroxy compound.
Examples of the above-described hydroxy compound include the compounds described in paragraphs 0092 to 0107 of JP2019-206689A, the contents of which are incorporated in the present specification.
In addition, a compound represented by Formula (H6) is also preferable.

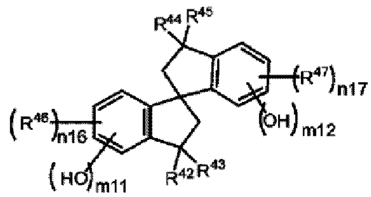

(H6)

In Formula (H6), $R^{42}$, $R^{43}$, $R^{44}$, and $R^{45}$ each independently represent a hydrogen atom or a monovalent organic group and are preferably a hydrogen atom or a monovalent organic group having 1 to 20 carbon atoms, more preferably a hydrogen atom or an alkyl group having 1 to 20 carbon atoms, and still more preferably an alkyl group having 1 to 4 carbon atoms.
In Formula (H6), $R^{46}$ and $R^{47}$ are each independently preferably an alkyl group, an alkoxy group, or an aryl group, and more preferably an alkyl group.
In Formula (H6), n16 and n17 are each independently preferably an integer of 0 to 2, and more preferably 0 or 1.
In Formula (H6), m11 and m12 are each independently preferably an integer of 1 to 3, and more preferably 2 or 3.
Examples of the compound represented by Formula (H6) include the following compounds.

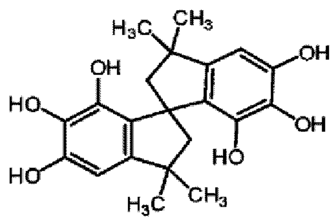

In addition, examples of the hydroxy compound include polyhydroxybenzophenones such as 2,3,4-trihydroxybenzophenone, 2,4,4'-trihydroxybenzophenone, 2,4,6-trihydroxybenzophenone, 2,3,4-trihydroxy-2'-methylbenzophenone, 2,3,4,4'-tetrahydroxybenzophenone, 2,2',4,4'-tetrahydroxybenzophenone, 2,4,6,3',4'-pentahydroxybenzophenone, 2,3,4,2',4'-pentahydroxybenzophenone, 2,3,4,2',5'-pentahydroxybenzophenone, 2,4,6,3',4',5'-hexahydroxybenzophenone, and 2,3,4,3',4',5'-hexahydroxybenzophenone; polyhydroxyphenylalkylketones such as 2,3,4-trihydroxyacetophenone, 2,3,4-trihydroxyphenylpentylketone, and 2,3,4-trihydroxyphenylhexylketone,

bis((poly)hydroxyphenyl) alkanes such as bis(2,4-dihydroxyphenyl)methane, bis(2,3,4-trihydroxyphenyl)methane, bis(2,4-dihydroxyphenyl)propane-1, bis(2,3,4-trihydroxyphenyl)propane-1, nordihydroguaiaretic acid, and 1,1-bis(4-hydroxyphenyl)cyclohexane, polyhydroxybenzoic acid esters such as 3,4,5-trihydroxybenzoic acid propyl, 2,3,4-trihydroxybenzoic acid phenyl, and 3,4,5-trihydroxybenzoic acid phenyl, and bis(polyhydroxybenzoil) alkanes or bis(polyhydroxybenzoil) aryls such as bis(2,3,4-trihydroxybenzoyl)methane, bis(3-acetyl-4,5,6-trihydroxyphenyl)-methane, bis(2,3,4-trihydroxybenzoyl)benzene, and bis(2,4,6-trihydroxybenzoyl)benzene,
alkylene-di(polyhydroxybenzoate) such as ethylene glycol-di(3,5-dihydroxybenzoate) or ethylene glycol-di(3,4,5-trihydroxybenzoate), polyhydroxybiphenyl such as 2,3,4-biphenyltriol, 3,4,5-biphenyltriol, 3,5,3',5'-biphenyltetrol,

2,4,2',4'-biphenyltetrol, 2,4,6,3',5'-biphenylpentol, 2,4,6,2',4',6'-biphenylhexol, or 2,3,4,2',3',4'-biphenylhexol, bis(polyhydroxy) sulfide such as 4,4'-thiobis(1,3-dihydroxy)benzene, bis(polyhydroxyphenyl) ether such as 2,2',4,4'-tetrahydroxydiphenyl ether, bis(polyhydroxyphenyl)sulfoxide such as 2,2',4,4'-tetrahydroxydiphenylsulfoxide, bis(polyhydroxyphenyl)sulfone such as 2,2',4,4'-diphenylsulfone,

polyhydroxytriphenylmethanes such as tris(4-hydroxyphenyl)methane, 4,4',4"-trihydroxy-3,5,3',5'-tetramethyltriphenylmethane, 4,4',3",4"-tetrahydroxy-3,5,3',5'-tetramethyltriphenylmethane, 4-[bis(3,5-dimethyl-4-hydroxyphenyl)methyl]-2-methoxyphenol, 4,4'-(3,4-diol-benzylidene)bis[2,6-dimethylphenol], 4,4'-[(2-hydroxyphenyl)methylene]bis[2-cyclohexyl-5-methylphenol, 4,4',2",3",4"-pentahydroxy-3,5,3',5'-tetramethyltriphenylmethane, 2,3,4,2',3',4'-hexahydroxy-5,5'-diacetyltriphenylmethane, 2,3,4,2',3',4',3",4"-octahydroxy-5,5'-diacetyltriphenylmethane, and 2,4,6,2',4',6'-hexahydroxy-5,5'-dipropionyltriphenylmethane, polyhydroxytriphenylethanes such as 4,4'-(phenylmethylene)bisphenol, 4,4'-(1-phenyl-ethylidene)bis[2-methylphenol], and 4,4',4"-ethylidene-trisphenol, polyhydroxyspirobiindanes such as 3,3,3',3'-tetramethyl-1,1'-spirobiindane-5,6,5',6'-tetrol, 3,3,3',3'-tetramethyl-1,1'-spirobiindane-5,6,7,5',6',7'-hexool, 3,3,3',3'-tetramethyl-1,1'-spirobiindane-4,5,6,4',5',6'-hexool, and 3,3,3',3'-tetramethyl-1,1'-spirobiindane-4,5,6,5',6',7'-hexool, polyhydroxyflavans such as 2,4,4-trimethyl-2',4',7'-trihydroxyflavan, polyhydroxyphthalides such as 3,3-bis(3,4-dihydroxyphenyl)phthalide, 3,3-bis(2,3,4-trihydroxyphenyl)phthalide, and 3',4',5',6'-tetrahydroxyspiro[phthalido-3,9'-xanthene], flavono coloring agents such as morin, quercetin, and rutin,

α,α',α"-tris(4-hydroxyphenyl) 1,3,5-triisopropylbenzene, α,α',α"-tris(3,5-dimethyl-4-hydroxyphenyl) 1,3,5-triisopropylbenzene, α,α',α"-tris(3,5-diethyl-4-hydroxyphenyl) 1,3,5-triisopropylbenzene, α,α',α"-tris(3,5-di-n-propyl-4-hydroxyphenyl) 1,3,5-triisopropylbenzene, α,α',α"-tris(3,5-diisopropyl-4-hydroxyphenyl) 1,3,5-triisopropylbenzene, α,α',α"-tris(3,5-di-n-butyl-4-hydroxyphenyl) 1,3,5-triisopropylbenzene, α,α',α"-tris(3-methyl-4-hydroxyphenyl) 1,3,5-triisopropylbenzene, α,α',α"-tris(3-methoxy-4-hydroxyphenyl) 1,3,5-triisopropylbenzene, α,α',α"-tris(2,4-dihydroxyphenyl) 1,3,5-triisopropylbenzene, 1,3,5-tris(3,5-dimethyl-4-hydroxyphenyl)benzene, 1,3,5-tris(5-methyl-2-hydroxyphenyl)benzene, 2,4,6-tris(3,5-dimethyl-4-hydroxyphenylthiomethyl)mesitylene, 1-[α-methyl-α-(4'-hydroxyphenyl)ethyl]-4-[α,α'-bis(4"-hydroxyphenyl)ethyl]benzene,polyhydroxy compounds described in JP1992-253058A (JP-H4-253058A) such as 1-[α-methyl(4'-hydroxyphenyl)ethyl]-3-[α,α'-bis(4"-hydroxyphenyl) ethyl]benzene, 1-[α-methyl-α-(3',5'-dimethyl-4'-hydroxyphenyl)ethyl]-4-[α,α'-bis(3",5"-dimethyl-4"-hydroxyphenyl) ethyl]benzene, 1-[α-methyl(3'-methyl-4'-hydroxyphenyl)ethyl]-4-[α',α'-bis(3"-methyl-4"-hydroxyphenyl)ethyl]benzene, 1-[α-methyl-α-(3'-methoxy-4'-hydroxyphenyl)ethyl]-4-[α',α'-bis(3"-methoxy-4"-hydroxyphenyl)ethyl]benzene, 1-[α-methyl-α-(2',4'-dihydroxyphenyl)ethyl]-4-[α',α'-bis(4"-hydroxyphenyl)ethyl]benzene, and 1-[α-methyl(2',4'-dihydroxyphenyl)ethyl]-3-[α',α'-bis(4"-hydroxyphenyl)ethyl]benzene, polyhydroxy compounds described in JP1993-224410A (JP-H5-224410A) such as α,α,α',α',α",α"-hexakis-(4-hydroxyphenyl)-1,3,5-triethylbenzene, and poly(hydroxyphenyl)alkanes described in JP1993-303200A (JP-H5-303200A) and EP-530148 such as 1,2,2,3-tetra(p-hydroxyphenyl)propane and 1,3,3,5-tetra(p-hydroxyphenyl)pentane,

p-bis(2,3,4-trihydroxybenzoyl)benzene, p-bis(2,4,6-trihydroxybenzoyl)benzene, m-bis(2,3,4-trihydroxybenzoyl) benzene, m-bis(2,4,6-trihydroxybenzoyl)benzene, p-bis(2,5-dihydroxy-3-bromobenzoyl)benzene, p-bis(2,3,4-trihydroxy-5-methylbenzoyl)benzene, p-bis(2,3,4-trihydroxy-5-methoxybenzoyl)benzene, p-bis(2,3,4-trihydroxy-5-nitrobenzoyl)benzene, p-bis(2,3,4-trihydroxy-5-cyanobenzoyl)benzene, 1,3,5-tris(2,5-dihydroxybenzoyl)benzene, 1,3,5-tris(2,3,4-trihydroxybenzoyl)benzene, 1,2,3-tris(2,3,4-trihydroxybenzoyl)benzene, 1,2,4-tris(2,3,4-trihydroxybenzoyl)benzene, 1,2,4,5-tetrakis(2,3,4-trihydroxybenzoyl)benzene, α,α'-bis(2,3,4-trihydroxybenzoyl)p-xylene, α,α',α'-tris(2,3,4-trihydroxybenzoyl)mesilene,

2,6-bis-(2-hydroxy-3,5-dimethylbenzyl)-p-cresol, 2,6-bis-(2-hydroxy-5'-methylbenzyl)-p-cresol, 2,6-bis-(2,4,6-trihydroxybenzyl)-p-cresol, 2,6-bis-(2,3,4-trihydroxybenzyl)-p-cresol, 2,6-bis(2,3,4-trihydroxybenzyl)-3,5-dimethyl-phenol, 4,6-bis-(4-hydroxy-3,5-dimethylbenzyl)-pyrogallol, 2,6-bis-(4-hydroxy-3,5-dimethylbenzyl)-1,3,4-trihydroxyphenol, 4,6-bis-(2,4,6-trihydroxybenzyl)-2,4-dimethyl-phenol, 4,6-bis-(2,3,4-trihydroxybenzyl)-2,5-dimethyl-phenol, 2,6-bis-(4-hydroxybenzyl)-p-cresol, 2,6-bis(4-hydroxybenzyl)-4-cyclohexylphenol, 2,6-bis(4-hydroxy-3-methylbenzyl)-p-cresol, 2,6-bis(4-hydroxy-3,5-dimethylbenzyl)-p-cresol, 2,6-bis(4-hydroxy-2,5-dimethylbenzyl)-p-cresol, 2,6-bis(4-hydroxy-3-methylbenzyl)-4-phenyl-phenol, 2,2',6,6'-tetrakis[(4-hydroxyphenyl)methyl]-4,4'-methylenediphenol, 2,2',6,6'-tetrakis[(4-hydroxy-3,5-dimethylphenyl)methyl]-4,4'-methylenediphenol, 2,2',6,6'-tetrakis[(4-hydroxy-3-methylphenyl)methyl]-4,4'-methylenediphenol, 2,2'-bis[(4-hydroxy-3,5-dimethylphenyl)methyl] 6,6'-dimethyl-4,4'-methylenediphenol, 2,2',3,3'-tetrahydro-3,3,3',3'-tetramethyl-1,1'-spiro-bi(1H-indene)-5,5',6,6',7,7'-hexanol, and bis(4-hydroxy-3,5-dimethylphenyl)-(4-hydroxy-3-methoxyphenyl)methane.

In addition, a hyponuclear form of a phenol resin, such as a novolak resin, can also be used.

Examples of the naphthoquinone diazide sulfonic acid include 6-diazo 5,6-dihydro-5-oxo-1-naphthalenesulfonic acid and 1,2-naphthoquinone-(2)-diazo-5-sulfonic acid, where these may be mixedly used.

A production method for a naphthoquinone diazide sulfonic acid ester of a hydroxy compound is not particularly limited. However, it is obtained, for example, by producing a sulfonyl chloride from naphthoquinone diazide sulfonic acid

with chlorosulfonic acid or thionyl chloride, and subjecting the obtained naphthoquinone diazide sulfonyl chloride to a condensation reaction with the hydroxy compound.

For example, it can be obtained by subjecting a hydroxy compound and a predetermined amount of naphthoquinone diazide sulfonyl chloride to a reaction in a solvent such as dioxane, acetone, or tetrahydrofuran, in the presence of a basic catalyst such as triethylamine to carry out esterification, washing the obtained product with water, and carrying out drying.

The esterification rate for the naphthoquinone diazide sulfonic acid ester is not particularly limited; however, it is preferably 10% or more, and more preferably 20% or more. The upper limit of the esterification rate is not particularly limited and may be 100%.

The esterification rate can be checked by $^1$H-NMR or the like as a proportion of the esterified groups among the hydroxy groups contained in the hydroxy compound.

[Coloring agent having changed absorbance upon exposure]

The coloring agent having a changed absorbance upon exposure is not particularly limited, and a known photochromic material can be used. Examples thereof include a leuco coloring agent, a diarylethene coloring agent, fulgides, spiroxazines, spiropirans, and an azobenzene-based compound.

Examples of the leuco coloring agent include leuco coloring agents which are triarylmethane-based (for example, triphenylmethane-based), spiropyran-based, fluoran-based, diphenylmethane-based, rhodamine lactam-based, indolyl phthalide-based, and leucoauramine-based. Among these, a triarylmethane-based leuco coloring agent is preferable.

In addition, the leuco coloring agent is preferably a leuco coloring agent which has a lactone ring, a sultine ring, or a sultone ring, and in which the absorbance changes by the ring opening or ring closure of the lactone ring, the sultine ring, or the sultone ring.

As the leuco coloring agent, a commercially available product may be used, examples of which include Victoria Pure Blue NAPS.

The diarylethene compound is, for example, preferably a diarylethene compound in which the absorbance changes by undergoing ring closure as described below. It is noted that the steric conformation in the following formula is an example, which is not limited thereto.

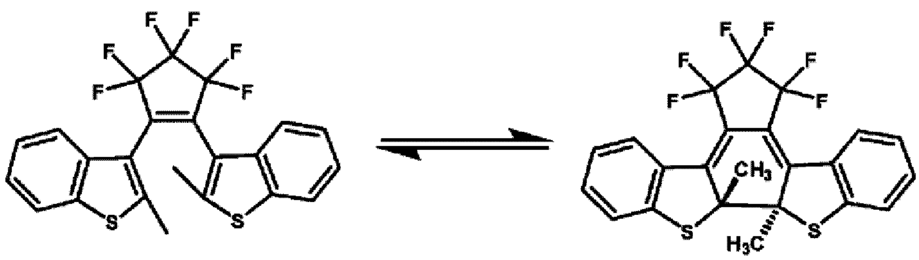

The diarylethene compound is not particularly limited, and a known compound can be used. However, examples thereof include the compounds described in paragraphs 0049 to 0056 of JP2004-91638A.

[Content]

The content of the compound AA with respect to the total solid content of the resin composition according to the embodiment of the present invention is not particularly limited, but is preferably 0.1% to 20% by mass, more preferably 0.5% to 10% by mass, and still more preferably 1% to 5% by mass.

<Other additives>

The resin composition according to the embodiment of the present invention may contain various additives as necessary, for example, a surfactant, a higher fatty acid derivative, a thermal polymerization initiator, inorganic particles, an ultraviolet absorbing agent, an organic titanium compounds, an antioxidant, an aggregation inhibitor, a phenol-based compound, another polymer compound, a plasticizer, and other auxiliary agents (for example, an antifoaming agent, and a flame retardant) within the scope in which the effect of the present invention is obtained. By appropriately containing these components, properties such as film properties can be adjusted. The details of the components can be found in, for example, paragraph "0183" and subsequent paragraphs of JP2012-003225A (corresponding to paragraph 0237 of US2013/0034812A) and paragraphs 0101 to 0104 and 0107 to 0109 of JP2008-250074A, the contents of which are

incorporated in the present specification. In a case where these additives are blended, the total content thereof is preferably 3% by mass or less of the solid content of the resin composition according to the embodiment of the present invention.

[Surfactant]

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

In a case where a surfactant is contained in the photosensitive resin composition according to the embodiment of the present invention, the liquid characteristics (particularly, the fluidity) in a case where a coating liquid composition is prepared are further improved, and thus the uniformity of the coating thickness and the liquid saving property can be further improved. That is, in a case where a film is formed using a coating liquid containing a surfactant, the interfacial tension between a surface to be coated and a coating liquid is reduced, the wettability to the surface to be coated is improved, and thus the coatability to the surface to be coated is improved. Therefore, it is possible to more suitably form a uniform film having a small thickness unevenness.

Examples of the fluorine-based surfactant include the compounds described in paragraph 0328 of WO2021/112189A, the contents of which are incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples thereof include the following compounds.

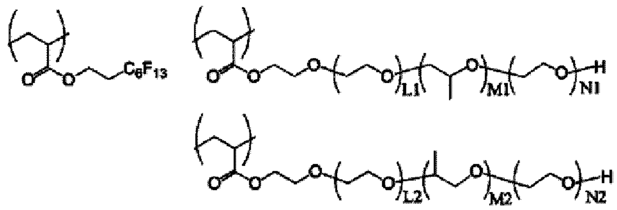

L1+N1+L2+N2=14
M1+M2=17

62%　　38%

The weight-average molecular weight of the above-described compound is preferably 3,000 to 50,000 and more preferably 5,000 to 30,000.

Regarding the fluorine-based surfactant, a fluorine-containing polymer having an ethylenically unsaturated group in the side chain can also be used as the fluorine-based surfactant. Specific examples thereof include the compounds described in paragraphs "0050" to "0090" and "0289" to "0295" of JP2010-164965A, the content of which is incorporated in the present specification. Further, examples of the commercially available product thereof include MEGAFACE RS-101, RS-102, and RS-718K, all manufactured by DIC Corporation.

The content of fluorine in the fluorine-based surfactant is preferably 3% to 40% by mass, more preferably 5% to 30% by mass, and particularly preferably 7% to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of the silicone-based surfactant, the hydrocarbon-based surfactant, the nonionic surfactant, the cationic surfactant, and the anionic surfactant include the compounds described in paragraphs 0329 to 0334 of WO2021/112189A, the contents of which are incorporated in the present specification.

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

[Higher fatty acid derivative]

In the resin composition according to the embodiment of the present invention, in order to prevent polymerization inhibition due to oxygen, a higher fatty acid derivative such as behenic acid or behenic acid amide may be added and be caused to be present at a higher density on the surface of the resin composition according to the embodiment of the present invention in the process of drying after coating.

In addition, as the higher fatty acid derivative, the compounds described in paragraph 0155 of WO2015/199219A can also be used, the content of which is incorporated in the present specification.

In a case where the resin composition has a higher fatty acid derivative, the content of the higher fatty acid derivative is preferably 0.1% to 10% by mass with respect to the total solid content of the resin composition. One kind of higher fatty acid derivative may be used, or two or more kinds thereof may be used. In a case where two or more kinds of higher fatty acid derivatives are used, the total thereof is preferably within the above-described range.

[Thermal polymerization initiator]

Examples of the thermal polymerization initiator include a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and thus the solvent resistance can be further improved. In addition, there is a case where the photopolymerization initiator also has a function of initiating polymerization by heat, and thus there is a case where it can be added as a thermal polymerization initiator.

Specific examples of thermal radical polymerization initiator include compounds described in paragraphs 0074 to 0118 of JP2008-063554A, the content of which is incorporated in the present specification.

In a case where a thermal polymerization initiator is contained, the content thereof is preferably 0.1% to 30% by mass, more preferably 0.1% to 20% by mass, and still more preferably 0.5% to 15% by mass with respect to the total solid content of the resin composition. Only one kind of thermal polymerization initiator may be contained, or two or more kinds thereof may be contained. In a case where two or more kinds of thermal polymerization initiators are contained, the total amount thereof is preferably within the above-described range.

[Inorganic particle]

Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, and glass.

The average particle diameter of the inorganic particles is preferably 0.01 to 2.0 μm, more preferably 0.02 to 1.5 μm, still more preferably 0.03 to 1.0 μm, and particularly preferably 0.04 to 0.5 μm.

The average particle diameter of the inorganic particles is the primary particle diameter and the volume average particle diameter. The volume average particle diameter can be measured by, for example, a dynamic light scattering method with Nanotrac WAVE II EX-150 (manufactured by Nikkiso Co., Ltd.).

In a case where the above measurement is difficult, the measurement can also be carried out by a centrifugal sedimentation light transmission method, an X-ray transmission method, or a laser diffraction/light scattering method.

[Ultraviolet absorbing agent]

Examples of the ultraviolet absorbing agent include a salicylate-based ultraviolet absorbing agent, a benzophenone-based ultraviolet absorbing agent, a benzotriazole-based ultraviolet absorbing agent, a substituted acrylonitrile-based ultraviolet absorbing agent, and a triazine-based ultraviolet absorbing agent.

Specific examples of the ultraviolet absorbing agent include the compounds described in paragraphs 0341 and 0342 of WO2021/112189A, the contents of which are incorporated in the present specification.

One kind of the ultraviolet absorbing agent may be used alone, or two or more kinds thereof may be used in combination.

In a case where the resin composition contains an ultraviolet absorbing agent, the content of the ultraviolet absorbing agent is preferably 0.001% by mass or more and 1% by mass or less, and more preferably 0.01% by mass or more and 0.1% by mass or less with respect to the total solid content mass of the resin composition.

[Organic titanium compound]

In a case where the resin composition contains an organic titanium compound, it is possible to form a resin layer having excellent chemical resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.

I) Titanium chelate compounds: a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).

II) Tetraalkoxytitanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), titanium tetrastearyloxide, and titanium tetrakis[bis{2,2-(aryloxymethyl)butoxide}].

III) Titanocene compounds: examples thereof include pentamethylcyclopentadienyl titanium trimethoxide, bis(η5-2,4-cyclopentadien-1-yl)bis(2,6-difluorophenyl)titanium, and bis(η5-2,4-cyclopentadien-1-yl)bis(2,6-difluoro-3-(1H-pyrrol-1-yl)phenyl)titanium.

IV) Monoalkoxytitanium compounds: examples thereof include titanium tris(dioctyl phosphate)isopropoxide, and titanium tris(dodecylbenzene sulfonate)isopropoxide.

V) Titanium oxide compounds: examples thereof include titanium oxide bis(pentanedionate), titanium oxide bis(tetramethylheptandionate), and phthalocyanine titanium oxide.

VI) Titanium tetraacetylacetonate compounds: examples thereof include titanium tetraacetylacetonate.

VII) Titanate coupling agents: examples thereof include isopropyltridodecylbenzenesulfonyl titanate.

Among these, it is preferable that the organic titanium compound is at least one compound selected from the group consisting of the above-described I) titanium chelate compound, II) tetraalkoxytitanium compound, and III) titanocene compound, from the viewpoint of more favorable chemical resistance. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In a case of containing an organic titanium compound, the content thereof is preferably 0.05 to 10 parts by mass and more preferably 0.1 to 2 parts by mass with respect to 100 parts by mass of the resin. In a case where the content thereof is 0.05 parts by mass or more, the heat resistance and the chemical resistance of the cured pattern to be obtained are further improved, and in a case where the content thereof is 10 parts by mass or less, the storage stability of the composition is more excellent.

[Antioxidant]

In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. Specific examples of the antioxidant include the compounds described in paragraphs 0348 to 0357 of WO2021/112189A, the contents of which are incorporated in the present specification.

The content of the antioxidant is preferably 0.1 to 10 parts by mass and more preferably 0.5 to 5 parts by mass with respect to 100% parts by mass of the resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

[Aggregation inhibitor]

Examples of the aggregation inhibitor include sodium polyacrylate.

One kind of the aggregation inhibitor may be used alone, or two or more kinds thereof may be used in combination.

In a case where the resin composition contains an aggregation inhibitor, the content of the aggregation inhibitor is preferably 0.01% by mass or more and 10% by mass or less, and more preferably 0.02% by mass or more and 5% by mass or less with respect to the total solid content mass of the resin composition.

[Phenol-based compound]

Examples of the phenol-based compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X (all of which are trade names, manufactured by Honshu Chemical Industry Co., Ltd.), BIP-PC, BIR-PC, BIR-PTBP, and BIR-BIPC-F (all of which are trade names, manufactured by ASAHI YUKIZAI Corporation).

One kind of the phenol-based compound may be used alone, or two or more kinds thereof may be used in

combination.

In a case where the resin composition contains a phenol-based compound, the content of the phenol-based compound is preferably 0.01% by mass or more and 30% by mass or less and more preferably 0.02% by mass or more and 20% by mass or less with respect to the total solid content mass of the resin composition.

[Other polymer compound A]

Examples of the other polymer compound include a siloxane resin, a (meth)acrylic polymer obtained by copolymerizing (meth)acrylic acid, a novolac resin, a resol resin, a polyhydroxystyrene resin, and a copolymer thereof. The other polymer compound may be a modified product into which a crosslinking group such as a methylol group, an alkoxymethyl group, or an epoxy group has been introduced.

One kind of the other polymer compound may be used alone, or two or more kinds thereof may be used in combination.

In a case where the resin composition contains the other polymer compound, the content of the other polymer compound is preferably 0.01% by mass or more and 30% by mass or less and more preferably 0.02% by mass or more and 20% by mass or less with respect to the total solid content mass of the resin composition.

<Colorant>

The resin composition according to the embodiment of the present invention may contain a colorant, but the content of the colorant in the total solid content may be 10% by mass or less, 5% by mass or less, or 1% by mass or less.

The colorant means a colored organic pigment and an organic dye. Examples of the colorant include a colorant used for a color filter. The resin composition according to the embodiment of the present invention may not contain a colorant (that is, the content of the colorant in the total solid content may be 0% by mass).

<Preparation of resin composition>

The resin composition according to the embodiment of the present invention can be prepared by mixing the above-described components. The mixing method is not particularly limited, and mixing can be carried out by methods publicly known in the related art.

Examples of the mixing method include mixing with a stirring blade, mixing with a ball mill, and mixing by rotating a tank.

The temperature during the mixing is preferably 10°C to 30°C, and more preferably 15°C to 25°C.

It is preferable to carry out filtration using a filter for the intended purpose of removing foreign substances such as dust and fine particles in the resin composition according to the embodiment of the present invention. The filter pore diameter is, for example, preferably 5 μm or less, more preferably 1 μm or less, still more preferably 0.5 μm or less, and even still more preferably 0.1 μm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore diameters or different materials may be used in combination. Examples of the connection aspect include an aspect in which an HDPE filter having a pore diameter of 1 μm is connected in series as the first stage and an HDPE filter having a pore diameter of 0.2 μm is connected in series as the second stage. In addition, various materials may be filtered a plurality of times. In a case of being filtered a plurality of times, circulation filtration may be used. In addition, filtration may be carried out under pressure. In a case of carrying out pressurization to carry out filtration, the pressure for pressurization is, for example, preferably 0.01 MPa or more and 1.0 MPa or less, more preferably 0.03 MPa or more and 0.9 MPa or less, still more preferably 0.05 MPa or more and 0.7 MPa or less, and even still more preferably 0.05 MPa or more and 0.5 MPa or less.

In addition to filtration using a filter, impurity removal treatment using an adsorbing material may be carried out. The filtration using a filter and the impurity removal treatment using an adsorbing material may be combined. As the adsorbing material, a publicly known adsorbing material can be used. Examples thereof include an inorganic adsorbing material such as silica gel and zeolite and an organic adsorbing material such as activated carbon.

After filtration using a filter, a step of placing a bottle filled with the resin composition under reduced pressure to carry out degassing may be provided.

<Manufacturing method for film>

Next, a method for producing the film according to the embodiment of the present invention will be described.

A manufacturing method for a film according to the embodiment of the present invention, including
a step of applying a photosensitive resin composition onto a base material and then drying the photosensitive resin composition under a pressure of 5,000 Pa or less, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

The photosensitive resin composition used in the manufacturing method for a film according to the embodiment of the present invention is the same as the above-described photosensitive resin composition according to the embodiment of the present invention.

[Base material]

The kind of the base material can be appropriately determined depending on the use application and is not particularly limited. Examples of the base material include a base material for semiconductor production, such as silicon, silicon nitride, polysilicon, silicon oxide, or amorphous silicon, quartz, glass, an optical film, a ceramic material, a vapor-deposited film, a magnetic film, a reflective film, a metal base material (for example, it may be any one of a base material formed from a metal or a base material having a metal layer formed by plating, vapor deposition, or the like) such as Ni, Cu, Cr, Fe, Al, or Ti, paper, spin-on-glass (SOG), a thin film transistor (TFT) array base material, a mold base material, and an electrode plate of a plasma display panel (PDP). The base material is particularly preferably a semiconductor production base material, and more preferably a silicon base material (a base material containing silicon), a Cu base material (a base material containing Cu), or a mold base material.
A layer such as an intimate attachment layer made of hexamethyl disilazane (HMDS) or the like, or an oxide layer may be provided on the surface of these base materials.
The shape of the base material is not particularly limited, and it may be a circular shape or may be a rectangular shape.
In a case where the base material has a circular shape, the size of the base material is, for example, preferably a diameter of 100 to 450 mm and more preferably 200 to 450 mm. In a case of a rectangular shape, the length of the short side is, for example, preferably 100 to 1,000 mm and more preferably 200 to 700 mm.
As the base material, for example, a base material having a plate shape and preferably a base material (a substrate) having a panel shape are used.
In a case where the resin composition is applied to form a film on a surface of a resin layer (for example, a layer consisting of a cured substance) or on a surface of a metal layer, the resin layer or the metal layer serves as the base material.
It is preferable that the base material contains Cu on the surface. Here, the surface is a region having a thickness within a depth of 0.5 μm from the outermost surface of the base material. It is preferable that a volume content of Cu in the above-described region is 50% or more.
The base material may be subjected to a pretreatment (surface activation treatment) on at least a part or all of the base material.
By performing the surface activation treatment on the base material, the adhesiveness to the photosensitive resin composition layer (resin layer) provided on the surface can be improved.
Specifically, the surface activation treatment is selected from plasma treatment of various raw material gases (oxygen, hydrogen, argon, nitrogen, nitrogen/hydrogen mixed gas, argon/oxygen mixed gas, and the like), corona discharge treatment, etching treatment with $CF_4/O_2$, $NF_3/O_2$, $SF_6$, $NF_3$, or $NF_3/O_2$, surface treatment with an ultraviolet ray (UV) ozone method, immersion treatment in an organic surface treating agent including a compound having at least one of an amino group or a thiol group after immersion in an aqueous hydrochloric acid solution to remove the oxide film, and mechanical roughening treatment using a brush. It is preferably plasma treatment and particularly preferably oxygen plasma treatment using oxygen as the raw material gas. In a case of corona discharge treatment, the energy is preferably 500 to 200,000 $J/m^2$, more preferably 1,000 to 100,000 $J/m^2$, and most preferably 10,000 to 50,000 $J/m^2$.
The means for applying the resin composition onto a base material is preferably coating.
Specific examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of the uniformity of the film thickness, a spin coating method, a slit coating method, a spray coating method, or an ink jet method is more

preferable, and from the viewpoint of the uniformity of the film thickness and the viewpoint of productivity, a spin coating method or a slit coating method is more preferable, and a slit coating method is particularly preferable. A film having a desired thickness can be obtained by adjusting the concentration of solid contents of the resin composition and application conditions according to the means to be applied. In addition, the coating method can be appropriately selected depending on the shape of the base material. In a case where a circular base material such as a wafer is used, a spin coating method, a spray coating method, an ink jet method, or the like is preferable, and in a case where a rectangular base material is used, a slit coating method, a spray coating method, an ink jet method, or the like is preferable. For example, the spin coating method can be applied at a rotation speed of 500 to 3,500 rotations per minute (rpm) for about 10 seconds to 3 minutes.

In addition, it is also possible to apply a method of transferring a coating film formed in advance on a temporary support by the above-described coating method, onto a base material.

Regarding the transfer method, the production methods described in paragraphs 0023 and 0036 to 0051 of JP2006-023696A and paragraphs 0096 to 0108 of JP2006-047592A can also be suitably used.

In addition, a step of removing an unnecessary film at the end part of the base material may be carried out. Examples of such a step include edge bead rinsing (EBR) and back rinsing.

A pre-wetting step of applying the base material and various solvents before applying the resin composition onto the base material to improve the wettability of the base material and then applying the resin composition may be adopted.

<Drying step>

The above film is subjected to a step (a drying step) of drying the film (or the layer) formed for removing the solvent, after the film forming step (the layer forming step).

In the present invention, a step of applying the photosensitive resin composition onto a base material and then drying the photosensitive resin composition under a pressure of 5,000 Pa or less (also referred to as a "reduced pressure drying step") is included.

The pressure in the reduced pressure drying step is preferably 1 Pa to 3,000 Pa, more preferably 3 Pa to 2,000 Pa, and still more preferably 5 Pa to 1,500 Pa.

The drying temperature of the film in the reduced pressure drying step is preferably 35°C or higher and 150°C or lower, and more preferably 35°C or higher and 80°C or lower. The reduced pressure drying time is exemplified as 1 minute to 30 minutes, and is preferably 2 minutes to 20 minutes and more preferably 3 minutes to 15 minutes.

<Second aspect of manufacturing method for film>

The manufacturing method for a film according to the embodiment of the present invention may have the following aspect (also referred to as "second aspect").

A manufacturing method for a film, including

a step of applying a photosensitive resin composition onto a base material and then drying the photosensitive resin composition at a first temperature, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent, and

a step of drying the photosensitive resin composition at a second temperature higher than the first temperature under a pressure within a range of ±10% of the pressure in the step of drying the photosensitive resin composition at the first temperature.

The photosensitive resin composition and the base material used in the second aspect of the manufacturing method for a film according to the embodiment of the present invention are the same as those described above.

<Drying step of second aspect>

In the second aspect of the manufacturing method for a film according to the embodiment of the present invention, the above film is subjected to a step (a drying step) of drying the film (or the layer) formed for removing the solvent, after the film forming step (the layer forming step).

The second aspect of the manufacturing method for a film according to the embodiment of the present invention includes a step of drying the photosensitive resin composition at a first temperature after applying the photosensitive resin composition onto a base material, and a step of drying the photosensitive resin composition at a second temperature higher than the first temperature.
The pressure in the step of drying at the first temperature is not particularly limited, and may be, for example, normal pressure (101,325 Pa).
The pressure in the step of drying at the second temperature higher than the first temperature is within a range of ± 10% of the pressure in the step of drying at the first temperature (in a case where the pressure in the step of drying at the first temperature is denoted by "$P_1$ (Pa)", the pressure in the step of drying at the second temperature higher than the first temperature is "0.9 $P_1$ (Pa) or more and 1.1 $P_1$ (Pa) or less"). For example, in a case where the pressure in the step of drying at the first temperature is 101,325 Pa, the pressure in the step of drying at the second temperature higher than the first temperature is 91,193 Pa or more and 111,458 Pa or less.
The first temperature is not particularly limited, and is, for example, preferably 30°C or higher and 150°C or lower, and more preferably 35°C or higher and 110°C or lower.
The time for drying at the first temperature is not particularly limited, and may be, for example, 1 minute to 30 minutes, preferably 2 minutes to 20 minutes, and more preferably 3 minutes to 15 minutes.
The second temperature is not particularly limited, and for example, it is preferably 45°C or higher and 160°C or lower, and more preferably 50°C or higher and 130°C or lower.
It is preferable that the second temperature is higher than the first temperature by 20°C or more.
The time for drying at the second temperature is not particularly limited, and may be, for example, 1 minute to 30 minutes, preferably 1 minute to 20 minutes, and more preferably 1 minute to 15 minutes.
The second aspect of the manufacturing method for a film according to the embodiment of the present invention may further include one or more steps (for example, a step of drying at a third temperature, a step of drying at a fourth temperature, and the like) of drying at a temperature higher than the second temperature after the step of drying at the second temperature. In a case of including a step of drying at a temperature higher than the second temperature, it is preferable that the temperature of each step is higher than the temperature of the previous step by 20°C or more. In addition, in a case of including a step of drying at a temperature higher than the second temperature, the pressure in each step is preferably within a range of ± 10% of the pressure in the previous step.
In a case of including the step of drying at a temperature higher than the second temperature, the time for drying in each step is not particularly limited, and may be, for example, 1 minute to 30 minutes, preferably 1 minute to 20 minutes, and more preferably 1 minute to 15 minutes.

<Third aspect of manufacturing method for film>

The manufacturing method for a film according to the embodiment of the present invention may have the following aspect (also referred to as "third aspect").
A manufacturing method for a film, comprising only:

a step of applying a photosensitive resin composition onto a base material and then drying the photosensitive resin composition at 90°C or higher for a time longer than 5 minutes as a drying step, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

The photosensitive resin composition and the base material used in the third aspect of the manufacturing method for a film according to the embodiment of the present invention are the same as those described above.

<Drying step of third aspect>

In the third aspect of the manufacturing method for a film according to the embodiment of the present invention, the above film is subjected to a step (a drying step) of drying the film (or the layer) formed for removing the solvent, after the film forming step (the layer forming step).
The third aspect of the manufacturing method for a film according to the embodiment of the present invention

includes only a step of applying the photosensitive resin composition onto the base material and then drying the base material at 90°C or higher for a time longer than **5 minutes** as a drying step.

The pressure in the drying step of the third aspect is not particularly limited, and may be, for example, normal pressure (101,325 Pa).

The temperature in the drying step of the third aspect is 90°C or higher, preferably 100°C or higher and 150°C or lower, and more preferably 100°C or higher and 130°C or lower.

The time for drying in the drying step of the third aspect is a time longer than 5 minutes, and is preferably 8 minutes to 30 minutes, more preferably 10 minutes to 20 minutes, and still more preferably 10 minutes to 15 minutes.

**In** the third aspect, the drying step includes only a step of drying at 90°C or higher for a time longer than 5 minutes.

<Cured substance and manufacturing method for cured substance >

The cured substance according to the embodiment of the present invention is obtained by curing the above-described photosensitive resin composition according to the embodiment of the present invention.

The manufacturing method for a cured substance according to the embodiment of the present invention includes a step (film forming step) of applying the above-described photosensitive resin composition according to the embodiment of the present invention onto a base material and drying the applied composition under reduced pressure to form a film, an exposure step of selectively exposing the film, and a development step of developing the film exposed by the exposure step using a developer to form a pattern.

The manufacturing method for a cured substance may include at least one of a heating step of heating the pattern obtained by the development step or a post-development exposure step of exposing the pattern obtained by the development step.

**In** addition, the manufacturing method for a cured substance may include a step of heating the film.

Hereinafter, details of each step will be described.

<Film forming step>

The film forming step is as described above.

<Exposure step>

The film may be subjected to an exposure step of selectively exposing the film.

The manufacturing method for a cured substance may include an exposure step of selectively exposing the film formed by the film forming step.

The selective exposure means that a part of the film is exposed. **In** addition, by selectively exposing the film, an exposed region (an exposed portion) and an unexposed region (a non-exposed portion) are formed in the film.

The exposure amount is not particularly limited as long as the resin composition according to the embodiment of the present invention can be cured; however, it is, for example, preferably 50 to 10,000 mJ/cm$^2$ and more preferably 200 to 8,000 mJ/cm$^2$ in terms of conversion of exposure energy at a wavelength of 365 nm.

The exposure wavelength can be appropriately determined in a range of 190 to 1,000 nm and preferably in a range of 240 to 550 nm.

Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet ray: EUV (wavelength: 13.6 nm); (6) an electron beam; and (7) a second harmonic wave of 532 nm and a third harmonic wave of 355 nm of a YAG laser. Regarding the resin composition according to the embodiment of the present invention, exposure with a high pressure mercury lamp is particularly preferable, and from the viewpoint of exposure sensitivity, exposure with an i-line is more preferable.

The exposure method is not particularly limited as long as at least a part of the film consisting of the resin composition according to the embodiment of the present invention is exposed; however, examples thereof include exposure using a photo mask and exposure by a laser direct imaging method.

<Post-exposure heating step>

The film may be subjected to a step of carrying out heating after the exposure (a post-exposure heating step).

That is, the manufacturing method for a cured substance according to the embodiment of the present invention

may include a post-exposure heating step of heating the film exposed in the exposure step.

The post-exposure heating step can be carried out after the exposure step and before the development step.

The heating temperature in the post-exposure heating step is preferably 50°C to 140°C and more preferably 60°C to 120°C.

The heating time in the post-exposure heating step is preferably 30 seconds to 300 minutes and more preferably 1 minute to 10 minutes.

**In** the post-exposure heating step, the temperature rising rate from the temperature at the start of heating to the maximum heating temperature is preferably 1 to 12 °C/min, more preferably 2 to 10 °C/min, and still more preferably 3 to 10 °C/min.

**In** addition, the temperature rising rate may be appropriately changed during heating.

The heating means in the post-exposure heating step is not particularly limited, and a publicly known hot plate, oven, infrared heater, or the like can be used.

**In** addition, it is also preferable to carry out the heating in an atmosphere having a low oxygen concentration by allowing an inert gas such as nitrogen, helium, argon, or the like to flow.

<Development step>

The exposed film may be subjected to a development step of carrying out development using a developer to form a pattern.

That is, the manufacturing method for a cured substance according to the embodiment of the present invention may include a development step of developing the film exposed in the exposure step using a developer to form a pattern.

By carrying out the development, one of the exposed portion and the non-exposed portion of the film is removed, and a pattern is formed.

Here, the development in which the non-exposed portion of the film is removed by the development step is referred to as negative-tone development, and the development in which the exposed portion of the film is removed by the development step is referred to as positive-tone development.

[Developer]

Examples of the developer that is used in the development step include a developer containing an alkaline aqueous solution or an organic solvent.

**In** a case where the developer is an alkaline aqueous solution, examples of the basic compound that can be contained in the alkaline aqueous solution include inorganic alkalis, primary amines, secondary amines, tertiary amines, and a quaternary ammonium salt. The basic compound is preferably tetramethylammonium hydroxide (TMAH), potassium hydroxide, sodium carbonate, sodium hydroxide, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and it is more preferably TMAH. The content of the basic compound in the developer is preferably 0.01% to 10% by mass, more preferably 0.1% to 5% by mass, and still more preferably 0.3% to 3% by mass in the total mass of the developer.

**In** a case where the developer contains an organic solvent, the compounds described in paragraph 0387 of WO2021/112189A can be used as the organic solvent. The content thereof is incorporated in the present specification. **In** addition, suitable examples of the alcohols include methanol, ethanol, propanol, isopropanol, butanol, pentanol, octanol, diethylene glycol, propylene glycol, methyl isobutyl carbinol, and triethylene glycol, and suitable examples of the amides include N-methylpyrrolidone, N-ethylpyrrolidone, and dimethylformamide.

**In** a case where the developer contains an organic solvent, one kind of organic solvent can be used, or two or more kinds thereof can be mixedly used. **In** the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is particularly preferable.

**In** a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. **In** addition, the above content may be 100% by mass.

**In** a case where the developer contains an organic solvent, the developer may further contain at least one of a basic compound or a base generator. **In** a case where at least one of the basic compound or the base generator in the developer permeates into the pattern, the performance such as the breaking elongation of the pattern may be improved.

The basic compound is preferably an organic base from the viewpoint of the reliability in a case of being remained in the cured film (the adhesiveness to the base material in a case where the cured substance is further heated).

The basic compound is preferably a basic compound having an amino group and preferably a primary amine, a secondary amine, a tertiary amine, an ammonium salt, a tertiary amide, or the like. However, in order to accelerate the imidization reaction, it is preferably a primary amine, a secondary amine, a tertiary amine, or an ammonium salt, more preferably a secondary amine, a tertiary amine, or an ammonium salt, still more preferably a secondary amine or a tertiary amine, and particularly preferably a tertiary amine.

From the viewpoint of mechanical characteristics (the breaking elongation) of the cured substance, it is preferable that the basic compound hardly remains in the cured film (the obtained cured substance), and from the viewpoint of accelerating cyclization, it is preferable that the residual amount of the basic compound hardly decreases due to vaporization or the like before heating.

Therefore, the boiling point of the basic compound is preferably 30°C to 350°C, more preferably 80°C to 270°C, and still more preferably 100°C to 230°C at normal pressure (101,325 Pa).

The boiling point of the basic compound is preferably higher than the temperature obtained by subtracting 20°C from the boiling point of the organic solvent contained in the developer, and it is more preferably higher than the boiling point of the organic solvent contained in the developer.

For example, in a case where the boiling point of the organic solvent is 100°C, the basic compound to be used preferably has a boiling point of 80°C or higher and more preferably a boiling point of 100°C or higher.

The developer may contain only one kind of basic compound having an amide group or may contain two or more kinds thereof.

Specific examples of the basic compound include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, tetrabutylammonium hydroxide, ethylenediamine, butanediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl) amine, piperidine, methyl piperidine, dimethylpiperidine, piperazine, tropane, N-phenylbenzylamine, 1,2-dianilinoethane, 2-aminoethanol, toluidine, aminophenol, hexylaniline, phenylene diamine, phenylethylamine, dibenzylamine, pyrrole, N-methylpyrrole, N,N,N,N-tetramethylethylenediamine, and N,N,N,N-tetramethyl-1,3-propanediamine.

A preferred aspect of the base generator is the same as the preferred aspect of the base generator contained in the above-described composition. In particular, the base generator is preferably a thermal-base generator.

In a case where the developer contains at least one of a basic compound or a base generator, the content of the basic compound or the base generator is preferably 10% by mass or less, and more preferably 5% by mass or less with respect to the total mass of the developer. The lower limit of the content is not particularly limited; however, it is, for example, preferably 0.1% by mass or more.

In a case where the basic compound or the base generator is a solid in an environment where the developer is used, the content of the basic compound or the base generator is also preferably 70% to 100% by mass with respect to the total solid content of the developer.

The developer may contain only one kind of the basic compound or base generator or may contain two or more kinds thereof. In a case where at least one of the basic compound or the base generator is two or more kinds, the total thereof is preferably within the above-described range.

The developer may further contain another component.

Examples of the other component include a publicly known surfactant and a publicly known anti-foaming agent.

[Method of supplying developer]

The method of supplying a developer is not particularly limited as long as a desired pattern can be formed, and it includes a method of immersing a base material on which a film has been formed in a developer, puddle development of supplying a developer to a film formed on a base material using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the non-image area, and the manufacturing efficiency, a method of supplying a developer with a straight nozzle or a method of continuously supplying a developer with a spray nozzle is preferable, and from the viewpoint of the permeability of the developer into the image area,

a method of supplying a developer with a spray nozzle is more preferable.

In addition, after the continuous supply by a straight nozzle, the base material is spun to remove the developer from the base material, and then the developer is continuously supplied by the straight nozzle again after the spin drying, a step of spinning the base material to remove the developer from the base material may be adopted, and this step may be repeated a plurality of times.

Examples of the method of supplying a developer in the development step include a step of continuously supplying a developer to a base material, a step of keeping a developer in a substantially stationary state on a base material, a step of vibrating a developer on a base material by ultrasonic waves or the like, and a step obtained by combining these steps.

The development time is preferably 10 seconds to 10 minutes and more preferably 20 seconds to 5 minutes. The temperature of the developer during development is not particularly determined; however, it is preferably 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

[Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.

Examples of the organic solvent in a case where the rinsing liquid contains an organic solvent include the same organic solvents as the organic solvents exemplified in the above-described case where the developer contains an organic solvent.

The organic solvent contained in the rinsing liquid is preferably an organic solvent different from the organic solvent contained in the developer, and it is more preferably an organic solvent having a solubility of the pattern, which is lower than that of the organic solvent contained in the developer.

In a case where the rinsing liquid contains an organic solvent, one kind of organic solvent can be used, or two or more kinds thereof can be mixedly used. As the organic solvent, cyclopentanone, γ-butyrolactone, dimethyl sulfoxide, N-methylpyrrolidone, cyclohexanone, propylene glycol monomethyl ether acetate (PGMEA), or propylene glycol monomethyl ether (PGME) is preferable, cyclopentanone, γ-butyrolactone, dimethyl sulfoxide, PGMEA, or PGME is more preferable, and cyclohexanone or PGMEA is still more preferable.

In a case where the rinsing liquid contains an organic solvent, the organic solvent is preferably 50% by mass or more, more preferably 70% by mass or more, and still more preferably 90% by mass or more with respect to the total mass of the rinsing liquid. In addition, the organic solvent may be 100% by mass with respect to the total mass of the rinsing liquid.

The rinsing liquid may contain at least one of a basic compound or a base generator.

Although not particularly limited, in a case where the developer contains an organic solvent, an aspect in which the rinsing liquid contains at least one of an organic solvent, a basic compound, or a base generator is also one of the preferred aspects of the present invention.

Examples of the basic compound and the base generator which are contained in the rinsing liquid include the compounds exemplified as the basic compound and the base generator which may be contained in a case where the developer contains an organic solvent, and the same applies to the preferred aspects thereof.

The basic compound and the base generator, which are contained in the rinsing liquid, may be selected in consideration of the solubility in the solvent in the rinsing liquid.

In a case where the rinsing liquid contains at least one of a basic compound or a base generator, the content of the basic compound or the base generator is preferably 10% by mass or less, and more preferably 5% by mass or less with respect to the total mass of the rinsing liquid. The lower limit of the content is not particularly limited; however, it is, for example, preferably 0.1% by mass or more.

In a case where the basic compound or the base generator is a solid in an environment where the rinsing liquid is used, the content of the basic compound or the base generator is also preferably 70% to 100% by mass with respect to the total solid content of the rinsing liquid.

In a case where the rinsing liquid contains at least one of a basic compound or a base generator, the rinsing liquid may contain only one kind of the basic compound or base generator or may contain two or more kinds thereof. In a case where at least one of the basic compound or the base generator is two or more kinds, the total thereof is preferably within the above-described range.

The rinsing liquid may further contain another component.

Examples of the other component include a publicly known surfactant and a publicly known anti-foaming agent.

[Method of supplying rinsing liquid]

The method of supplying a rinsing liquid is not particularly limited as long as a desired pattern can be formed and includes a method of immersing a base material in a rinsing liquid, a method of supplying a rinsing liquid to a base material by liquid filling, a method of supplying a rinsing liquid to a base material with a shower, and a method of continuously supplying a rinsing liquid to a base material by means such as a straight nozzle.

From the viewpoint of the permeability of the rinsing liquid, the removability of non-image area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.

That is, the rinsing step is preferably a step of supplying, with a straight nozzle, or continuously supplying a rinsing liquid to the exposed film, and it is more preferably a step of supplying a rinsing liquid with a spray nozzle.

In the method of supplying a rinsing liquid in the rinsing step, a step of continuously supplying a rinsing liquid to a base material, a step of keeping a rinsing liquid in a substantially stationary state on a base material, a step of vibrating a rinsing liquid on the base material by ultrasonic waves or the like, and a step obtained by combining these steps can be adopted.

The rinsing time is preferably 10 seconds to 10 minutes and more preferably 20 seconds to 5 minutes. The temperature of the rinsing liquid during rinsing is not particularly determined; however, it is preferably 10°C to 45°C and more preferably 18°C to 30°C.

The development step may include a step of bringing the treatment liquid into contact with the pattern after the treatment using the developer or after the pattern is washed with the rinsing liquid. In addition, such a method of supplying a treatment liquid before the developer or rinsing liquid which is in contact with the pattern is completely dried may be adopted.

Examples of the treatment liquid include a treatment liquid containing at least one of water or an organic solvent and at least one of a basic compound or a base generator.

Preferred aspects of the organic solvent and at least one of the basic compound or the base generator are the same as the preferred aspects of the organic solvent and at least one of the basic compound or the base generator, which are used in the above-described rinsing liquid.

As a method of supplying the treatment liquid to the pattern, the same method as the above-described method of supplying the rinsing liquid can be used, and the same applies to the preferred aspect thereof.

The content of the basic compound or the base generator in the treatment liquid is preferably 10% by mass or less and more preferably 5% by mass or less with respect to the total mass of the treatment liquid. The lower limit of the content is not particularly limited; however, it is, for example, preferably 0.1% by mass or more.

In addition, In a case where the basic compound or the base generator is a solid in an environment where the treatment liquid is used, the content of the basic compound or the base generator is also preferably 70% to 100% by mass with respect to the total solid content of the treatment liquid.

In a case where the treatment liquid contains at least one of a basic compound or a base generator, the treatment liquid may contain only one kind of the basic compound or the base generator, or may contain two or more kinds thereof. In a case where at least one of the basic compound or the base generator is two or more kinds, the total thereof is preferably within the above-described range.

<Heating step>

The pattern obtained by the development step (a pattern after the rinsing in a case where the rinsing step is carried out) may be subjected to a heating step of heating the pattern obtained by the development.

That is, the manufacturing method for a cured substance according to the embodiment of the present invention may include a heating step of heating the pattern obtained by the development step.

In addition, the manufacturing method for a cured substance according to the embodiment of the present invention may include a pattern obtained by another method without carrying out the development step, or a heating step of heating a film obtained by the film forming step.

In the heating step, the resin such as the polyimide precursor is cyclized to be a resin such as polyimide.

In addition, the crosslinking of unreacted crosslinkable groups in the specific resin or a crosslinking agent other than the specific resin also proceeds.

The heating temperature (the maximum heating temperature) in the heating step is preferably 50°C to 450°C, more preferably 150°C to 350°C, still more preferably 150°C to 250°C, even still more preferably 160°C to 250°C, and particularly preferably 160°C to 230°C.

The heating step is preferably a step of accelerating the cyclization reaction of the polyimide precursor in the pattern under the action of the base or the like generated from the base generator by heating.
The heating in the heating step is preferably carried out at a temperature rising rate of 1 to 12°C/min from the temperature at the start of heating to the maximum heating temperature. The temperature rising rate is more preferably 2 to 10 °C/min and still more preferably 3 to 10 °C/min. In a case where the above temperature rising rate is set to 1 °C/min or higher, the excessive volatilization of the acid or solvent can be prevented while securing productivity, and in a case where the above temperature rising rate is to 12 °C/min or lower, the residual stress of the cured substance can be relaxed.
In addition, in a case of an oven that enables rapid heating, the heating is preferably carried out at a temperature rising rate of 1 to 8°C/sec from the temperature at the start of heating to the maximum heating temperature, more preferably 2 to 7 °C/sec, and still more preferably 3 to 6 °C/sec.
The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a base material and then dried, the temperature at the start of heating is the temperature of the film (the layer) after drying, and for example, it is preferable to raise the temperature from a temperature lower by 30°C to 200°C than the boiling point of the solvent contained in the resin composition.
The heating time (the heating time at the maximum heating temperature) is preferably 5 to 360 minutes, more preferably 10 to 300 minutes, and still more preferably 15 to 240 minutes.
In particular, in a case of forming a multilayered laminate, the heating temperature is preferably 30°C or higher, more preferably 80°C or higher, still more preferably 100°C or higher, and particularly preferably 120°C or higher, from the viewpoint of adhesiveness between layers.
The upper limit of the heating temperature is preferably 350°C or lower, more preferably 250°C or lower, and still more preferably 240°C or lower.
The heating may be carried out stepwise. For example, a step in which the temperature is raised from 25°C to 120°C at 3 °C/min, held at 120°C for 60 minutes, raised from 120°C to 180°C at 2 °C/min, and held at 180°C for 120 minutes, may be carried out. In addition, it is also preferable to carry out the treatment while carrying out irradiation with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment may be carried out as a step of two or more stages, for example, a first stage pretreatment step may be carried out in a range of 100°C to 150°C, and then a second stage pretreatment step may be carried out in a range of 150°C to 200°C.
Further, cooling may be carried out after heating, and the cooling rate, in this case, is preferably 1 to 5 °C/min.
From the viewpoint of preventing the decomposition of the specific resin, it is preferable that the heating step is carried out in an atmosphere of a low oxygen concentration, for example, by allowing an inert gas such as nitrogen, helium, argon, or the like to flow, or carrying out heating under reduced pressure. The oxygen concentration is preferably 50 ppm (volume ratio) or lower, and more preferably 20 ppm (volume ratio) or lower.
The heating means in the heating step is not particularly limited; however, examples thereof include a hot plate, an infrared furnace, an electric heating oven, a hot air oven, and an infrared oven.

<Post-development exposure step>

The pattern obtained by the development step (a pattern after the rinsing in a case where the rinsing step is carried out) may be subjected to a post-development exposure step of exposing the pattern after the development step, instead of the heating step or in addition to the heating step.
That is, the manufacturing method for a cured substance according to the embodiment of the present invention may include a post-development exposure step of exposing the pattern obtained by the development step. The manufacturing method for a cured substance according to the embodiment of the present invention may include the heating step and the post-development exposure step or may include only one of the heating step and the post-development exposure step.
In the post-development exposure step, it is possible to accelerate, for example, a reaction in which the cyclization of a polyimide precursor or the like proceeds by photosensitization of a photobase generator, a reaction in which the elimination of an acid-decomposable group proceeds by photosensitization of a photoacid generator.
In the post-development exposure step, it is sufficient that at least a part of the pattern obtained in the development step is exposed; however, it is preferable that the whole of the above pattern is exposed.
The exposure amount in the post-development exposure step is preferably 50 to 20,000 mJ/$cm^2$ and more preferably 100 to 15,000 mJ/$cm^2$ in terms of conversion of exposure energy at the wavelength at which the photosensitive compound has a sensitivity.
The post-development exposure step can be carried out using, for example, the light source in the above-described exposure step, and it is preferable to use broadband light.

<Metal layer forming step>

The pattern (preferably a pattern that has been subjected to at least one of the heating step or the post-development exposure step) obtained by the development step may be subjected to a metal layer forming step of forming a metal layer on the pattern.

That is, it is preferable that the manufacturing method for a cured substance according to the embodiment of the present invention includes a metal layer forming step of forming a metal layer on the pattern (preferably a pattern that has been subjected to at least one of the heating step or the post-development exposure step) obtained by the development step.

For the metal layer, existing metal kinds can be used without particular limitations. Examples thereof include copper, aluminum, nickel, vanadium, titanium, chromium, cobalt, gold, tungsten, tin, silver, and an alloy including these metals, where copper or aluminum is more preferable, and copper is still more preferable.

The forming method for the metal layer is not particularly limited, and the existing method can be applied. For example, the methods described in JP2007-157879A, JP2001-521288A, JP2004-214501A, JP2004-101850A, US7888181B2, and US9177926B2 can be used. For example, photolithography, physical vapor deposition method (PVD), chemical vapor phase growth method (CVD), lift-off, electrolytic plating, electroless plating, etching, printing, and a method obtained by combining these may be conceivable. More specific examples of the forming method for the metal layer include a patterning method obtained by combining sputtering, photolithography, and etching, and a patterning method combining photolithography and electrolytic plating. Examples of the preferred aspect of the plating include electrolytic plating using a copper sulfate plating liquid or a copper cyanide plating liquid.

The thickness of the metal layer at the thickest portion is preferably 0.01 to 50 $\mu$m and more preferably 1 to 10 $\mu$m.

<Use application>

Examples of the field to which the manufacturing method for a cured substance according to the embodiment of the present invention or the cured substance according to the embodiment of the present invention can be applied include an insulating film of an electronic device, an interlayer insulating film for a re-distribution layer, and a stress buffer film. In addition, a sealing film, a substrate material (a base film or cover lay of a flexible print substrate, an interlayer insulating film), or such an insulating film in a use application for mounting as described above, which is patterned by etching, is mentioned. For these use applications, for example, Science & Technology Co., Ltd., "High functionality and applied technology of polyimide" April 2008, Technical library CMC TL "Basics and development of polyimide materials" supervised by Masaaki Kakimoto, published in November 2011, "Latest Polyimide Basics and Applications" edited by Japan Polyimide & Aromatic Polymers Study Group, NTS Inc., August 2010, or the like can be referred to.

The manufacturing method for a cured substance according to the embodiment of the present invention and the cured substance according to the embodiment of the present invention can also be used for the production of board surfaces such as an offset board surface or a screen board surface, for etching of molded parts, for the production of protective lacquers and dielectric layers in electronics, in particular, microelectronics.

(Laminate and manufacturing method for laminate)

A laminate according to the embodiment of the present invention refers to a structure body having a plurality of layers consisting of the cured substance according to the embodiment of the present invention.

The laminate is a laminate including two or more layers consisting of a cured substance, and it may be a laminate in which three or more layers are laminated.

At least one of the two or more layers consisting of a cured substance, which are included in the laminate, is a layer consisting of the cured substance according to the embodiment of the present invention, and from the viewpoint of suppressing the shrinkage of the cured substance or the deformation of the cured substance due to the shrinkage, it is also preferable that all the layers consisting of a cured substance which are included in the laminate are layers consisting of the cured substance according to the embodiment of the present invention.

That is, it is preferable that the manufacturing method for a laminate according to the embodiment of the present invention includes the manufacturing method for a cured substance according to the embodiment of the present invention, and it is more preferable to include repeating, a plurality of times, the manufacturing method for a cured substance according to the embodiment of the present invention.

In the laminate according to the embodiment of the present invention, an aspect in which two or more layers of layers consisting of a cured substance are included and a metal layer is provided between any of the layers consisting of the cured substance is preferable. The metal layer is preferably formed in the metal layer forming step.

That is, it is preferable that the manufacturing method for a laminate according to the embodiment of the present invention further includes a metal layer forming step of forming a metal layer on a layer consisting of the cured substance, between the manufacturing methods for a cured substance which are carried out a plurality of times. The preferred aspect of the metal layer forming step is as described above.

Examples of the preferred laminate include a laminate including at least a layer structure in which three layers of a layer consisting of a first cured substance, a metal layer, and a layer consisting of a second cured substance are laminated in order.

It is preferable that both the layer consisting of the first cured substance and the layer consisting of the second cured substance are layers consisting of the cured substance according to the embodiment of the present invention. The resin composition according to the embodiment of the present invention which is used for forming a layer consisting of the first cured substance and the resin composition according to the embodiment of the present invention which is used for forming a layer consisting of the second cured substance may have the same composition or may have compositions different from each other. The metal layer in the laminate according to the embodiment of the present invention is preferably used as the metal wiring line of the re-distribution layer or the like.

<Laminating step>

The manufacturing method for a laminate according to the embodiment of the present invention preferably further includes a laminating step.

The laminating step is a series of steps including carrying out again, in the following order on the surface of the pattern (the resin layer) or the metal layer, at least one of (a) the film forming step (the layer forming step), (b) the exposure step, (c) the development step, or (d) the heating step and the post-development exposure step. However, the aspect thereof may be such that at least one of (a) the film forming step or (d) the heating step and the post-development exposure step is repeated. In addition, (e) the metal layer forming step may be included after at least one of the heating step or the post-development exposure step of (d). It is needless to say that the laminating step may further include appropriately the above-described drying step.

In a case where another laminating step is further carried out after the laminating step, a surface activation treatment step may be further carried out after the exposure step, the heating step, or the metal layer forming step. Examples of the surface activation treatment include plasma treatment. Details of the surface activation treatment will be described later.

The laminating step is preferably carried out 2 to 20 times and more preferably 2 to 9 times.

For example, a configuration having resin layers of 2 or more layers and 20 or less layers, such as a resin layer/a metal layer/a resin layer/a metal layer/a resin layer/a metal layer, is preferable, and a configuration having resin layers of 2 or more layers and 9 or less layers is still more preferable.

In the above layers, the compositions, shapes, film thicknesses, and the like may be the same or may be different from each other.

In the present invention, an aspect in which a metal layer is provided, and then furthermore, a cured substance (a resin layer) of the resin composition according to the aspect of the present invention is formed to cover the metal layer is particularly preferable. Specific examples thereof include an aspect in which (a) the film forming step, (b) the exposure step, (c) the development step, (d) at least one of the heating step or the post-development exposure step, (e) the metal layer forming step are repeated in this order, and an aspect in which (a) the film forming step, (d) at least one of the heating step or the post-development exposure step, and (e) the metal layer forming step are repeated in order. By alternately carrying out the laminating step of laminating the resin composition layer (the resin layer) of the present invention and the metal layer forming step, the resin composition layer (the resin layer) according to the embodiment of the present invention and the metal layer can be alternately laminated.

(Surface activation treatment step)

The manufacturing method for a laminate according to the embodiment of the present invention preferably includes a surface activation treatment step of subjecting at least a part of the metal layer or a part of the resin composition layer to a surface activation treatment.

The surface activation treatment step is usually carried out after the metal layer forming step (preferably, after at least one of the heating step or the post-development exposure step). However, after the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is preferable

to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

It is preferable that the surface activation treatment is carried out on a part or whole of the resin composition layer (the resin layer) after the exposure. In a case where a surface of the resin composition layer is subjected to the surface activation treatment in this manner, it is possible to improve the adhesiveness to a metal layer or a resin layer to be provided on the surface that has been subjected to the surface activation treatment. In particular, in a case where the resin composition layer is cured, such as in a case where negative-tone development is carried out, it is less likely to be damaged by the surface treatment, and thus the adhesiveness is likely to be improved.

The surface activation treatment can be carried out, for example, according to the method described in paragraph 0415 of WO2021/112189A. The content thereof is incorporated in the present specification.

(Semiconductor device and manufacturing method therefor)

The present invention also discloses a semiconductor device, which includes the cured substance according to the embodiment of the present invention or the laminate.

In addition, the present invention also discloses a manufacturing method for a semiconductor device, which includes the manufacturing method for a cured substance according to the embodiment of the present invention or the manufacturing method for a laminate according to the embodiment of the present invention.

As the specific examples of the semiconductor device using the resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

Examples

Hereinafter, the present invention will be described in detail using examples. Materials, using amounts, proportions, treatment details, treatment content, and the like shown in the following examples can be appropriately changed without departing from the gist of the present invention. Accordingly, the scope of the present invention is not limited to the following specific examples. Unless otherwise specified, "parts" and "%" are based on mass.

<Examples and Comparative Examples>

In each of Examples and Comparative Examples, the components shown in Tables 1 to 4 below were mixed to obtain each resin composition.

Specifically, the content of the solid content among each component shown in Tables 1 to 4 was the amount (parts by mass) shown in the column of "amount" in each column of the tables. The "amount" of the solvent is a content mass ratio of each solvent with respect to the total amount of the solvent. The usage amount of the total solvent was adjusted such that the concentration of solid contents of each resin composition was the value shown in the table.

The obtained resin composition was filtered under pressure using a filter made of polytetrafluoroethylene, having a micropore width of 0.5 μm.

In the table, "(B-1)" represents "(B-1) radically polymerizable compound", "(C)" represents "(C) photopolymerization initiator", "(D-1)" represents "(D-1) compound having free radical in molecule", "(D-2)" represents "(D-2) compound having no free radical in molecule and having molecular weight of 270 or more", "(DR)" represents "(DR) other polymerization inhibitors", "(F)" represents "(F) surfactant", "(G)" represents "(G) metal adhesiveness improving agent (silane coupling agent)", "(K)" represents "(K) base generator", "(N)" represents "(N) migration suppressing agent", and "(M)" represents "(M) other additives".

In the table, the description of "-" indicates that the corresponding component is not contained in the resin composition.

"G-12" described in the column of "(G)" of Example 37 means a mixture of G-1 and G-2 (G-1/G-2 in terms of mass ratio = 1/1). That is, in Example 37, as the (G) metal adhesiveness improving agent (silane coupling agent), G-1 and G-2 were used in a total amount of 1.60 parts by mass at a mass ratio of G-1/G-2 = 1/1.

"K-12" described in the column of "(K)" of Example 64 means a mixture of K-1 and K-2 (K-1/K-2 = 1/1 in terms of mass ratio). That is, in Example 64, as the (K) base generator, K-1 and K-2 were used in a total amount of 2.40 parts by mass at a mass ratio of K-1/K-2 = 1/1.

"N-12" described in the column of "(N)" of Example 68 means a mixture of N-1 and N-2 (N-1/N-2 = 1/1 in terms of mass ratio). That is, in Example 68, as the (N) migration suppressing agent, N-1 and N-2 were used in a total amount of 0.36

parts by mass at a mass ratio of N-1/N-2 = 1/1.

In Example 124, 2.46 parts by mass of C-3 and 1.25 parts by mass of C-7 were used as the (C) photopolymerization initiator.

[Table 1]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-1) | | (C) | | (D-1) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 1 | 23.00 | A-1 | 80.78 | B-1-1 | 12.50 | C-3 | 2.75 | D-1-1 | 0.20 | - | 0.00 | - | 0.00 | - | 0.00 | G-1 | 1.50 | K-1 | 2.00 | N-1 | 0.27 | - | 0.00 | E-3 | 80 | E-4 | 20 |
| | 2 | 24.00 | A-2 | 80.07 | B-1-2 | 12.80 | C-3 | 2.68 | D-1-2 | 0.55 | - | 0.00 | - | 0.00 | - | 0.00 | G-2 | 1.65 | K-1 | 1.95 | N-2 | 0.30 | - | 0.00 | E-3 | 80 | E-4 | 20 |
| | 3 | 21.40 | A-3 | 80.80 | B-1-3 | 12.00 | C-3 | 2.88 | D-1-3 | 0.18 | - | 0.00 | - | 0.00 | - | 0.00 | G-1 | 1.70 | K-1 | 2.20 | N-1 | 0.24 | - | 0.00 | E-3 | 80 | E-4 | 20 |
| | 4 | 24.60 | A-4 | 80.27 | B-1-4 | 12.40 | C-3 | 2.91 | D-1-4 | 0.36 | - | 0.00 | - | 0.00 | - | 0.00 | G-2 | 1.70 | K-1 | 2.00 | N-2 | 0.36 | - | 0.00 | E-3 | 75 | E-4 | 25 |
| | 5 | 26.10 | A-5 | 80.33 | B-1-5 | 12.60 | C-3 | 2.64 | D-1-5 | 0.50 | - | 0.00 | - | 0.00 | - | 0.00 | G-1 | 1.65 | K-1 | 1.98 | N-1 | 0.30 | - | 0.00 | E-3 | 80 | E-4 | 20 |
| | 6 | 22.80 | A-6 | 80.99 | B-1-6 | 12.50 | C-3 | 2.58 | D-1-6 | 0.32 | - | 0.00 | - | 0.00 | - | 0.00 | G-2 | 1.45 | K-1 | 1.89 | N-2 | 0.27 | - | 0.00 | E-3 | 80 | E-4 | 20 |
| | 7 | 32.00 | A-7 | 80.84 | B-1-7 | 12.20 | C-3 | 2.64 | D-1-7 | 0.20 | - | 0.00 | - | 0.00 | - | 0.00 | G-5 | 2.00 | K-1 | 1.90 | N-1 | 0.22 | - | 0.00 | E-3 | 80 | E-4 | 20 |
| | 8 | 23.30 | A-8 | 81.31 | B-1-1 | 12.40 | C-3 | 2.60 | D-1-8 | 0.11 | - | 0.00 | - | 0.00 | - | 0.00 | G-5 | 1.40 | K-1 | 1.94 | N-2 | 0.24 | - | 0.00 | E-3 | 80 | E-4 | 20 |
| | 9 | 24.70 | A-9 | 79.65 | B-1-1 | 13.00 | C-3 | 2.80 | D-1-9 | 0.44 | - | 0.00 | - | 0.00 | - | 0.00 | G-5 | 1.75 | K-1 | 2.00 | N-1 | 0.36 | - | 0.00 | E-3 | 80 | E-4 | 20 |
| | 10 | 27.50 | A-10 | 80.45 | B-1-8 | 12.80 | C-3 | 2.65 | D-1-10 | 0.22 | - | 0.00 | - | 0.00 | - | 0.00 | G-5 | 1.60 | K-1 | 1.98 | N-2 | 0.30 | - | 0.00 | E-3 | 80 | E-4 | 20 |
| | 11 | 25.50 | A-11 | 81.83 | B-1-9 | 14.00 | C-3 | 2.77 | D-1-11 | 0.24 | - | 0.00 | - | 0.00 | - | 0.00 | G-1 | 1.00 | - | 0.00 | N-1 | 0.16 | - | 0.00 | E-1 | 100 | - | 0 |
| | 12 | 22.90 | A-12 | 80.56 | B-1-10 | 15.00 | C-3 | 2.96 | D-1-12 | 0.26 | - | 0.00 | - | 0.00 | - | 0.00 | G-2 | 1.00 | - | 0.00 | N-2 | 0.22 | - | 0.00 | E-3 | 80 | E-4 | 20 |
| | 13 | 24.90 | A-13 | 83.30 | B-1-1 | 12.50 | C-3 | 2.72 | D-1-11 | 0.26 | - | 0.00 | - | 0.00 | - | 0.00 | G-2 | 1.00 | - | 0.00 | N-2 | 0.22 | - | 0.00 | E-3 | 80 | E-4 | 20 |
| | 14 | 26.00 | A-14 | 82.06 | B-1-1 | 13.20 | C-3 | 3.10 | D-1-13 | 0.20 | - | 0.00 | - | 0.00 | - | 0.00 | G-2 | 1.20 | - | 0.00 | N-1 | 0.24 | - | 0.00 | E-3 | 80 | E-4 | 20 |
| | 15 | 27.10 | A-1 | 78.83 | B-1-1 | 12.20 | C-3 | 2.48 | D-1-14 | 0.29 | - | 0.00 | - | 0.00 | - | 0.00 | G-2 | 1.15 | K-2 | 2.85 | N-2 | 0.20 | M-1 | 2.00 | E-3 | 80 | E-4 | 20 |
| | 16 | 21.90 | A-2 | 79.60 | B-1-1 | 12.60 | C-3 | 2.76 | D-1-15 | 0.30 | - | 0.00 | - | 0.00 | - | 0.00 | G-2 | 1.30 | K-2 | 3.00 | N-2 | 0.44 | - | 0.00 | E-3 | 75 | E-4 | 25 |
| | 17 | 22.80 | A-3 | 81.52 | B-1-1 | 11.80 | C-3 | 2.58 | D-1-16 | 0.26 | - | 0.00 | - | 0.00 | - | 0.00 | G-2 | 1.45 | K-2 | 1.99 | N-2 | 0.40 | - | 0.00 | E-3 | 80 | E-4 | 20 |
| | 18 | 26.40 | A-4 | 80.21 | B-1-1 | 12.20 | C-3 | 2.55 | D-1-17 | 0.23 | - | 0.00 | - | 0.00 | - | 0.00 | G-2 | 1.80 | K-2 | 2.66 | N-2 | 0.35 | - | 0.00 | E-3 | 80 | E-4 | 20 |
| | 19 | 25.10 | A-5 | 79.08 | B-1-1 | 12.60 | C-3 | 2.67 | D-1-18 | 0.25 | - | 0.00 | - | 0.00 | - | 0.00 | G-2 | 2.20 | K-2 | 2.87 | N-2 | 0.33 | - | 0.00 | E-3 | 80 | E-4 | 20 |
| | 20 | 24.20 | A-6 | 80.32 | B-1-1 | 12.40 | C-3 | 2.49 | D-1-19 | 0.34 | - | 0.00 | - | 0.00 | - | 0.00 | G-2 | 1.65 | K-2 | 2.46 | N-2 | 0.34 | - | 0.00 | E-3 | 80 | E-4 | 20 |
| | 21 | 29.00 | A-7 | 80.84 | B-1-1 | 11.60 | C-3 | 2.85 | D-1-20 | 0.30 | - | 0.00 | - | 0.00 | - | 0.00 | G-2 | 1.45 | K-2 | 2.66 | N-2 | 0.30 | - | 0.00 | E-3 | 80 | E-4 | 20 |
| | 22 | 26.70 | A-8 | 79.93 | B-1-1 | 12.80 | C-3 | 2.88 | D-1-21 | 0.28 | - | 0.00 | - | 0.00 | - | 0.00 | G-2 | 1.30 | K-2 | 2.45 | N-2 | 0.36 | - | 0.00 | E-1 | 80 | E-2 | 20 |
| | 23 | 24.40 | A-9 | 81.04 | B-1-1 | 11.00 | C-3 | 2.91 | D-1-22 | 0.36 | - | 0.00 | - | 0.00 | - | 0.00 | G-2 | 1.75 | K-2 | 2.70 | N-2 | 0.24 | - | 0.00 | E-3 | 80 | E-4 | 20 |
| | 24 | 26.00 | A-10 | 80.66 | B-1-1 | 12.60 | C-3 | 2.50 | D-1-23 | 0.24 | - | 0.00 | - | 0.00 | - | 0.00 | G-2 | 1.50 | K-2 | 2.20 | N-2 | 0.30 | - | 0.00 | E-3 | 80 | E-4 | 20 |
| | 25 | 23.70 | A-12 | 82.71 | B-1-1 | 12.40 | C-3 | 2.63 | D-1-24 | 0.20 | - | 0.00 | - | 0.00 | - | 0.00 | G-2 | 1.90 | - | 0.00 | N-2 | 0.16 | - | 0.00 | E-3 | 80 | E-4 | 20 |
| | 26 | 24.10 | A-1 | 81.01 | B-1-2 | 10.00 | C-3 | 2.90 | D-1-25 | 0.18 | - | 0.00 | - | 0.00 | - | 0.00 | G-2 | 1.45 | K-3 | 1.50 | N-1 | 0.22 | M-3 | 2.74 | E-3 | 80 | E-4 | 20 |
| | 27 | 20.80 | A-2 | 80.88 | B-1-2 | 12.40 | C-3 | 2.74 | D-1-26 | 0.30 | - | 0.00 | - | 0.00 | - | 0.00 | G-2 | 1.55 | K-3 | 1.98 | N-1 | 0.15 | - | 0.00 | E-1 | 100 | - | 0 |
| | 28 | 25.00 | A-3 | 82.02 | B-1-2 | 12.00 | C-3 | 2.70 | D-1-27 | 0.22 | - | 0.00 | - | 0.00 | - | 0.00 | G-2 | 1.80 | K-3 | 1.14 | N-1 | 0.12 | - | 0.00 | E-3 | 80 | E-4 | 20 |
| | 29 | 23.60 | A-4 | 80.38 | B-1-2 | 12.80 | C-3 | 2.75 | D-1-28 | 0.24 | - | 0.00 | - | 0.00 | - | 0.00 | G-2 | 2.05 | K-3 | 1.60 | N-1 | 0.18 | - | 0.00 | E-3 | 80 | E-4 | 20 |
| | 30 | 22.20 | A-5 | 80.80 | B-1-2 | 13.20 | C-3 | 2.68 | D-1-29 | 0.20 | - | 0.00 | - | 0.00 | - | 0.00 | G-2 | 1.45 | K-3 | 1.47 | N-1 | 0.20 | - | 0.00 | E-3 | 80 | E-4 | 20 |
| | 31 | 27.00 | A-6 | 81.49 | B-1-2 | 11.20 | C-3 | 3.04 | D-1-30 | 0.34 | - | 0.00 | - | 0.00 | - | 0.00 | G-2 | 1.55 | K-3 | 2.05 | N-1 | 0.33 | - | 0.00 | E-3 | 80 | E-4 | 20 |
| | 32 | 34.40 | A-7 | 81.62 | B-1-2 | 10.80 | C-3 | 3.34 | D-1-31 | 0.30 | - | 0.00 | - | 0.00 | - | 0.00 | G-2 | 1.75 | K-3 | 1.95 | N-1 | 0.24 | - | 0.00 | E-3 | 80 | E-4 | 20 |
| | 33 | 28.30 | A-8 | 79.52 | B-1-2 | 12.00 | C-3 | 2.77 | D-1-32 | 0.24 | - | 0.00 | - | 0.00 | - | 0.00 | G-2 | 1.85 | K-3 | 1.76 | N-1 | 0.26 | M-4 | 1.60 | E-3 | 80 | E-4 | 20 |
| | 34 | 21.60 | A-9 | 80.86 | B-1-2 | 12.40 | C-3 | 2.90 | D-1-33 | 0.32 | - | 0.00 | - | 0.00 | - | 0.00 | G-2 | 1.65 | K-3 | 1.67 | N-1 | 0.20 | - | 0.00 | E-3 | 80 | E-4 | 20 |
| | 35 | 24.00 | A-10 | 80.77 | B-1-2 | 12.60 | C-3 | 2.84 | D-1-34 | 0.28 | - | 0.00 | - | 0.00 | - | 0.00 | G-2 | 1.45 | K-3 | 1.80 | N-1 | 0.26 | - | 0.00 | E-3 | 80 | E-4 | 20 |
| | 36 | 22.30 | A-12 | 81.84 | B-1-2 | 11.40 | C-3 | 2.80 | D-1-35 | 0.20 | - | 0.00 | - | 0.00 | - | 0.00 | G-2 | 1.50 | K-1 | 1.99 | N-1 | 0.27 | - | 0.00 | E-3 | 80 | E-4 | 20 |
| | 37 | 29.00 | A-1 | 77.13 | B-1-3 | 12.60 | C-3 | 2.68 | D-1-36 | 0.24 | - | 0.00 | - | 0.00 | - | 0.00 | G-12 | 1.60 | K-1 | 2.10 | N-2 | 0.30 | M-5 | 3.35 | E-3 | 80 | E-4 | 20 |
| | 38 | 21.60 | A-2 | 80.25 | B-1-3 | 13.40 | C-3 | 2.75 | D-1-37 | 0.16 | - | 0.00 | - | 0.00 | - | 0.00 | G-2 | 1.50 | K-1 | 1.84 | N-3 | 0.10 | - | 0.00 | E-3 | 80 | E-4 | 20 |
| | 39 | 20.70 | A-3 | 80.55 | B-1-3 | 12.20 | C-3 | 3.00 | D-1-38 | 0.22 | - | 0.00 | - | 0.00 | - | 0.00 | G-2 | 1.75 | K-1 | 2.04 | N-2 | 0.24 | - | 0.00 | E-3 | 80 | E-4 | 20 |
| | 40 | 23.80 | A-4 | 80.62 | B-1-1 | 12.40 | C-3 | 2.70 | - | 0.00 | D-2-1 | 0.33 | - | 0.00 | - | 0.00 | G-2 | 1.65 | K-1 | 2.00 | N-2 | 0.30 | - | 0.00 | E-3 | 80 | E-4 | 20 |

[Table 2]

| | | Concentration of solid contents [mass%] | Solid content | | | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|---|---|
| | | | Resin (A) | | (B-1) | | (C) | | (D-1) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 41 | 22.60 | A-5 | 82.12 | B-1-1 | 10.80 | C-3 | 2.80 | - | 0.00 | D-2-2 | 0.30 | - | 0.00 | - | 0.00 | G-2 | 1.85 | K-1 | 1.87 | N-2 | 0.26 | - | 0.00 | E-3 | 80 | E-4 | 20 |
| | 42 | 20.00 | A-1 | 79.24 | B-1-2 | 10.00 | C-3 | 2.95 | - | 0.00 | D-2-3 | 0.28 | - | 0.00 | - | 0.00 | G-1 | 2.00 | K-4 | 3.30 | N-1 | 0.18 | M-6 | 2.05 | E-3 | 75 | E-4 | 25 |
| | 43 | 22.40 | A-2 | 76.53 | B-1-2 | 12.60 | C-3 | 2.79 | - | 0.00 | D-2-4 | 0.26 | - | 0.00 | - | 0.00 | G-1 | 1.55 | K-4 | 2.75 | N-1 | 0.30 | M-3 | 3.22 | E-3 | 80 | E-4 | 20 |
| | 44 | 21.80 | A-3 | 81.16 | B-1-3 | 11.40 | C-3 | 2.80 | - | 0.00 | D-2-5 | 0.30 | - | 0.00 | - | 0.00 | G-1 | 1.70 | K-4 | 2.40 | N-1 | 0.24 | - | 0.00 | E-3 | 80 | E-4 | 20 |
| | 45 | 23.10 | A-4 | 78.78 | B-1-3 | 13.20 | C-3 | 2.76 | - | 0.00 | D-2-6 | 0.24 | - | 0.00 | - | 0.00 | G-1 | 1.65 | K-4 | 3.15 | N-1 | 0.22 | - | 0.00 | E-3 | 80 | E-4 | 20 |
| | 46 | 23.30 | A-5 | 77.79 | B-1-4 | 14.00 | C-3 | 2.90 | - | 0.00 | D-2-7 | 0.30 | - | 0.00 | - | 0.00 | G-1 | 1.80 | K-4 | 2.94 | N-1 | 0.27 | - | 0.00 | E-3 | 80 | E-4 | 20 |
| | 47 | 21.10 | A-6 | 79.78 | B-1-4 | 12.40 | C-3 | 2.85 | - | 0.00 | D-2-8 | 0.26 | - | 0.00 | - | 0.00 | G-1 | 1.45 | K-4 | 3.00 | N-1 | 0.26 | - | 0.00 | E-3 | 80 | E-4 | 20 |
| | 48 | 27.00 | A-7 | 82.19 | B-1-5 | 10.60 | C-3 | 2.90 | - | 0.00 | D-2-9 | 0.20 | - | 0.00 | - | 0.00 | G-1 | 1.20 | K-4 | 2.66 | N-1 | 0.25 | - | 0.00 | E-6 | 80 | E-4 | 20 |
| | 49 | 22.30 | A-8 | 80.01 | B-1-5 | 11.60 | C-3 | 2.88 | - | 0.00 | D-2-10 | 0.36 | - | 0.00 | - | 0.00 | G-1 | 1.85 | K-4 | 3.10 | N-1 | 0.20 | - | 0.00 | E-3 | 80 | E-4 | 20 |
| | 50 | 22.40 | A-9 | 80.15 | B-1-1 | 12.20 | C-3 | 2.64 | - | 0.00 | D-2-11 | 0.32 | - | 0.00 | - | 0.00 | G-1 | 1.45 | K-4 | 3.00 | N-1 | 0.24 | - | 0.00 | E-1 | 80 | E-2 | 20 |
| | 51 | 23.30 | A-10 | 80.09 | B-1-1 | 12.80 | C-3 | 2.59 | - | 0.00 | D-2-12 | 0.28 | - | 0.00 | - | 0.00 | G-1 | 1.50 | K-4 | 2.49 | N-1 | 0.25 | - | 0.00 | E-3 | 80 | E-4 | 20 |
| | 52 | 22.60 | A-1 | 79.58 | B-1-2 | 12.40 | C-3 | 2.89 | D-1-11 | 0.22 | - | 0.00 | - | 0.00 | - | 0.00 | G-2 | 1.65 | K-2 | 2.93 | N-2 | 0.33 | - | 0.00 | E-3 | 80 | E-4 | 20 |
| | 53 | 21.50 | A-2 | 80.28 | B-1-2 | 12.00 | C-3 | 2.80 | D-1-12 | 0.18 | - | 0.00 | - | 0.00 | - | 0.00 | G-2 | 1.70 | K-2 | 2.74 | N-2 | 0.30 | - | 0.00 | E-3 | 80 | E-4 | 20 |
| | 54 | 24.50 | A-3 | 79.66 | B-1-3 | 13.00 | C-3 | 2.90 | D-1-13 | 0.28 | - | 0.00 | - | 0.00 | - | 0.00 | G-2 | 1.15 | K-2 | 2.65 | N-2 | 0.36 | - | 0.00 | E-6 | 80 | E-4 | 20 |
| | 55 | 20.80 | A-4 | 80.22 | B-1-3 | 12.20 | C-3 | 2.65 | D-1-14 | 0.22 | - | 0.00 | - | 0.00 | - | 0.00 | G-2 | 1.95 | K-2 | 2.46 | N-2 | 0.30 | - | 0.00 | E-3 | 80 | E-4 | 20 |
| | 56 | 23.00 | A-5 | 81.02 | B-1-5 | 11.20 | C-3 | 2.80 | D-1-15 | 0.20 | - | 0.00 | - | 0.00 | - | 0.00 | G-2 | 2.30 | K-2 | 2.24 | N-2 | 0.24 | - | 0.00 | E-3 | 80 | E-4 | 20 |
| | 57 | 24.20 | A-6 | 79.03 | B-1-5 | 13.00 | C-3 | 2.75 | D-1-16 | 0.34 | - | 0.00 | - | 0.00 | - | 0.00 | G-2 | 1.95 | K-2 | 2.65 | N-2 | 0.28 | - | 0.00 | E-3 | 80 | E-4 | 20 |
| | 58 | 27.70 | A-7 | 79.87 | B-1-5 | 12.60 | C-3 | 2.70 | D-1-17 | 0.32 | - | 0.00 | - | 0.00 | - | 0.00 | G-2 | 1.85 | K-2 | 2.46 | N-2 | 0.20 | - | 0.00 | E-3 | 80 | E-4 | 20 |
| | 59 | 25.00 | A-8 | 80.50 | B-1-5 | 12.40 | C-3 | 2.55 | D-1-18 | 0.30 | - | 0.00 | - | 0.00 | - | 0.00 | G-2 | 1.35 | K-2 | 2.44 | N-2 | 0.46 | - | 0.00 | E-3 | 75 | E-4 | 25 |
| | 60 | 25.30 | A-9 | 77.67 | B-1-5 | 12.80 | C-3 | 2.97 | D-1-19 | 0.28 | - | 0.00 | - | 0.00 | - | 0.00 | G-2 | 1.40 | K-2 | 2.26 | N-2 | 0.40 | M-4 | 2.22 | E-3 | 80 | E-4 | 20 |
| | 61 | 24.40 | A-10 | 79.66 | B-1-5 | 12.60 | C-3 | 2.68 | D-1-20 | 0.22 | - | 0.00 | - | 0.00 | - | 0.00 | G-2 | 1.65 | K-2 | 2.64 | N-2 | 0.55 | - | 0.00 | E-1 | 80 | E-2 | 20 |
| | 62 | 19.80 | A-12 | 84.74 | B-1-5 | 11.00 | C-3 | 2.57 | D-1-21 | 0.20 | - | 0.00 | - | 0.00 | - | 0.00 | G-1 | 1.15 | - | 0.00 | N-2 | 0.34 | - | 0.00 | E-3 | 80 | E-4 | 20 |
| | 63 | 22.20 | A-1 | 77.84 | B-1-1 | 13.20 | C-3 | 2.80 | D-1-22 | 0.18 | - | 0.00 | - | 0.00 | - | 0.00 | G-1 | 1.05 | K-2 | 2.00 | N-2 | 0.29 | M-5 | 2.64 | E-6 | 70 | E-4 | 30 |
| | 64 | 24.00 | A-2 | 78.51 | B-1-1 | 13.40 | C-3 | 2.92 | D-1-23 | 0.32 | - | 0.00 | - | 0.00 | - | 0.00 | G-1 | 2.15 | K-12 | 2.40 | N-2 | 0.30 | - | 0.00 | E-3 | 80 | E-4 | 20 |
| | 65 | 19.60 | A-3 | 80.24 | B-1-1 | 12.40 | C-3 | 2.76 | D-1-24 | 0.36 | - | 0.00 | - | 0.00 | - | 0.00 | G-1 | 1.35 | K-2 | 2.55 | N-2 | 0.34 | - | 0.00 | E-3 | 80 | E-4 | 20 |
| | 66 | 26.00 | A-4 | 79.43 | B-1-1 | 12.80 | C-3 | 2.84 | D-1-25 | 0.30 | - | 0.00 | - | 0.00 | - | 0.00 | G-1 | 1.65 | K-2 | 2.65 | N-2 | 0.33 | - | 0.00 | E-3 | 80 | E-4 | 20 |
| | 67 | 25.10 | A-5 | 79.34 | B-1-1 | 12.60 | C-3 | 2.89 | D-1-26 | 0.22 | - | 0.00 | - | 0.00 | - | 0.00 | G-1 | 1.45 | K-2 | 3.10 | N-2 | 0.40 | - | 0.00 | E-3 | 80 | E-4 | 20 |
| | 68 | 27.60 | A-1 | 80.20 | B-1-2 | 12.20 | C-2 | 2.42 | D-1-27 | 0.38 | - | 0.00 | - | 0.00 | - | 0.00 | G-1 | 1.60 | K-1 | 2.84 | N-12 | 0.36 | - | 0.00 | E-3 | 80 | E-4 | 20 |
| | 69 | 24.70 | A-2 | 80.51 | B-1-2 | 12.40 | C-4 | 2.56 | D-1-28 | 0.48 | - | 0.00 | - | 0.00 | - | 0.00 | G-3 | 1.85 | K-1 | 1.90 | N-2 | 0.30 | - | 0.00 | E-3 | 80 | E-4 | 20 |
| | 70 | 23.30 | A-3 | 80.50 | B-1-2 | 12.20 | C-3 | 2.64 | D-1-29 | 0.36 | - | 0.00 | - | 0.00 | - | 0.00 | G-4 | 1.70 | K-1 | 2.25 | N-2 | 0.35 | - | 0.00 | E-3 | 80 | E-4 | 20 |
| | 71 | 21.70 | A-4 | 81.73 | B-1-2 | 11.00 | C-3 | 2.64 | D-1-30 | 0.26 | - | 0.00 | - | 0.00 | - | 0.00 | G-1 | 1.90 | K-1 | 2.20 | N-2 | 0.27 | - | 0.00 | E-3 | 50 | E-4 | 50 |
| | 72 | 22.00 | A-5 | 81.03 | B-1-2 | 11.20 | C-3 | 2.98 | D-1-31 | 0.22 | - | 0.00 | - | 0.00 | - | 0.00 | G-1 | 1.85 | K-1 | 2.54 | N-2 | 0.18 | - | 0.00 | E-3 | 80 | E-4 | 20 |
| | 73 | 23.20 | A-6 | 79.28 | B-1-2 | 13.00 | C-3 | 2.49 | D-1-32 | 0.36 | - | 0.00 | - | 0.00 | - | 0.00 | G-1 | 2.05 | K-1 | 2.40 | N-2 | 0.42 | - | 0.00 | E-6 | 80 | E-4 | 20 |
| | 74 | 25.10 | A-7 | 79.46 | B-1-2 | 12.60 | C-3 | 2.47 | D-1-33 | 0.24 | - | 0.00 | - | 0.00 | - | 0.00 | G-1 | 2.00 | K-1 | 2.87 | N-2 | 0.36 | - | 0.00 | E-3 | 90 | E-4 | 10 |
| | 75 | 22.10 | A-8 | 75.98 | B-1-2 | 12.40 | C-1 | 3.03 | D-1-34 | 0.38 | - | 0.00 | - | 0.00 | - | 0.00 | G-1 | 1.85 | K-1 | 2.98 | N-2 | 0.35 | M-2 | 3.03 | E-3 | 80 | E-4 | 20 |
| | 76 | 20.70 | A-9 | 76.75 | B-1-2 | 12.80 | C-1 | 3.64 | D-1-35 | 0.40 | - | 0.00 | - | 0.00 | - | 0.00 | G-1 | 1.75 | K-1 | 2.46 | N-2 | 0.38 | M-2 | 1.82 | E-3 | 70 | E-4 | 30 |
| | 77 | 21.50 | A-10 | 75.39 | B-1-2 | 13.20 | C-1 | 2.22 | D-1-36 | 0.30 | - | 0.00 | - | 0.00 | - | 0.00 | G-1 | 1.55 | K-1 | 2.57 | N-2 | 0.33 | M-2 | 4.44 | E-6 | 80 | E-4 | 20 |
| | 78 | 20.30 | A-1 | 78.76 | B-1-3 | 12.20 | C-5 | 4.02 | D-1-37 | 0.32 | - | 0.00 | - | 0.00 | - | 0.00 | G-1 | 1.65 | K-2 | 2.65 | N-4 | 0.40 | - | 0.00 | E-3 | 80 | E-4 | 20 |
| | 79 | 22.40 | A-2 | 77.57 | B-1-3 | 13.00 | C-6 | 3.85 | D-1-38 | 0.33 | - | 0.00 | - | 0.00 | - | 0.00 | G-1 | 1.80 | K-2 | 3.20 | N-2 | 0.25 | - | 0.00 | E-3 | 80 | E-4 | 20 |
| | 80 | 24.80 | A-3 | 79.49 | B-1-3 | 12.00 | C-3 | 2.97 | D-1-11 | 0.10 | - | 0.00 | - | 0.00 | F-1 | 0.16 | G-1 | 2.00 | K-2 | 3.00 | N-1 | 0.28 | - | 0.00 | E-3 | 80 | E-4 | 20 |

[Table 3]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-I) | | (C) | | (D-1) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 81 | 20.50 | A-4 | 79.89 | B-I-3 | 12.60 | C-3 | 2.67 | D-I-11 | 0.18 | - | 0.00 | - | 0.00 | - | 0.00 | G-1 | 1.25 | K-2 | 3.15 | N-1 | 0.26 | - | 0.00 | E-3 | 80 | E-4 | 20 |
| | 82 | 21.00 | A-5 | 78.71 | B-I-3 | 12.80 | C-3 | 2.80 | D-I-14 | 0.22 | - | 0.00 | - | 0.00 | F-2 | 0.20 | G-2 | 1.95 | K-2 | 2.99 | N-2 | 0.33 | - | 0.00 | E-6 | 80 | E-4 | 20 |
| | 83 | 22.20 | A-6 | 80.99 | B-I-3 | 11.80 | C-3 | 2.90 | D-I-14 | 0.22 | - | 0.00 | - | 0.00 | - | 0.00 | G-2 | 1.25 | K-2 | 2.54 | N-2 | 0.30 | - | 0.00 | E-3 | 80 | E-4 | 20 |
| | 84 | 31.10 | A-7 | 80.64 | B-I-3 | 12.00 | C-3 | 2.64 | D-I-16 | 0.26 | - | 0.00 | - | 0.00 | F-3 | 0.08 | G-2 | 1.45 | K-2 | 2.65 | N-2 | 0.28 | - | 0.00 | E-3 | 80 | E-4 | 20 |
| | 85 | 26.00 | A-8 | 79.99 | B-I-3 | 12.20 | C-3 | 2.80 | D-I-16 | 0.26 | - | 0.00 | - | 0.00 | - | 0.00 | G-2 | 1.65 | K-2 | 2.87 | N-2 | 0.23 | - | 0.00 | E-6 | 80 | E-4 | 20 |
| | 86 | 20.90 | A-9 | 79.45 | B-I-3 | 12.40 | C-3 | 2.85 | D-I-18 | 0.24 | - | 0.00 | - | 0.00 | F-4 | 0.02 | G-2 | 1.70 | K-2 | 2.99 | N-2 | 0.35 | - | 0.00 | E-3 | 80 | E-4 | 20 |
| | 87 | 21.90 | A-10 | 80.12 | B-I-3 | 12.20 | C-3 | 2.80 | D-I-18 | 0.24 | - | 0.00 | - | 0.00 | - | 0.00 | G-2 | 1.40 | K-2 | 2.94 | N-2 | 0.30 | - | 0.00 | E-3 | 80 | E-4 | 20 |
| | 88 | 22.50 | A-1 | 80.36 | B-I-5 | 12.60 | C-6 | 2.85 | D-I-23 | 0.28 | - | 0.00 | - | 0.00 | F-5 | 0.12 | G-2 | 1.60 | K-1 | 1.84 | N-2 | 0.35 | - | 0.00 | E-3 | 80 | E-4 | 20 |
| | 89 | 23.00 | A-2 | 80.93 | B-I-5 | 12.00 | C-3 | 2.68 | D-I-23 | 0.28 | - | 0.00 | - | 0.00 | - | 0.00 | G-2 | 1.80 | K-1 | 1.97 | N-2 | 0.34 | - | 0.00 | E-6 | 80 | E-4 | 20 |
| | 90 | 24.40 | A-3 | 80.96 | B-I-5 | 12.40 | C-3 | 2.28 | D-I-25 | 0.22 | - | 0.00 | - | 0.00 | F-6 | 0.16 | G-2 | 1.50 | K-1 | 2.20 | N-2 | 0.28 | - | 0.00 | E-3 | 80 | E-4 | 20 |
| | 91 | 17.60 | A-4 | 92.96 | - | 0.00 | C-3 | 2.40 | D-I-25 | 0.22 | - | 0.00 | - | 0.00 | - | 0.00 | G-2 | 1.70 | K-1 | 2.42 | N-2 | 0.30 | - | 0.00 | E-3 | 80 | E-4 | 20 |
| | 92 | 25.30 | A-5 | 79.12 | B-I-5 | 13.00 | C-3 | 2.64 | D-I-27 | 0.26 | - | 0.00 | - | 0.00 | F-3 | 0.10 | G-2 | 1.95 | K-1 | 2.60 | N-1 | 0.33 | - | 0.00 | E-3 | 80 | E-4 | 20 |
| | 93 | 21.60 | A-6 | 79.83 | B-I-5 | 12.60 | C-3 | 2.80 | D-I-27 | 0.26 | - | 0.00 | - | 0.00 | - | 0.00 | G-2 | 1.80 | K-1 | 2.35 | N-1 | 0.36 | - | 0.00 | E-3 | 80 | E-4 | 20 |
| | 94 | 28.80 | A-7 | 77.25 | B-I-5 | 12.40 | C-3 | 2.84 | D-I-32 | 0.30 | - | 0.00 | - | 0.00 | F-4 | 0.06 | G-2 | 1.75 | K-1 | 2.40 | N-1 | 0.50 | M-6 | 2.50 | E-3 | 80 | E-4 | 20 |
| | 95 | 23.00 | A-8 | 80.31 | B-I-5 | 12.60 | C-3 | 2.60 | D-I-32 | 0.30 | - | 0.00 | - | 0.00 | - | 0.00 | G-2 | 1.80 | K-1 | 2.15 | N-1 | 0.24 | - | 0.00 | E-3 | 80 | E-4 | 20 |
| | 96 | 22.20 | A-9 | 81.01 | B-I-5 | 12.00 | C-3 | 2.67 | D-I-33 | 0.24 | - | 0.00 | - | 0.00 | F-5 | 0.24 | G-2 | 1.45 | K-1 | 2.11 | N-1 | 0.28 | - | 0.00 | E-6 | 80 | E-4 | 20 |
| | 97 | 23.00 | A-10 | 81.71 | B-I-5 | 11.80 | C-3 | 2.70 | D-I-33 | 0.24 | - | 0.00 | - | 0.00 | - | 0.00 | G-2 | 1.20 | K-1 | 2.00 | N-1 | 0.35 | - | 0.00 | E-3 | 80 | E-4 | 20 |
| | 98 | 23.10 | A-1 | 81.01 | B-I-1 | 12.00 | C-3 | 2.66 | D-I-11 | 0.30 | - | 0.00 | DR-1 | 0.10 | F-6 | 0.30 | G-2 | 1.35 | K-1 | 1.98 | N-2 | 0.30 | - | 0.00 | E-1 | 100 | - | 0 |
| | 99 | 23.80 | A-2 | 81.01 | B-I-2 | 12.20 | C-3 | 2.90 | D-I-14 | 0.30 | - | 0.00 | DR-2 | 0.11 | - | 0.00 | G-2 | 1.40 | K-1 | 1.84 | N-2 | 0.24 | - | 0.00 | E-3 | 60 | E-4 | 40 |
| | 100 | 24.00 | A-3 | 80.28 | B-I-3 | 12.60 | C-3 | 2.79 | D-I-16 | 0.32 | - | 0.00 | DR-3 | 0.08 | - | 0.00 | G-2 | 1.35 | K-1 | 1.98 | N-2 | 0.60 | - | 0.00 | E-3 | 80 | E-4 | 20 |
| | 101 | 23.80 | A-4 | 80.51 | B-I-4 | 12.20 | C-3 | 2.90 | D-I-18 | 0.28 | - | 0.00 | DR-4 | 0.12 | - | 0.00 | G-2 | 1.80 | K-1 | 1.95 | N-2 | 0.24 | - | 0.00 | E-6 | 80 | E-4 | 20 |
| | 102 | 20.00 | A-5 | 80.40 | B-I-5 | 12.40 | C-3 | 2.46 | D-I-23 | 0.22 | - | 0.00 | DR-5 | 0.15 | - | 0.00 | G-2 | 1.95 | K-1 | 2.12 | N-2 | 0.30 | - | 0.00 | E-3 | 80 | E-4 | 20 |
| | 103 | 20.90 | A-6 | 80.70 | B-I-1 | 12.00 | C-3 | 2.99 | D-I-25 | 0.26 | - | 0.00 | DR-6 | 0.16 | - | 0.00 | G-2 | 1.60 | K-1 | 2.05 | N-2 | 0.24 | - | 0.00 | E-3 | 80 | E-4 | 20 |
| | 104 | 23.20 | A-7 | 80.16 | B-I-1 | 12.60 | C-3 | 3.03 | D-I-27 | 0.30 | D-2-1 | 0.11 | - | 0.00 | - | 0.00 | G-2 | 1.45 | K-1 | 2.00 | N-2 | 0.35 | - | 0.00 | E-3 | 100 | - | 0 |
| | 105 | 27.00 | A-8 | 80.03 | B-I-2 | 12.40 | C-3 | 3.20 | D-I-32 | 0.24 | D-2-1 | 0.15 | - | 0.00 | - | 0.00 | G-2 | 1.60 | K-1 | 2.05 | N-2 | 0.33 | - | 0.00 | E-3 | 80 | E-4 | 20 |
| | 106 | 21.50 | A-9 | 80.36 | B-I-3 | 12.80 | C-3 | 2.88 | D-I-32 | 0.24 | D-2-1 | 0.11 | DR-2 | 0.06 | - | 0.00 | G-2 | 1.55 | K-1 | 1.80 | N-2 | 0.20 | - | 0.00 | E-3 | 80 | E-4 | 20 |
| | 107 | 22.50 | A-1 | 80.46 | B-I-1 | 12.60 | C-3 | 2.75 | D-I-1 | 0.20 | - | 0.00 | - | 0.00 | - | 0.00 | G-1 | 1.65 | K-1 | 1.99 | N-1 | 0.35 | - | 0.00 | E-3 | 80 | E-4 | 20 |
| | 108 | 29.00 | A-1 | 80.46 | B-I-1 | 12.60 | C-3 | 2.70 | - | 0.00 | D-2-13 | 0.24 | - | 0.00 | - | 0.00 | G-2 | 1.60 | K-1 | 2.10 | N-2 | 0.30 | - | 0.00 | E-3 | 80 | E-4 | 20 |
| | 109 | 21.60 | A-2 | 80.02 | B-I-2 | 13.40 | C-3 | 2.75 | - | 0.00 | D-2-14 | 0.20 | - | 0.00 | - | 0.00 | G-2 | 1.60 | K-1 | 1.85 | N-2 | 0.18 | - | 0.00 | E-3 | 80 | E-4 | 20 |
| | 110 | 20.70 | A-3 | 80.79 | B-I-3 | 12.20 | C-3 | 2.90 | - | 0.00 | D-2-15 | 0.22 | - | 0.00 | - | 0.00 | G-2 | 1.65 | K-1 | 2.00 | N-2 | 0.24 | - | 0.00 | E-3 | 80 | E-4 | 20 |
| | 111 | 23.80 | A-4 | 80.52 | B-I-1 | 12.40 | C-3 | 2.80 | - | 0.00 | D-2-16 | 0.33 | - | 0.00 | - | 0.00 | G-2 | 1.65 | K-1 | 2.00 | N-2 | 0.30 | - | 0.00 | E-5 | 80 | E-4 | 20 |
| Comparative Example | 1 | 23.00 | A-1 | 80.78 | B-I-1 | 12.50 | C-3 | 2.75 | - | 0.00 | - | 0.00 | DR-1 | 0.20 | - | 0.00 | G-1 | 1.50 | K-1 | 2.00 | N-1 | 0.27 | - | 0.00 | E-3 | 80 | E-4 | 20 |
| | 2 | 24.00 | A-2 | 80.07 | B-I-2 | 12.80 | C-3 | 2.68 | - | 0.00 | - | 0.00 | DR-2 | 0.55 | - | 0.00 | G-2 | 1.65 | K-1 | 1.95 | N-2 | 0.30 | - | 0.00 | E-3 | 80 | E-4 | 20 |
| | 3 | 21.40 | A-3 | 80.80 | B-I-1 | 12.00 | C-3 | 2.88 | - | 0.00 | - | 0.00 | DR-3 | 0.18 | - | 0.00 | G-1 | 1.70 | K-1 | 2.20 | N-1 | 0.24 | - | 0.00 | E-3 | 80 | E-4 | 20 |
| | 4 | 24.60 | A-4 | 80.27 | B-I-3 | 12.40 | C-3 | 2.91 | - | 0.00 | - | 0.00 | DR-4 | 0.36 | - | 0.00 | G-2 | 1.70 | K-1 | 2.00 | N-2 | 0.36 | - | 0.00 | E-3 | 80 | E-4 | 20 |
| | 5 | 26.10 | A-5 | 80.33 | B-I-1 | 12.60 | C-3 | 2.64 | - | 0.00 | - | 0.00 | DR-5 | 0.50 | - | 0.00 | G-1 | 1.65 | K-1 | 1.98 | N-1 | 0.30 | - | 0.00 | E-3 | 80 | E-4 | 20 |
| | 6 | 22.80 | A-6 | 80.99 | B-I-4 | 12.50 | C-3 | 2.58 | - | 0.00 | - | 0.00 | DR-6 | 0.32 | - | 0.00 | G-2 | 1.45 | K-1 | 1.89 | N-2 | 0.27 | - | 0.00 | E-3 | 80 | E-4 | 20 |
| | 7 | 32.00 | A-7 | 78.20 | B-I-1 | 12.20 | C-3 | 2.64 | - | 0.00 | - | 0.00 | DR-1 | 0.20 | - | 0.00 | G-5 | 2.00 | K-1 | 1.90 | N-1 | 0.22 | M-4 | 2.64 | E-3 | 80 | E-4 | 20 |
| | 8 | 23.30 | A-8 | 81.31 | B-I-5 | 12.40 | C-3 | 2.60 | - | 0.00 | - | 0.00 | DR-2 | 0.11 | - | 0.00 | G-5 | 1.40 | K-1 | 1.94 | N-2 | 0.24 | - | 0.00 | E-3 | 80 | E-4 | 20 |
| | 9 | 24.70 | A-9 | 79.43 | B-I-1 | 13.00 | C-3 | 2.80 | - | 0.00 | - | 0.00 | DR-3 | 0.44 | F-1 | 0.22 | G-5 | 1.75 | K-1 | 2.00 | N-1 | 0.36 | - | 0.00 | E-3 | 80 | E-4 | 20 |
| | 10 | 27.50 | A-10 | 80.45 | B-I-1 | 12.80 | C-3 | 2.65 | - | 0.00 | - | 0.00 | DR-4 | 0.22 | - | 0.00 | G-5 | 1.60 | K-1 | 1.98 | N-2 | 0.30 | - | 0.00 | E-3 | 80 | E-4 | 20 |
| | 11 | 23.00 | A-1 | 80.78 | B-I-1 | 12.50 | C-3 | 2.75 | D-I-1 | 0.20 | - | 0.00 | - | 0.00 | - | 0.00 | G-1 | 1.50 | K-1 | 2.00 | N-1 | 0.27 | - | 0.00 | E-3 | 80 | E-4 | 20 |

[Table 4]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-I) | | (C) | | (D-I) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 112 | 22.20 | A-1 | 80.63 | B-I-1 | 12.60 | C-3 | 2.98 | D-I-11 | 0.12 | D-2-17 | 0.12 | - | 0.00 | - | 0.00 | G-1 | 1.43 | K-1 | 1.88 | N-1 | 0.24 | - | 0.00 | E-3 | 80 | E-4 | 20 |
| | 113 | 24.10 | A-2 | 81.93 | B-I-2 | 11.88 | C-4 | 2.69 | D-I-23 | 0.10 | - | 0.00 | DR-7 | 0.10 | - | 0.00 | G-2 | 1.25 | K-1 | 1.75 | N-2 | 0.30 | - | 0.00 | E-3 | 80 | E-4 | 20 |
| | 114 | 20.70 | A-3 | 79.87 | B-I-3 | 13.45 | C-5 | 2.78 | D-I-32 | 0.18 | - | 0.00 | - | 0.00 | - | 0.00 | G-1 | 1.44 | K-1 | 1.98 | N-5 | 0.30 | - | 0.00 | E-1 | 100 | - | 0 |
| | 115 | 21.50 | A-4 | 81.31 | B-I-5 | 12.13 | C-3 | 3.01 | D-I-18 | 0.20 | - | 0.00 | - | 0.00 | - | 0.00 | G-2 | 1.56 | K-1 | 1.54 | N-6 | 0.25 | - | 0.00 | E-3 | 80 | E-4 | 20 |
| | 116 | 26.00 | A-5 | 81.90 | B-I-6 | 11.46 | C-4 | 2.98 | D-I-11 | 0.24 | - | 0.00 | - | 0.00 | - | 0.00 | G-1 | 1.62 | K-1 | 1.56 | N-7 | 0.24 | - | 0.00 | E-3 | 80 | E-4 | 20 |
| | 117 | 24.30 | A-6 | 80.80 | B-I-7 | 10.75 | C-5 | 3.05 | D-I-23 | 0.19 | - | 0.00 | - | 0.00 | - | 0.00 | G-2 | 1.34 | K-2 | 2.85 | N-1 | 0.22 | M-7 | 0.80 | E-3 | 80 | E-4 | 20 |
| | 118 | 20.40 | A-7 | 78.21 | B-I-1 | 14.10 | C-3 | 2.87 | D-I-32 | 0.22 | - | 0.00 | - | 0.00 | - | 0.00 | G-1 | 1.58 | K-1 | 1.68 | N-2 | 0.24 | M-8 | 1.10 | E-3 | 80 | E-4 | 20 |
| | 119 | 21.90 | A-8 | 79.68 | B-I-2 | 12.43 | C-7 | 3.88 | D-I-18 | 0.44 | - | 0.00 | - | 0.00 | - | 0.00 | G-2 | 1.46 | K-1 | 1.78 | N-2 | 0.33 | - | 0.00 | E-3 | 80 | E-4 | 20 |
| | 120 | 22.60 | A-9 | 80.68 | B-I-3 | 12.56 | C-8 | 2.84 | D-I-11 | 0.18 | D-2-17 | 0.12 | - | 0.00 | - | 0.00 | G-5 | 1.58 | K-1 | 1.80 | N-2 | 0.24 | - | 0.00 | E-3 | 80 | E-4 | 20 |
| | 121 | 23.40 | A-10 | 81.70 | B-I-11 | 10.46 | C-1 | 3.25 | - | 0.00 | D-2-5 | 0.25 | - | 0.00 | - | 0.00 | G-1 | 1.23 | - | 0.00 | - | 0.00 | M-2 | 3.11 | E-3 | 80 | E-2 | 20 |
| | 122 | 21.80 | A-12 | 81.23 | B-I-12 | 11.59 | C-9 | 3.25 | D-I-11 | 0.15 | - | 0.00 | DR-2 | 0.05 | - | 0.00 | G-2 | 1.60 | K-1 | 1.90 | N-1 | 0.23 | - | 0.00 | E-3 | 80 | E-4 | 20 |
| | 123 | 23.10 | A-13 | 83.13 | B-I-13 | 10.07 | C-8 | 2.99 | D-I-23 | 0.10 | - | 0.00 | DR-3 | 0.07 | - | 0.00 | G-2 | 1.65 | K-1 | 1.78 | N-2 | 0.21 | - | 0.00 | E-3 | 80 | E-4 | 20 |
| | 124 | 22.00 | A-8 | 79.04 | B-I-1 | 12.55 | C-3/C-7 | 2.46/1.25 | D-I-32 | 0.20 | - | 0.00 | DR-7 | 0.08 | - | 0.00 | G-2 | 1.64 | K-2 | 2.50 | N-2 | 0.28 | - | 0.00 | E-3 | 80 | E-4 | 20 |
| | 125 | 20.80 | A-15 | 78.70 | B-I-12 | 12.46 | C-3 | 3.10 | D-I-18 | 0.10 | D-2-1 | 0.10 | - | 0.00 | - | 0.00 | G-2 | 1.46 | K-1 | 1.78 | N-2 | 0.30 | M-6 | 2.00 | E-3 | 80 | E-4 | 20 |
| | 126 | 25.00 | A-16 | 82.99 | B-I-13 | 10.08 | C-3 | 2.84 | D-I-11 | 0.22 | - | 0.00 | - | 0.00 | F-3 | 0.10 | G-2 | 1.58 | K-1 | 1.90 | N-2 | 0.29 | - | 0.00 | E-3 | 100 | - | 0 |

Details of each of the components listed in the table are as follows.

[(A) resin]

Resins A-1 to A-16 represented by the following structural formulae were used. For the resin including two or more kinds of repeating units, the content (molar ratio) of each repeating unit is also described. The structure of the resin terminal is also described for A-16. * represents a bonding position.

A-1, A-7:

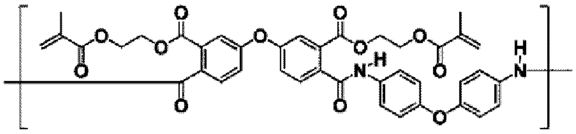

A-2:

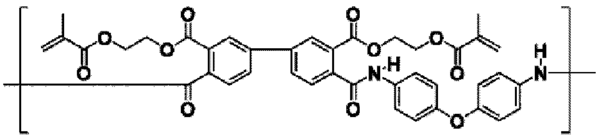

A-3:

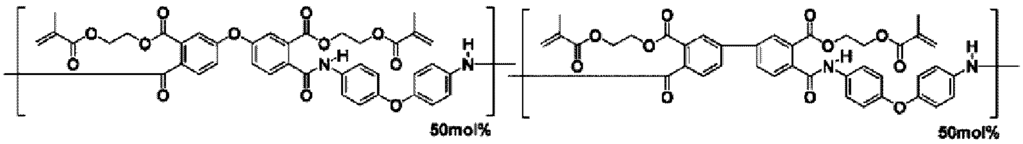

50mol% 50mol%

A-4:

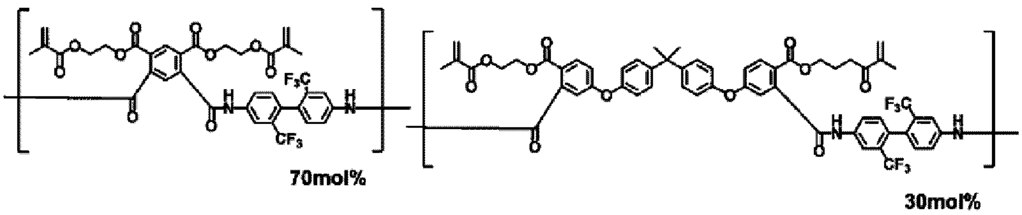

70mol% 30mol%

A-5:

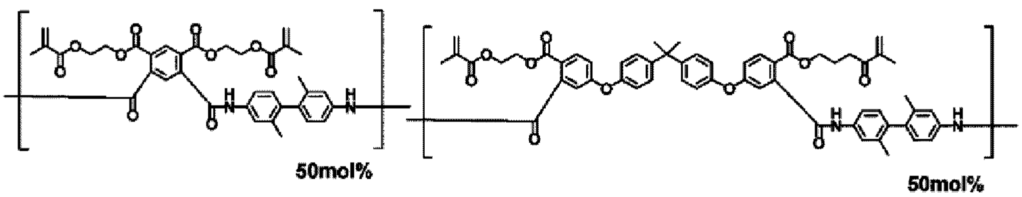

50mol% 50mol%

A-6:

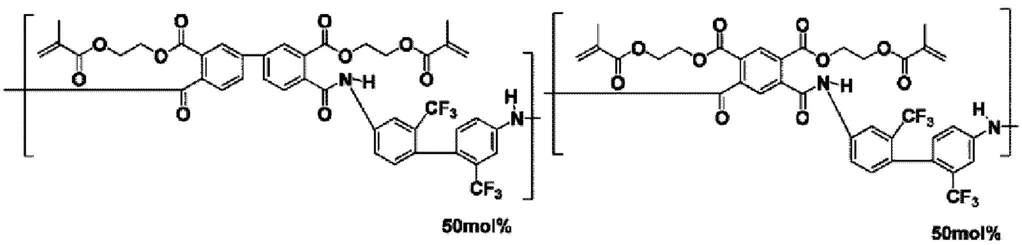

50mol% 50mol%

A-8:

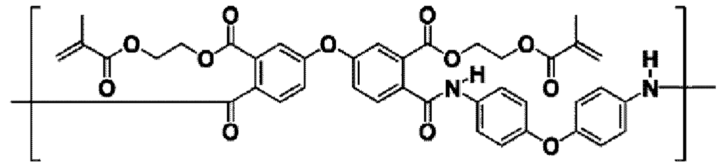

A-9:

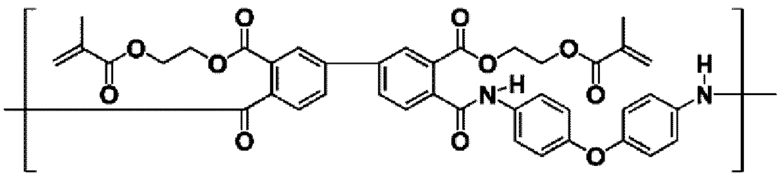

A-10:

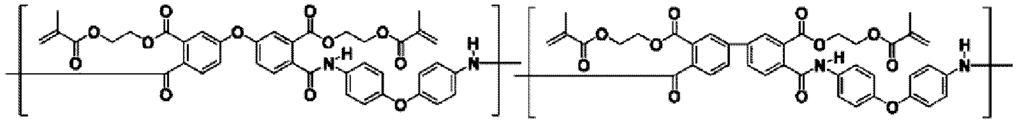

50mol% 50mol%

A-11:

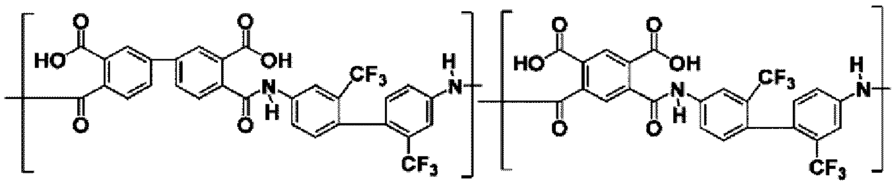

50mol% 50mol%

A-12:

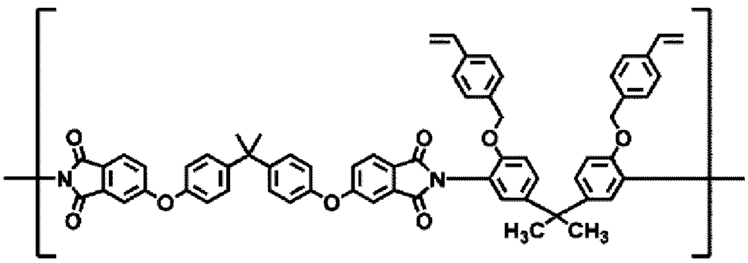

A-13:

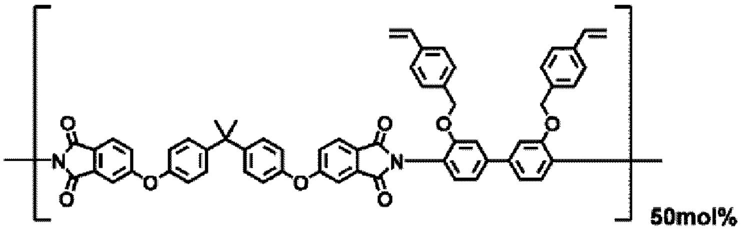

50mol%

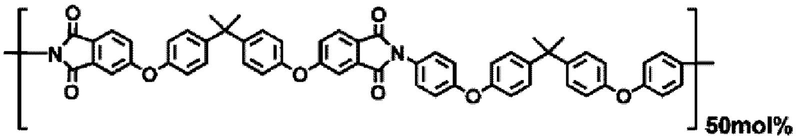

50mol%

A－14：

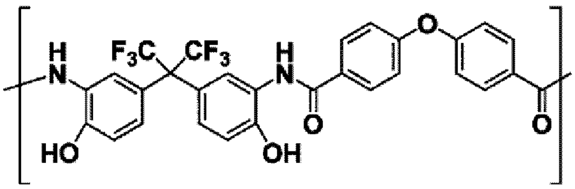

## A-15:

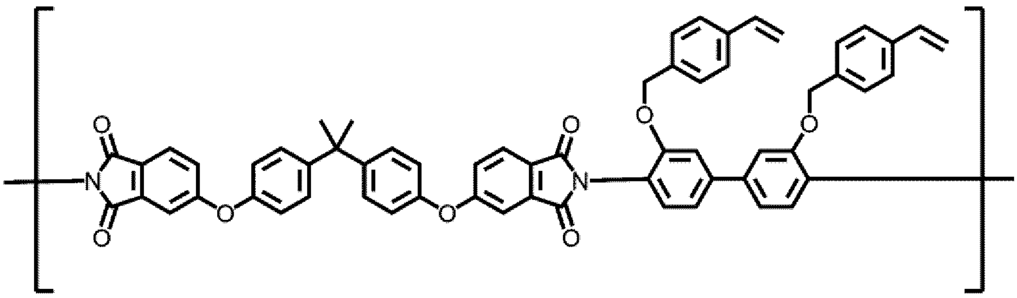

25mol%

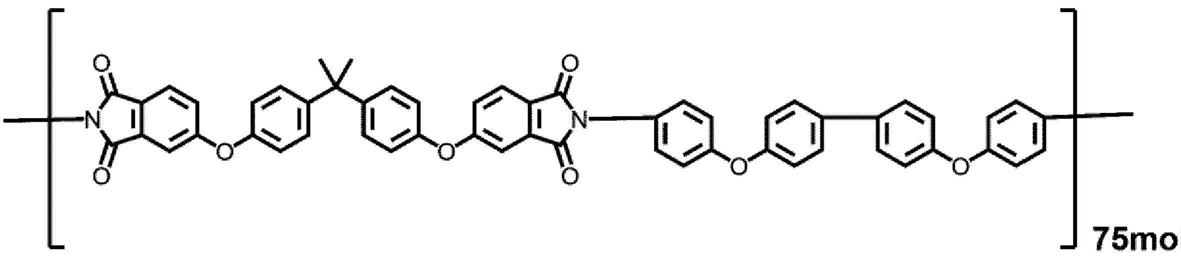

75mol%

## A-16:

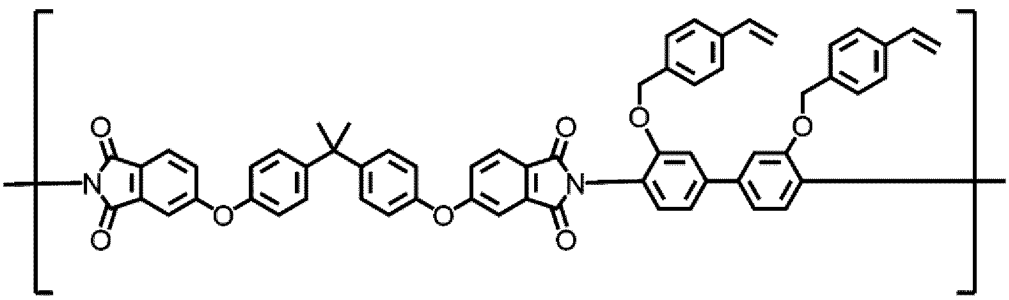

50mol%

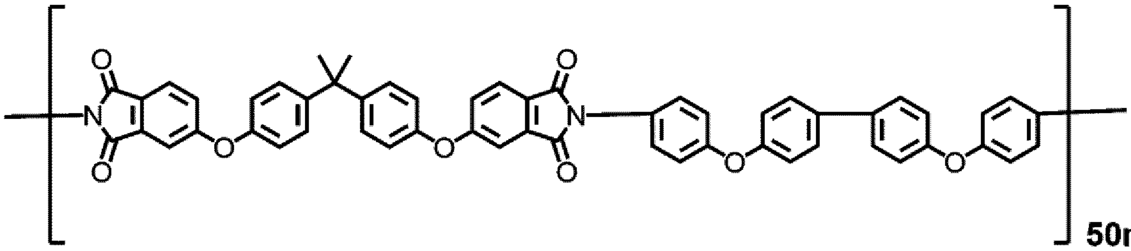

50mol%

RESIN TERMINAL:

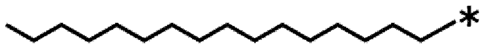

The weight-average molecular weight (Mw) of each resin is shown in Table 5.

[Table 5]

| (A) Resin | Mw |
|---|---|
| A-1 | 27,500 |
| A-2 | 28,000 |
| A-3 | 27,000 |
| A-4 | 27,500 |
| A-5 | 28,500 |
| A-6 | 27,000 |
| A-7 | 20,000 |
| A-8 | 27,500 |
| A-9 | 28,000 |
| A-10 | 27,000 |
| A-11 | 22,500 |
| A-12 | 25,000 |
| A-13 | 19,000 |
| A-14 | 25,000 |
| A-15 | 21,000 |
| A-16 | 19,700 |

Synthesis examples of the (A) resin will be shown below.

<Synthesis Example 1: Synthesis of resin A-1>

20.0 g (64.5 mmol) of 4,4'-oxydiphthalic acid dianhydride (dried at 140°C for 12 hours) and 17.12 g (131.58 mmol) of 2-hydroxyethyl methacrylate (HEMA) were suspended in 50 mL of N-methylpyrrolidone and dried with a molecular sieve. The suspension was heated at 100°C for 3 hours. A transparent solution was obtained a few minutes after the start of heating. The reaction mixture was cooled to room temperature, and 21.43 g (270.9 mmol) pyridine and 90 ml N-methylpyrrolidone were added thereto. Then, the reaction mixture was cooled to -10°C, and 16.12 g (135.5 mmol) of $SOCl_2$ was added thereto over 10 minutes while keeping the temperature at -10°C $\pm$ 4°C. Viscosity increased while adding $SOCl_2$. After diluting with 50 ml of N-methylpyrrolidone, the reaction mixture was stirred at room temperature for 2 hours. Then, a solution prepared by dissolving 11.75 g (58.7 mmol) of 4,4'-diaminodiphenyl ether in 100 ml of N-methylpyrrolidone was dropwise added to the reaction mixture at 20°C to 23°C over 20 minutes. The reaction mixture was then stirred overnight at room temperature. The polyimide precursor was then precipitated in 5 L of water and the water-polyimide precursor mixture was stirred for 15 minutes at a speed of 5,000 rpm. The polyimide precursor was collected by filtration, put into 4 L of water again, stirred for 30 minutes, and filtered again. Next, the obtained polyimide precursor was dried at 45°C for 3 days under reduced pressure to obtain a resin A-1. Regarding the obtained resin A-1, the results of analyzing the weight-average molecular weight (Mw) by measuring the resin A-1 by gel permeation chromatography (in terms of

standard polystyrene) as N-methylpyrrolidone (NMP) eluent are shown in Table 5.

Resins A-2 to A-7 were synthesized in the same manner as in Synthesis Example 1, except that the dicarboxylic acid dianhydride and the diamine were appropriately changed.

<Synthesis Example 2: Synthesis of resin A-8>

155.1 g of 4,4'-oxydiphthalic acid dianhydride (ODPA) was placed in a separable flask, 131.2 g of 2-hydroxyethyl methacrylate (HEMA) and 400 ml of γ-butyrolactone were placed therein, and the resultant mixture was stirred at room temperature, and then 81.5 g of pyridine was added to the mixture with stirring to obtain a reaction mixture. After the heat generation due to the reaction was stopped, the mixture was allowed to cool to room temperature and left to stand for 16 hours.

Next, under ice-cooling, a solution obtained by dissolving 206.3 g of dicyclohexylcarbodiimide (DCC) in 180 ml of γ-butyrolactone was added to the reaction mixture over 40 minutes with stirring, and subsequently a suspension obtained by suspending 93.0 g of 4,4'-diaminodiphenyl ether (DADPE) in 350 ml of γ-butyrolactone was added thereto over 60 minutes with stirring. After further stirring at room temperature for 2 hours, 30 ml of ethyl alcohol was added thereto, the mixture was stirred for 1 hour, and then 400 ml of γ-butyrolactone was added thereto. The precipitate formed in the reaction mixture was removed by filtration to obtain a reaction solution.

The obtained reaction solution was added to 3 L of ethyl alcohol to form a precipitate consisting of a crude polymer. The produced crude polymer was filtered out and then dissolved in 1.5 L of tetrahydrofuran to obtain a crude polymer solution. The obtained crude polymer solution was added dropwise to 28 liters of water to precipitate the polymer, and the obtained precipitate was filtered out and then vacuum dried to obtain a powdery resin A-8. The molecular weight of the resin A-8 was measured by gel permeation chromatography (in terms of standard polystyrene) as N-methylpyrrolidone (NMP) eluent, and the results of analyzing the weight-average molecular weight (Mw) are shown in Table 5.

Resins A-9 to A-10 were synthesized in the same manner as in Synthesis Example 2, except that the dicarboxylic acid dianhydride and the diamine were appropriately changed.

<Synthesis Example 3: Synthesis of resin A-11>

A resin A-11 was synthesized from pyromellitic acid dianhydride, 3,3',4,4'-biphenyltetracarboxylic acid dianhydride, and 2,2'-bis(trifluoromethyl)benzidine by the same method as the method for synthesizing PFAA in H. Seino et al., J. Polym. Sci., Part A: Polym. Chem., 36, 2261 (1998).

<Synthesis Example 4: Synthesis of resin A-12>

20.80 g (40 mmol) of 4,4'-(4,4'-isopropylidenediphenoxy)diphtalic acid anhydride was dissolved in 70 g of N-methylpyrrolidone (NMP). Subsequently, 9.08 g (35.2 mmol) of 4,4'-isopropylidenebis(2-aminophenol) was dissolved in 50 g of NMP, and the solution was added dropwise over 1 hour at a temperature of 10°C to 25°C and stirred at 25°C for 30 minutes. Then, 10 g of toluene was added thereto, the mixture was reacted at 200°C for 4 hours while nitrogen was flowing, and the mixture was cooled to 25°C. Subsequently, 15.3 g (100 mmol) of 4-(chloromethyl)styrene, 16.6 g (120 mmol) of potassium carbonate, 1.66 g (12 mmol) of potassium iodide, and 0.08 g of 2,2,6,6-tetramethylpiperidine 1-oxide free radical were added thereto, the mixture was reacted at 95°C for 15 hours, cooled to 25°C, and diluted with 120 g of tetrahydrofuran. Subsequently, the reaction solution was added dropwise to a mixed solution of 1.8 L of methanol and 0.6 L of water, and the mixture was stirred for 15 minutes and a polyimide resin was filtered. Next, the resin was subjected to reslurrying with 1 L of water, filtered, reslurried again with 1 L of methanol, filtered, and dried at 40°C for 8 hours under reduced pressure. Subsequently, the resin dried as described above was dissolved in 250 g of tetrahydrofuran, 40 g of an ion exchange resin (MB-1: manufactured by ORGANO CORPORATION) was added thereto, the mixture was stirred for 4 hours, the ion exchange resin was filtered and removed, and then the polyimide resin was precipitated in 2 L of methanol and stirred for 15 minutes. The polyimide precursor resin was filtered and acquired, and dried at 45°C for 1 day under reduced pressure to obtain a polyimide resin (A-12). The molecular weight of the resin A-12 was measured by gel permeation chromatography (in terms of standard polystyrene) as N-methylpyrrolidone (NMP) eluent, and the results of analyzing the weight-average molecular weight (Mw) are shown in Table 5.

Resins A-13 and A-15 were synthesized in the same manner as in Synthesis Example 4, except that the diamine was appropriately changed.

<Synthesis Example 5: Synthesis of resin A-14>

In a separable flask, 2,2-bis(3-amino-4-hydroxyphenyl) -hexafluoropropane 183.1 g (0.5 mol), N,N-dimethylacetamide (DMAc) 640.9 g, pyridine 63.3 g (0.8 mol) was mixed and stirred at room temperature (25°C) to prepare a uniform

solution. To this solution, a solution obtained by dissolving 118.0 g (0.4 mol) of 4,4'-diphenyl ether dicarbonyl chloride in 354 g of diethylene glycol dimethyl ether (DMDG) was added dropwise with a dropping funnel. In this case, the separable flask was cooled in a water bath at 15°C to 20°C. The time required for the dropwise addition was 40 minutes, and the maximum temperature of the reaction solution was 30°C.

After 3 hours from the completion of the dropwise addition, 30.8 g (0.2 mol) of 1,2-cyclohexyldicarboxylic acid anhydride was added to the reaction solution, and the resultant mixture was left to stand with stirring at room temperature for 15 hours to block 99% of all amine terminal groups of the polymer chain with a carboxycyclohexylamide group. It is noted that the reaction rate in this case can be easily calculated by tracking the remaining amount of the charged 1,2-cyclohexyldicarboxylic acid anhydride with high performance liquid chromatography (HPLC). Thereafter, the above reaction solution was added dropwise to 2 L of water with high speed stirring to disperse and precipitate the polymer, which was subsequently recovered, washed with water as appropriate, dehydrated, and vacuum dried, thereby obtaining a crude polybenzoxazole precursor.

The crude polybenzoxazole precursor obtained as described above was redissolved in γ-butyrolactone (GBL) and then treated with a cation exchange resin and an anion exchange resin. The resultant solution was put into ion exchange water, the precipitated polymer was filtered out, washed with water, and vacuum dried to obtain a purified polybenzoxazole precursor (a resin A-14). The molecular weight of the resin A-14 was measured by gel permeation chromatography (in terms of standard polystyrene) as N-methylpyrrolidone (NMP) eluent, and the results of analyzing the weight-average molecular weight (Mw) are shown in Table 5.

<Synthesis Example 6: Synthesis of resin A-16>

30.00 g (57.64 mmol) of 4,4'-(4,4'-isopropylidenediphenoxy)diphtalic acid anhydride was dissolved in 150 g of N-methylpyrrolidone (NMP). Subsequently, 5.36 g (24.79 mmol) of HAB (3,3'-dihydroxybenzidine, manufactured by Wakayama Seika Co., Ltd.), 9.13 g (24.79 mmol) of 4,4'-bis(3-aminophenoxy)biphenyl, 2.51 g (10.38 mmol) of hexadecylamine, and 10 g of toluene were added while washing with 30 g of NMP, and the mixture was stirred for 15 minutes, reacted at 200°C for 4 hours while flowing nitrogen, and cooled to 25°C. Subsequently, 15.3 g (100 mmol) of 4-(chloromethyl)styrene, 19.92 g (144 mmol) of potassium carbonate, 2.39 g (14 mmol) of potassium iodide, and 0.1 g of 2,2,6,6-tetramethylpiperidine 1-oxide free radical were added thereto, the mixture was reacted at 95°C for 15 hours, cooled to 25°C, diluted with 150 g of tetrahydrofuran, and the salts in the reaction solution were filtered through filter paper. Subsequently, the reaction solution was added dropwise to a mixed solution of 1.8 L of methanol and 0.6 L of water, and the mixture was stirred for 15 minutes and a polyimide resin was filtered. Next, the resin was subjected to reslurrying with 1 L of water, filtered, reslurried again with 1 L of methanol, filtered, and dried at 40°C for 8 hours under reduced pressure. Subsequently, the resin dried as described above was dissolved in 300 g of tetrahydrofuran, 40 g of an ion exchange resin (MB-1: manufactured by ORGANO CORPORATION) was added thereto, the mixture was stirred for 4 hours, the ion exchange resin was filtered and removed, and then the polyimide resin was precipitated in 2 L of methanol and stirred for 15 minutes. The polyimide resin was filtered and acquired, and dried at 45°C for 1 day under reduced pressure to obtain an A-16. The molecular weight of the resin A-16 was measured by gel permeation chromatography (in terms of standard polystyrene) as N-methylpyrrolidone (NMP) eluent, and the results of analyzing the weight-average molecular weight (Mw) are shown in Table 5.

[(B-1) Radically polymerizable compound]

B-1-1 to B-1-13 below were used.

· B-1-1: compound represented by the following structural formula (tetraethylene glycol dimethacrylate)

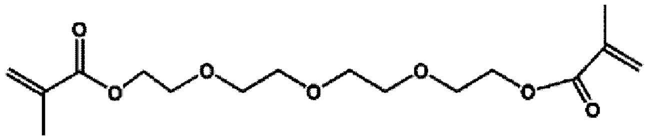

· B-1-2: TPGDA (manufactured by Daicel-Allnex Ltd.)

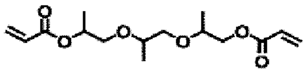

TPGDA

· B-1-3: DPGDA (manufactured by Daicel-Allnex Ltd.)

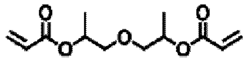

DPGDA

· B-1-4: HDDA (manufactured by Daicel-Allnex Ltd.)
· B-1-5: KAYARAD DPHA (manufactured by Nippon Kayaku Co., Ltd.)
· B-1-6: Tetraethylene glycol diacrylate
· B-1-7: LIGHT ESTER 3EG (manufactured by KYOEISHA CHEMICAL Co., Ltd.)
· B-1-8: LIGHT ESTER NP (manufactured by KYOEISHA CHEMICAL Co., Ltd.)
· B-1-9: LIGHT ESTER 1.6HX (manufactured by Kyoeisha Chemical Co., Ltd.)
· B-1-10: LIGHT ESTER 1.9ND (manufactured by KYOEISHA CHEMICAL Co., Ltd.)
· B-1-11: NK ESTER A-9300 (manufactured by Shin-Nakamura Chemical Co., Ltd.)
· B-1-12: NK ESTER A-DOD-N (manufactured by Shin-Nakamura Chemical Co., Ltd.)
· B-1-13: 1,12-dodecanediol dimethacrylate (manufactured by TCI)

[(C) Photopolymerization initiator]

The following C-1 to C-9 were used.

· C-1: 1-phenyl-1,2-propanedione-2-(O-ethoxycarbonyl)-oxime
· C-2: NCI 831 (manufactured by ADEKA Corporation)
· C-3: Irgacure OXE01 (manufactured by BASF SE) (compound represented by the following structural formula)

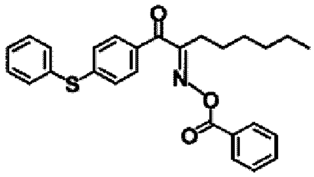

· C-4: Irgacure OXE 02 (manufactured by BASF SE)
· C-5: Irgacure OXE 03 (manufactured by BASF SE)
· C-6: Irgacure 784 (manufactured by BASF SE)
· C-7: Omnirad 819 (manufactured by IGM Resins B.V.)
· C-8: TR-PBG-304 (manufactured by Tronly)
· C-9: the following compound

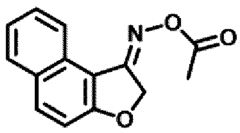

C-9

[(D) Radical polymerization inhibitor]

<(D-1) Compound having free radical in molecule>

The following D-1-1 to D-1-38 were used as the compound (D-1). The molecular weight of each compound is also described. D-1-21 is a polymer of D-1-20, and the weight-average molecular weight thereof is 10,000. D-1-33 is a mixture of two kinds of compounds (EGG-TEMPO manufactured by Seiko Chemical Co., Ltd.).

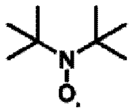

Molecular Weight: 144.24

D-1-1

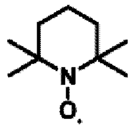

Molecular Weight: 156.25

D-1-2

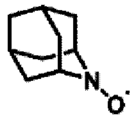

Molecular Weight: 152.22

D-1-3

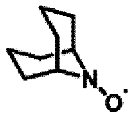

Molecular Weight: 140.21

D-1-4

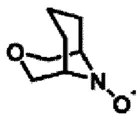

Molecular Weight: 142.18

D-1-5

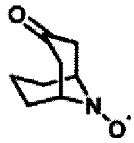

Molecular Weight: 154.19

D-1-6

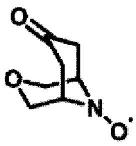

Molecular Weight: 156.16

D-1-7

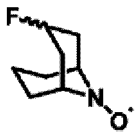

Molecular Weight: 158.20

D-1-8

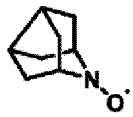

Molecular Weight: 138.19

D-1-9

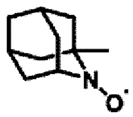

Molecular Weight: 166.24

D-1-10

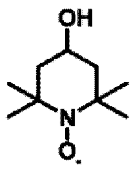

Molecular Weight: 172.25

D-1-11

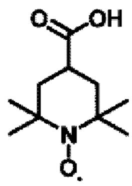

Molecular Weight: 200.26

D-1-12

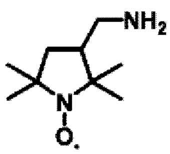

Molecular Weight: 171.26

D-1-13

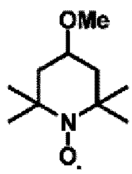

Molecular Weight: 186.28

D-1-14

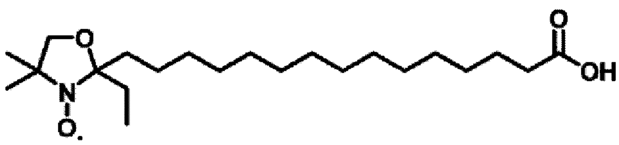

Molecular Weight: 384.58

D-1-15

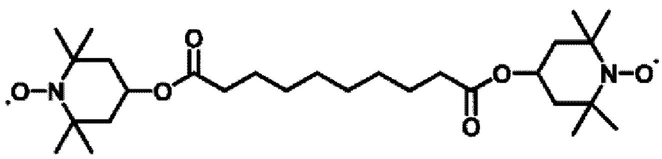

Molecular Weight: 510.72

D-1-16

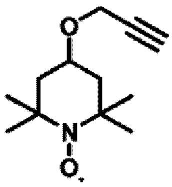

Molecular Weight: 210.30

D-1-17

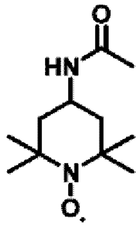

Molecular Weight: 213.30

D-1-18

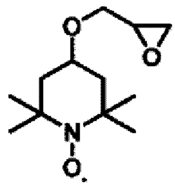

Molecular Weight: 228.31

D-1-19

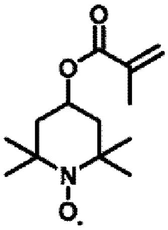

Molecular Weight: 240.32

D-1-20

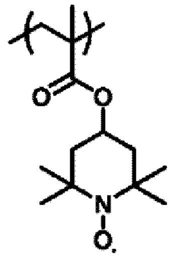

D-1-21

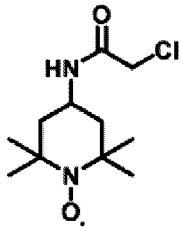

Molecular Weight: 247.74

D-1-22

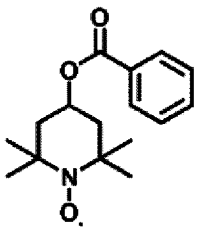

Molecular Weight: 276.36

D-1-23

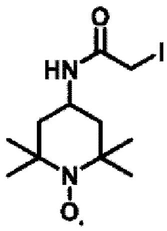

Molecular Weight: 339.20

D-1-24

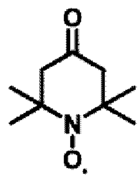

Molecular Weight: 170.23

D-1-25

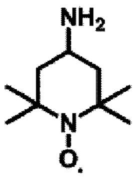

Molecular Weight: 171.26

D-1-26

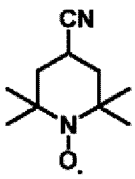

Molecular Weight: 181.26

D-1-27

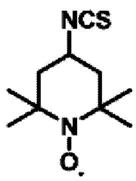

Molecular Weight: 213.32

D-1-28

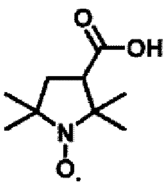

Molecular Weight: 186.23

D-1-29

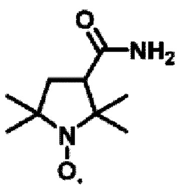

Molecular Weight: 185.25

D-1-30

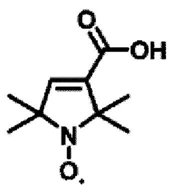

Molecular Weight: 184.22

D-1-31

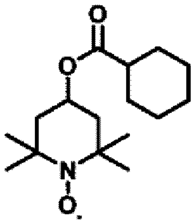

Molecular Weight: 282.40

D-1-32

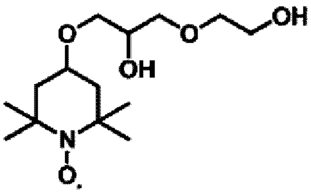

Molecular Weight: 290.38

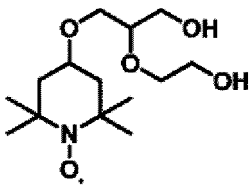

Molecular Weight: 290.38

D-1-33

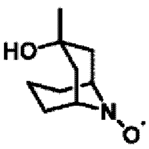

Molecular Weight: 170.23

D-1-34

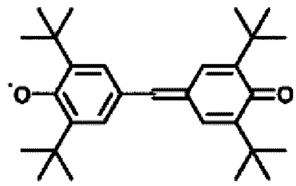

Molecular Weight: 421.65

D-1-35

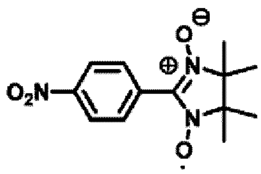

Molecular Weight: 278.29

D-1-36

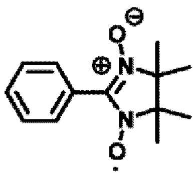

Molecular Weight: 233.29

D-1-37

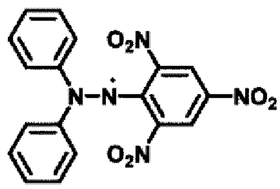

Molecular Weight: 394.32

D-1-38

<(D-2) Compound having no free radical in molecule and having molecular weight of 270 or more>

The following D-2-1 to D-2-17 were used as the compound (D-2). The molecular weight of each compound is also described.

**D-2-1**

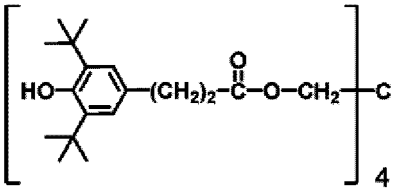

**Molecular Weight: 1177.66**
**(Irganox 1010)**

**D-2-2**

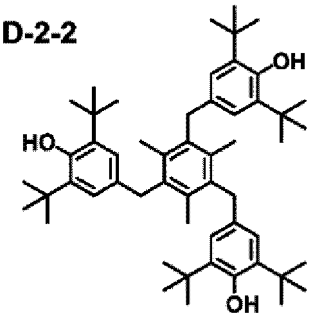

**Molecular Weight: 775.22**
**(Irganox 1330)**

**D-2-3**

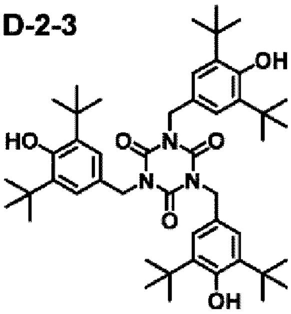

**Molecular Weight: 784.10**
**(Irganox 3114)**

**D-2-4**

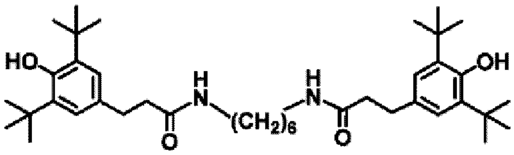

**Molecular Weight: 636.96**
**(Irganox 1098)**

**D-2-6**

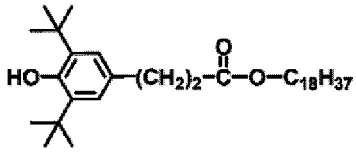

**Molecular Weight: 530.88**
**(Irganox 1076)**

**D-2-5**

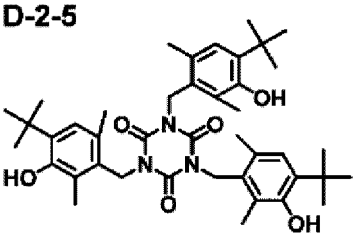

**Molecular Weight: 699.93**

- D-2-7: Irganox 1135 (manufactured by BASF SE) (molecular weight: 390)
- D-2-8: Irganox 1520L (manufactured by BASF SE) (molecular weight: 425)
- D-2-9: Irganox 245 (manufactured by BASF SE) (molecular weight: 587)
- D-2-10: Irganox 259 (manufactured by BASF SE) (molecular weight: 639)
- D-2-11: Irganox 565 (manufactured by BASF SE) (molecular weight: 589)

D-2-12

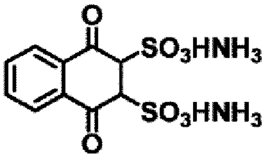

Molecular Weight: 354.35

D-2-13

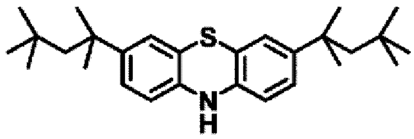

Molecular Weight: 423.70

D-2-14

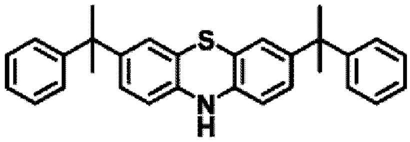

Molecular Weight: 435.63

D-2-15

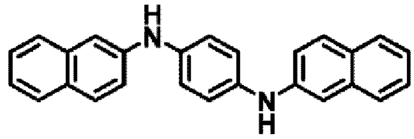

Molecular Weight: 360.46

· D-2-16: α-tocopherol

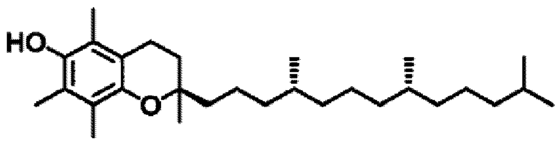

Molecular Weight: 430.72

D-2-17

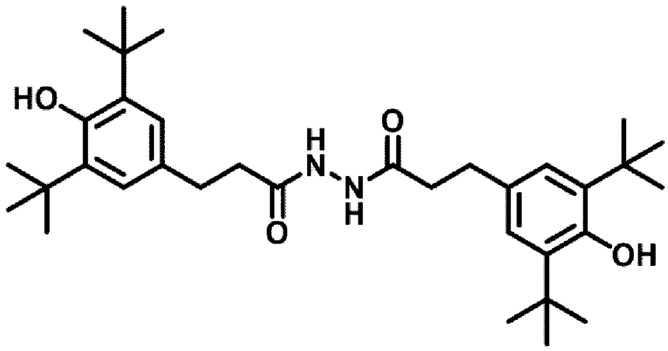

Molecular Weight: 552.80

(ADEKA STAB CDA-10)

[(DR) Other polymerization inhibitors]

The following DR-1 to DR-7 were used.

- · DR-1: p-benzoquinone (molecular weight: 108.10)
- · DR-2: 4-methoxyphenol

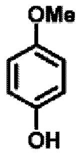

Molecular Weight: 124.14

· DR-3: 2-nitroso-1-naphthol

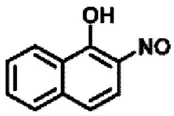

Molecular Weight: 173.17

· DR-4: phenothiazine

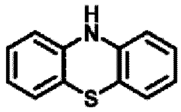

Molecular Weight: 199.27

· DR-5: phenoxazine

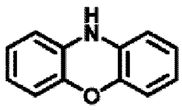

Molecular Weight: 183.21

· DR-6: 2,5-diphenyl-p-benzoquinone

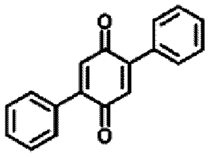

Molecular Weight: 260.29

· DR-7: 1-methoxy-4-naphthol

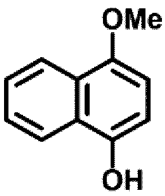

Molecular Weight: 174.20

[(E) Solvent]

· E-1: N-methylpyrrolidone
· E-2: Ethyl lactate

- E-3: γ-butyrolactone
- E-4: Dimethyl sulfoxide
- E-5: N,N-dimethylacetamide
- E-6: γ-valerolactone

[(F) Surfactant]

- F-1: F-554 (manufactured by DIC Corporation)
- F-2: F-557 (manufactured by DIC Corporation)
- F-3: KF-6000 (manufactured by Shin-Etsu Chemical Co., Ltd.)
- F-4: KF-6001 (manufactured by Shin-Etsu Chemical Co., Ltd.)
- F-5: KF-6017 (manufactured by Shin-Etsu Chemical Co., Ltd.)
- F-6: TSF4445 (manufactured by Akros Industry Co., Ltd.)

[(G) Metal adhesiveness improving agent (silane coupling agent)]

- G-1: N-[3-(triethoxysilyl)propyl]phthalamic acid
- G-2: N-[3-(triethoxysilyl)propyl]maleamic acid
- G-3: 3-methacryloxypropyltrimethoxysilane
- G-4: 2-(3,4-epoxycyclohexyl)ethyltrimethoxysilane
- G-5: The following compound

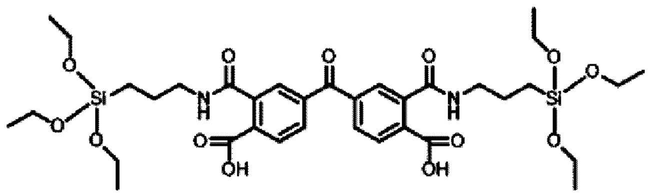

[(K) Base generator]

K-1

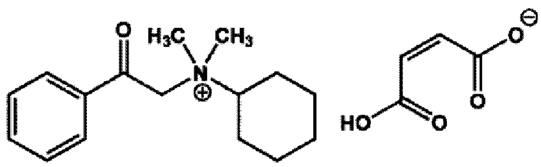

K-2

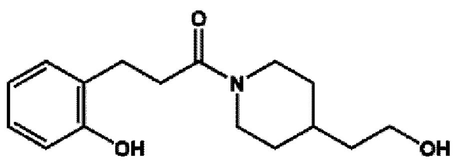

K-3

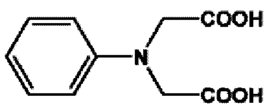

K-4 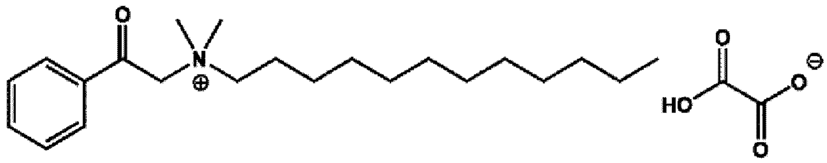

[(N) Migration suppressing agent]

- · N-1: 1H-tetrazole
- · N-2: 5-aminotetrazole
- · N-3: 3-aminotriazole
- · N-4: Benzotriazole
- · N-5: ADEKA STAB CDA-1
- · N-6: ADEKA STAB CDA-1M
- · N-7: ADEKA STAB CDA-6S

[(M) Other additives]

- · M-1: 7-diethylamino-3-ethoxycarbonylcoumarin
- · M-2: N-phenyldiethanolamine
- · M-3: An ester of 2,2',3,3'-tetrahydro-3,3,3',3'-tetramethyl-1,1'-spiro-bi(1H-indene)-5,5',6,6',7,7'-hexanol and 1,2-naphthoquinone-(2)-diazo-5-sulfonic acid (the following Formula, * represents a binding site.)

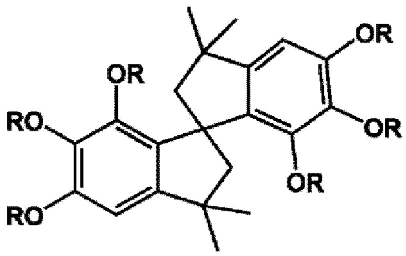

R= 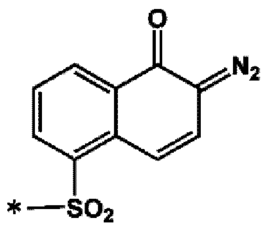 or H

- · M-4: An ester between 2,6-bis(2,3,4-trihydroxybenzyl)-p-cresol and 6-diazo5,6-dihydro-5-oxo-1-naphthalenesulfonic acid

M-5: An ester between bis(4-hydroxy-3,5-dimethylphenyl)-(4-hydroxy-3-methoxyphenyl)methane and 6-diazo-5,6-dihydro-5-oxonaphthalene-1-sulfonic acid

. M-6: The following compound

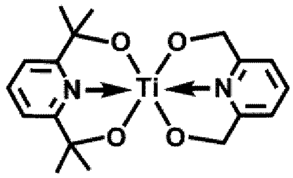

- · M-7: The following compound

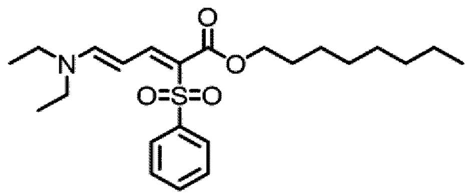

· M-8: The following compound

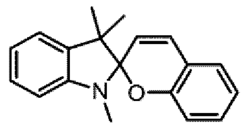

<Evaluation>

The evaluation was carried out as follows, and the results are shown in Tables 6 to 9.

[Resolution]

In each of Examples and Comparative Examples, the prepared resin composition was applied onto a base material by a slit coating method with a coater LC-R300G manufactured by SCREEN Holdings Co., Ltd.

A base material was used, where a pretreatment ($O_2$ plasma ashing treatment) under the conditions (temperature, output, and time) shown in Tables 6 to 9 was carried out on a surface on which CU of the base material is present, the base material (also referred to as "copper wafer") including CU (volume content of Cu in a region having a thickness of a depth of 0.5 μm or less from the outermost surface is 50% or more) on a surface (entire surface) consisting of silicon. However, in Example 107, a copper wafer which had not been subjected to the pretreatment was used.

The copper wafer having the coating film of the resin composition was dried under reduced pressure at the pressure, the temperature, and the time shown in Tables 6 to 9. More specifically, the temperature of the reduced pressure dryer was set to the temperature shown in "Temperature [°C]" of "Reduced pressure drying" in Tables 6 to 9, the pressure was reduced from the normal pressure to the pressure shown in "Step 1" for the time shown in "Step 1", the pressure shown in "Step 2" was maintained for the time shown in "Step 2", and then the pressure was reduced to the reaching pressure shown in "Step 3" at once, thereby carrying out the reduced pressure drying. For example, in Example 1, the temperature of the reduced pressure dryer was set to 60°C, and reduced pressure drying was performed by step 1: reducing pressure from normal pressure to 500 Pa over 100 seconds, step 2: maintaining the pressure at 500 Pa for 600 seconds, and then step 3: rapidly reducing pressure until the reduced pressure degree reached 15 Pa.

After the reduced pressure drying, drying was performed on a hot plate (at normal pressure) at the temperature and the time (for example, 100°C and 5 minutes in Example 1) shown in the columns of "Hot plate drying" described in Tables 6 to 9 to form a resin composition layer having a uniform thickness of 10 μm on the copper wafer. The film thickness was adjusted by controlling a gap between the nozzle and the wafer, a scanning speed, a jetting amount of the liquid, and the like.

In the examples in which "M" is described in the exposure conditions of Tables 6 to 9, the resin composition layer on the copper wafer was exposed at an exposure wavelength of 365 nm using a photomask of a contact hole having a hole diameter of 5 μm to 20 μm in increments of 1 μm, using a stepper. The exposure amount was changed in a range of 100 to 900 $mJ/cm^2$ in increments of 100 $mJ/cm^2$.

In the examples in which "D" is described in the exposure conditions of Tables 6 to 9, laser direct imaging exposure was performed using a direct exposure device (Adtech DE-6UH III) so that the contact holes had a hole diameter of 5 μm to 20 μm in increments of 1 μm. The exposure wavelength was set to 405 nm, and the exposure amount was changed in a range of 100 to 900 $mJ/cm^2$ in increments of 100 $mJ/cm^2$.

The exposed resin composition layer was subjected to shower development with cyclopentanone for 35 seconds, then showered with cyclopentanone-propylene glycol monomethyl ether acetate (PGMEA) for 5 seconds, and then shower rinsed with PGMEA for 15 seconds.

The diameter of the pattern obtained after the development, having the smallest contact hole pattern size, was denoted as the "minimum hole diameter" and evaluated according to the following evaluation standards. It can be said that the smaller the minimum hole diameter is, the more excellent the resolution is. This indicates that, for example, the width of the metal wire to be formed in the subsequent plating step can be made finer, which is a preferred result. The measurement limit is 5 μm. The evaluation results are described in the column of "Resolution" in the table. A, B, or C is acceptable, and A

or B is preferable.

- Evaluation standards -

A: The minimum hole diameter was less than 6 μm.
B: The minimum hole diameter was 6 μm or more and less than 8 μm.
C: The minimum hole diameter was 8 μm or more and less than 10 μm.
D: The minimum hole diameter was 10 μm or more or the hole was closed.

[Residues of unexposed portion]

In the resolution evaluation, the residues of the unexposed portion were evaluated by the film thickness measurement. A or B is preferable.

- Evaluation standards -

A: no residues were observed. (film thickness less than 0.01 μm)
B: very small residues were observed. (film thickness is 0.01 μm or more and less than 0.1 μm)
C: residues were observed. (film thickness is 0.1 μm or more and less than 1 μm)
D: residues were observed. (film thickness is 1 μm or more)

[Sensitivity (residual film ratio after development)]

In the resolution evaluation, the sensitivity was evaluated by checking the residual film ratio after development in a case of exposure at the exposure amount (sensitivity confirmation exposure amount) shown in Tables 6 to 9. It was found that all of Examples 1 to 126 had a residual film ratio of 90% or more and had appropriate exposure sensitivity. The residual film ratio was determined by (film thickness of exposed portion/film thickness before exposure) × 100 (%) after development.
In Comparative Examples 1 to 10, the residual film ratio was 90% or more, but in Comparative Example 11, the residual film ratio was less than 90%, and the result was that a part of the film was peeled off. Therefore, in Comparative Example 11, the resolution and the evaluation of the residue of the unexposed portion were not performed.

[Table 6]

| Temperature [°C] | | Pretreatrnent of base material | | | Reduced pressure drying | | | | | | Hot plate drying | | Exposing candition | | Evaluation result | |
|---|---|---|---|---|---|---|---|---|---|---|---|---|---|---|---|---|
| | | | | | Temperature [°C] | Step L | | Step 2 | | Step 3 | | | Method | Sensitivity confirmation exposure amount | Resolution | Resldues in unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| Example | 1 | 50 | 700 | 30 | 60 | 100 | 500 | 500 | 600 | 15 | 100 | 5 | M | 400 | B | A |
| | 2 | 50 | 700 | 30 | 60 | 100 | 500 | 500 | 600 | 15 | 100 | 5 | M | 400 | B | A |
| | 3 | 50 | 700 | 30 | 60 | 100 | 500 | 500 | 600 | 15 | 100 | 5 | M | 400 | B | A |
| | 4 | 50 | 700 | 30 | 60 | 100 | 500 | 500 | 600 | 15 | 100 | 5 | M | 400 | B | A |
| | 5 | 50 | 700 | 30 | 60 | 100 | 500 | 500 | 600 | 15 | 100 | 5 | M | 400 | B | A |
| | 6 | 50 | 700 | 30 | 60 | 100 | 500 | 500 | 600 | 15 | 100 | 5 | M | 400 | B | A |
| | 7 | 50 | 700 | 30 | 60 | 100 | 500 | 500 | 600 | 15 | 100 | 5 | M | 400 | B | A |
| | 8 | 50 | 700 | 30 | 60 | 100 | 500 | 500 | 600 | 15 | 100 | 5 | M | 400 | B | A |
| | 9 | 50 | 700 | 30 | 60 | 100 | 500 | 500 | 600 | 15 | 100 | 5 | M | 400 | B | B |
| | 10 | 50 | 700 | 30 | 60 | 100 | 500 | 500 | 600 | 15 | 100 | 5 | M | 400 | A | A |
| | 11 | 50 | 700 | 30 | 60 | 100 | 500 | 500 | 600 | 15 | 100 | 5 | M | 400 | B | A |
| | 12 | 50 | 700 | 30 | 60 | 100 | 500 | 500 | 600 | 15 | 100 | 5 | M | 400 | B | A |
| | 13 | 50 | 700 | 30 | 60 | 100 | 500 | 500 | 600 | 15 | 100 | 5 | M | 400 | B | A |
| | 14 | 50 | 700 | 30 | 60 | 100 | 500 | 500 | 600 | 15 | 100 | 5 | M | 400 | B | A |
| | 15 | 50 | 700 | 30 | 60 | 100 | 500 | 500 | 600 | 15 | 100 | 5 | M | 400 | A | A |
| | 16 | 50 | 700 | 30 | 60 | 100 | 500 | 500 | 600 | 15 | 100 | 5 | M | 400 | A | A |
| | 17 | 50 | 700 | 30 | 60 | 100 | 500 | 500 | 600 | 15 | 100 | 5 | M | 400 | A | A |
| | 18 | 50 | 700 | 30 | 60 | 100 | 500 | 500 | 600 | 15 | 100 | 5 | M | 400 | A | A |
| | 19 | 50 | 700 | 30 | 60 | 100 | 500 | 500 | 600 | 15 | 100 | 5 | M | 400 | A | A |
| | 20 | 50 | 700 | 30 | 60 | 100 | 500 | 500 | 600 | 15 | 100 | 5 | M | 400 | A | A |
| | 21 | 50 | 700 | 30 | 60 | 100 | 500 | 500 | 600 | 15 | 100 | 5 | M | 400 | A | A |

(continued)

| Temperature [°C] | | Pretreatrnent of base material | | | Reduced pressure drying | | | | | | Hot plate drying | | Exposing candition | | Evaluation result | |
|---|---|---|---|---|---|---|---|---|---|---|---|---|---|---|---|---|
| | | | | | Temperature [°C] | Step L | | Step 2 | | Step 3 | | | Method | Sensitivity confirmation exposure amount | Resolution | Resldues in unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| | 22 | 50 | 700 | 30 | 60 | 100 | 500 | 500 | 600 | 15 | 100 | 5 | M | 400 | A | A |
| | 23 | 50 | 700 | 30 | 60 | 100 | 500 | 500 | 600 | 15 | 100 | 5 | M | 400 | A | A |
| | 24 | 50 | 700 | 30 | 60 | 100 | 500 | 500 | 600 | 15 | 100 | 5 | M | 400 | A | A |
| | 25 | 50 | 700 | 30 | 60 | 100 | 500 | 500 | 600 | 15 | 100 | 5 | M | 400 | B | A |
| | 26 | 50 | 700 | 30 | 60 | 100 | 500 | 500 | 600 | 15 | 100 | 5 | M | 600 | A | A |
| | 27 | 50 | 700 | 30 | 60 | 100 | 500 | 500 | 600 | 15 | 100 | 5 | M | 400 | A | A |
| | 28 | 50 | 700 | 30 | 60 | 100 | 500 | 500 | 600 | 15 | 100 | 5 | M | 400 | A | A |
| | 29 | 50 | 700 | 30 | 60 | 100 | 500 | 500 | 600 | 15 | 100 | 5 | M | 400 | A | A |
| | 30 | 50 | 700 | 30 | 60 | 100 | 500 | 500 | 600 | 15 | 100 | 5 | M | 400 | A | A |
| | 31 | 50 | 700 | 30 | 60 | 100 | 500 | 500 | 600 | 15 | 100 | 5 | M | 400 | A | A |
| | 32 | 50 | 700 | 30 | 60 | 100 | 500 | 500 | 600 | 15 | 100 | 5 | M | 400 | A | A |
| | 33 | 50 | 700 | 30 | 60 | 100 | 500 | 500 | 600 | 15 | 100 | 5 | M | 600 | A | A |
| | 34 | 50 | 700 | 30 | 60 | 100 | 500 | 500 | 600 | 15 | 100 | 5 | M | 400 | A | A |
| | 35 | 50 | 700 | 30 | 60 | 100 | 500 | 500 | 600 | 15 | 100 | 5 | M | 400 | A | A |
| | 36 | 50 | 700 | 30 | 60 | 100 | 500 | 500 | 600 | 15 | 100 | 5 | M | 400 | B | A |
| | 37 | 50 | 700 | 30 | 60 | 100 | 500 | 500 | 600 | 15 | 100 | 5 | M | 600 | A | A |
| | 38 | 50 | 700 | 30 | 60 | 100 | 500 | 500 | 600 | 15 | 100 | 5 | M | 400 | A | A |
| | 39 | 50 | 700 | 30 | 60 | 100 | 500 | 500 | 600 | 15 | 100 | 5 | M | 400 | A | A |
| | 40 | 50 | 700 | 30 | 60 | 100 | 500 | 500 | 600 | 15 | 100 | 5 | M | 400 | B | B |

[Table 7]

| | | Pretreatment of base material | | | Reduced pressure drying | | | | | | Hot plate drying | | Exposing condition | | Evaluation result | |
|---|---|---|---|---|---|---|---|---|---|---|---|---|---|---|---|---|
| | | | | | Temperature [°C] | Step 1 | | Step 2 | | Step 3 | | | Method | Sensdtivity confirmation exposure amount | Resolution | Residues in unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| | 41 | 50 | 700 | 30 | 60 | 100 | 500 | 500 | 600 | 15 | 100 | 5 | M | 400 | B | B |
| | 42 | 50 | 700 | 30 | 60 | 60 | 1500 | 1500 | 600 | 15 | 100 | 5 | M | 400 | B | B |
| | 43 | 50 | 700 | 30 | 60 | 100 | 500 | 500 | 600 | 15 | 100 | 5 | M | 600 | C | B |
| | 44 | 50 | 700 | 30 | 60 | 100 | 500 | 500 | 600 | 15 | 100 | 5 | M | 400 | C | B |
| | 45 | 50 | 700 | 30 | 60 | 100 | 500 | 500 | 600 | 15 | 100 | 5 | M | 400 | C | B |
| | 46 | 50 | 700 | 30 | 60 | 100 | 500 | 500 | 600 | 15 | 100 | 5 | M | 400 | C | B |
| | 47 | 50 | 700 | 30 | 60 | 100 | 500 | 500 | 600 | 15 | 100 | 5 | M | 400 | C | B |
| | 48 | 50 | 700 | 30 | 60 | 100 | 500 | 500 | 600 | 15 | 100 | 5 | M | 400 | C | B |
| | 49 | 50 | 700 | 30 | 60 | 100 | 500 | 500 | 600 | 15 | 100 | 5 | M | 400 | C | B |
| | 50 | 50 | 700 | 30 | 60 | 100 | 500 | 500 | 600 | 15 | 100 | 5 | M | 400 | C | B |
| | 51 | 50 | 700 | 30 | 60 | 100 | 500 | 500 | 600 | 15 | 100 | 5 | M | 400 | C | B |
| | 52 | 50 | 700 | 30 | 60 | 100 | 500 | 500 | 600 | 15 | 100 | 5 | M | 400 | A | A |
| | 53 | 50 | 700 | 30 | 60 | 100 | 500 | 500 | 600 | 15 | 100 | 5 | M | 400 | B | A |
| | 54 | 50 | 700 | 60 | 60 | 100 | 500 | 500 | 600 | 15 | 100 | 5 | M | 400 | A | A |
| | 55 | 60 | 700 | 30 | 60 | 100 | 500 | 500 | 600 | 15 | 100 | 5 | M | 400 | A | A |
| | 56 | 40 | 700 | 30 | 60 | 100 | 500 | 500 | 600 | 15 | 100 | 5 | M | 400 | A | A |
| | 57 | 50 | 700 | 30 | 60 | 100 | 500 | 500 | 600 | 15 | 100 | 5 | M | 400 | A | A |
| | 58 | 50 | 700 | 30 | 60 | 100 | 500 | 500 | 600 | 15 | 100 | 5 | M | 400 | A | A |
| | 59 | 50 | 700 | 30 | 35 | 100 | 500 | 500 | 750 | 15 | 100 | 5 | M | 400 | A | A |
| | 60 | 50 | 700 | 30 | 50 | 100 | 500 | 500 | 600 | 15 | 100 | 5 | M | 600 | A | A |

(continued)

| | | Pretreatment of base material | | | Reduced pressure drying | | | | | | Hot plate drying | | Exposing condition | | Evaluation result | |
|---|---|---|---|---|---|---|---|---|---|---|---|---|---|---|---|---|
| | | | | | Temperature [°C] | Step 1 | | Step 2 | | Step 3 | | | Method | Sensdtivity confirmation exposure amount | Resolution | Residues in unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| Example | 61 | 50 | 700 | 30 | 60 | 100 | 500 | 500 | 600 | 15 | 100 | 5 | M | 400 | A | A |
| | 62 | 50 | 700 | 30 | 60 | 100 | 500 | 500 | 600 | 15 | 100 | 5 | M | 400 | B | A |
| | 63 | 50 | 700 | 30 | 40 | 100 | 500 | 500 | 750 | 15 | 100 | 5 | M | 600 | A | A |
| | 64 | 50 | 700 | 30 | 80 | 100 | 500 | 500 | 240 | 15 | 100 | 5 | M | 400 | A | A |
| | 65 | 50 | 700 | 30 | 25 | 100 | 500 | 500 | 930 | 15 | 100 | 5 | M | 400 | A | A |
| | 66 | 50 | 700 | 30 | 60 | 120 | 300 | 300 | 600 | 15 | 100 | 5 | M | 400 | A | A |
| | 67 | 50 | 700 | 30 | 60 | 100 | 1000 | 1000 | 600 | 15 | 100 | 5 | M | 400 | A | A |
| | 68 | 50 | 700 | 30 | 60 | 100 | 500 | 500 | 600 | 10 | 100 | 5 | M | 400 | A | A |
| | 69 | 50 | 700 | 30 | 60 | 100 | 500 | 500 | 600 | 15 | 100 | 5 | M | 400 | A | A |
| | 70 | 50 | 700 | 30 | 60 | 100 | 500 | 500 | 600 | 15 | 100 | 5 | M | 400 | A | A |
| | 71 | 50 | 700 | 30 | 60 | 100 | 500 | 500 | 600 | 15 | 100 | 5 | M | 400 | A | A |
| | 72 | 50 | 700 | 45 | 60 | 100 | 500 | 500 | 600 | 15 | 100 | 5 | M | 400 | A | A |
| | 73 | 50 | 700 | 30 | 60 | 100 | 500 | 500 | 600 | 15 | 100 | 5 | M | 400 | A | A |
| | 74 | 50 | 700 | 30 | 60 | 100 | 500 | 500 | 600 | 15 | 100 | 5 | M | 400 | A | A |
| | 75 | 50 | 700 | 30 | 25 | 100 | 500 | 500 | 930 | 15 | 100 | 5 | M | 400 | A | A |
| | 76 | 50 | 700 | 30 | 60 | 100 | 500 | 500 | 600 | 15 | 100 | 5 | M | 400 | A | A |
| | 77 | 50 | 700 | 30 | 60 | 100 | 500 | 500 | 600 | 15 | 100 | 5 | M | 400 | A | A |
| | 78 | 50 | 700 | 30 | 90 | 100 | 500 | 500 | 180 | 15 | 100 | 5 | M | 400 | B | A |
| | 79 | 50 | 700 | 30 | 60 | 100 | 500 | 500 | 600 | 15 | 100 | 5 | D | 600 | A | A |
| | 80 | 50 | 700 | 30 | 60 | 100 | 500 | 500 | 600 | 15 | 100 | 5 | M | 400 | A | A |

[Table 8]

| | | Pretreatment of base material | | | Reduced pressure drying | | | | | | Hot plate drying | | Exposing condition | | Evaluation result | |
|---|---|---|---|---|---|---|---|---|---|---|---|---|---|---|---|---|
| | | | | | Temperature [°C] | Step 1 | | Step 2 | | Step 3 | | | Method | Sensitivity confirmation exposure amount | Resolution | Residues unexposed portion |
| | | Temperature [°C] | Output [W] | Time [sec.] | | Time [sec.] | Pressure [Pa] | Pressure [Pa] | Time [sec.] | Reaching pressure [Pa] | Temp erature [°C] | Time [min.] | M or D | [mJ/cm$^2$] | | |
| Example | 81 | 50 | 700 | 30 | 60 | 100 | 500 | 500 | 600 | 15 | 100 | 5 | M | 400 | A | A |
| | 82 | 50 | 700 | 30 | 60 | 100 | 500 | 500 | 600 | 15 | 100 | 5 | M | 400 | A | A |
| | 83 | 50 | 700 | 30 | 60 | 100 | 500 | 500 | 600 | 15 | 100 | 5 | M | 400 | A | A |
| | 84 | 50 | 700 | 30 | 60 | 100 | 500 | 500 | 600 | 20 | 90 | 5 | M | 400 | A | A |
| | 85 | 50 | 700 | 30 | 60 | 100 | 500 | 500 | 600 | 15 | 100 | 5 | M | 400 | A | A |
| | 86 | 50 | 700 | 30 | 60 | 100 | 500 | 500 | 600 | 15 | 100 | 5 | M | 400 | A | A |
| | 87 | 50 | 700 | 30 | 60 | 100 | 500 | 500 | 600 | 15 | 100 | 5 | M | 400 | A | A |
| | 88 | 50 | 700 | 30 | 60 | 100 | 500 | 500 | 600 | 15 | 100 | 5 | D | 600 | A | A |
| | 89 | 50 | 700 | 30 | 60 | 100 | 500 | 500 | 600 | 15 | 100 | 5 | M | 400 | A | A |
| | 90 | 50 | 700 | 30 | 60 | 100 | 500 | 500 | 600 | 15 | 100 | 5 | M | 400 | A | A |
| | 91 | 50 | 700 | 30 | 60 | 100 | 500 | 500 | 600 | 15 | 100 | 5 | M | 400 | A | A |
| | 92 | 50 | 700 | 30 | 60 | 100 | 500 | 500 | 600 | 15 | 100 | 5 | M | 400 | A | A |
| | 93 | 50 | 700 | 30 | 60 | 100 | 500 | 500 | 600 | 15 | 100 | 5 | M | 400 | A | A |
| | 94 | 50 | 700 | 30 | 60 | 100 | 500 | 500 | 600 | 15 | 100 | 5 | M | 400 | A | A |
| | 95 | 50 | 700 | 30 | 60 | 100 | 500 | 500 | 600 | 15 | 100 | 5 | M | 400 | A | A |
| | 96 | 50 | 700 | 90 | 60 | 100 | 500 | 500 | 600 | 15 | 100 | 5 | M | 400 | A | A |
| | 97 | 50 | 700 | 30 | 60 | 100 | 500 | 500 | 600 | 15 | 100 | 5 | M | 400 | A | A |
| | 98 | 50 | 700 | 30 | 60 | 100 | 500 | 500 | 600 | 15 | 110 | 5 | M | 400 | A | A |
| | 99 | 50 | 700 | 30 | 60 | 100 | 500 | 500 | 600 | 15 | 100 | 5 | M | 400 | A | A |
| | 100 | 50 | 700 | 30 | 60 | 100 | 500 | 500 | 600 | 15 | 100 | 5 | M | 400 | A | A |

(continued)

| | | Pretreatment of base material | | | Reduced pressure drying | | | | | | Hot plate drying | | Exposing condition | | Evaluation result | |
|---|---|---|---|---|---|---|---|---|---|---|---|---|---|---|---|---|
| | | | | | Temperature [°C] | Step 1 | | Step 2 | | Step 3 | | | Method | Sensitivity confirmation exposure amount | Resolution | Residues unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| | 101 | 50 | 700 | 30 | 60 | 100 | 500 | 500 | 600 | 15 | 100 | 5 | M | 400 | A | A |
| | 102 | 50 | 700 | 30 | 60 | 100 | 500 | 500 | 600 | 15 | 100 | 5 | M | 400 | A | A |
| | 103 | 50 | 700 | 30 | 60 | 100 | 500 | 500 | 600 | 8 | 100 | 5 | M | 400 | A | A |
| | 104 | 50 | 700 | 30 | 60 | 100 | 500 | 500 | 600 | 15 | 120 | 3 | M | 400 | A | A |
| | 105 | 50 | 700 | 30 | 60 | 100 | 500 | 500 | 600 | 15 | 100 | 5 | M | 400 | A | A |
| | 106 | 50 | 700 | 30 | 60 | 100 | 500 | 500 | 600 | 15 | 100 | 5 | M | 400 | A | A |
| | 107 | - | - | - | 60 | 100 | 500 | 500 | 600 | 15 | 100 | 5 | M | 400 | B | B |
| | 108 | 50 | 700 | 30 | 60 | 100 | 500 | 500 | 600 | 15 | 100 | 5 | M | 600 | B | B |
| | 109 | 50 | 700 | 30 | 60 | 100 | 500 | 500 | 600 | 15 | 100 | 5 | M | 400 | B | B |
| | 110 | 50 | 700 | 30 | 60 | 100 | 500 | 500 | 600 | 15 | 100 | 5 | M | 400 | B | B |
| | 111 | 50 | 700 | 30 | 60 | 100 | 500 | 500 | 600 | 15 | 100 | 5 | M | 400 | B | B |
| Comparative Example | 1 | 50 | 700 | 30 | 60 | 100 | 500 | 500 | 600 | 15 | 100 | 5 | M | 400 | D | D |
| | 2 | 50 | 700 | 30 | 60 | 100 | 500 | 500 | 600 | 15 | 100 | 5 | M | 400 | D | D |
| | 3 | 50 | 700 | 30 | 60 | 100 | 500 | 500 | 600 | 15 | 100 | 5 | M | 400 | D | D |
| | 4 | 50 | 700 | 30 | 60 | 100 | 500 | 500 | 600 | 15 | 100 | 5 | M | 400 | D | D |
| | 5 | 50 | 700 | 30 | 60 | 100 | 500 | 500 | 600 | 15 | 100 | 5 | M | 400 | D | D |
| | 6 | 50 | 700 | 30 | 60 | 100 | 500 | 500 | 600 | 15 | 100 | 5 | M | 400 | D | D |
| | 7 | 50 | 700 | 30 | 40 | 100 | 500 | 500 | 750 | 15 | 100 | 5 | M | 600 | D | D |
| | 8 | 50 | 700 | 60 | 60 | 100 | 500 | 500 | 600 | 15 | 100 | 5 | M | 400 | D | D |
| | 9 | 50 | 700 | 30 | 60 | 100 | 500 | 500 | 600 | 15 | 100 | 5 | M | 400 | D | D |
| | 10 | 50 | 700 | 30 | 60 | 100 | 500 | 500 | 300 | 15 | 100 | 5 | M | 400 | D | D |

(continued)

| | | Pretreatment of base material | | | Reduced pressure drying | | | | | | Hot plate drying | | Exposing condition | | Evaluation result | |
|---|---|---|---|---|---|---|---|---|---|---|---|---|---|---|---|---|
| | | | | | Temperature [°C] | Step 1 | | Step 2 | | Step 3 | | | Method | Sensitivity confirmation exposure amount | Resolution | Residues unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| | 11 | 50 | 700 | 30 | 60 | 100 | 10000 | 10000 | 600 | 10000 | 100 | 5 | M | 400 | - | - |

[Table 9]

| | | Pretreatment of base material | | | Reduced pressure drying | | | | | | Hot plate drying | | Exposing condition | | Evaluation result | |
|---|---|---|---|---|---|---|---|---|---|---|---|---|---|---|---|---|
| | | | | | Temperature [°C] | Step 1 | | Step 2 | | Step 3 | | | Method | Sensitivity confirmation exposure amount | Resolution | Residues in unexposed portion |
| | | Temperature [°C] | Output [W] | Time [sec.] | | Time [sec.] | Pressure [Pa] | Pressure [Pa] | Time [sec.] | Reaching pressure [Pa] | Temperature [°C] | Time [min.] | M or D | [mJ/cm$^2$] | | |
| Example | 112 | 50 | 700 | 30 | 40 | 100 | 500 | 500 | 600 | 15 | 100 | 4 | M | 400 | B | B |
| | 113 | 50 | 700 | 30 | 40 | 100 | 500 | 500 | 600 | 15 | 100 | 5 | M | 400 | A | A |
| | 114 | 50 | 700 | 30 | 40 | 100 | 500 | 500 | 600 | 15 | 100 | 5 | M | 400 | A | A |
| | 115 | 50 | 700 | 30 | 50 | 100 | 500 | 500 | 600 | 15 | 100 | 5 | M | 400 | A | A |
| | 116 | 50 | 700 | 30 | 50 | 100 | 500 | 500 | 600 | 15 | 100 | 6 | M | 400 | A | A |
| | 117 | 50 | 700 | 30 | 50 | 100 | 500 | 500 | 600 | 15 | 100 | 4 | M | 400 | A | A |
| | 118 | 50 | 700 | 30 | 60 | 100 | 500 | 500 | 300 | 15 | 100 | 5 | M | 400 | A | A |
| | 119 | 50 | 700 | 30 | 60 | 100 | 500 | 500 | 300 | 15 | 100 | 5 | M | 400 | A | A |
| | 120 | 50 | 700 | 30 | 25 | 100 | 500 | 500 | 300 | 15 | 100 | 5 | M | 400 | A | A |
| | 121 | 50 | 700 | 30 | 40 | 100 | 500 | 500 | 600 | 15 | 100 | 5 | M | 400 | B | B |
| | 122 | 50 | 700 | 30 | 40 | 100 | 500 | 500 | 600 | 15 | 110 | 5 | M | 400 | A | A |
| | 123 | 50 | 700 | 30 | 40 | 100 | 500 | 500 | 600 | 15 | 90 | 5 | M | 400 | A | A |
| | 124 | 50 | 700 | 30 | 25 | 100 | 500 | 500 | 600 | 15 | 100 | 5 | M | 400 | A | A |
| | 125 | 50 | 700 | 30 | 50 | 100 | 500 | 500 | 600 | 15 | 100 | 5 | M | 400 | A | A |
| | 126 | 50 | 700 | 30 | 50 | 100 | 500 | 500 | 600 | 15 | 100 | 5 | M | 400 | A | A |

<Examples 127 to 225 and Comparative Examples 12 to 22>

In each of Examples and Comparative Examples, the components shown in Tables 10 to 13 below were mixed to obtain each resin composition.

Specifically, the content of the solid content among each component shown in Tables 10 to 13 was the amount (parts by mass) shown in the column of "amount" in each column of the tables. The "amount" of the solvent is a content mass ratio of each solvent with respect to the total amount of the solvent. The usage amount of the total solvent was adjusted such that the concentration of solid contents of each resin composition was the value shown in the table.

The obtained resin composition was filtered under pressure using a filter made of polytetrafluoroethylene, having a micropore width of 0.5 μm.

In the table, "(B-1)" represents "(B-1) radically polymerizable compound", "(C)" represents "(C) photopolymerization initiator", "(D-1)" represents "(D-1) compound having free radical in molecule", "(D-2)" represents "(D-2) compound having no free radical in molecule and having molecular weight of 270 or more", "(DR)" represents "(DR) other polymerization inhibitors", "(F)" represents "(F) surfactant", "(G)" represents "(G) metal adhesiveness improving agent (silane coupling agent)", "(K)" represents "(K) base generator", "(N)" represents "(N) migration suppressing agent", and "(M)" represents "(M) other additives".

In the table, the description of "-" indicates that the corresponding component is not contained in the resin composition.

"G-12" described in the column of "(G)" of Example 163 means a mixture of G-1 and G-2 (G-1/G-2 in terms of mass ratio = 1/1). That is, in Example 163, as the (G) metal adhesiveness improving agent (silane coupling agent), G-1 and G-2 were used in a total amount of 1.60 parts by mass at a mass ratio of G-1/G-2 = 1/1.

"K-12" described in the column of "(K)" of Example 190 means a mixture of K-1 and K-2 (K-1/K-2 = 1/1 in terms of mass ratio). That is, in Example 190, as the (K) base generator, K-1 and K-2 were used in a total amount of 2.40 parts by mass at a mass ratio of K-1/K-2 = 1/1.

"N-12" described in the column of "(N)" of Example 194 means a mixture of N-1 and N-2 (N-1/N-2 = 1/1 in terms of mass ratio). That is, in Example 194, as the (N) migration suppressing agent, N-1 and N-2 were used in a total amount of 0.36 parts by mass at a mass ratio of N-1/N-2 = 1/1.

In Example 250, 2.46 parts by mass of C-3 and 1.25 parts by mass of C-7 were used as the (C) photopolymerization initiator.

[Table 10]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-I) | | (C) | | (D-I) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 127 | 23.00 | A-1 | 80.78 | B-I-1 | 12.50 | C-3 | 2.75 | D-I-1 | 0.20 | - | 0.00 | - | 0.00 | - | 0.00 | G-1 | 1.50 | K-1 | 2.00 | N-1 | 0.27 | - | 0.00 | E-3 | 80 | E-4 | 20 |
| | 128 | 24.00 | A-2 | 80.07 | B-I-2 | 12.80 | C-3 | 2.68 | D-I-2 | 0.55 | - | 0.00 | - | 0.00 | - | 0.00 | G-2 | 1.65 | K-1 | 1.95 | N-2 | 0.30 | - | 0.00 | E-3 | 80 | E-4 | 20 |
| | 129 | 21.40 | A-3 | 80.80 | B-I-3 | 12.00 | C-3 | 2.88 | D-I-3 | 0.18 | - | 0.00 | - | 0.00 | - | 0.00 | G-1 | 1.70 | K-1 | 2.20 | N-1 | 0.24 | - | 0.00 | E-3 | 80 | E-4 | 20 |
| | 130 | 24.60 | A-4 | 80.27 | B-I-4 | 12.40 | C-3 | 2.91 | D-I-4 | 0.36 | - | 0.00 | - | 0.00 | - | 0.00 | G-2 | 1.70 | K-1 | 2.00 | N-2 | 0.36 | - | 0.00 | E-3 | 75 | E-4 | 25 |
| | 131 | 26.10 | A-5 | 80.33 | B-I-5 | 12.60 | C-3 | 2.54 | D-I-5 | 0.50 | - | 0.00 | - | 0.00 | - | 0.00 | G-1 | 1.65 | K-1 | 1.98 | N-1 | 0.30 | - | 0.00 | E-3 | 80 | E-4 | 20 |
| | 132 | 22.80 | A-6 | 80.99 | B-I-6 | 12.50 | C-3 | 2.58 | D-I-6 | 0.32 | - | 0.00 | - | 0.00 | - | 0.00 | G-2 | 1.45 | K-1 | 1.89 | N-2 | 0.27 | - | 0.00 | E-3 | 80 | E-4 | 20 |
| | 133 | 32.00 | A-7 | 80.84 | B-I-7 | 12.20 | C-3 | 2.54 | D-I-7 | 0.20 | - | 0.00 | - | 0.00 | - | 0.00 | G-5 | 2.00 | K-1 | 1.90 | N-1 | 0.22 | - | 0.00 | E-3 | 80 | E-4 | 20 |
| | 134 | 23.30 | A-8 | 81.31 | B-I-1 | 12.40 | C-3 | 2.60 | D-I-8 | 0.11 | - | 0.00 | - | 0.00 | - | 0.00 | G-5 | 1.40 | K-1 | 1.94 | N-2 | 0.24 | - | 0.00 | E-3 | 80 | E-4 | 20 |
| | 135 | 24.70 | A-9 | 79.65 | B-I-1 | 13.00 | C-3 | 2.80 | D-I-9 | 0.44 | - | 0.00 | - | 0.00 | - | 0.00 | G-5 | 1.75 | K-1 | 2.00 | N-1 | 0.36 | - | 0.00 | E-3 | 80 | E-4 | 20 |
| | 136 | 27.50 | A-10 | 80.45 | B-I-8 | 12.80 | C-3 | 2.55 | D-I-10 | 0.22 | - | 0.00 | - | 0.00 | - | 0.00 | G-5 | 1.60 | K-1 | 1.98 | N-2 | 0.30 | - | 0.00 | E-3 | 80 | E-4 | 20 |
| | 137 | 25.50 | A-11 | 81.83 | B-I-9 | 14.00 | C-3 | 2.77 | D-I-11 | 0.24 | - | 0.00 | - | 0.00 | - | 0.00 | G-1 | 1.00 | - | 0.00 | N-1 | 0.16 | - | 0.00 | E-1 | 100 | - | 0 |
| | 138 | 22.90 | A-12 | 80.56 | B-I-10 | 15.00 | C-3 | 2.96 | D-I-12 | 0.26 | - | 0.00 | - | 0.00 | - | 0.00 | G-2 | 1.00 | - | 0.00 | N-2 | 0.22 | - | 0.00 | E-3 | 80 | E-4 | 20 |
| | 139 | 24.90 | A-13 | 83.30 | B-I-1 | 12.50 | C-3 | 2.72 | D-I-11 | 0.26 | - | 0.00 | - | 0.00 | - | 0.00 | G-2 | 1.00 | - | 0.00 | N-2 | 0.22 | - | 0.00 | E-3 | 80 | E-4 | 20 |
| | 140 | 26.00 | A-14 | 82.06 | B-I-1 | 13.20 | C-3 | 3.10 | D-I-13 | 0.20 | - | 0.00 | - | 0.00 | - | 0.00 | G-2 | 1.20 | - | 0.00 | N-1 | 0.24 | - | 0.00 | E-3 | 80 | E-4 | 20 |
| | 141 | 27.10 | A-1 | 78.83 | B-I-1 | 12.20 | C-3 | 2.48 | D-I-14 | 0.29 | - | 0.00 | - | 0.00 | - | 0.00 | G-2 | 1.15 | K-2 | 2.85 | N-2 | 0.20 | M-1 | 2.00 | E-3 | 80 | E-4 | 20 |
| | 142 | 21.90 | A-2 | 79.60 | B-I-1 | 12.60 | C-3 | 2.76 | D-I-15 | 0.30 | - | 0.00 | - | 0.00 | - | 0.00 | G-2 | 1.30 | K-2 | 3.00 | N-2 | 0.44 | - | 0.00 | E-3 | 75 | E-4 | 25 |
| | 143 | 22.80 | A-3 | 81.52 | B-I-1 | 11.80 | C-3 | 2.58 | D-I-16 | 0.26 | - | 0.00 | - | 0.00 | - | 0.00 | G-2 | 1.45 | K-2 | 1.99 | N-2 | 0.40 | - | 0.00 | E-3 | 80 | E-4 | 20 |
| | 144 | 26.40 | A-4 | 80.21 | B-I-1 | 12.20 | C-3 | 2.55 | D-I-17 | 0.23 | - | 0.00 | - | 0.00 | - | 0.00 | G-2 | 1.80 | K-2 | 2.66 | N-2 | 0.35 | - | 0.00 | E-3 | 80 | E-4 | 20 |
| | 145 | 25.10 | A-5 | 79.08 | B-I-1 | 12.60 | C-3 | 2.67 | D-I-18 | 0.25 | - | 0.00 | - | 0.00 | - | 0.00 | G-2 | 2.20 | K-2 | 2.87 | N-2 | 0.33 | - | 0.00 | E-3 | 80 | E-4 | 20 |
| | 146 | 24.20 | A-6 | 80.32 | B-I-1 | 12.40 | C-3 | 2.49 | D-I-19 | 0.34 | - | 0.00 | - | 0.00 | - | 0.00 | G-2 | 1.65 | K-2 | 2.46 | N-2 | 0.34 | - | 0.00 | E-3 | 80 | E-4 | 20 |
| | 147 | 29.00 | A-7 | 80.84 | B-I-1 | 11.60 | C-3 | 2.85 | D-I-20 | 0.30 | - | 0.00 | - | 0.00 | - | 0.00 | G-2 | 1.45 | K-2 | 2.66 | N-2 | 0.30 | - | 0.00 | E-3 | 80 | E-4 | 20 |
| | 148 | 26.70 | A-8 | 79.93 | B-I-1 | 12.80 | C-3 | 2.88 | D-I-21 | 0.28 | - | 0.00 | - | 0.00 | - | 0.00 | G-2 | 1.30 | K-2 | 2.45 | N-2 | 0.36 | - | 0.00 | E-1 | 80 | E-2 | 20 |
| | 149 | 24.40 | A-9 | 81.04 | B-I-1 | 11.00 | C-3 | 2.91 | D-I-22 | 0.36 | - | 0.00 | - | 0.00 | - | 0.00 | G-2 | 1.75 | K-2 | 2.70 | N-2 | 0.24 | - | 0.00 | E-3 | 80 | E-4 | 20 |
| | 150 | 26.00 | A-10 | 80.66 | B-I-1 | 12.60 | C-3 | 2.50 | D-I-23 | 0.24 | - | 0.00 | - | 0.00 | - | 0.00 | G-2 | 1.50 | K-2 | 2.20 | N-2 | 0.30 | - | 0.00 | E-3 | 80 | E-4 | 20 |
| | 151 | 23.70 | A-12 | 82.71 | B-I-1 | 12.40 | C-3 | 2.53 | D-I-24 | 0.20 | - | 0.00 | - | 0.00 | - | 0.00 | G-2 | 1.90 | - | 0.00 | N-2 | 0.16 | - | 0.00 | E-3 | 80 | E-4 | 20 |
| | 152 | 24.10 | A-1 | 81.01 | B-I-2 | 10.00 | C-3 | 2.90 | D-I-25 | 0.18 | - | 0.00 | - | 0.00 | - | 0.00 | G-2 | 1.45 | K-3 | 1.50 | N-1 | 0.22 | M-3 | 2.74 | E-3 | 80 | E-4 | 20 |
| | 153 | 20.80 | A-2 | 80.88 | B-I-2 | 12.40 | C-3 | 2.74 | D-I-26 | 0.30 | - | 0.00 | - | 0.00 | - | 0.00 | G-2 | 1.55 | K-3 | 1.98 | N-1 | 0.15 | - | 0.00 | E-1 | 100 | - | 0 |
| | 154 | 25.00 | A-3 | 82.02 | B-I-2 | 12.00 | C-3 | 2.70 | D-I-27 | 0.22 | - | 0.00 | - | 0.00 | - | 0.00 | G-2 | 1.80 | K-3 | 1.14 | N-1 | 0.12 | - | 0.00 | E-3 | 80 | E-4 | 20 |
| | 155 | 23.60 | A-4 | 80.38 | B-I-2 | 12.80 | C-3 | 2.75 | D-I-28 | 0.24 | - | 0.00 | - | 0.00 | - | 0.00 | G-2 | 2.05 | K-3 | 1.60 | N-1 | 0.18 | - | 0.00 | E-3 | 80 | E-4 | 20 |
| | 156 | 22.20 | A-5 | 80.80 | B-I-2 | 13.20 | C-3 | 2.58 | D-I-29 | 0.20 | - | 0.00 | - | 0.00 | - | 0.00 | G-2 | 1.45 | K-3 | 1.47 | N-1 | 0.20 | - | 0.00 | E-3 | 80 | E-4 | 20 |
| | 157 | 27.00 | A-6 | 81.49 | B-I-2 | 11.20 | C-3 | 3.04 | D-I-30 | 0.34 | - | 0.00 | - | 0.00 | - | 0.00 | G-2 | 1.55 | K-3 | 2.05 | N-1 | 0.33 | - | 0.00 | E-3 | 80 | E-4 | 20 |
| | 158 | 34.40 | A-7 | 81.62 | B-I-2 | 10.80 | C-3 | 3.34 | D-I-31 | 0.30 | - | 0.00 | - | 0.00 | - | 0.00 | G-2 | 1.75 | K-3 | 1.95 | N-1 | 0.24 | - | 0.00 | E-3 | 80 | E-4 | 20 |
| | 159 | 28.30 | A-8 | 79.52 | B-I-2 | 12.00 | C-3 | 2.77 | D-I-32 | 0.24 | - | 0.00 | - | 0.00 | - | 0.00 | G-2 | 1.85 | K-3 | 1.76 | N-1 | 0.26 | M-4 | 1.60 | E-3 | 80 | E-4 | 20 |
| | 160 | 21.60 | A-9 | 80.86 | B-I-2 | 12.40 | C-3 | 2.90 | D-I-33 | 0.32 | - | 0.00 | - | 0.00 | - | 0.00 | G-2 | 1.65 | K-3 | 1.67 | N-1 | 0.20 | - | 0.00 | E-3 | 80 | E-4 | 20 |
| | 161 | 24.00 | A-10 | 80.77 | B-I-2 | 12.60 | C-3 | 2.84 | D-I-34 | 0.28 | - | 0.00 | - | 0.00 | - | 0.00 | G-2 | 1.45 | K-3 | 1.80 | N-1 | 0.26 | - | 0.00 | E-3 | 80 | E-4 | 20 |
| | 162 | 22.30 | A-12 | 81.84 | B-I-2 | 11.40 | C-3 | 2.80 | D-I-35 | 0.20 | - | 0.00 | - | 0.00 | - | 0.00 | G-2 | 1.50 | K-1 | 1.99 | N-1 | 0.27 | - | 0.00 | E-3 | 80 | E-4 | 20 |
| | 163 | 29.00 | A-1 | 77.13 | B-I-3 | 12.60 | C-3 | 2.68 | D-I-36 | 0.24 | - | 0.00 | - | 0.00 | - | 0.00 | G-12 | 1.60 | K-1 | 2.10 | N-2 | 0.30 | M-5 | 3.35 | E-3 | 80 | E-4 | 20 |
| | 164 | 21.60 | A-2 | 80.25 | B-I-3 | 13.40 | C-3 | 2.75 | D-I-37 | 0.16 | - | 0.00 | - | 0.00 | - | 0.00 | G-2 | 1.50 | K-1 | 1.84 | N-3 | 0.10 | - | 0.00 | E-3 | 80 | E-4 | 20 |
| | 165 | 20.70 | A-3 | 80.55 | B-I-3 | 12.20 | C-3 | 3.00 | D-I-38 | 0.22 | - | 0.00 | - | 0.00 | - | 0.00 | G-2 | 1.75 | K-1 | 2.04 | N-2 | 0.24 | - | 0.00 | E-3 | 80 | E-4 | 20 |
| | 166 | 23.80 | A-4 | 80.62 | B-I-1 | 12.40 | C-3 | 2.70 | - | 0.00 | D-2-1 | 0.33 | - | 0.00 | - | 0.00 | G-2 | 1.65 | K-1 | 2.00 | N-2 | 0.30 | - | 0.00 | E-3 | 80 | E-4 | 20 |

[Table 11]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-I) | | (C) | | (D-I) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 167 | 22.60 | A-5 | 82.12 | B-I-1 | 10.80 | C-3 | 2.80 | - | 0.00 | D-2-2 | 0.30 | - | 0.00 | - | 0.00 | G-2 | 1.85 | K-1 | 1.87 | N-2 | 0.26 | - | 0.00 | E-3 | 80 | E-4 | 20 |
| | 168 | 20.00 | A-1 | 79.24 | B-I-2 | 10.00 | C-3 | 2.95 | - | 0.00 | D-2-3 | 0.28 | - | 0.00 | - | 0.00 | G-1 | 2.00 | K-4 | 3.30 | N-1 | 0.18 | M-6 | 2.05 | F-3 | 75 | F-4 | 25 |
| | 169 | 22.40 | A-2 | 76.53 | B-I-2 | 12.60 | C-3 | 2.79 | - | 0.00 | D-2-4 | 0.26 | - | 0.00 | - | 0.00 | G-1 | 1.55 | K-4 | 2.75 | N-1 | 0.30 | M-3 | 3.22 | E-3 | 80 | E-4 | 20 |
| | 170 | 21.80 | A-3 | 81.16 | B-I-3 | 11.40 | C-3 | 2.80 | - | 0.00 | D-2-5 | 0.30 | - | 0.00 | - | 0.00 | G-1 | 1.70 | K-4 | 2.40 | N-1 | 0.24 | - | 0.00 | E-3 | 80 | E-4 | 20 |
| | 171 | 23.10 | A-4 | 78.78 | B-I-3 | 13.20 | C-3 | 2.76 | - | 0.00 | D-2-6 | 0.24 | - | 0.00 | - | 0.00 | G-1 | 1.65 | K-4 | 3.15 | N-1 | 0.22 | - | 0.00 | E-3 | 80 | E-4 | 20 |
| | 172 | 23.30 | A-5 | 77.79 | B-I-4 | 14.00 | C-3 | 2.90 | - | 0.00 | D-2-7 | 0.30 | - | 0.00 | - | 0.00 | G-1 | 1.80 | K-4 | 2.94 | N-1 | 0.27 | - | 0.00 | E-3 | 80 | E-4 | 20 |
| | 173 | 21.10 | A-6 | 79.78 | B-I-4 | 12.40 | C-3 | 2.85 | - | 0.00 | D-2-8 | 0.26 | - | 0.00 | - | 0.00 | G-1 | 1.45 | K-4 | 3.00 | N-1 | 0.26 | - | 0.00 | E-3 | 80 | E-4 | 20 |
| | 174 | 27.00 | A-7 | 82.19 | B-I-5 | 10.60 | C-3 | 2.90 | - | 0.00 | D-2-9 | 0.20 | - | 0.00 | - | 0.00 | G-1 | 1.20 | K-4 | 2.66 | N-1 | 0.25 | - | 0.00 | E-6 | 80 | E-4 | 20 |
| | 175 | 22.30 | A-8 | 80.01 | B-I-5 | 11.60 | C-3 | 2.88 | - | 0.00 | D-2-10 | 0.36 | - | 0.00 | - | 0.00 | G-1 | 1.85 | K-4 | 3.10 | N-1 | 0.20 | - | 0.00 | E-3 | 80 | E-4 | 20 |
| | 176 | 22.40 | A-9 | 80.15 | B-I-1 | 12.20 | C-3 | 2.64 | - | 0.00 | D-2-11 | 0.32 | - | 0.00 | - | 0.00 | G-1 | 1.45 | K-4 | 3.00 | N-1 | 0.24 | - | 0.00 | E-1 | 80 | E-2 | 20 |
| | 177 | 23.30 | A-10 | 80.09 | B-I-1 | 12.80 | C-3 | 2.59 | - | 0.00 | D-2-12 | 0.28 | - | 0.00 | - | 0.00 | G-1 | 1.50 | K-4 | 2.49 | N-1 | 0.25 | - | 0.00 | E-3 | 80 | E-4 | 20 |
| | 178 | 22.60 | A-1 | 79.58 | B-I-2 | 12.40 | C-3 | 2.89 | D-I-11 | 0.22 | - | 0.00 | - | 0.00 | - | 0.00 | G-2 | 1.65 | K-2 | 2.93 | N-2 | 0.33 | - | 0.00 | E-3 | 80 | E-4 | 20 |
| | 179 | 21.50 | A-2 | 80.28 | B-I-2 | 12.00 | C-3 | 2.80 | D-I-12 | 0.18 | - | 0.00 | - | 0.00 | - | 0.00 | G-2 | 1.70 | K-2 | 2.74 | N-2 | 0.30 | - | 0.00 | E-3 | 80 | E-4 | 20 |
| | 180 | 24.50 | A-3 | 79.66 | B-I-3 | 13.00 | C-3 | 2.90 | D-I-13 | 0.28 | - | 0.00 | - | 0.00 | - | 0.00 | G-2 | 1.15 | K-2 | 2.65 | N-2 | 0.36 | - | 0.00 | E-6 | 80 | E-4 | 20 |
| | 181 | 20.80 | A-4 | 80.22 | B-I-3 | 12.20 | C-3 | 2.65 | D-I-14 | 0.22 | - | 0.00 | - | 0.00 | - | 0.00 | G-2 | 1.95 | K-2 | 2.46 | N-2 | 0.30 | - | 0.00 | E-3 | 80 | E-4 | 20 |
| | 182 | 23.00 | A-5 | 81.02 | B-I-5 | 11.20 | C-3 | 2.80 | D-I-15 | 0.20 | - | 0.00 | - | 0.00 | - | 0.00 | G-2 | 2.30 | K-2 | 2.24 | N-2 | 0.24 | - | 0.00 | E-3 | 80 | E-4 | 20 |
| | 183 | 24.20 | A-6 | 79.03 | B-I-5 | 13.00 | C-3 | 2.75 | D-I-16 | 0.34 | - | 0.00 | - | 0.00 | - | 0.00 | G-2 | 1.95 | K-2 | 2.65 | N-2 | 0.28 | - | 0.00 | E-3 | 80 | E-4 | 20 |
| | 184 | 27.70 | A-7 | 79.87 | B-I-5 | 12.60 | C-3 | 2.70 | D-I-17 | 0.32 | - | 0.00 | - | 0.00 | - | 0.00 | G-2 | 1.85 | K-2 | 2.46 | N-2 | 0.20 | - | 0.00 | E-3 | 80 | E-4 | 20 |
| | 185 | 25.00 | A-8 | 80.50 | B-I-5 | 12.40 | C-3 | 2.55 | D-I-18 | 0.30 | - | 0.00 | - | 0.00 | - | 0.00 | G-2 | 1.35 | K-2 | 2.44 | N-2 | 0.46 | - | 0.00 | E-3 | 75 | E-4 | 25 |
| | 186 | 25.30 | A-9 | 77.67 | B-I-5 | 12.80 | C-3 | 2.97 | D-I-19 | 0.28 | - | 0.00 | - | 0.00 | - | 0.00 | G-2 | 1.40 | K-2 | 2.26 | N-2 | 0.40 | M-4 | 2.22 | E-3 | 80 | E-4 | 20 |
| | 187 | 24.40 | A-10 | 79.66 | B-I-5 | 12.60 | C-3 | 2.68 | D-I-20 | 0.22 | - | 0.00 | - | 0.00 | - | 0.00 | G-2 | 1.65 | K-2 | 2.64 | N-2 | 0.55 | - | 0.00 | E-1 | 80 | E-2 | 20 |
| | 188 | 19.80 | A-12 | 84.74 | B-I-5 | 11.00 | C-3 | 2.57 | D-I-21 | 0.20 | - | 0.00 | - | 0.00 | - | 0.00 | G-1 | 1.15 | - | 0.00 | N-2 | 0.34 | - | 0.00 | E-3 | 80 | E-4 | 20 |
| | 189 | 22.20 | A-1 | 77.84 | B-I-1 | 13.20 | C-3 | 2.80 | D-I-22 | 0.18 | - | 0.00 | - | 0.00 | - | 0.00 | G-1 | 1.05 | K-2 | 2.00 | N-2 | 0.29 | M-5 | 2.64 | F-6 | 70 | F-4 | 30 |
| | 190 | 24.00 | A-2 | 78.51 | B-I-1 | 13.40 | C-3 | 2.92 | D-I-23 | 0.32 | - | 0.00 | - | 0.00 | - | 0.00 | G-1 | 2.15 | K-12 | 2.40 | N-2 | 0.30 | - | 0.00 | F-3 | 80 | F-4 | 20 |
| | 191 | 19.60 | A-3 | 80.24 | B-I-1 | 12.40 | C-3 | 2.76 | D-I-24 | 0.36 | - | 0.00 | - | 0.00 | - | 0.00 | G-1 | 1.35 | K-2 | 2.55 | N-2 | 0.34 | - | 0.00 | F-3 | 80 | F-4 | 20 |
| | 192 | 26.00 | A-4 | 79.43 | B-I-1 | 12.80 | C-3 | 2.84 | D-I-25 | 0.30 | - | 0.00 | - | 0.00 | - | 0.00 | G-1 | 1.65 | K-2 | 2.65 | N-2 | 0.33 | - | 0.00 | F-3 | 80 | F-4 | 20 |
| | 193 | 25.10 | A-5 | 79.34 | B-I-1 | 12.60 | C-3 | 2.89 | D-I-26 | 0.22 | - | 0.00 | - | 0.00 | - | 0.00 | G-1 | 1.45 | K-2 | 3.10 | N-2 | 0.40 | - | 0.00 | E-3 | 80 | E-4 | 20 |
| | 194 | 27.60 | A-1 | 80.20 | B-I-2 | 12.20 | C-2 | 2.42 | D-I-27 | 0.38 | - | 0.00 | - | 0.00 | - | 0.00 | G-1 | 1.60 | K-1 | 2.84 | N-12 | 0.36 | - | 0.00 | E-3 | 80 | E-4 | 20 |
| | 195 | 24.70 | A-2 | 80.51 | B-I-2 | 12.40 | C-4 | 2.56 | D-I-28 | 0.48 | - | 0.00 | - | 0.00 | - | 0.00 | G-3 | 1.85 | K-1 | 1.90 | N-2 | 0.30 | - | 0.00 | E-3 | 80 | E-4 | 20 |
| | 196 | 23.30 | A-3 | 80.50 | B-I-2 | 12.20 | C-3 | 2.64 | D-I-29 | 0.36 | - | 0.00 | - | 0.00 | - | 0.00 | G-4 | 1.70 | K-1 | 2.25 | N-2 | 0.35 | - | 0.00 | E-3 | 80 | E-4 | 20 |
| | 197 | 21.70 | A-4 | 81.73 | B-I-2 | 11.00 | C-3 | 2.64 | D-I-30 | 0.26 | - | 0.00 | - | 0.00 | - | 0.00 | G-1 | 1.90 | K-1 | 2.20 | N-2 | 0.27 | - | 0.00 | E-3 | 50 | E-4 | 50 |
| | 198 | 22.00 | A-5 | 81.03 | B-I-2 | 11.20 | C-3 | 2.98 | D-I-31 | 0.22 | - | 0.00 | - | 0.00 | - | 0.00 | G-1 | 1.85 | K-1 | 2.54 | N-2 | 0.18 | - | 0.00 | E-3 | 80 | E-4 | 20 |
| | 199 | 23.20 | A-6 | 79.28 | B-I-2 | 13.00 | C-3 | 2.49 | D-I-32 | 0.36 | - | 0.00 | - | 0.00 | - | 0.00 | G-1 | 2.05 | K-1 | 2.40 | N-2 | 0.42 | - | 0.00 | E-6 | 80 | E-4 | 20 |
| | 200 | 25.10 | A-7 | 79.46 | B-I-2 | 12.60 | C-3 | 2.47 | D-I-33 | 0.24 | - | 0.00 | - | 0.00 | - | 0.00 | G-1 | 2.00 | K-1 | 2.87 | N-2 | 0.36 | - | 0.00 | E-3 | 90 | E-4 | 10 |
| | 201 | 22.10 | A-8 | 75.98 | B-I-2 | 12.40 | C-1 | 3.03 | D-I-34 | 0.38 | - | 0.00 | - | 0.00 | - | 0.00 | G-1 | 1.85 | K-1 | 2.98 | N-2 | 0.35 | M-2 | 3.03 | E-3 | 80 | E-4 | 20 |
| | 202 | 20.70 | A-9 | 76.75 | B-I-2 | 12.80 | C-1 | 3.64 | D-I-35 | 0.40 | - | 0.00 | - | 0.00 | - | 0.00 | G-1 | 1.75 | K-1 | 2.46 | N-2 | 0.38 | M-2 | 1.82 | E-3 | 70 | E-4 | 30 |
| | 203 | 21.50 | A-10 | 75.39 | B-I-2 | 13.20 | C-1 | 2.22 | D-I-36 | 0.30 | - | 0.00 | - | 0.00 | - | 0.00 | G-1 | 1.55 | K-1 | 2.57 | N-2 | 0.33 | M-2 | 4.44 | E-6 | 80 | E-4 | 20 |
| | 204 | 20.30 | A-1 | 78.76 | B-I-3 | 12.20 | C-5 | 4.02 | D-I-37 | 0.32 | - | 0.00 | - | 0.00 | - | 0.00 | G-1 | 1.65 | K-2 | 2.65 | N-4 | 0.40 | - | 0.00 | E-3 | 80 | E-4 | 20 |
| | 205 | 22.40 | A-2 | 77.57 | B-I-3 | 13.00 | C-6 | 3.85 | D-I-38 | 0.33 | - | 0.00 | - | 0.00 | - | 0.00 | G-1 | 1.80 | K-2 | 3.20 | N-2 | 0.25 | - | 0.00 | E-3 | 80 | E-4 | 20 |
| | 206 | 24.80 | A-3 | 79.49 | B-I-3 | 12.00 | C-3 | 2.97 | D-I-11 | 0.10 | - | 0.00 | - | 0.00 | F-1 | 0.16 | G-1 | 2.00 | K-2 | 3.00 | N-1 | 0.28 | - | 0.00 | E-3 | 80 | E-4 | 20 |

[Table 12]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-I) | | (C) | | (D-I) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 207 | 20.50 | A-4 | 79.89 | B-I-3 | 12.60 | C-3 | 2.67 | D-I-11 | 0.18 | - | 0.00 | - | 0.00 | - | 0.00 | G-1 | 1.25 | K-2 | 3.15 | N-1 | 0.26 | - | 0.00 | E-3 | 80 | E-4 | 20 |
| | 208 | 21.00 | A-5 | 78.71 | B-I-3 | 12.80 | C-3 | 2.80 | D-I-14 | 0.22 | - | 0.00 | - | 0.00 | F-2 | 0.20 | G-2 | 1.95 | K-2 | 2.99 | N-2 | 0.33 | - | 0.00 | E-6 | 80 | E-4 | 20 |
| | 209 | 22.20 | A-6 | 80.99 | B-I-3 | 11.80 | C-3 | 2.90 | D-I-14 | 0.22 | - | 0.00 | - | 0.00 | - | 0.00 | G-2 | 1.25 | K-2 | 2.54 | N-2 | 0.30 | - | 0.00 | E-3 | 80 | E-4 | 20 |
| | 210 | 31.10 | A-7 | 80.64 | B-I-3 | 12.00 | C-3 | 2.64 | D-I-16 | 0.26 | - | 0.00 | - | 0.00 | F-3 | 0.08 | G-2 | 1.45 | K-2 | 2.65 | N-2 | 0.28 | - | 0.00 | E-3 | 80 | E-4 | 20 |
| | 211 | 26.00 | A-8 | 79.99 | B-I-3 | 12.20 | C-3 | 2.80 | D-I-16 | 0.26 | - | 0.00 | - | 0.00 | - | 0.00 | G-2 | 1.65 | K-2 | 2.87 | N-2 | 0.23 | - | 0.00 | E-6 | 80 | E-4 | 20 |
| | 212 | 20.90 | A-9 | 79.45 | B-I-3 | 12.40 | C-3 | 2.85 | D-I-18 | 0.24 | - | 0.00 | - | 0.00 | F-4 | 0.02 | G-2 | 1.70 | K-2 | 2.99 | N-2 | 0.35 | - | 0.00 | E-3 | 80 | E-4 | 20 |
| | 213 | 21.90 | A-10 | 80.12 | B-I-3 | 12.20 | C-3 | 2.80 | D-I-18 | 0.24 | - | 0.00 | - | 0.00 | - | 0.00 | G-2 | 1.40 | K-2 | 2.94 | N-2 | 0.30 | - | 0.00 | E-3 | 80 | E-4 | 20 |
| | 214 | 22.50 | A-1 | 80.36 | B-I-5 | 12.60 | C-6 | 2.85 | D-I-23 | 0.28 | - | 0.00 | - | 0.00 | F-5 | 0.12 | G-2 | 1.60 | K-1 | 1.84 | N-2 | 0.35 | - | 0.00 | F-3 | 80 | F-4 | 20 |
| | 215 | 23.00 | A-2 | 80.93 | B-I-5 | 12.00 | C-3 | 2.68 | D-I-23 | 0.28 | - | 0.00 | - | 0.00 | - | 0.00 | G-2 | 1.80 | K-1 | 1.97 | N-2 | 0.34 | - | 0.00 | F-6 | 80 | F-4 | 20 |
| | 216 | 24.40 | A-3 | 80.96 | B-I-5 | 12.40 | C-3 | 2.28 | D-I-25 | 0.22 | - | 0.00 | - | 0.00 | F-6 | 0.16 | G-2 | 1.50 | K-1 | 2.20 | N-2 | 0.28 | - | 0.00 | E-3 | 80 | E-4 | 20 |
| | 217 | 17.60 | A-4 | 92.96 | - | 0.00 | C-3 | 2.40 | D-I-25 | 0.22 | - | 0.00 | - | 0.00 | - | 0.00 | G-2 | 1.70 | K-1 | 2.42 | N-2 | 0.30 | - | 0.00 | E-3 | 80 | E-4 | 20 |
| | 218 | 25.30 | A-5 | 79.12 | B-I-5 | 13.00 | C-3 | 2.64 | D-I-27 | 0.26 | - | 0.00 | - | 0.00 | F-3 | 0.10 | G-2 | 1.95 | K-1 | 2.60 | N-1 | 0.33 | - | 0.00 | E-3 | 80 | E-4 | 20 |
| | 219 | 21.60 | A-6 | 79.83 | B-I-5 | 12.60 | C-3 | 2.80 | D-I-27 | 0.26 | - | 0.00 | - | 0.00 | - | 0.00 | G-2 | 1.80 | K-1 | 2.35 | N-1 | 0.36 | - | 0.00 | E-3 | 80 | E-4 | 20 |
| | 220 | 28.80 | A-7 | 77.25 | B-I-5 | 12.40 | C-3 | 2.84 | D-I-32 | 0.30 | - | 0.00 | - | 0.00 | F-4 | 0.06 | G-2 | 1.75 | K-1 | 2.40 | N-1 | 0.50 | M-6 | 2.50 | E-3 | 80 | E-4 | 20 |
| | 221 | 23.00 | A-8 | 80.31 | B-I-5 | 12.60 | C-3 | 2.60 | D-I-32 | 0.30 | - | 0.00 | - | 0.00 | - | 0.00 | G-2 | 1.80 | K-1 | 2.15 | N-1 | 0.24 | - | 0.00 | E-3 | 80 | E-4 | 20 |
| | 222 | 22.20 | A-9 | 81.01 | B-I-5 | 12.00 | C-3 | 2.67 | D-I-33 | 0.24 | - | 0.00 | - | 0.00 | F-5 | 0.24 | G-2 | 1.45 | K-1 | 2.11 | N-1 | 0.28 | - | 0.00 | E-6 | 80 | E-4 | 20 |
| | 223 | 23.00 | A-10 | 81.71 | B-I-5 | 11.80 | C-3 | 2.70 | D-I-33 | 0.24 | - | 0.00 | - | 0.00 | - | 0.00 | G-2 | 1.20 | K-1 | 2.00 | N-1 | 0.35 | - | 0.00 | E-3 | 80 | E-4 | 20 |
| | 224 | 23.10 | A-1 | 81.01 | B-I-1 | 12.00 | C-3 | 2.66 | D-I-11 | 0.30 | - | 0.00 | DR-1 | 0.10 | F-6 | 0.30 | G-2 | 1.35 | K-1 | 1.98 | N-2 | 0.30 | - | 0.00 | E-1 | 100 | - | 0 |
| | 225 | 23.80 | A-2 | 81.01 | B-I-2 | 12.20 | C-3 | 2.90 | D-I-14 | 0.30 | - | 0.00 | DR-2 | 0.11 | - | 0.00 | G-2 | 1.40 | K-1 | 1.84 | N-2 | 0.24 | - | 0.00 | E-3 | 60 | E-4 | 40 |
| | 226 | 24.00 | A-3 | 80.28 | B-I-3 | 12.60 | C-3 | 2.79 | D-I-16 | 0.32 | - | 0.00 | DR-3 | 0.08 | - | 0.00 | G-2 | 1.35 | K-1 | 1.98 | N-2 | 0.60 | - | 0.00 | E-3 | 80 | E-4 | 20 |
| | 227 | 23.80 | A-4 | 80.51 | B-I-4 | 12.20 | C-3 | 2.90 | D-I-18 | 0.28 | - | 0.00 | DR-4 | 0.12 | - | 0.00 | G-2 | 1.80 | K-1 | 1.95 | N-2 | 0.24 | - | 0.00 | E-6 | 80 | E-4 | 20 |
| | 228 | 20.00 | A-5 | 80.40 | B-I-5 | 12.40 | C-3 | 2.46 | D-I-23 | 0.22 | - | 0.00 | DR-5 | 0.15 | - | 0.00 | G-2 | 1.95 | K-1 | 2.12 | N-2 | 0.30 | - | 0.00 | E-3 | 80 | E-4 | 20 |
| | 229 | 20.90 | A-6 | 80.70 | B-I-1 | 12.00 | C-3 | 2.99 | D-I-25 | 0.26 | - | 0.00 | DR-6 | 0.16 | - | 0.00 | G-2 | 1.60 | K-1 | 2.05 | N-2 | 0.24 | - | 0.00 | E-3 | 80 | E-4 | 20 |
| | 230 | 23.20 | A-7 | 80.16 | B-I-1 | 12.60 | C-3 | 3.03 | D-I-27 | 0.30 | D-2-1 | 0.11 | - | 0.00 | - | 0.00 | G-2 | 1.45 | K-1 | 2.00 | N-2 | 0.35 | - | 0.00 | E-3 | 100 | - | 0 |
| | 231 | 27.00 | A-8 | 80.03 | B-I-2 | 12.40 | C-3 | 3.20 | D-I-32 | 0.24 | D-2-1 | 0.15 | - | 0.00 | - | 0.00 | G-2 | 1.60 | K-1 | 2.05 | N-2 | 0.33 | - | 0.00 | F-3 | 80 | F-4 | 20 |
| | 232 | 21.50 | A-9 | 80.36 | B-I-3 | 12.80 | C-3 | 2.88 | D-I-32 | 0.24 | D-2-1 | 0.11 | DR-2 | 0.06 | - | 0.00 | G-2 | 1.55 | K-1 | 1.80 | N-2 | 0.20 | - | 0.00 | F-3 | 80 | F-4 | 20 |
| | 233 | 22.50 | A-1 | 80.46 | B-I-1 | 12.60 | C-3 | 2.75 | D-I-1 | 0.20 | - | 0.00 | - | 0.00 | - | 0.00 | G-1 | 1.65 | K-1 | 1.99 | N-1 | 0.35 | - | 0.00 | F-3 | 80 | F-4 | 20 |
| | 234 | 29.00 | A-1 | 80.46 | B-I-1 | 12.60 | C-3 | 2.70 | - | 0.00 | D-2-13 | 0.24 | - | 0.00 | - | 0.00 | G-2 | 1.60 | K-1 | 2.10 | N-2 | 0.30 | - | 0.00 | E-3 | 80 | E-4 | 20 |
| | 235 | 21.60 | A-2 | 80.02 | B-I-2 | 13.40 | C-3 | 2.75 | - | 0.00 | D-2-14 | 0.20 | - | 0.00 | - | 0.00 | G-2 | 1.60 | K-1 | 1.85 | N-2 | 0.18 | - | 0.00 | E-3 | 80 | E-4 | 20 |
| | 236 | 20.70 | A-3 | 80.79 | B-I-3 | 12.20 | C-3 | 2.90 | - | 0.00 | D-2-15 | 0.22 | - | 0.00 | - | 0.00 | G-2 | 1.65 | K-1 | 2.00 | N-2 | 0.24 | - | 0.00 | E-3 | 80 | E-4 | 20 |

[Table 13]

| | | Concentration of solid contents [mass%] | Solid content | | | | | | | | | | | | | | | | | | | | | | (E) Solvent | | | |
|---|---|---|---|---|---|---|---|---|---|---|---|---|---|---|---|---|---|---|---|---|---|---|---|---|---|---|---|---|
| | | | Resin (A) | | (B-I) | | (C) | | (D-I) | | (D-2) | | (DR) | | (F) | | (G) | | (K) | | (N) | | (M) | | Solvent 1 | | Solvent 2 | |
| | | | Type | Amount | Type | Amount | Type | Amount | Type | Amount | Type | Amount | Type | Amount | Type | Amount | Type | Amount | Type | Amount | Type | Amount | Type | Amount | Type | Amount | Type | Amount |
| Example | 237 | 23.80 | A-4 | 80.52 | B-I-1 | 12.40 | C-3 | 2.80 | - | 0.00 | D-2-16 | 0.33 | - | 0.00 | - | 0.00 | G-2 | 1.65 | K-1 | 2.00 | N-2 | 0.30 | - | 0.00 | E-5 | 80 | E-4 | 20 |
| | 238 | 22.20 | A-1 | 80.63 | B-I-1 | 12.60 | C-3 | 2.98 | D-1-11 | 0.12 | D-2-17 | 0.12 | - | 0.00 | - | 0.00 | G-1 | 1.43 | K-1 | 1.88 | N-1 | 0.24 | - | 0.00 | E-3 | 80 | E-4 | 20 |
| | 239 | 24.10 | A-2 | 81.93 | B-I-2 | 11.88 | C-4 | 2.69 | D-I-23 | 0.10 | - | 0.00 | DR-7 | 0.10 | - | 0.00 | G-2 | 1.25 | K-1 | 1.75 | N-2 | 0.30 | - | 0.00 | E-3 | 80 | E-4 | 20 |
| | 240 | 20.70 | A-3 | 79.87 | B-I-3 | 13.45 | C-5 | 2.78 | D-I-32 | 0.18 | - | 0.00 | - | 0.00 | - | 0.00 | G-1 | 1.44 | K-1 | 1.98 | N-5 | 0.30 | - | 0.00 | E-1 | 100 | - | 0 |
| | 241 | 21.50 | A-4 | 81.31 | B-I-5 | 12.13 | C-3 | 3.01 | D-I-18 | 0.20 | - | 0.00 | - | 0.00 | - | 0.00 | G-2 | 1.56 | K-1 | 1.54 | N-6 | 0.25 | - | 0.00 | E-3 | 80 | E-4 | 20 |
| | 242 | 26.00 | A-5 | 81.90 | B-I-6 | 11.46 | C-4 | 2.98 | D-I-11 | 0.24 | - | 0.00 | - | 0.00 | - | 0.00 | G-1 | 1.62 | K-1 | 1.56 | N-7 | 0.24 | - | 0.00 | E-3 | 80 | E-4 | 20 |
| | 243 | 24.30 | A-6 | 80.80 | B-I-7 | 10.75 | C-5 | 3.06 | D-I-23 | 0.19 | - | 0.00 | - | 0.00 | - | 0.00 | G-2 | 1.34 | K-2 | 2.85 | N-1 | 0.22 | M-7 | 0.80 | E-3 | 80 | E-4 | 20 |
| | 244 | 20.40 | A-7 | 78.21 | B-I-1 | 14.10 | C-3 | 2.87 | D-I-32 | 0.22 | - | 0.00 | - | 0.00 | - | 0.00 | G-1 | 1.58 | K-1 | 1.68 | N-2 | 0.24 | M-8 | 1.10 | E-3 | 80 | E-4 | 20 |
| | 245 | 21.90 | A-8 | 79.68 | B-I-2 | 12.43 | C-7 | 3.88 | D-I-18 | 0.44 | - | 0.00 | - | 0.00 | - | 0.00 | G-2 | 1.46 | K-1 | 1.78 | N-2 | 0.33 | - | 0.00 | E-3 | 80 | E-4 | 20 |
| | 246 | 22.60 | A-9 | 80.68 | B-I-3 | 12.56 | C-8 | 2.84 | D-I-11 | 0.18 | D-2-17 | 0.12 | - | 0.00 | - | 0.00 | G-5 | 1.58 | K-1 | 1.80 | N-2 | 0.24 | - | 0.00 | E-3 | 80 | E-4 | 20 |
| | 247 | 23.40 | A-10 | 81.70 | B-I-11 | 10.46 | C-1 | 3.25 | - | 0.00 | D-2-5 | 0.25 | - | 0.00 | - | 0.00 | G-1 | 1.23 | - | 0.00 | - | 0.00 | M-2 | 3.11 | E-3 | 80 | E-2 | 20 |
| | 248 | 21.80 | A-12 | 81.23 | B-I-12 | 11.59 | C-9 | 3.25 | D-I-11 | 0.15 | - | 0.00 | DR-2 | 0.05 | - | 0.00 | G-2 | 1.60 | K-1 | 1.90 | N-1 | 0.23 | - | 0.00 | E-6 | 80 | E-4 | 20 |
| | 249 | 23.10 | A-13 | 83.13 | B-1-13 | 10.07 | C-8 | 2.99 | D-1-23 | 0.10 | - | 0.00 | DR-3 | 0.07 | - | 0.00 | G-2 | 1.65 | K-1 | 1.78 | N-2 | 0.21 | - | 0.00 | E-3 | 80 | E-4 | 20 |
| | 250 | 22.00 | A-8 | 79.04 | B-I-1 | 12.55 | C-3/C-7 | 2.46/1.25 | D-I-32 | 0.20 | - | 0.00 | DR-7 | 0.08 | - | 0.00 | G-2 | 1.64 | K-2 | 2.50 | N-2 | 0.28 | - | 0.00 | E-3 | 80 | E-4 | 20 |
| | 251 | 20.80 | A-15 | 78.70 | B-I-12 | 12.46 | C-3 | 3.10 | D-I-18 | 0.10 | D-2-1 | 0.10 | - | 0.00 | - | 0.00 | G-2 | 1.46 | K-1 | 1.78 | N-2 | 0.30 | M-6 | 2.00 | E-3 | 80 | E-4 | 20 |
| | 252 | 25.00 | A-16 | 82.99 | B-1-13 | 10.08 | C-3 | 2.84 | D-1-11 | 0.22 | - | 0.00 | - | 0.00 | F-3 | 0.10 | G-2 | 1.58 | K-1 | 1.90 | N-2 | 0.29 | - | 0.00 | E-3 | 100 | - | 0 |
| Comparative Example | 12 | 23.00 | A-1 | 80.78 | B-I-1 | 12.50 | C-3 | 2.75 | - | 0.00 | - | 0.00 | DR-1 | 0.20 | - | 0.00 | G-1 | 1.50 | K-1 | 2.00 | N-1 | 0.27 | - | 0.00 | E-3 | 80 | E-4 | 20 |
| | 13 | 24.00 | A-2 | 80.07 | B-I-2 | 12.80 | C-3 | 2.68 | - | 0.00 | - | 0.00 | DR-2 | 0.55 | - | 0.00 | G-2 | 1.65 | K-1 | 1.95 | N-2 | 0.30 | - | 0.00 | E-3 | 80 | E-4 | 20 |
| | 14 | 21.40 | A-3 | 80.80 | B-I-1 | 12.00 | C-3 | 2.88 | - | 0.00 | - | 0.00 | DR-3 | 0.18 | - | 0.00 | G-1 | 1.70 | K-1 | 2.20 | N-1 | 0.24 | - | 0.00 | E-3 | 80 | E-4 | 20 |
| | 15 | 24.60 | A-4 | 80.27 | B-I-3 | 12.40 | C-3 | 2.91 | - | 0.00 | - | 0.00 | DR-4 | 0.36 | - | 0.00 | G-2 | 1.70 | K-1 | 2.00 | N-2 | 0.36 | - | 0.00 | E-3 | 80 | E-4 | 20 |
| | 16 | 26.10 | A-5 | 80.33 | B-I-1 | 12.60 | C-3 | 2.64 | - | 0.00 | - | 0.00 | DR-5 | 0.50 | - | 0.00 | G-1 | 1.65 | K-1 | 1.98 | N-1 | 0.30 | - | 0.00 | E-3 | 80 | E-4 | 20 |
| | 17 | 22.80 | A-6 | 80.99 | B-I-4 | 12.50 | C-3 | 2.58 | - | 0.00 | - | 0.00 | DR-6 | 0.32 | - | 0.00 | G-2 | 1.45 | K-1 | 1.89 | N-2 | 0.27 | - | 0.00 | E-3 | 80 | E-4 | 20 |
| | 18 | 32.00 | A-7 | 78.20 | B-I-1 | 12.20 | C-3 | 2.64 | - | 0.00 | - | 0.00 | DR-1 | 0.20 | - | 0.00 | G-5 | 2.00 | K-1 | 1.90 | N-1 | 0.22 | M-4 | 2.64 | E-3 | 80 | E-4 | 20 |
| | 19 | 23.30 | A-8 | 81.31 | B-I-5 | 12.40 | C-3 | 2.60 | - | 0.00 | - | 0.00 | DR-2 | 0.11 | - | 0.00 | G-5 | 1.40 | K-1 | 1.94 | N-2 | 0.24 | - | 0.00 | E-3 | 80 | E-4 | 20 |
| | 20 | 24.70 | A-9 | 79.43 | B-I-1 | 13.00 | C-3 | 2.80 | - | 0.00 | - | 0.00 | DR-3 | 0.44 | F-1 | 0.22 | G-5 | 1.75 | K-1 | 2.00 | N-1 | 0.36 | - | 0.00 | E-3 | 80 | E-4 | 20 |
| | 21 | 27.50 | A-10 | 80.45 | B-I-1 | 12.80 | C-3 | 2.65 | - | 0.00 | - | 0.00 | DR-4 | 0.22 | - | 0.00 | G-5 | 1.60 | K-1 | 1.98 | N-2 | 0.30 | - | 0.00 | E-3 | 80 | E-4 | 20 |
| | 22 | 23.00 | A-1 | 80.78 | B-I-1 | 12.50 | C-3 | 2.75 | D-1-1 | 0.20 | - | 0.00 | - | 0.00 | - | 0.00 | G-1 | 1.50 | K-1 | 2.00 | N-1 | 0.27 | - | 0.00 | E-3 | 80 | E-4 | 20 |

The details of each component described in the above table are as described above.

<Evaluation>

The evaluation was carried out as follows, and the results are shown in Tables 14 to 17.

[Resolution]

In each of Examples and Comparative Examples, the prepared resin composition was applied onto a base material by a slit coating method with a coater LC-R300G manufactured by SCREEN Holdings Co., Ltd.

A base material was used, where a pretreatment ($O_2$ plasma ashing treatment) under the conditions (temperature, output, and time) shown in Tables 14 to 17 was carried out on a surface on which CU of the base material is present, the base material (also referred to as "copper wafer") including CU (volume content of Cu in a region having a thickness of a depth of 0.5 μm or less from the outermost surface is 50% or more) on a surface (entire surface) consisting of silicon. However, in Example 233, a copper wafer which had not been subjected to the pretreatment was used.

The copper wafer having the coating film of the resin composition was dried at the temperature and time shown in Tables 14 to 17. More specifically, the resin composition was dried on a hot plate (at normal pressure) at the temperature and time (minutes) shown in the column of "Step 1" in "Hot plate drying" described in Tables 14 to 17, and only in a case where the description is made in the tables, the resin composition was dried in the order of "Step 2", "Step 3", and "Step 4" at the temperature and time (minutes) shown in each column, thereby forming a resin composition layer having a uniform thickness of 10 μm on a copper wafer. The film thickness was adjusted by controlling a gap between the nozzle and the wafer, a scanning speed, a jetting amount of the liquid, and the like. The heating of "Step 1", "Step 2", "Step 3", and "Step 4" was all performed under normal pressure (101,325 Pa).

In the examples in which "M" is described in the exposure conditions of Tables 14 to 17, the resin composition layer on the copper wafer was exposed at an exposure wavelength of 365 nm using a photomask of a contact hole having a hole diameter of 5 μm to 20 μm in increments of 1 μm, using a stepper. The exposure amount was changed in a range of 100 to 900 $mJ/cm^2$ in increments of 100 $mJ/cm^2$.

In the examples in which "D" is described in the exposure conditions of Tables 14 to 17, laser direct imaging exposure was performed using a direct exposure device (Adtech DE-6UH III) so that the contact holes had a hole diameter of 5 μm to 20 μm in increments of 1 μm. The exposure wavelength was set to 405 nm, and the exposure amount was changed in a range of 100 to 900 $mJ/cm^2$ in increments of 100 $mJ/cm^2$.

The exposed resin composition layer was subjected to shower development with cyclopentanone for 35 seconds, then showered with cyclopentanone-propylene glycol monomethyl ether acetate (PGMEA) for 5 seconds, and then shower rinsed with PGMEA for 15 seconds.

The diameter of the pattern obtained after the development, having the smallest contact hole pattern size, was denoted as the "minimum hole diameter" and evaluated according to the following evaluation standards. It can be said that the smaller the minimum hole diameter is, the more excellent the resolution is. This indicates that, for example, the width of the metal wire to be formed in the subsequent plating step can be made finer, which is a preferred result. The measurement limit is 5 μm. The evaluation results are described in the column of "Resolution" in the table. A, B, or C is acceptable, and A or B is preferable.

- Evaluation standards -

A: The minimum hole diameter was less than 6 μm.
B: The minimum hole diameter was 6 μm or more and less than 8 μm.
C: The minimum hole diameter was 8 μm or more and less than 10 μm.
D: The minimum hole diameter was 10 μm or more or the hole was closed.

[Residues of unexposed portion]

In the resolution evaluation, the residues of the unexposed portion were evaluated by the film thickness measurement. A or B is preferable.

- Evaluation standards -

A: no residues were observed. (film thickness less than 0.01 μm)
B: very small residues were observed. (film thickness is 0.01 μm or more and less than 0.1 μm)
C: residues were observed. (film thickness is 0.1 μm or more and less than 1 μm)
D: residues were observed. (film thickness is 1 μm or more)

[Sensitivity (residual film ratio after development)]

In the resolution evaluation, the sensitivity was evaluated by checking the residual film ratio after development in a case of exposure at the exposure amount (sensitivity confirmation exposure amount) shown in Tables 14 to 17. It was found that all of Examples 127 to 252 had a residual film ratio of 90% or more and had appropriate exposure sensitivity. The residual film ratio was determined by (film thickness of exposed portion/film thickness before exposure) × 100 (%) after development.

In Comparative Examples 12 to 21, the residual film ratio was 90% or more, but in Comparative Example 22, the residual film ratio was less than 90%, and the result was that a part of the film was peeled off. Therefore, in Comparative Example 22, the resolution and the evaluation of the residue of the unexposed portion were not performed.

[Table 14]

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| Example | 127 | 50 | 700 | 30 | 50 | 5 | 80 | 5 | 100 | 5 | - | 0 | M | 400 | B | A |
| | 128 | 50 | 700 | 30 | 40 | 6 | 80 | 5 | 120 | 4 | - | 0 | M | 400 | B | A |
| | 129 | 50 | 700 | 30 | 60 | 5 | 80 | 5 | 100 | 5 | - | 0 | M | 400 | B | A |
| | 130 | 50 | 700 | 30 | 40 | 6 | 80 | 5 | 120 | 4 | - | 0 | M | 400 | B | A |
| | 131 | 50 | 700 | 30 | 50 | 5 | 70 | 5 | 100 | 5 | - | 0 | M | 400 | B | A |
| | 132 | 50 | 700 | 30 | 50 | 5 | 80 | 5 | 100 | 5 | - | 0 | M | 400 | B | A |
| | 133 | 50 | 700 | 30 | 50 | 5 | 70 | 5 | 100 | 5 | - | 0 | M | 400 | B | A |
| | 134 | 50 | 700 | 30 | 60 | 5 | 80 | 5 | 100 | 5 | - | 0 | M | 400 | B | A |
| | 135 | 50 | 700 | 30 | 60 | 10 | 100 | 5 | - | 0 | - | 0 | M | 400 | B | B |
| | 136 | 50 | 700 | 30 | 40 | 6 | 80 | 5 | 120 | 4 | - | 0 | M | 400 | A | A |
| | 137 | 50 | 700 | 30 | 50 | 5 | 70 | 5 | 100 | 5 | - | 0 | M | 400 | B | A |
| | 138 | 50 | 700 | 30 | 50 | 15 | 110 | 5 | - | 0 | - | 0 | M | 400 | B | A |
| | 139 | 50 | 700 | 30 | 50 | 5 | 70 | 5 | 100 | 5 | - | 0 | M | 400 | B | A |
| | 140 | 50 | 700 | 30 | 40 | 6 | 80 | 5 | 120 | 4 | - | 0 | M | 400 | B | A |
| | 141 | 50 | 700 | 30 | 60 | 10 | 100 | 5 | - | 0 | - | 0 | M | 600 | A | A |
| | 142 | 50 | 700 | 30 | 40 | 6 | 80 | 5 | 120 | 4 | - | 0 | M | 400 | A | A |
| | 143 | 50 | 700 | 30 | 50 | 5 | 80 | 5 | 100 | 5 | - | 0 | M | 400 | A | A |
| | 144 | 50 | 700 | 30 | 40 | 6 | 80 | 5 | 120 | 4 | - | 0 | M | 400 | A | A |
| | 145 | 50 | 700 | 30 | 50 | 15 | 110 | 5 | - | 0 | - | 0 | M | 400 | A | A |
| | 146 | 50 | 700 | 30 | 40 | 10 | 100 | 5 | - | 0 | - | 0 | M | 400 | A | A |
| | 147 | 50 | 700 | 30 | 60 | 5 | 80 | 5 | 100 | 5 | - | 0 | M | 400 | A | A |

(continued)

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| | 148 | 50 | 700 | 30 | 40 | 6 | 80 | 5 | 120 | 4 | - | 0 | M | 400 | A | A |
| | 149 | 50 | 700 | 30 | 60 | 10 | 100 | 5 | - | 0 | - | 0 | M | 400 | A | A |
| | 150 | 50 | 700 | 30 | 50 | 5 | 70 | 5 | 100 | 5 | - | 0 | M | 400 | A | A |
| | 151 | 50 | 700 | 30 | 100 | 15 | - | 0 | - | 0 | - | 0 | M | 400 | B | A |
| | 152 | 50 | 700 | 30 | 50 | 5 | 70 | 5 | 100 | 5 | - | 0 | M | 600 | A | A |
| | 153 | 50 | 700 | 30 | 50 | 5 | 80 | 5 | 100 | 5 | - | 0 | M | 400 | A | A |
| | 154 | 50 | 700 | 30 | 40 | 5 | 70 | 5 | 90 | 5 | 110 | 3 | M | 400 | A | A |
| | 155 | 50 | 700 | 30 | 50 | 5 | 70 | 5 | 100 | 5 | - | 0 | M | 400 | A | A |
| | 156 | 50 | 700 | 30 | 40 | 6 | 80 | 5 | 120 | 4 | - | 0 | M | 400 | A | A |
| | 157 | 50 | 700 | 30 | 50 | 5 | 70 | 5 | 100 | 5 | - | 0 | M | 400 | A | A |
| | 158 | 50 | 700 | 30 | 60 | 10 | 100 | 5 | - | 0 | - | 0 | M | 400 | A | A |
| | 159 | 50 | 700 | 30 | 60 | 5 | 80 | 5 | 100 | 5 | - | 0 | M | 600 | A | A |
| | 160 | 50 | 700 | 30 | 50 | 15 | 110 | 5 | - | 0 | - | 0 | M | 400 | A | A |
| | 161 | 50 | 700 | 30 | 50 | 5 | 80 | 5 | 100 | 5 | - | 0 | M | 400 | A | A |
| | 162 | 50 | 700 | 30 | 40 | 5 | 60 | 5 | 80 | 5 | 100 | 5 | M | 400 | B | A |
| | 163 | 50 | 700 | 30 | 60 | 5 | 80 | 5 | 100 | 5 | - | 0 | M | 600 | A | A |
| | 164 | 50 | 700 | 30 | 50 | 5 | 70 | 5 | 100 | 5 | - | 0 | M | 400 | A | A |
| | 165 | 50 | 700 | 30 | 40 | 6 | 80 | 5 | 120 | 4 | - | 0 | M | 400 | A | A |
| | 166 | 50 | 700 | 30 | 60 | 10 | 100 | 5 | - | 0 | - | 0 | M | 400 | B | B |

[Table 15]

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| Example | 167 | 50 | 700 | 30 | 60 | 5 | 80 | 5 | 100 | 5 | - | 0 | M | 400 | B | B |
| | 168 | 50 | 700 | 30 | 50 | 5 | 80 | 5 | 100 | 5 | - | 0 | M | 400 | B | B |
| | 169 | 50 | 700 | 30 | 50 | 15 | 110 | 5 | - | 0 | - | 0 | M | 600 | C | B |
| | 170 | 50 | 700 | 30 | 40 | 5 | 80 | 10 | 100 | 4 | - | 0 | M | 400 | C | B |
| | 171 | 50 | 700 | 30 | 60 | 10 | 100 | 5 | - | 0 | - | 0 | M | 400 | C | B |
| | 172 | 50 | 700 | 30 | 100 | 15 | - | 0 | - | 0 | - | 0 | M | 400 | C | B |
| | 173 | 50 | 700 | 30 | 50 | 5 | 80 | 5 | 100 | 5 | - | 0 | M | 400 | C | B |
| | 174 | 50 | 700 | 30 | 40 | 5 | 80 | 10 | 100 | 4 | - | 0 | M | 400 | C | B |
| | 175 | 50 | 700 | 30 | 60 | 5 | 80 | 5 | 100 | 5 | - | 0 | M | 400 | C | B |
| | 176 | 50 | 700 | 30 | 80 | 10 | 110 | 3 | - | 0 | - | 0 | M | 400 | C | B |
| | 177 | 50 | 700 | 30 | 110 | 10 | - | 0 | - | 0 | - | 0 | M | 400 | C | B |
| | 178 | 50 | 700 | 30 | 60 | 10 | 100 | 5 | - | 0 | - | 0 | M | 400 | A | A |
| | 179 | 50 | 700 | 30 | 60 | 5 | 80 | 5 | 100 | 5 | - | 0 | M | 400 | B | A |
| | 180 | 50 | 700 | 60 | 50 | 15 | 110 | 5 | - | 0 | - | 0 | M | 400 | A | A |
| | 181 | 60 | 700 | 30 | 40 | 5 | 80 | 10 | 100 | 4 | - | 0 | M | 400 | A | A |
| | 182 | 40 | 700 | 30 | 50 | 5 | 80 | 5 | 100 | 5 | - | 0 | M | 400 | A | A |
| | 183 | 50 | 700 | 30 | 40 | 6 | 80 | 5 | 120 | 4 | - | 0 | M | 400 | A | A |
| | 184 | 50 | 700 | 30 | 60 | 5 | 80 | 5 | 100 | 5 | - | 0 | M | 400 | A | A |
| | 185 | 50 | 700 | 30 | 50 | 5 | 80 | 5 | 100 | 5 | - | 0 | M | 400 | A | A |
| | 186 | 50 | 700 | 30 | 40 | 6 | 80 | 5 | 120 | 4 | - | 0 | M | 600 | A | A |
| | 187 | 50 | 700 | 30 | 60 | 10 | 100 | 5 | - | 0 | - | 0 | M | 400 | A | A |

(continued)

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| | 188 | 50 | 700 | 30 | 80 | 10 | 110 | 3 | - | 0 | - | 0 | M | 400 | B | A |
| | 189 | 50 | 700 | 30 | 40 | 5 | 70 | 5 | 90 | 5 | 110 | 0 | M | 600 | A | A |
| | 190 | 50 | 700 | 30 | 60 | 10 | 100 | 5 | - | 0 | - | 0 | M | 400 | A | A |
| | 191 | 50 | 700 | 30 | 50 | 15 | 110 | 5 | - | 0 | - | 0 | M | 400 | A | A |
| | 192 | 50 | 700 | 30 | 60 | 10 | 100 | 5 | - | 0 | - | 0 | M | 400 | A | A |
| | 193 | 50 | 700 | 30 | 40 | 6 | 80 | 5 | 120 | 4 | - | 0 | M | 400 | A | A |
| | 194 | 50 | 700 | 30 | 60 | 5 | 80 | 5 | 100 | 5 | - | 0 | M | 400 | A | A |
| | 195 | 50 | 700 | 30 | 50 | 5 | 70 | 5 | 100 | 5 | - | 0 | M | 400 | A | A |
| | 196 | 50 | 700 | 30 | 60 | 5 | 80 | 5 | 100 | 5 | - | 0 | M | 400 | A | A |
| | 197 | 50 | 700 | 30 | 80 | 10 | 110 | 3 | - | 0 | - | 0 | M | 400 | A | A |
| | 198 | 50 | 700 | 45 | 60 | 10 | 100 | 5 | - | 0 | - | 0 | M | 400 | A | A |
| | 199 | 50 | 700 | 30 | 50 | 15 | 110 | 5 | - | 0 | - | 0 | M | 400 | A | A |
| | 200 | 50 | 700 | 30 | 60 | 10 | 100 | 5 | - | 0 | - | 0 | M | 400 | A | A |
| | 201 | 50 | 700 | 30 | 50 | 5 | 80 | 5 | 100 | 5 | - | 0 | M | 400 | A | A |
| | 202 | 50 | 700 | 30 | 60 | 5 | 80 | 5 | 100 | 5 | - | 0 | M | 400 | A | A |
| | 203 | 50 | 700 | 30 | 60 | 10 | 100 | 5 | - | 0 | - | 0 | M | 400 | A | A |
| | 204 | 50 | 700 | 30 | 40 | 5 | 80 | 5 | 120 | 5 | - | 0 | M | 400 | B | A |
| | 205 | 50 | 700 | 30 | 40 | 5 | 80 | 10 | 100 | 4 | - | 0 | D | 600 | A | A |
| | 206 | 50 | 700 | 30 | 40 | 6 | 80 | 5 | 120 | 4 | - | 0 | M | 400 | A | A |

[Table 16]

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| Example | 207 | 50 | 700 | 30 | 40 | 6 | 80 | 5 | 120 | 4 | - | 0 | M | 400 | A | A |
| | 208 | 50 | 700 | 30 | 60 | 5 | 80 | 5 | 100 | 5 | - | 0 | M | 400 | A | A |
| | 209 | 50 | 700 | 30 | 60 | 10 | 100 | 5 | - | 0 | - | 0 | M | 400 | A | A |
| | 210 | 50 | 700 | 30 | 80 | 10 | 110 | 3 | - | 0 | - | 0 | M | 400 | A | A |
| | 211 | 50 | 700 | 30 | 60 | 5 | 80 | 5 | 100 | 5 | - | 0 | M | 400 | A | A |
| | 212 | 50 | 700 | 30 | 40 | 5 | 80 | 5 | 120 | 5 | - | 0 | M | 400 | A | A |
| | 213 | 50 | 700 | 30 | 50 | 15 | 110 | 5 | - | 0 | - | 0 | M | 400 | A | A |
| | 214 | 50 | 700 | 30 | 40 | 5 | 70 | 5 | 90 | 5 | 110 | 3 | D | 600 | A | A |
| | 215 | 50 | 700 | 30 | 60 | 10 | 100 | 5 | - | 0 | - | 0 | M | 400 | A | A |
| | 216 | 50 | 700 | 30 | 40 | 6 | 80 | 5 | 120 | 4 | - | 0 | M | 400 | A | A |
| | 217 | 50 | 700 | 30 | 50 | 5 | 80 | 5 | 100 | 5 | - | 0 | M | 400 | A | A |
| | 218 | 50 | 700 | 30 | 40 | 5 | 80 | 10 | 100 | 4 | - | 0 | M | 400 | A | A |
| | 219 | 50 | 700 | 30 | 50 | 5 | 80 | 5 | 100 | 5 | | 0 | M | 400 | A | A |
| | 220 | 50 | 700 | 30 | 40 | 5 | 70 | 5 | 90 | 5 | 110 | 3 | M | 400 | A | A |
| | 221 | 50 | 700 | 30 | 40 | 6 | 80 | 5 | 120 | 4 | - | 0 | M | 400 | A | A |
| | 222 | 50 | 700 | 90 | 60 | 10 | 100 | 5 | - | 0 | - | 0 | M | 400 | A | A |
| | 223 | 50 | 700 | 30 | 80 | 10 | 110 | 3 | - | 0 | - | 0 | M | 400 | A | A |
| | 224 | 50 | 700 | 30 | 40 | 5 | 80 | 5 | 120 | 5 | - | 0 | M | 400 | A | A |
| | 225 | 50 | 700 | 30 | 50 | 5 | 70 | 5 | 100 | 5 | - | 0 | M | 400 | A | A |
| | 226 | 50 | 700 | 30 | 60 | 5 | 80 | 5 | 100 | 5 | - | 0 | M | 400 | A | A |
| | 227 | 50 | 700 | 30 | 50 | 15 | 110 | 5 | - | 0 | - | 0 | M | 400 | A | A |

(continued)

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm²] | | |
| | 228 | 50 | 700 | 30 | 50 | 5 | 80 | 5 | 100 | 5 | - | 0 | M | 400 | A | A |
| | 2.29 | 50 | 700 | 30 | 50 | 5 | 70 | 5 | 100 | 5 | - | 0 | M | 400 | A | A |
| | 230 | 50 | 700 | 30 | 40 | 6 | 80 | 5 | 120 | 4 | - | 0 | M | 400 | A | A |
| | 231 | 50 | 700 | 30 | 60 | 10 | 100 | 5 | - | 0 | - | 0 | M | 400 | A | A |
| | 232 | 50 | 700 | 30 | 80 | 10 | 110 | 3 | - | 0 | - | 0 | M | 400 | A | A |
| | 233 | - | - | - | 40 | 6 | 80 | 5 | 120 | 4 | - | 0 | M | 400 | B | B |
| | 234 | 50 | 700 | 30 | 120 | 10 | - | 0 | - | 0 | - | 0 | M | 600 | B | B |
| | 235 | 50 | 700 | 30 | 60 | 5 | 80 | 5 | 100 | 5 | - | 0 | M | 400 | B | B |
| | 236 | 50 | 700 | 30 | 40 | 5 | 80 | 5 | 120 | 5 | - | 0 | M | 400 | B | B |

[Table 17]

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| Example | 237 | 50 | 700 | 30 | 100 | 20 | - | 0 | - | 0 | - | 0 | M | 400 | B | B |
| | 238 | 50 | 700 | 30 | 40 | 5 | 80 | 10 | 100 | 4 | - | 0 | M | 400 | B | B |
| | 239 | 50 | 700 | 30 | 50 | 5 | 80 | 5 | 100 | 5 | - | 0 | M | 400 | A | A |
| | 240 | 50 | 700 | 30 | 80 | 10 | 110 | 3 | - | 0 | - | 0 | M | 400 | A | A |
| | 241 | 50 | 700 | 30 | 50 | 5 | 70 | 5 | 100 | 5 | - | 0 | M | 400 | A | A |
| | 242 | 50 | 700 | 30 | 50 | 15 | 110 | 5 | - | 0 | - | 0 | M | 400 | A | A |
| | 243 | 50 | 700 | 30 | 40 | 5 | 80 | 5 | 120 | 5 | - | 0 | M | 400 | A | A |
| | 244 | 50 | 700 | 30 | 40 | 6 | 80 | 5 | 120 | 4 | - | 0 | M | 400 | A | A |
| | 245 | 50 | 700 | 30 | 40 | 5 | 80 | 5 | 120 | 5 | - | 0 | M | 400 | A | A |
| | 246 | 50 | 700 | 30 | 40 | 5 | 80 | 10 | 100 | 4 | - | 0 | M | 400 | A | A |
| | 247 | 50 | 700 | 30 | 80 | 10 | 110 | 3 | - | 0 | - | 0 | M | 400 | B | B |
| | 248 | 50 | 700 | 30 | 40 | 5 | 80 | 5 | 120 | 5 | - | 0 | M | 400 | A | A |
| | 249 | 50 | 700 | 30 | 80 | 10 | 110 | 3 | - | 0 | - | 0 | M | 400 | A | A |
| | 250 | 50 | 700 | 30 | 60 | 5 | 80 | 5 | 100 | 5 | - | 0 | M | 400 | A | A |
| | 251 | 50 | 700 | 30 | 50 | 5 | 80 | 5 | 100 | 5 | - | 0 | M | 400 | A | A |
| | 252 | 50 | 700 | 30 | 40 | 6 | 80 | 5 | 120 | 4 | - | 0 | M | 400 | A | A |

(continued)

| | | Pretreatment of base material | | | Hot plate drying | | | | | | | | Exposing condition | | Evaluation result | |
|---|---|---|---|---|---|---|---|---|---|---|---|---|---|---|---|---|
| | | | | | Step 1 | | Step 2 | | Step 3 | | Step 4 | | Method | Sensitivity confirmation exposure amount | Resolution | Residues in unexposed portion |
| | | Temperature [°C] | Output [W] | Time [sec.] | Temperature [°C] | Time [min.] | Temperature [°C] | Time [min.] | Temperature [°C] | Time [min.] | Temperature [°C] | Time [min.] | M or D | [mJ/cm$^2$] | | |
| Comparative Example | 12 | 50 | 700 | 30 | 50 | 5 | 80 | 5 | 100 | 5 | - | 0 | M | 400 | D | D |
| | 13 | 50 | 700 | 30 | 40 | 6 | 80 | 5 | 120 | 4 | - | 0 | M | 400 | D | D |
| | 14 | 50 | 700 | 30 | 60 | 5 | 80 | 5 | 100 | 5 | - | 0 | M | 400 | D | D |
| | 15 | 50 | 700 | 30 | 40 | 6 | 80 | 5 | 120 | 4 | - | 0 | M | 400 | D | D |
| | 16 | 50 | 700 | 30 | 50 | 5 | 70 | 5 | 100 | 5 | - | 0 | M | 400 | D | D |
| | 17 | 50 | 700 | 30 | 50 | 5 | 80 | 5 | 100 | 5 | - | 0 | M | 400 | D | D |
| | 18 | 50 | 700 | 30 | 50 | 5 | 70 | 5 | 100 | 5 | - | 0 | M | 600 | D | D |
| | 19 | 50 | 700 | 60 | 60 | 5 | 80 | 5 | 100 | 5 | - | 0 | M | 400 | D | D |
| | 20 | 50 | 700 | 30 | 60 | 10 | 100 | 5 | - | 0 | - | 0 | M | 400 | D | D |
| | 21 | 50 | 700 | 30 | 40 | 6 | 80 | 5 | 120 | 4 | - | 0 | M | 400 | D | D |
| | 22 | 50 | 700 | 30 | 90 | 5 | - | 0 | - | 0 | - | 0 | M | 400 | - | - |

From the above results, it was found that in Examples of the present invention, a film having excellent resolution and hardly generating residues in an unexposed portion can be manufactured.

The resin composition used in Example 1 was applied onto a base material by a slit coating method.

As the base material, a base material having a thin copper layer on the surface of a resin substrate, in which the thin copper layer was subjected to a pretreatment ($O_2$ plasma ashing treatment) under the conditions (temperature and time) shown in Table 6, was used.

Thereafter, the coating film of the resin composition was dried under reduced pressure with a reduced pressure dryer. Specifically, the temperature of the reduced pressure dryer was set to 60°C, and reduced pressure drying was performed by step 1: reducing pressure from normal pressure to 500 Pa over 100 seconds, step 2: maintaining the pressure at 500 Pa for 600 seconds, and then step 3: rapidly reducing pressure until the reduced pressure degree reached 15 Pa.

Thereafter, drying was performed on a hot plate (at normal pressure) at 100°C for 5 minutes to form a photosensitive film having a film thickness of 10 μm.

The obtained film was exposed using a stepper (NSR1505 i6, manufactured by Nikon Corporation). Exposure was carried out through a mask (a binary mask in which the pattern is a pattern of 1:1 line and space and the line width is 10 μm) at a wavelength of 365 nm. After the above-described exposure, the layer was subjected to shower development with cyclopentanone for 35 seconds, then subjected to showering with cyclopentanone-propylene glycol monomethyl ether acetate (PGMEA) for 5 seconds, and then subjected to shower rinsing with PGMEA for 15 seconds to obtain a layer pattern.

Next, the temperature was raised at a temperature rising rate of 10 °C/min in a nitrogen atmosphere, and after the temperature reached 220°C, the temperature was maintained at 220°C for 120 minutes, thereby forming an interlayer insulating film for a re-distribution layer. This interlayer insulating film for a re-distribution layer was excellent in insulating properties.

In addition, in a case where a semiconductor device including two to four re-distribution layers was manufactured using this interlayer insulating film for a re-distribution layer, it has been confirmed that the semiconductor device operates without any problem.

According to the present invention, it is possible to provide a manufacturing method for a film with excellent resolution and with less occurrence of residues in an unexposed portion.

In addition, according to the present invention, it is possible to provide a photosensitive resin composition capable of forming a film having excellent resolution and hardly generating residues in an unexposed portion, a manufacturing method for a cured substance using the photosensitive resin composition, a cured substance obtained by curing the photosensitive resin composition, and a laminate including the cured substance.

The present invention has been described in detail with reference to specific embodiments. To those skilled in the art, it is obvious that various changes or modifications can be added without departing from the gist and scope of the present invention.

The present application is based on Japanese Patent Application (JP2022-158659) filed on September 30, 2022 and Japanese Patent Application (JP2023-148829) filed on September 13, 2023, and the contents of which are incorporated herein by reference.

## Claims

**1.** A manufacturing method for a film, comprising:
a step of applying a photosensitive resin composition onto a base material and then drying the photosensitive resin composition under a pressure of 5,000 Pa or less, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

**2.** A manufacturing method for a film, comprising:

a step of applying a photosensitive resin composition onto a base material and then drying the photosensitive resin composition at a first temperature, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent; and

a step of drying the photosensitive resin composition at a second temperature higher than the first temperature under a pressure within a range of ±10% of the pressure in the step of drying the photosensitive resin composition at the first temperature.

**3.** A manufacturing method for a film, comprising only:
a step of applying a photosensitive resin composition onto a base material and then drying the photosensitive resin composition at 90°C or higher for a time longer than 5 minutes as a drying step, the photosensitive resin composition containing

(A) a resin,
(C) a photopolymerization initiator,
(D) a radical polymerization inhibitor which is at least one compound selected from the group consisting of (D-1) a compound having a free radical in a molecule and (D-2) a compound having no free radical in a molecule and having a molecular weight of 270 or more, and
(E) a solvent.

**4.** The manufacturing method for a film according to any one of claims 1 to 3,
wherein the photosensitive resin composition satisfies at least one of (i) or (ii),

(i) (B-1) radically polymerizable compound is contained,
(ii) the (A) includes a radically polymerizable site.

**5.** The manufacturing method for a film according to any one of claims 1 to 3,
wherein the (A) is at least one resin selected from the group consisting of a polyimide and a polyimide precursor.

**6.** The manufacturing method for a film according to any one of claims 1 to 3,

wherein the (A) includes a repeating unit represented by Formula (2),

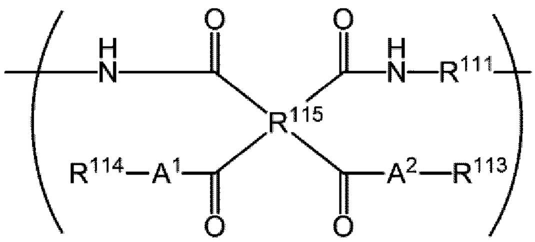

(2)

in Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group,
provided that at least one of $R^{113}$ or $R^{114}$ has a group represented by Formula (III),

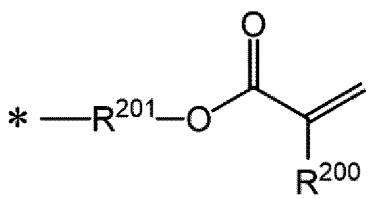

(III)

in Formula (III), $R^{200}$ represents a hydrogen atom, a methyl group, an ethyl group, or a methylol group, and *

represents a bonding site to another structure, $R^{201}$ represents an alkylene group having 2 to 12 carbon atoms, $-CH_2CH(OH)CH_2-$, a cycloalkylene group, or a polyalkyleneoxy group.

**7.** The manufacturing method for a film according to any one of claims 1 to 3, wherein the molecular weight of the (D-2) is 700 or more.

**8.** The manufacturing method for a film according to any one of claims 1 to 3, wherein a molecular weight of the (D-1) is 160 or more.

**9.** The manufacturing method for a film according to any one of claims 1 to 3, wherein a concentration of solid contents of the photosensitive resin composition is 35% by mass or less.

**10.** The manufacturing method for a film according to any one of claims 1 to 3, wherein the base material contains Cu on a surface.

**11.** The manufacturing method for a film according to claim 1, wherein a temperature in the step of drying under the pressure of 5,000 Pa or less is 35°C or higher and 80°C or lower.

**12.** A photosensitive resin composition comprising:

(A) a resin;
(C) a photopolymerization initiator;
(D) a radical polymerization inhibitor which is at least one compound selected from the group consisting of (D-1) a compound having a free radical in a molecule and (D-2) a compound having no free radical in a molecule and having a molecular weight of 270 or more; and
(E) a solvent.

**13.** The photosensitive resin composition according to claim 12,
wherein the photosensitive resin composition satisfies at least one of (i) or (ii),

(i) (B-1) radically polymerizable compound is contained,
(ii) the (A) includes a radically polymerizable site.

**14.** The photosensitive resin composition according to claim 12,
wherein the (A) is at least one resin selected from the group consisting of a polyimide and a polyimide precursor.

**15.** The photosensitive resin composition according to claim 12,

wherein the (A) includes a repeating unit represented by Formula (2),

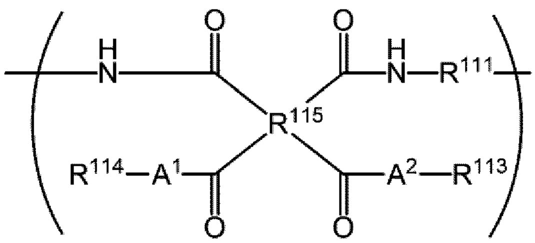

(2)

in Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group,
provided that at least one of $R^{113}$ or $R^{114}$ has a group represented by Formula (III),

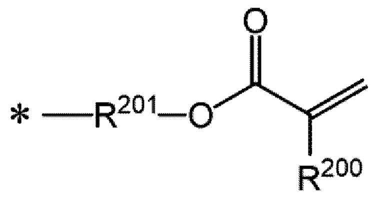

(III)

in Formula (III), $R^{200}$ represents a hydrogen atom, a methyl group, an ethyl group, or a methylol group, and * represents a bonding site to another structure, $R^{201}$ represents an alkylene group having 2 to 12 carbon atoms, $-CH_2CH(OH)CH_2-$, a cycloalkylene group, or a polyalkyleneoxy group.

**16.** The photosensitive resin composition according to claim 12, wherein the molecular weight of the (D-2) is 700 or more.

**17.** The photosensitive resin composition according to claim 12, wherein a molecular weight of the (D-1) is 160 or more.

**18.** The photosensitive resin composition according to claim 12, wherein a concentration of solid contents of the photosensitive resin composition is 35% by mass or less.

**19.** The photosensitive resin composition according to any one of claims 12 to 18, wherein the photosensitive resin composition is used for forming an interlayer insulating film for a redistribution layer.

**20.** A manufacturing method for a cured substance, comprising:

a step of applying the photosensitive resin composition according to any one of claims 12 to 18 onto a base material to dry the photosensitive resin composition under a reduced pressure to form a film;
an exposure step of selectively exposing the film; and
a development step of developing the film exposed by the exposure step using a developer to form a pattern.

**21.** A cured substance obtained by curing the photosensitive resin composition according to any one of claims 12 to 18.

**22.** A laminate comprising:

two or more layers consisting of the cured substance according to claim 21; and
a metal layer provided between any of the layers consisting of the cured substance.

## INTERNATIONAL SEARCH REPORT

International application No.
**PCT/JP2023/034551**

### A. CLASSIFICATION OF SUBJECT MATTER

***G03F 7/004***(2006.01)i; ***C08F 290/14***(2006.01)i; ***C08G 73/10***(2006.01)i; ***G03F 7/027***(2006.01)i; ***G03F 7/09***(2006.01)i; ***G03F 7/20***(2006.01)i; ***G03F 7/26***(2006.01)i; ***H01L 21/312***(2006.01)i
FI: G03F7/004 502; C08F290/14; C08G73/10; G03F7/004 501; G03F7/027 514; G03F7/09 501; G03F7/20 501; G03F7/26; H01L21/312 B; H01L21/312 D

According to International Patent Classification (IPC) or to both national classification and IPC

### B. FIELDS SEARCHED

Minimum documentation searched (classification system followed by classification symbols)

G03F7/004; C08F290/14; C08G73/10; G03F7/027; G03F7/09; G03F7/20; G03F7/26; H01L21/312

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2021/246457 A1 (FUJIFILM CORP.) 09 December 2021 (2021-12-09) paragraphs [0464]-[0499] | 3-6, 10, 12-15, 18-19, 21-22 |
| Y | | 1-11, 18, 20 |
| X | WO 2020/166510 A1 (FUJIFILM CORP.) 20 August 2020 (2020-08-20) paragraphs [0222]-[0324] | 12-13, 17, 19, 21 |
| Y | | 1-4, 8-11, 18, 20, 2 |
| X | WO 2017/002859 A1 (FUJIFILM CORP.) 05 January 2017 (2017-01-05) paragraphs [0226]-[0247] | 3-8, 10, 12-17, 19, 21 |
| Y | | 1-11, 18, 20, 22 |
| X | JP 2011-099918 A (SUMITOMO CHEMICAL CO., LTD.) 19 May 2011 (2011-05-19) paragraphs [0169]-[0182] | 1, 4, 7, 9, 11-13, 16, 18-21 |
| Y | | 2-11, 22 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 November 2023** | **28 November 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2023/034551**

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2016-075845 A (FUJIFILM CORP.) 12 May 2016 (2016-05-12) paragraphs [0292]-[0396] | 12-13, 16, 19, 21<br>1-4, 7, 9-11, 18, 20, 22 |
| Y | WO 2013/099785 A1 (TORAY INDUSTRIES, INC.) 04 July 2013 (2013-07-04) paragraph [0154] | 2, 4-10 |
| Y | JP 2008-040109 A (MITSUBISHI CHEMICAL CORP.) 21 February 2008 (2008-02-21) paragraph [0189] | 2, 4-10 |

Form PCT/ISA/210 (second sheet) (January 2015)

**INTERNATIONAL SEARCH REPORT**
**Information on patent family members**

International application No.
**PCT/JP2023/034551**

| Patent document cited in search report | Publication date (day/month/year) | Patent family member(s) | Publication date (day/month/year) |
|---|---|---|---|
| WO 2021/246457 A1 | 09 December 2021 | KR 10-2023-0005356 A<br>CN 115667404 A | |
| WO 2020/166510 A1 | 20 August 2020 | US 2021/0382388 A1<br>paragraphs [0638]-[1022]<br>KR 10-2021-0111814 A<br>CN 113423743 A | |
| WO 2017/002859 A1 | 05 January 2017 | KR 10-2018-0005227 A<br>TW 201708957 A | |
| JP 2011-099918 A | 19 May 2011 | (Family: none) | |
| JP 2016-075845 A | 12 May 2016 | KR 10-2017-0048548 A<br>TW 201614011 A | |
| WO 2013/099785 A1 | 04 July 2013 | US 2014/0242787 A1<br>paragraph [0157]<br>EP 2799928 A1<br>CN 104011596 A<br>KR 10-2014-0109866 A | |
| JP 2008-040109 A | 21 February 2008 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019163860 A
- WO 2014045783 A
- WO 2017038598 A
- JP 2013256506 A
- JP 2016027357 A
- WO 2021112189 A
- JP 48041708 B
- JP S48041708 B
- JP 51037193 A
- JP S51037193 A
- JP 2032293 B
- JP H02032293 B
- JP 2016765 B
- JP H02016765 B
- JP 58049860 B
- JP S58049860 B
- JP 56017654 B
- JP 62039417 B
- JP S62039417 B
- JP 62039418 B
- JP S62039418 B
- JP 63277653 A
- JP S63277653 A
- JP 63260909 A
- JP S63260909 A
- JP 1105238 A
- JP H01105238 A
- WO 2015199219 A
- JP 2014130173 A
- JP 6301489 B
- WO 2018221177 A
- WO 2018110179 A
- JP 2019043864 A
- JP 2019044030 A
- JP 2019167313 A
- JP 2015087611 A
- JP 10291969 A
- JP H10291969 A
- JP 4225898 B
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- WO 2021020359 A
- JP 4600600 B
- JP 2007269779 A
- JP 2009191061 A
- WO 2015125469 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- JP 2011209692 A
- JP 2015194674 A
- JP 2015087409 A
- WO 2020066416 A
- WO 2018038002 A
- JP 2015123351 A
- JP 2018173573 A
- JP 2011128358 A
- JP 2014186186 A
- JP 2013072935 A
- JP 2013015701 A
- JP 2009283711 A
- JP 2011059656 A
- JP 2012194520 A
- WO 2018025738 A
- JP 2019206689 A
- JP 4253058 A
- JP H4253058 A
- JP 5224410 A
- JP H5224410 A
- JP 5303200 A
- JP H5303200 A
- EP 530148 A
- JP 2004091638 A
- JP 2012003225 A
- US 20130034812 A
- JP 2008250074 A
- JP 2010164965 A

- JP 2008063554 A
- JP 2006023696 A
- JP 2006047592 A
- US 9159547 B
- JP 2007157879 A
- JP 2001521288 A
- JP 2004214501 A
- JP 2004101850 A
- US 7888181 B2
- US 9177926 B2
- JP 2022158659 A
- JP 2023148829 A

**Non-patent literature cited in the description**


- Handbook of Chemistry, Pure Chemistry. Chemical Society of Japan
- *MATERIAL STAGE*, 2019, vol. 19 (3), 37-60
- *J. C. S. Perkin II*, 1979, 1653-1660
- *J. C. S. Perkin II*, 1979, 156-162
- *Journal of Photopolymer Science and Technology*, 1995, 202-232
- Polymer Dictionary. 2005, 683-684
- High functionality and applied technology of polyimide. Science & Technology Co., Ltd., April 2008
- Basics and development of polyimide materials. Technical library CMC TL, November 2011
- Latest Polyimide Basics and Applications. NTS Inc., August 2010
- **H. SEINO et al.** *J. Polym. Sci., Part A: Polym. Chem.*, 1998, vol. 36, 2261